# EUROPEAN PATENT APPLICATION

(11) **EP 4 607 274 A2**
(43) Date of publication of application: **27.08.2025**
(21) Application number: 25159169.9
(22) Date of filing: 20.02.2025
(51) Int. Cl.: G03F 7/00, G03F 7/022, G03F 7/09, G03F 7/32, G03F 7/40

(54) **CHEMICALLY AMPLIFIED POSITIVE RESIST COMPOSITION AND RESIST PATTERN FORMING PROCESS**

(30) Priority: 21.02.2024 JP 2024024526
(71) Applicant: Shin-Etsu Chemical Co., Ltd., Chiyoda-ku, Tokyo 1000005 (JP)
(72) Inventor: FUKUSHIMA, Masahiro, Joetsu-shi, 9428601 (JP); WATANABE, Satoshi, Joetsu-shi (JP); FUNATSU, Kenji, Joetsu-shi (JP); MASUNAGA, Keiichi, Joetsu-shi (JP); KOTAKE, Masaaki, Joetsu-shi (JP); MATSUZAWA, Yuta, Joetsu-shi (JP)
(74) Representative: Ter Meer Steinmeister & Partner

(57) **Abstract**

A chemically amplified positive resist composition comprises a base polymer comprising a polymer containing repeat units having the formula (A1) and repeat units having the formula (A2), the polymer being adapted to increase its solubility in an aqueous alkaline under the action of an acid.

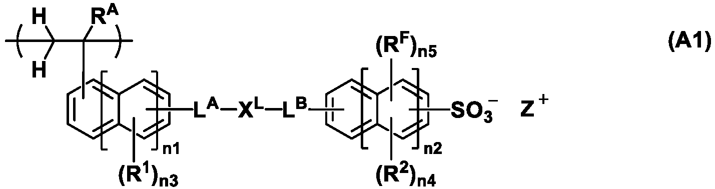

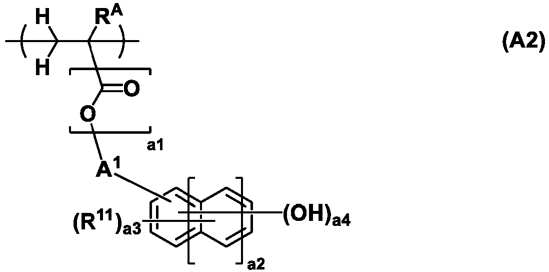

## Description

### TECHNICAL FIELD

This invention relates to a chemically amplified positive resist composition and a resist pattern forming process.

### BACKGROUND ART

The currently increasing integration density of integrated circuits requires pattern formation to a smaller feature size. In the lithography process of forming patterns with a feature size of 0.2 µm or less, chemically amplified resist compositions utilizing acid as a catalyst are mostly used. Here, as the energy source for exposure, high-energy radiation such as UV, deep UV or an electron beam (EB) is used. The EB lithography utilized as the ultrafine processing technology is indispensable for the processing of photomask blanks to produce photomasks for use in semiconductor device fabrication. The resist composition for use in the photolithography includes a positive resist composition for formation of a pattern in which an exposed region is dissolved and a negative resist composition for formation of a pattern in which an exposed region is retained. Of these, a resist composition is selected which is easier to use in light of a form of a required resist pattern.

In general, an image is written by EB without using a mask. In the case of positive resist, those regions of a resist film other than the regions to be retained are successively irradiated with EB having a minute area. In the case of negative resist, those regions of a resist film to be retained are successively irradiated. The operation of successively scanning all finely divided regions on the work surface takes a long time as compared with one-shot exposure through a photomask. To avoid any throughput decline, the resist film is required to have a high sensitivity. The long time of writing an image is likely to cause a difference between the region of an early written image and the region of a late written image. Temporal stability of the exposed region in vacuum is an important required performance item. One of the particularly important applications of chemically amplified resist material resides in processing of photomask blanks. Some photomask blanks have a surface material that can have an impact on the pattern profile of the overlying chemically amplified resist film, for example, a layer of a chromium compound, typically chromium oxide deposited on a photomask substrate. For high resolution and profile retention after etching, it is one important performance factor to maintain the profile of a resist film pattern rectangular independent of the type of substrate.

For the control of the sensitivity of the resist film and pattern profile, various improvements are made through a choice and combination of components in a resist composition and selection of processing conditions. One of such improvements addresses the problem of diffusion of acid that has a significant impact on the resolution of chemically amplified resist films. In the processing of photomasks, it is required that the profile of a resist pattern formed do not change with a lapse of time until post exposure baking (PEB). The major cause of such a change with time is diffusion of an acid generated upon exposure. The problem of acid diffusion has been widely studied not only in terms of photomask processing, but also in terms of general resist compositions because the acid diffusion has a significant impact on sensitivity and resolution.

Patent Documents 1 and 2 describe acid generators capable of generating bulky acids for controlling acid diffusion and reducing LER. Since these acid generators are still insufficient to control acid diffusion, it is desired to have an acid generator with shorter diffusion.

Patent Documents 3 to 6 disclose a resist composition comprising a resin to which a sulfonic acid generated upon exposure is bonded to control acid diffusion. This approach of controlling acid diffusion by introducing repeat units capable of generating acid upon exposure into a base polymer is effective in forming a pattern with small line edge roughness (LER). However, the base polymer having introduced therein repeat units capable of generating acid upon exposure sometimes encounters a problem with respect to its solubility in organic solvent, depending on the structure and proportion of the repeat units.

Polymers containing abundant aromatic skeletons with acidic side chains, for example, polyhydroxystyrene are used as the resist composition material for KrF lithography. These polymers are not used as the resist composition material for ArF lithography because of substantial absorption of light near to wavelength 200 nm. The above polymers are yet important, because of high etching resistance, as the resist compositions for the EB lithography and extreme ultraviolet (EUV) lithography which are promising for forming patterns of smaller size than the processing limit of ArF lithography.

Often used as the base polymer in positive resist compositions for EB and EUV lithography is a material having an acidic functional group on phenol side chain masked with an acid labile group. Upon exposure to high-energy radiation, a photoacid generator generates an acid and the acid labile group (acid-decomposable protective group) is deprotected by the catalysis of the generated acid whereby the polymer turns soluble in alkaline developer. Tertiary alkyl, tert-butoxycarbonyl, and acetal groups are mainly used as the acid labile group. On use of acetal and similar protective groups requiring relatively small activation energy for deprotection, one advantage is that a resist film having a high sensitivity is obtained. Unless the diffusion of the generated acid is fully suppressed, however, deprotection reaction can take place even in the unexposed region of the resist film. There arise problems like degradation of LER and a loss of dimensional uniformity (CDU) of the pattern line width.

As the feature size of a resist pattern is reduced in recent years, the collapse of resist pattern during development and poor resistance during subsequent etching step become outstanding problems. Incorporating repeat units capable of generating an acid upon exposure is effective in restraining the diffusion of the generated acid to some extent. There is left room for improvement in lithography properties, resist pattern collapse, and etching resistance. To meet the future demand for further miniaturization, it is quite important to have a polymer-bound acid generator capable of meeting the desired lithography performance, especially resist pattern collapse and etching resistance.

### Citation List

Patent Document 1: JP-A 2009-053518
Patent Document 2: JP-A 2010-100604
Patent Document 3: JP 4425776
Patent Document 4: JP 5201363
Patent Document 5: JP 5231357
Patent Document 6: WO 2008/081832

### SUMMARY OF THE INVENTION

In recent years, there has been a demand for a resist composition that is excellent in line-and-space (LS), iso-line (IL), iso-space (IS), hole pattern profile, and etch resistance after pattern formation.

The invention has been made in view of the above-described circumstances, and an object of the invention is to provide a chemically amplified positive resist composition which is processed by photolithography using, in particular, high-energy radiation such as KrF excimer laser, ArF excimer laser, EB or EUV, has good solvent solubility, and is excellent in lithographic performance such as resolution, LER and a pattern profile, and excellent in resistance to pattern collapse and etch resistance even in fine pattern formation, and a pattern forming process using the chemically amplified resist composition.

The inventors have extensively conducted studies for achieving the above-described object, and resultantly found that by using a polymer comprising repeat units derived from an onium salt containing an aromatic sulfonic acid anion having a vinyl-substituted aromatic ring as a polymer-bound acid generator and repeat units having a phenolic hydroxy group, as a material for a chemically amplified positive resist composition, there is obtained a chemically amplified positive resist composition which is processed by, in particular, EB lithography and EUV lithography, has good solvent solubility, and is excellent in lithographic performance such as resolution, LER and a pattern profile, and excellent in resistance to pattern collapse and etch resistance even in fine pattern formation.

Accordingly, the invention provides a chemically amplified positive resist composition and a resist pattern forming process, as defined below.
1. A chemically amplified positive resist composition comprising (A) a base polymer comprising a polymer containing repeat units having the formula (A1) and repeat units having the formula (A2), the polymer being adapted to increase its solubility in an aqueous alkaline under the action of an acid: 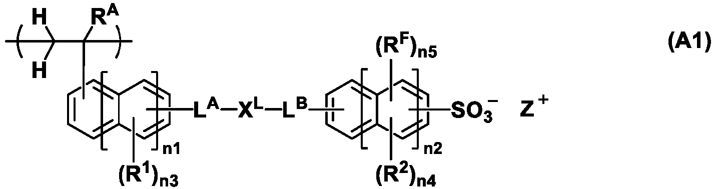
   wherein n1 is 0 or 1, n2 is 0 or 1, n3 is an integer of 0 to 4, n4 is an integer of 0 to 4, n5 is an integer of 0 to 4, n4 + n5 is from 0 to 4 when n2 is 0, n4 + n5 is from 0 to 6 when n2 is 1, excluding that all n1 to n5 are 0,
      R^{A} is a hydrogen atom, fluorine atom, methyl group or trifluoromethyl group,
      R¹ is a halogen atom, nitro group, cyano group or C₁-C₂₀ hydrocarbyl group which may contain a heteroatom, and a plurality of R¹ may bond together to form a ring with the carbon atoms to which they are attached when n3 is 2 or more,
      R² is a C₁-C₂₀ hydrocarbyl group which may contain a heteroatom, and a plurality of R² may bond together to form a ring with the carbon atom to which they are attached when n4 is 2 or more,
      R^{F} is a fluorine atom, C₁-C₆ fluorinated alkyl group, C₁-C₆ fluorinated alkoxy group or C₁-C₆ fluorinated alkylthio group,
      L^{A} and L^{B} are each independently a single bond, ether bond, ester bond, sulfonic ester bond, sulfonic amide bond, carbonate bond or carbamate bond,
      X^{L} is a C₁-C₄₀ hydrocarbylene group which may contain a heteroatom, and
      Z⁺ is an onium cation, 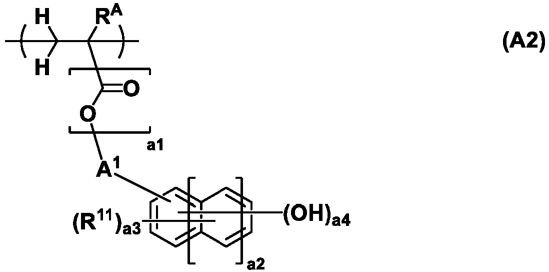
   wherein a1 is 0 or 1, a2 is an integer of 0 to 2, a3 is an integer which satisfies 0 ≤ a3 ≤ 5+2(a2)-a4, and a4 is an integer of 1 to 3,
      R^{A} is a hydrogen atom, fluorine atom, methyl group or trifluoromethyl group,
      R¹¹ is a halogen atom, C₁-C₆ saturated hydrocarbyl group which may be substituted with a halogen atom, C₁-C₆ saturated hydrocarbyloxy group which may be substituted with a halogen atom, or C₂-C₈ saturated hydrocarbylcarbonyloxy group which may be substituted with a halogen atom, and
      A¹ is a single bond or C₁-C₁₀ saturated hydrocarbylene group in which some constituent -CH₂- may be replaced by -O-.
2. The chemically amplified positive resist composition according to 1, wherein the repeat units having the formula (A1) have the formula (A1-1): 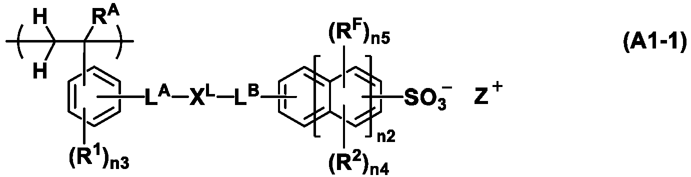 wherein n2 to n5, R^{A}, R¹, R², R^{F}, L^{A}, L^{B}, X^{L} and Z⁺ are as defined above.
3. The chemically amplified positive resist composition according to 2, wherein the repeat units having the formula (A1-1) have the formula (A1-2): 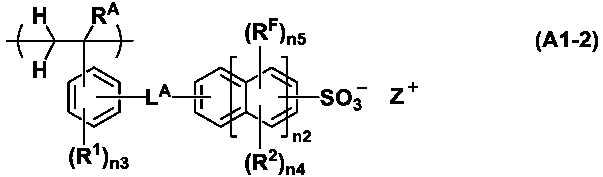 wherein n2 to n5, R^{A}, R¹, R², R^{F}, L^{A} and Z⁺ are as defined above.
4. The chemically amplified positive resist composition according to any one of 1 to 3, wherein Z⁺ is a sulfonium cation having the formula (cation-1) or iodonium cation having the formula (cation-2): 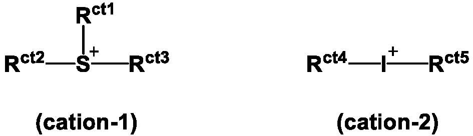 wherein R^{ct1} to R^{ct5} are each independently a halogen atom, or C₁-C₃₀ hydrocarbyl group which may contain a heteroatom, and R^{ct1} and R^{ct2} may bond together to form a ring with the sulfur atom to which they are attached.
5. The chemically amplified positive resist composition according to any one of 1 to 4, wherein the repeat units having the formula (A2) have the formula (A2-1): 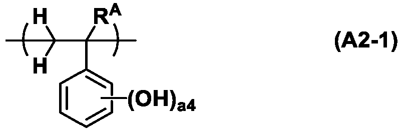 wherein R^{A} and a4 are as defined above.
6. The chemically amplified positive resist composition according to any one of 1 to 5, wherein the polymer further comprises repeat units of at least one type selected from repeat units having the formula (A3-1) and repeat units having the formula (A3-2): 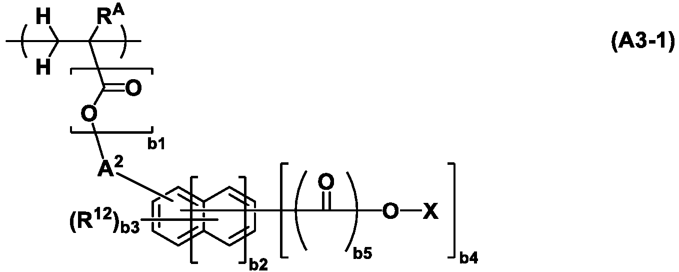 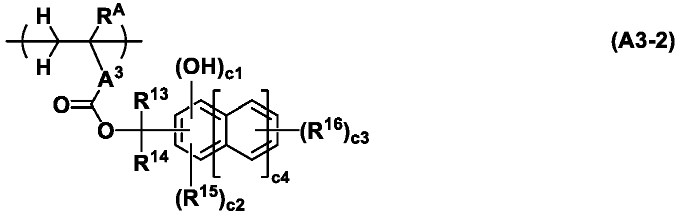
wherein b1 is 0 or 1, b2 is an integer of 0 to 2, b3 is an integer which satisfies 0 ≤ b3 ≤ 5+2(b2)-b4, b4 is an integer of 1 to 3, and b5 is 0 or 1,
c1 is an integer of 0 to 2, c2 is an integer of 0 to 2, c3 is an integer of 0 to 5, and c4 is an integer of 0 to 2,
R^{A} is a hydrogen atom, fluorine atom, methyl group or trifluoromethyl group,
R¹² is a halogen atom, C₁-C₆ saturated hydrocarbyl group which may be substituted with a halogen atom, C₁-C₆ saturated hydrocarbyloxy group which may be substituted with a halogen atom, or C₂-C₈ saturated hydrocarbylcarbonyloxy group which may be substituted with a halogen atom,
R¹³ and R¹⁴ are each independently a C₁-C₁₀ hydrocarbyl group which may contain a heteroatom, and R¹³ and R¹⁴ may bond together to form a ring with the carbon atom to which they are attached,
R¹⁵ is each independently a fluorine atom, C₁-C₅ fluorinated alkyl group or C₁-C₅ fluorinated alkoxy group,
R¹⁶ is each independently a C₁-C₁₀ hydrocarbyl group which may contain a heteroatom,
A² is a single bond or C₁-C₁₀ saturated hydrocarbylene group in which some constituent -CH₂- may be replaced by -O-,
X is an acid labile group when b4 is 1, and is each independently a hydrogen atom or acid labile group, at least one being an acid labile group, in case of b4 is 2 or 3, and
A³ is a single bond, phenylene group, naphthylene group or *-C(=O)-O-A³¹-, A³¹ is a C₁-C₂₀ aliphatic hydrocarbylene group, phenylene group, or naphthylene group, and the aliphatic hydrocarbylene group may contain at least one selected from a hydroxy group, an ether bond, an ester bond or a lactone ring, and the asterisk (*) designates a point of attachment to the carbon atom in the backbone.
7. The chemically amplified positive resist composition according to any one of 1 to 6, wherein the polymer further comprises repeat units of at least one type selected from repeat units having the formula (A4), repeat units having the formula (A5) and repeat units having the formula (A6): 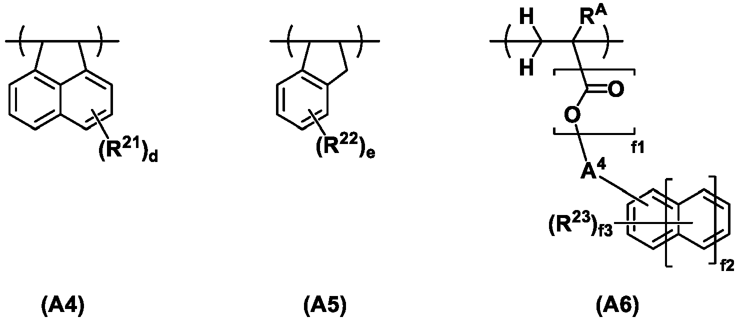 wherein d is an integer of 0 to 6, e is an integer of 0 to 4,
   f1 is 0 or 1, f2 is an integer of 0 to 2, and f3 is an integer of 0 to 5,
   R^{A} is a hydrogen atom, fluorine atom, methyl group or trifluoromethyl group,
   R²¹ and R²² are each independently a hydroxy group, halogen atom, C₁-C₆ saturated hydrocarbyl group which may be substituted with a halogen atom, C₁-C₆ saturated hydrocarbyloxy group which may be substituted with a halogen atom, or C₂-C₈ saturated hydrocarbylcarbonyloxy group which may be substituted with a halogen atom,
   R²³ is a halogen atom, nitro group, cyano group, C₁-C₂₀ saturated hydrocarbyl group, C₁-C₂₀ saturated hydrocarbyloxy group, C₂-C₂₀ saturated hydrocarbylcarbonyloxy group, C₂-C₂₀ saturated hydrocarbyloxyhydrocarbyl group or C₂-C₂₀ saturated hydrocarbylthiohydrocarbyl group, and may be a hydroxy group when f2 is 1 or 2, and
   A⁴ is a single bond or C₁-C₁₀ saturated hydrocarbylene group in which some constituent -CH₂- may be replaced by -O-.
8. The chemically amplified positive resist composition according to any one of 1 to 7, wherein the repeat units having an aromatic ring structure are incorporated in a range of 60 mol% or more based on the overall repeat units of the polymer contained in (A) the base polymer.
9. The chemically amplified positive resist composition according to any one of 1 to 8, further comprising (B) a quencher.
10. The chemically amplified positive resist composition according to any one of 1 to 9, further comprising (C) an organic solvent.
11. The chemically amplified positive resist composition according to any one of 1 to 10, further comprising (D) a fluorinated polymer containing repeat units of at least one type selected from repeat units having the formula (D1), repeat units having the formula (D2), repeat units having the formula (D3) and repeat units having the formula (D4): 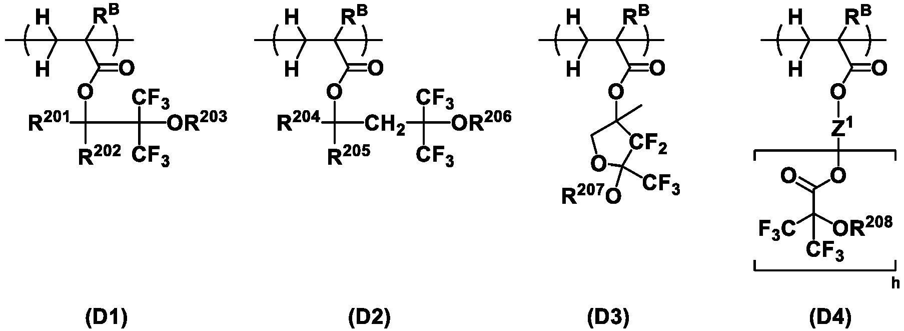 wherein h is an integer of 1 to 3,
   R^{B} is each independently a hydrogen atom, fluorine atom, methyl group, or trifluoromethyl group,
   R²⁰¹, R²⁰², R²⁰⁴ and R²⁰⁵ are each independently a hydrogen atom or C₁-C₁₀ saturated hydrocarbyl group,
   R²⁰³, R²⁰⁶, R²⁰⁷ and R²⁰⁸ are each independently a hydrogen atom, C₁-C₁₅ hydrocarbyl group, C₁-C₁₅ fluorinated hydrocarbyl group or acid labile group, and an ether bond or carbonyl group may intervene in a carbon-carbon bond when each of R²⁰³, R²⁰⁶, R²⁰⁷ and R²⁰⁸ is a hydrocarbyl group or fluorinated hydrocarbyl group, and
   Z¹ is a C₁-C₂₀ (h+1)-valent hydrocarbon group or C₁-C₂₀ (h+1)-valent fluorinated hydrocarbon group.
12. The chemically amplified positive resist composition according to 11, wherein the fluorinated polymer further comprises repeat units of at least one type selected from repeat units having the formula (D5) and repeat units having the formula (D6): 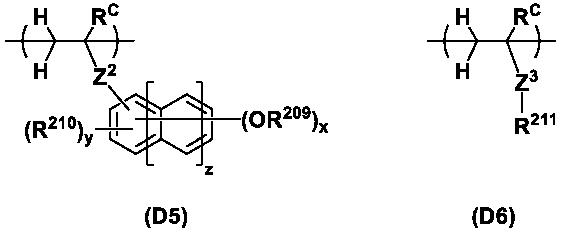 wherein x is an integer of 1 to 3, y is an integer which satisfies 0 ≤ y ≤ 5+2z-x, and z is 0 or 1,
   R^{C} is each independently a hydrogen atom or methyl group,
   R²⁰⁹ is a hydrogen atom or straight or branched C₁-C₅ hydrocarbyl group in which a group containing a heteroatom may intervene in a carbon-carbon bond,
   R²¹⁰ is a straight or branched C₁-C₅ hydrocarbyl group in which a group containing a heteroatom may intervene in a carbon-carbon bond,
   R²¹¹ is a C₁-C₂₀ saturated hydrocarbyl group in which at least one hydrogen atom is substituted by a fluorine atom, and some constituent -CH₂- of the saturated hydrocarbyl group may be replaced by an ester bond or ether bond,
   Z² is a single bond, *-C(=O)-O- or *-C(=O)-NH-,
   Z³ is a single bond, -O-, *-C(=O)-O-Z³¹-Z³²- or *-C(=O)-NH-Z³¹-Z³²-, Z³¹ is a single bond or C₁-C₁₀ saturated hydrocarbylene group, and Z³² is a single bond, ester bond, ether bond or sulfonamide bond, and
   the asterisk (*) designates a point of attachment to the carbon atom in the backbone.
13. The chemically amplified positive resist composition according to any one of 1 to 12, further comprising (E) a photoacid generator.
14. A resist pattern forming process comprising the steps of: applying the chemically amplified positive resist composition according to any one of claims 1 to 13 onto a substrate to form a resist film thereon, exposing the resist film to a pattern of high-energy radiation, and developing the exposed resist film in an alkaline developer.
15. The resist pattern forming process according to claim 14, wherein the high-energy radiation is KrF excimer laser, ArF excimer laser, an extreme ultraviolet ray or an electron beam.
16. The resist pattern forming process according to claim 14 or 15, wherein the substrate has the outermost surface of a material containing at least one selected from chromium, silicon, tantalum, molybdenum, cobalt, nickel, tungsten, and tin.
17. The resist pattern forming process according to any one of 14 to 16, wherein the substrate is a mask blank of transmission or reflection type.
18. A mask blank of transmission or reflection type which is coated with the chemically amplified positive resist composition according to any one of claims 1 to 13.

### ADVANTAGEOUS EFFECTS OF THE INVENTION

The inventive chemically amplified positive resist composition is processed by fine processing technology, in particular, EB lithography and EUV lithography, has extremely high resolution, and gives a pattern with small LER. The chemically amplified positive resist composition is suitable as a chemically amplified positive resist material because the chemically amplified positive resist composition is excellent in etch resistance after resist pattern formation.

### DESCRIPTION OF THE PREFERRED EMBODIMENT

Hereinafter, the present invention is described in detail. It is understood that for some structures represented by chemical formulae, there can exist enantiomers and diastereomers because of the presence of asymmetric carbon atoms. In such a case, a single formula collectively represents all such isomers. The isomers may be used alone or in admixture.

### Chemically amplified positive resist composition

### (A) Base polymer

The inventive resist composition comprises a base polymer as a component (A). The base polymer comprises a polymer adapted to increase its solubility in an aqueous alkaline by degrading under the action of an acid.

The polymer contains repeat units represented by the formula (A1), which are also referred to as repeat units A1, hereinafter.

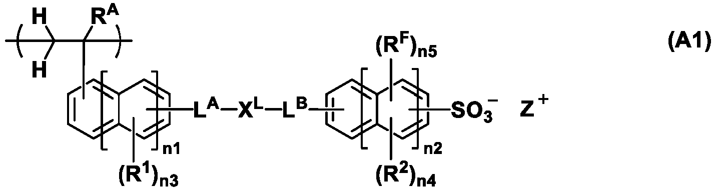

In formula (A1), n1 is 0 or 1. The onium salt type monomer has a benzene ring when n1 is 0, and a naphthalene ring when n1 is 1, and n1 is preferably 0 from the aspect of solvent solubility. The subscript n2 is 0 or 1. The subscript n3 is an integer of 0 to 4, preferably 0, 1 or 2. The subscript n4 is an integer of 0 to 4, preferably 0, 1 or 2. The subscript n5 is an integer of 0 to 4. From the aspect of acid strength of generated acid, n5 is preferably 1, 2, 3 or 4, more preferably 2, 3 or 4. The sum n4 + n5 is from 0 to 4 when n2 is 0, and n4 + n5 is from 0 to 6 when n2 is 1. It is excluded from the aspect of solvent solubility that all n1 to n5 are 0.

In formula (A1), R^{A} is a hydrogen atom, fluorine atom, methyl group, or trifluoromethyl group. Of these, a hydrogen atom and a methyl group are preferred, and a hydrogen atom is more preferred.

In formula (A1), R¹ is a halogen atom or C₁-C₂₀ hydrocarbyl group which may contain a heteroatom. The halogen atom is preferably a fluorine, chlorine, bromine or iodine atom, more preferably a fluorine or iodine atom. The hydrocarbyl group may be saturated or unsaturated, and may be straight, branched, or cyclic. Examples thereof include C₁-C₂₀ alkyl groups such as methyl, ethyl, n-propyl, isopropyl, n-butyl, isobutyl, sec-butyl, tert-butyl, n-pentyl, n-hexyl, n-octyl, n-nonyl, n-decyl, undecyl, dodecyl, tridecyl, tetradecyl, pentadecyl, heptadecyl, octadecyl, nonadecyl and icocyl groups; C₃-C₂₀ cyclic saturated hydrocarbyl groups such as cyclopropyl, cyclopentyl, cyclohexyl, cyclopropylmethyl, 4-methylcyclohexyl, cyclohexylmethyl, norbornyl and adamantyl groups; C₂-C₂₀ alkenyl groups such as vinyl, allyl, propenyl, butenyl and hexenyl groups; C₃-C₂₀ cyclic unsaturated hydrocarbyl groups such as a cyclohexenyl group; C₂-C₂₀ aryl groups such as phenyl and naphthyl groups; C₇-C₂₀ aralkyl groups such as benzyl, 1-phenylethyl and 2-phenylethyl groups; and combinations thereof. Of these, aryl groups are preferred. Some or all of hydrogen atoms of the hydrocarbyl group may be replaced by a group containing a heteroatom such as an oxygen atom, a sulfur atom, a nitrogen atom or a halogen atom, some constituent -CH₂- of the hydrocarbyl group may be replaced by a group containing a heteroatom such as an oxygen atom, a sulfur atom or a nitrogen atom, and as a result, the hydrocarbyl group may contain a hydroxy group, a cyano group, a fluorine atom, a chlorine atom, a bromine atom, an iodine atom, a carbonyl group, an ether bond, an ester bond, a sulfonic ester bond, a carbonate bond, a lactone ring, a sultone ring, carboxylic anhydride (-C(=O)-O-C(=O)-), a haloalkyl group, or the like. Groups R¹ may be the same or different when n3 is 2, 3 or 4.

A plurality of R¹ may bond together to form a ring with the aromatic ring carbon atom to which they are attached when n3 is 2, 3 or 4. Specific examples of the ring formed herein include cyclopropane, cyclobutane, cyclopentane, cyclohexane, norbornane and adamantane rings. Some or all of hydrogen atoms in the ring may be replaced by a group containing a heteroatom such as an oxygen atom, a sulfur atom, a nitrogen atom or a halogen atom, some constituent -CH₂- in the ring may be replaced by a group containing a heteroatom such as an oxygen atom, a sulfur atom or a nitrogen atom, and as a result, the hydrocarbyl group may contain a hydroxy group, a fluorine atom, a chlorine atom, a bromine atom, an iodine atom, a cyano group, a carbonyl group, an ether bond, an ester bond, a sulfonic ester bond, a carbonate bond, a lactone ring, a sultone ring, carboxylic anhydride (-C(=O)-O-C(=O)-), a haloalkyl group, or the like.

In formula (A1), R² is a C₁-C₂₀ hydrocarbyl group which may contain a heteroatom. The hydrocarbyl group may be saturated or unsaturated, and may be straight, branched, or cyclic. Examples of the hydrocarbyl group are as exemplified above as a hydrocarbyl group R¹, but not limited thereto. Groups R² may be the same or different when n4 is 2, 3 or 4. A plurality of R² may bond together to form a ring with the carbon atoms to which they are attached when n4 is 2, 3 or 4. The ring is preferably a five- or eight-membered ring.

In formula (A1), R^{F} is a fluorine atom, C₁-C₆ fluorinated alkyl group, C₁-C₆ fluorinated alkoxy group or C₁-C₆ fluorinated alkylthio group. R^{F} is preferably a fluorine atom, trifluoromethyl group, difluoromethyl group, trifluoromethoxy group, difluoromethoxy group, trifluoromethylthio group or difluoromethylthio, more preferably a fluorine atom, trifluoromethyl group or trifluoromethoxy group. Now that a fluorine atom or fluorinated substituent is contained, the generated acid has so high acid strength due to the electron withdrawing effect that deprotection reaction of acid labile groups such as tertiary esters and tertiary ethers may take place smoothly. Groups R^{F} may be the same or different when n5 is 2, 3 or 4.

In formula (A1), L^{A} and L^{B} are each independently a single bond, ether bond, ester bond, sulfonic ester bond, sulfonic amide bond, carbonate bond or carbamate bond. Inter alia, L^{A} is preferably a single bond, an ether bond, an ester bond or a sulfonic ester bond, more preferably an ester bond or a sulfonic ester bond. L^{B} is preferably a single bond, ether bond, ester bond or sulfonic ester bond, more preferably a single bond, ester bond or sulfonic ester bond.

In formula (A1), X^{L} is a single bond or C₁-C₄₀ hydrocarbylene group which may contain a heteroatom. The hydrocarbylene group may be straight, branched or cyclic, and specific examples thereof include an alkanediyl group, a cyclic saturated hydrocarbylene group, and an arylene group. Specific examples of the heteroatom include oxygen, nitrogen and sulfur atoms.

Examples of the C₁-C₄₀ hydrocarbylene group X^{L} which may contain a heteroatom are shown below, but not limited thereto. In the formulae, the asterisk (*) is a point of attachment to L^{A} and L^{B}.

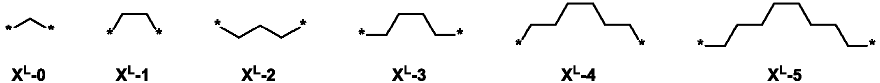

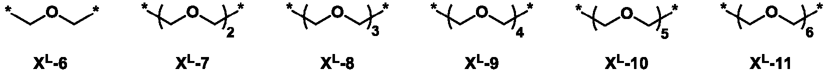

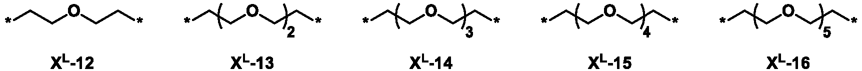

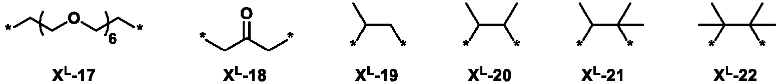

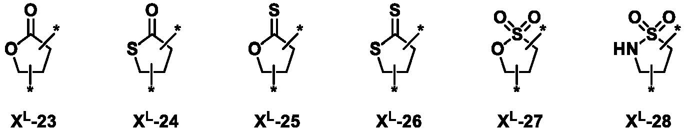

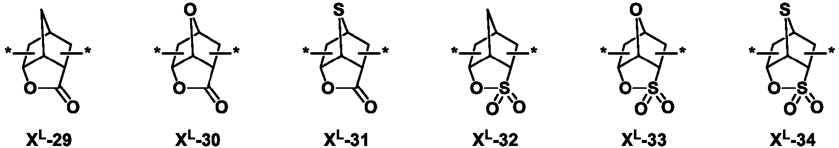

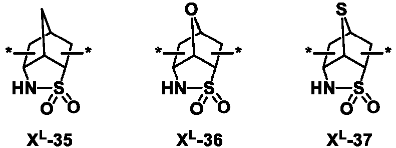

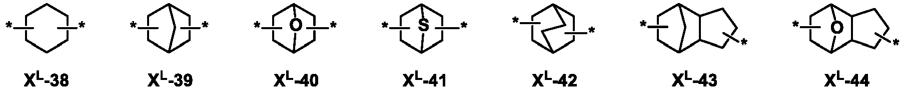

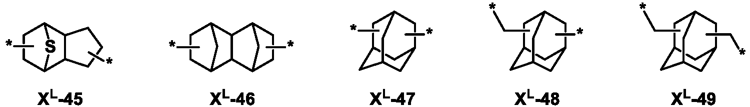

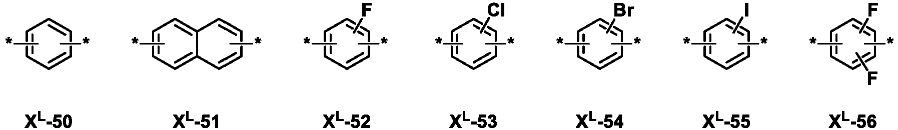

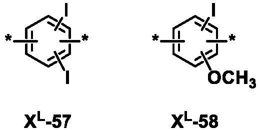

Of these, X^{L}-0 to X^{L}-22, X^{L}-29 to X^{L}-34, and X^{L}-47 to X^{L}-58 are preferred. The repeat unit A1 is preferably a repeat unit having the formula (A1-1). 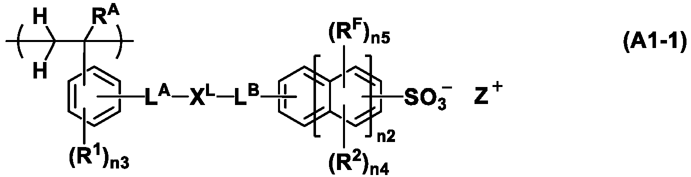 wherein n2 to n5, R^{A}, R¹, R², R^{F}, L^{A}, L^{B}, X^{L} and Z⁺ are as defined above.

Of the repeat units of formula (A1-1), those having formula (A1-2) are preferred. 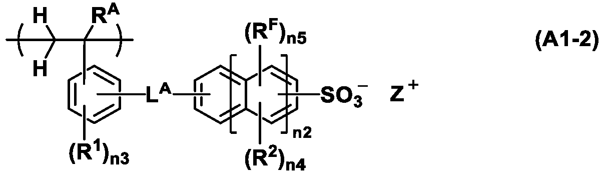 wherein n2 to n5, R^{A}, R¹, R², R^{F}, L^{A} and Z⁺ are as defined above.

Examples of the anion of the monomer from which repeat units A1 are derived are shown below, but not limited thereto. In the formulae, Me is a methyl group. The bonding positions of the substituents on the aromatic ring may be interchanged.

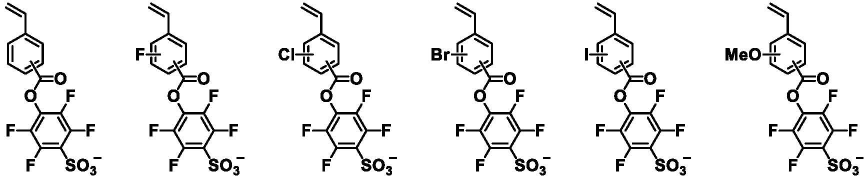

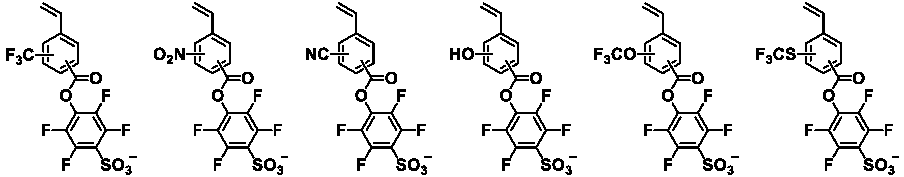

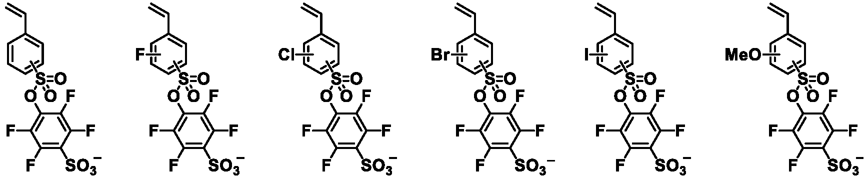

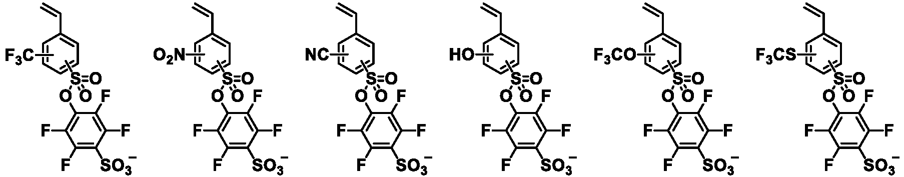

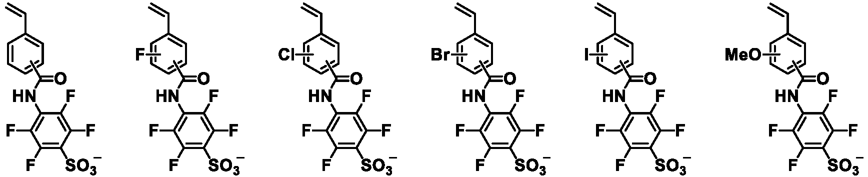

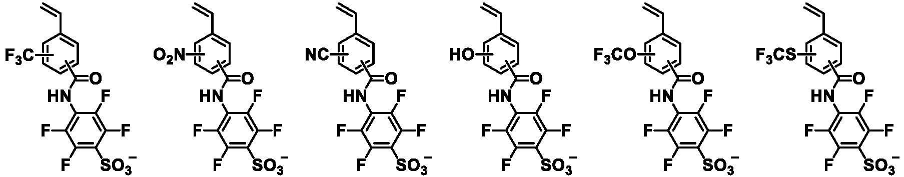

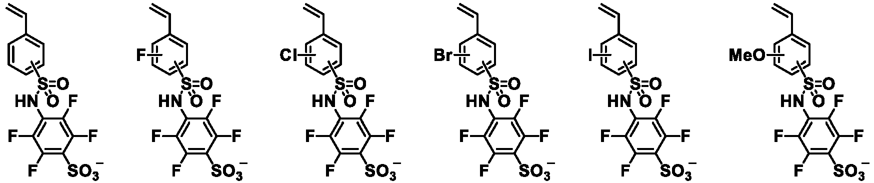

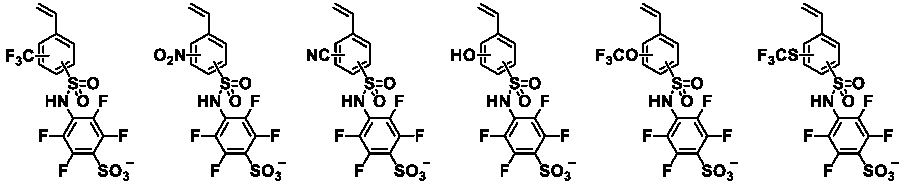

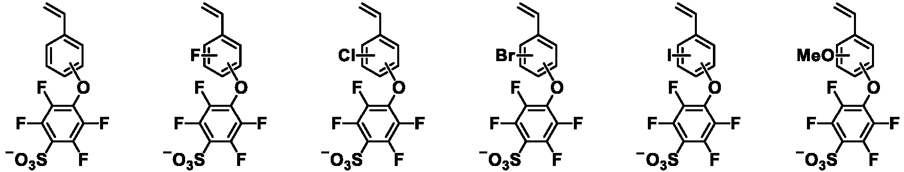

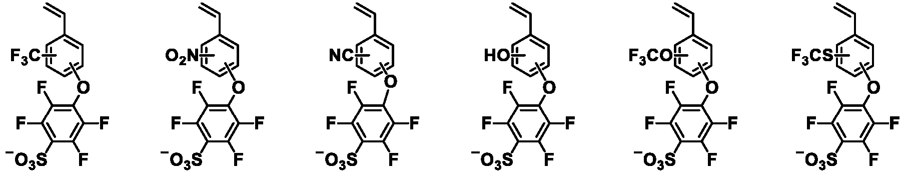

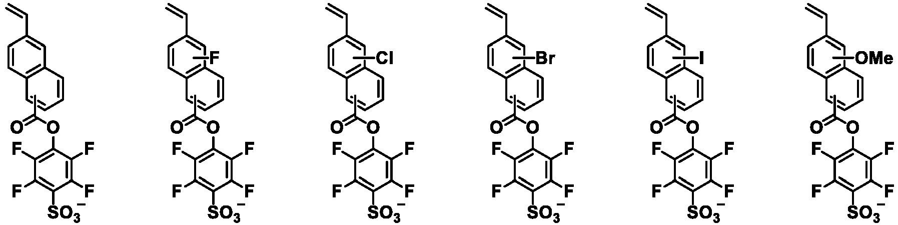

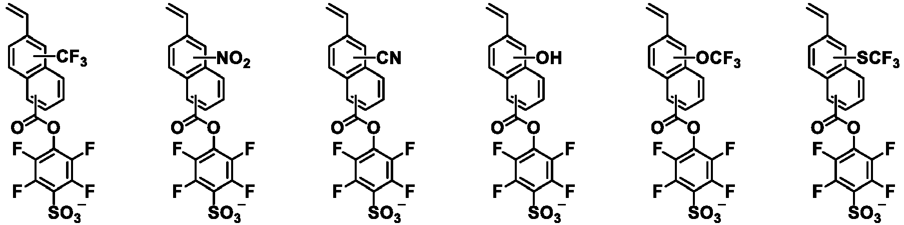

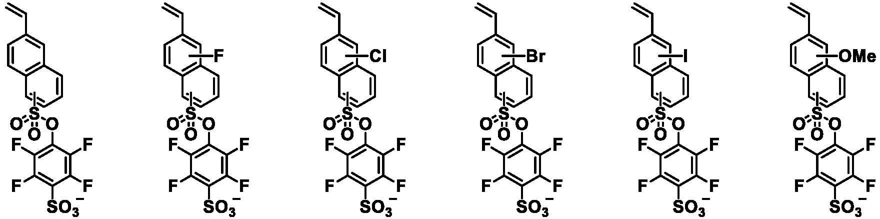

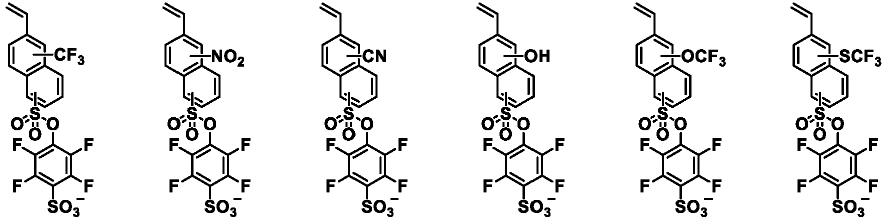

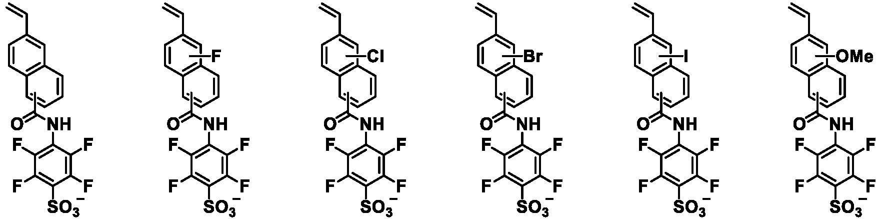

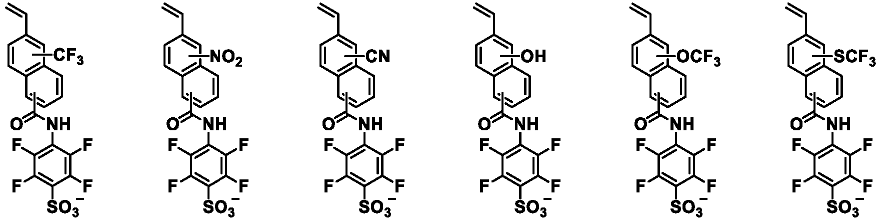

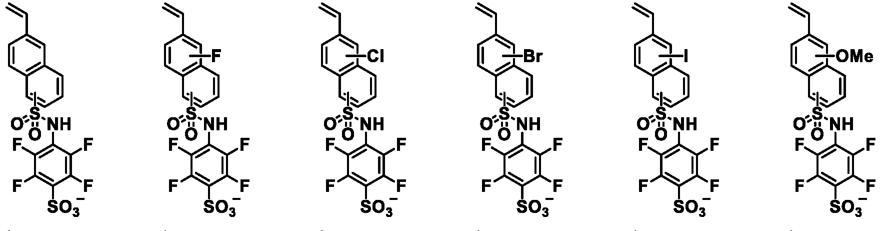

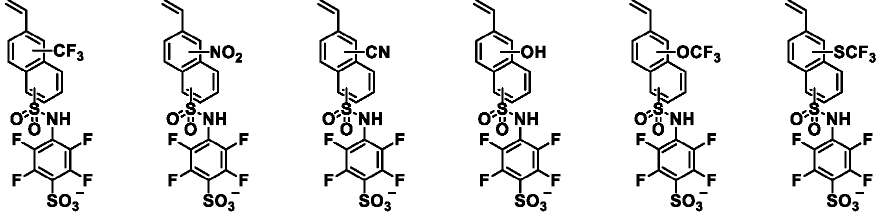

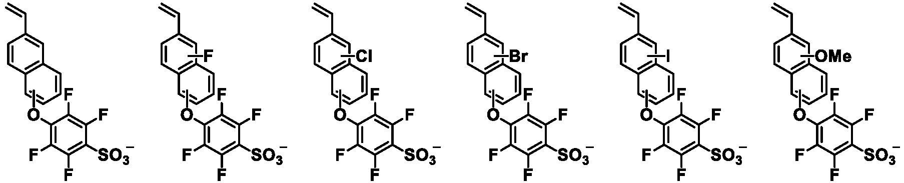

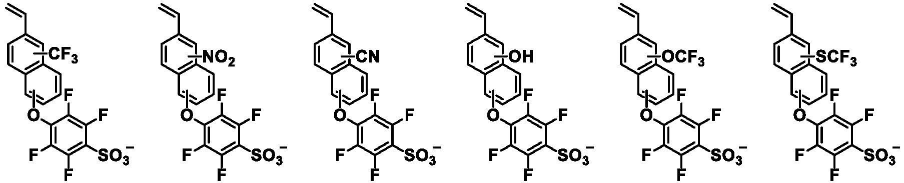

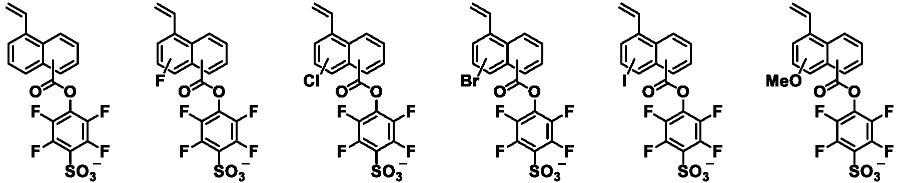

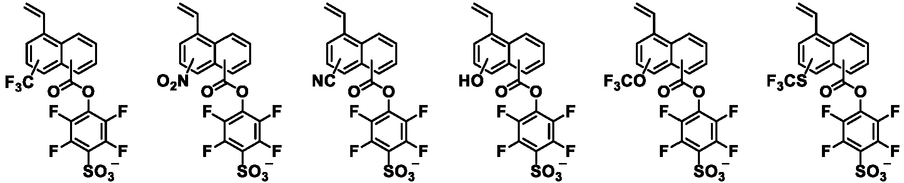

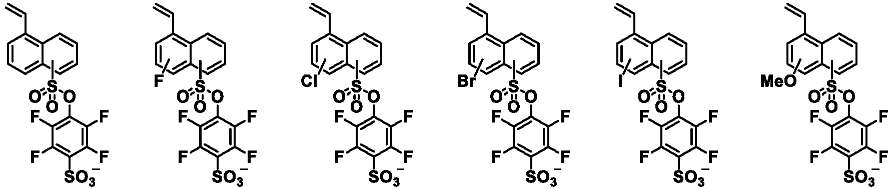

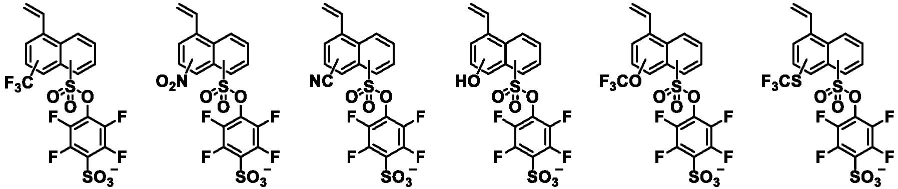

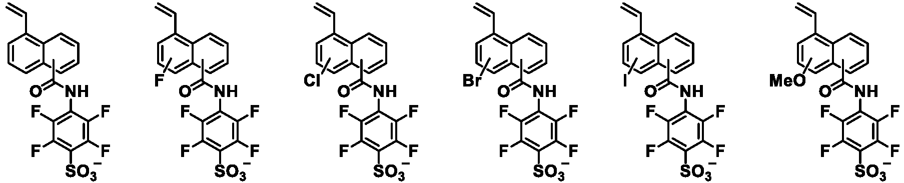

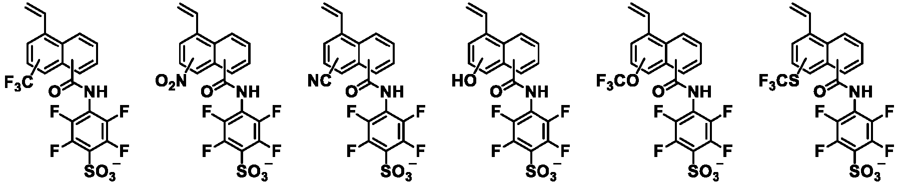

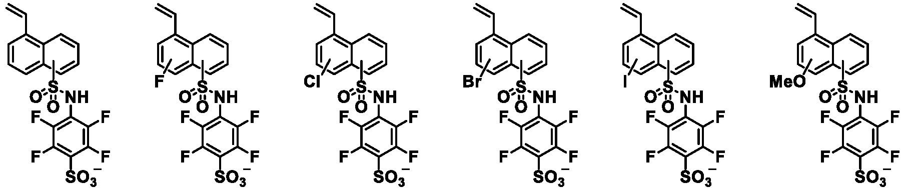

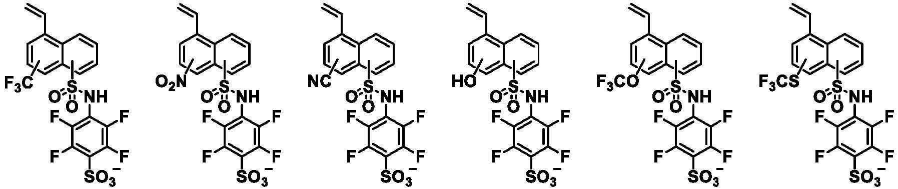

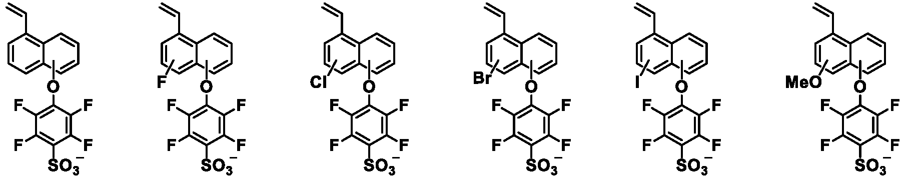

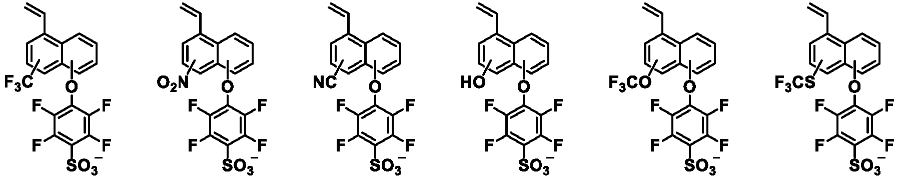

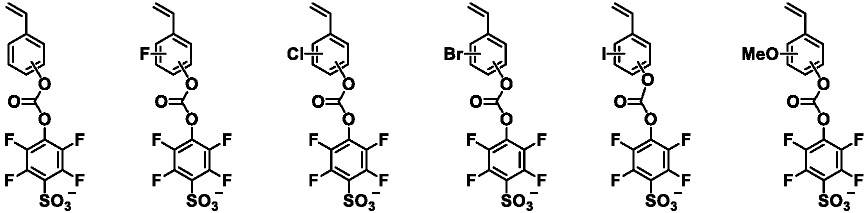

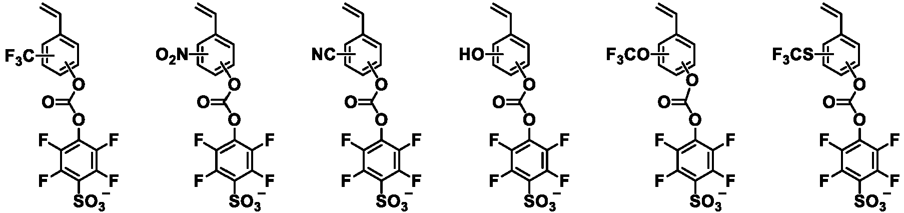

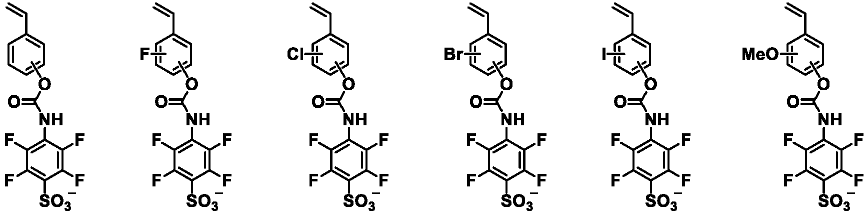

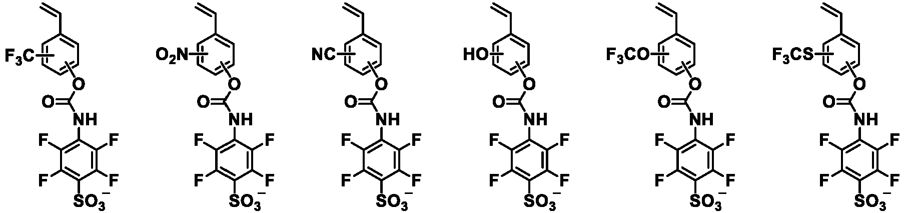

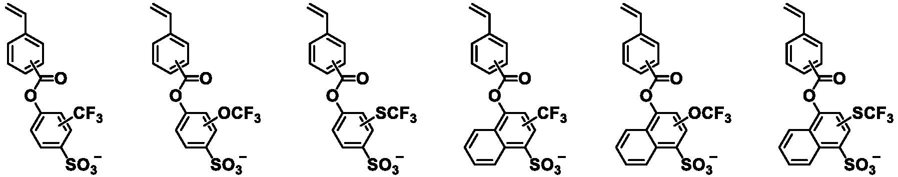

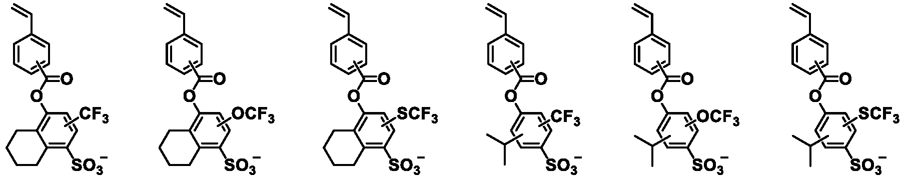

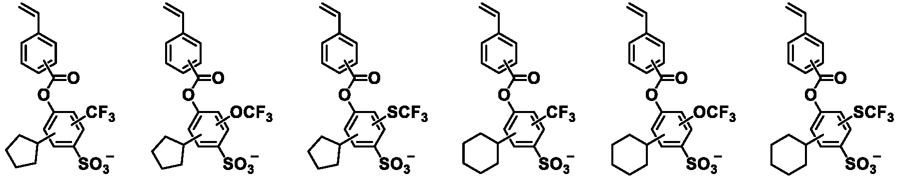

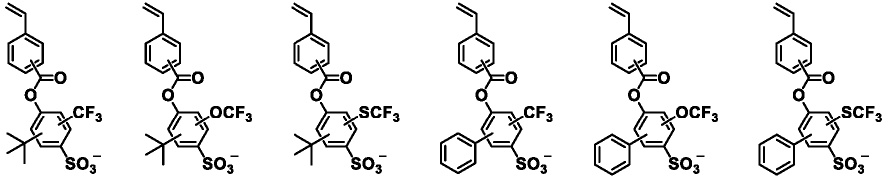

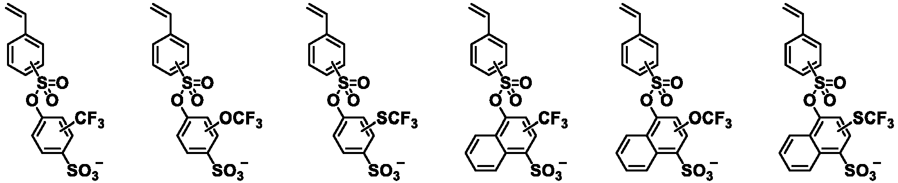

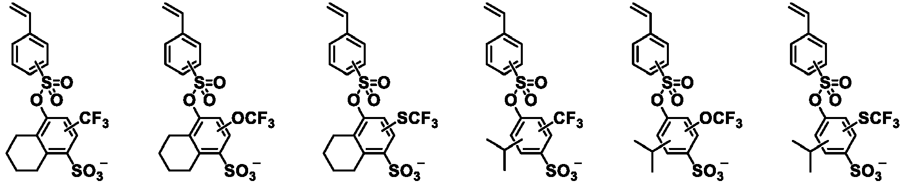

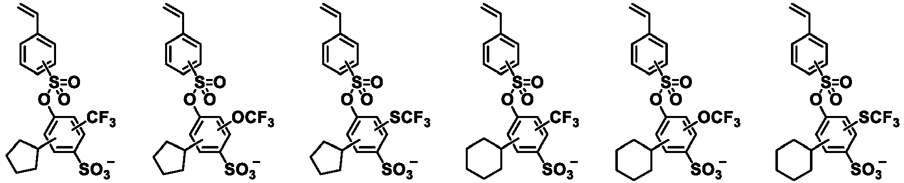

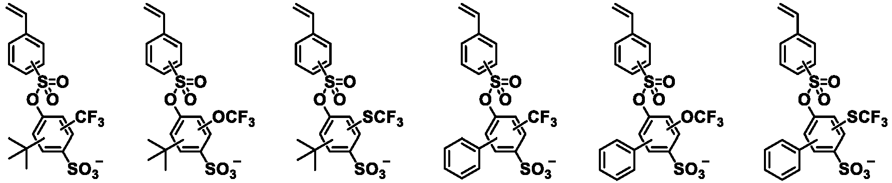

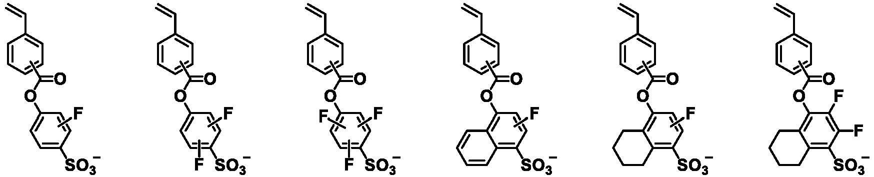

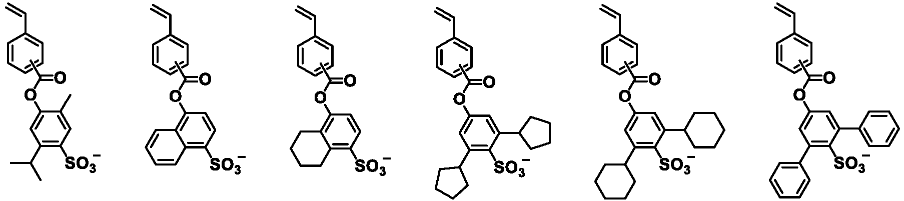

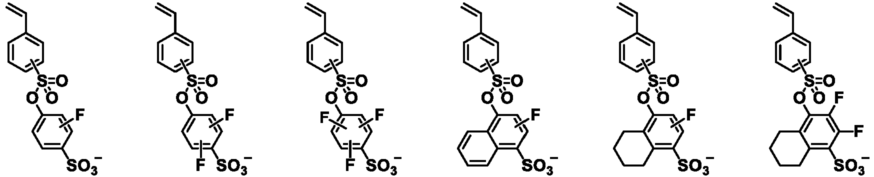

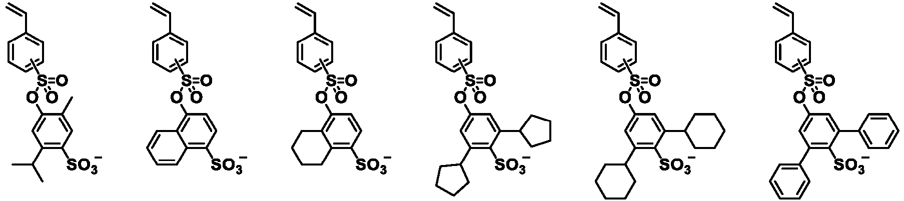

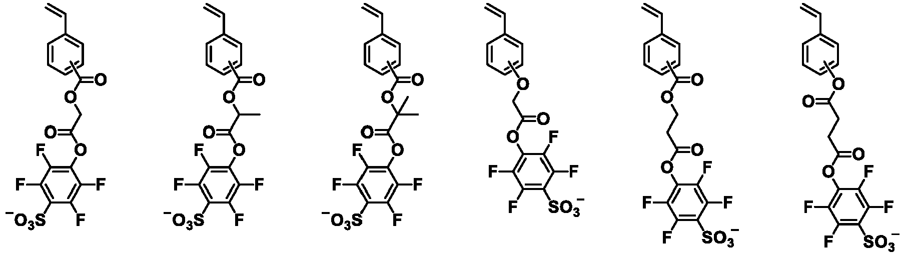

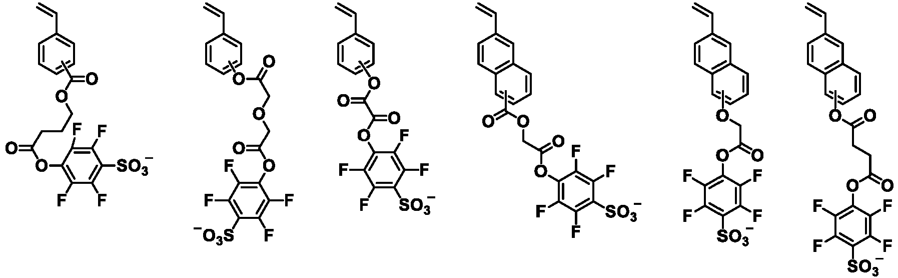

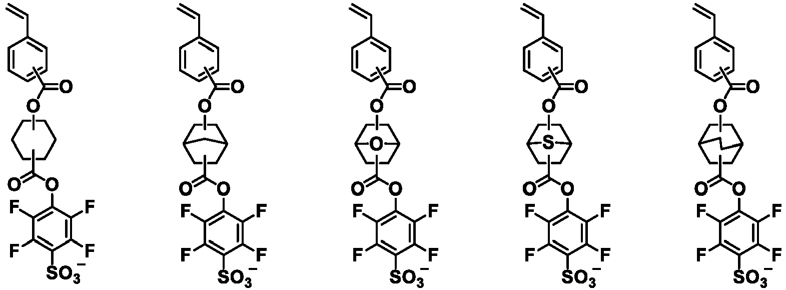

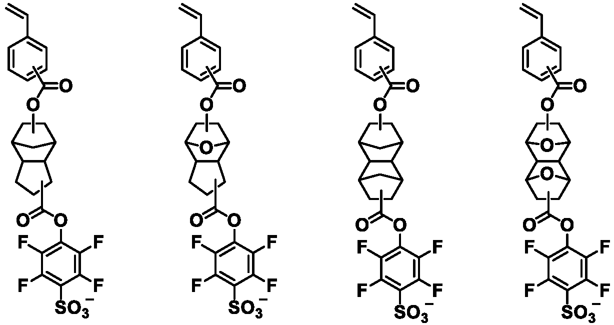

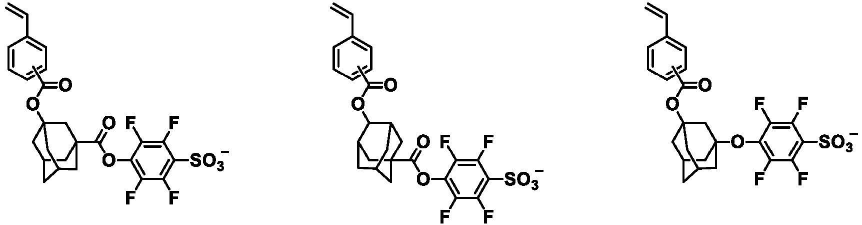

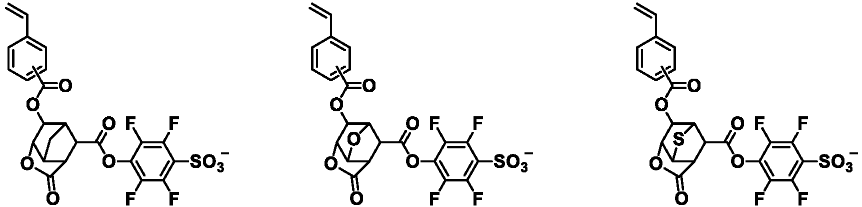

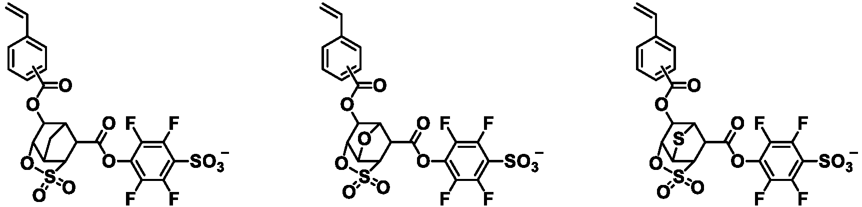

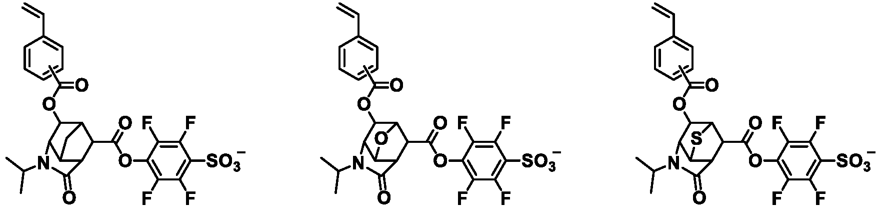

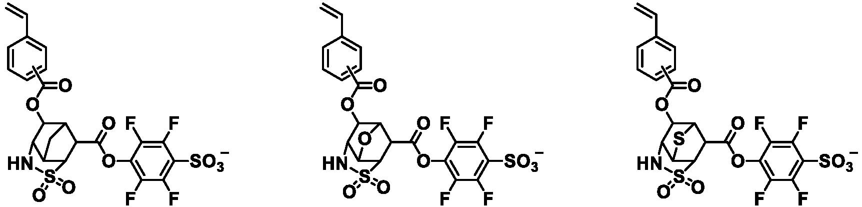

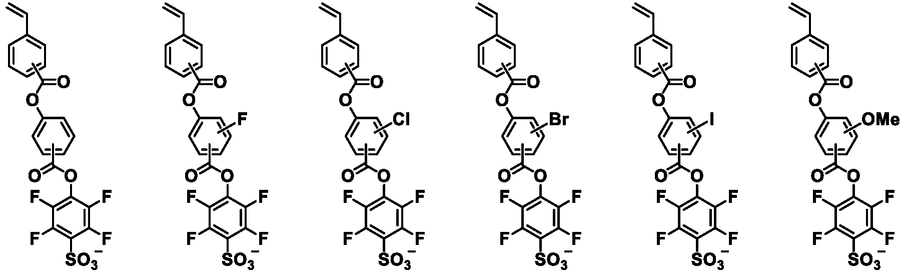

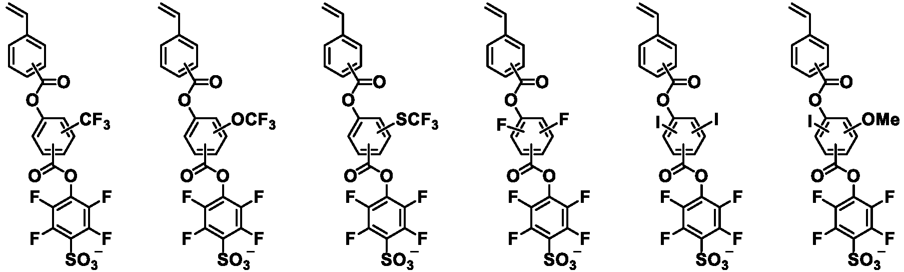

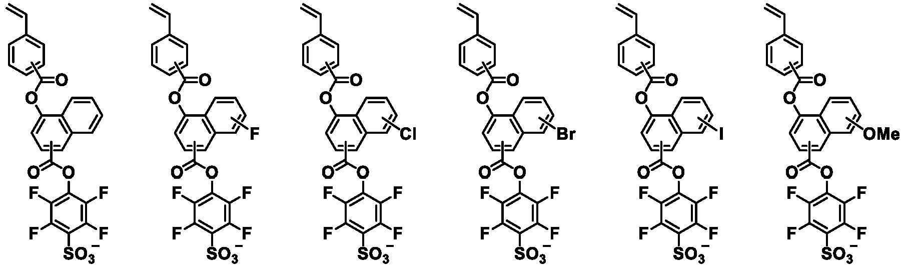

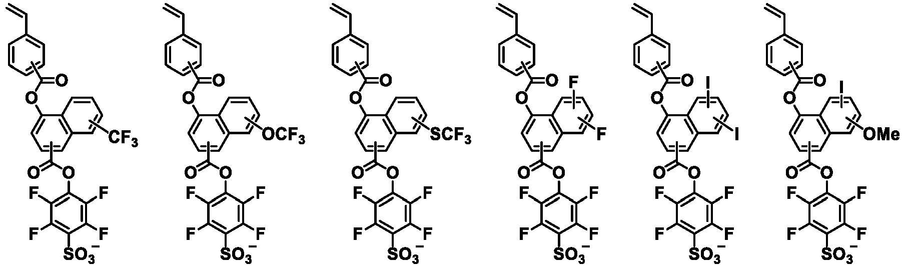

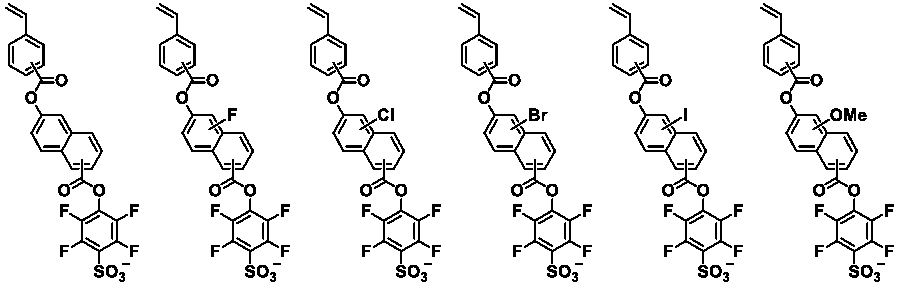

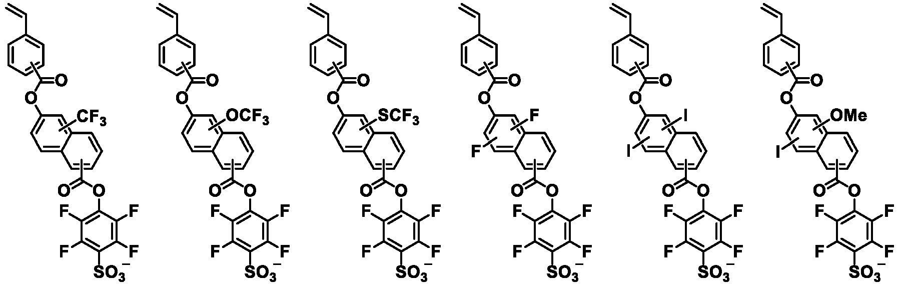

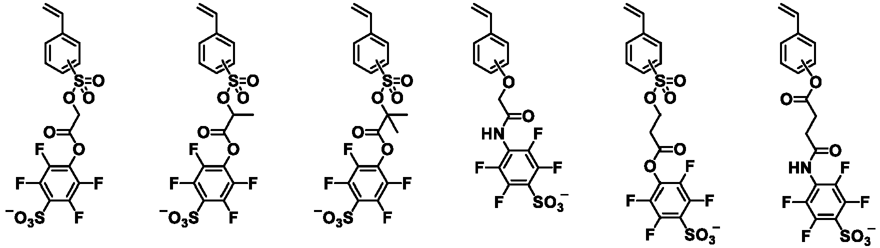

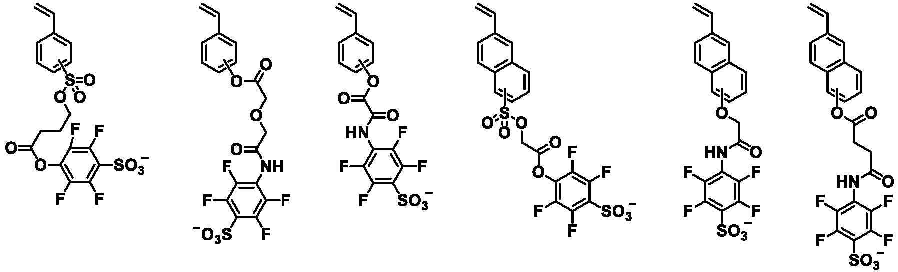

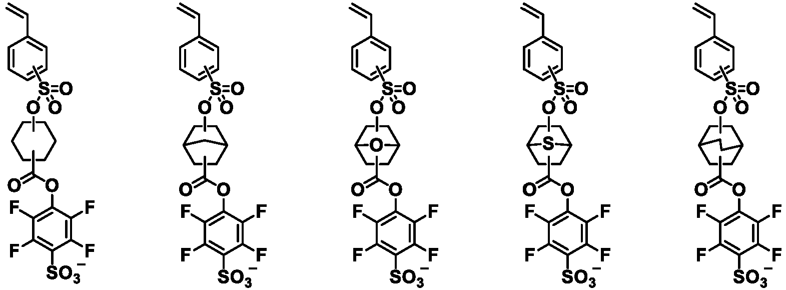

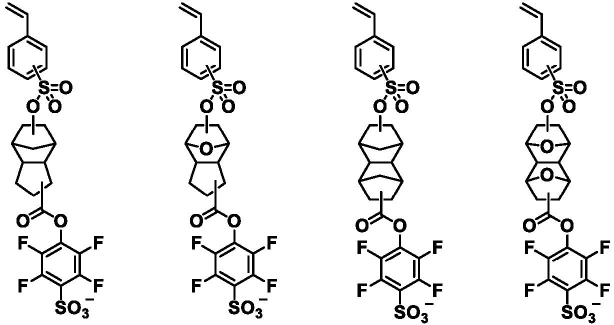

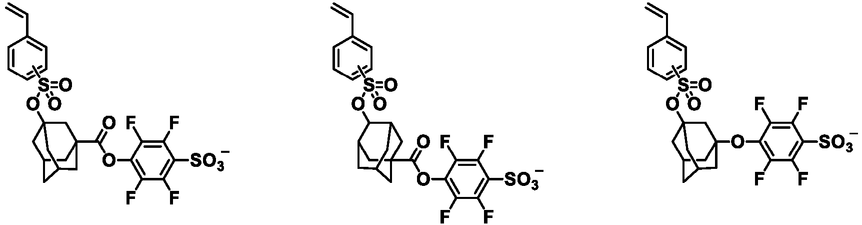

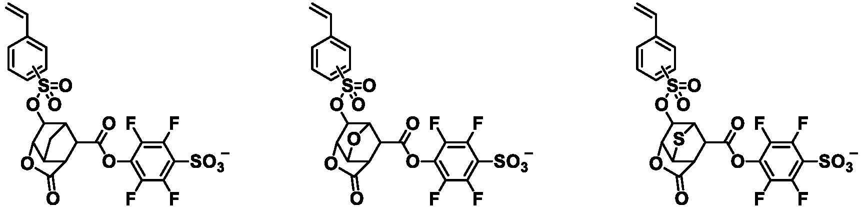

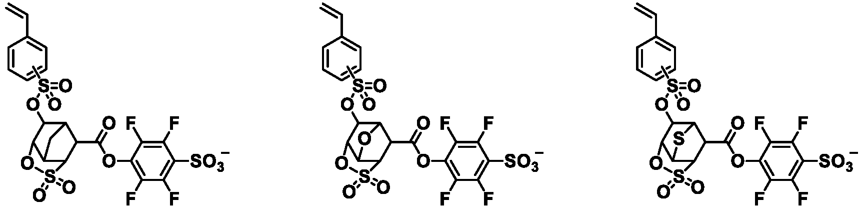

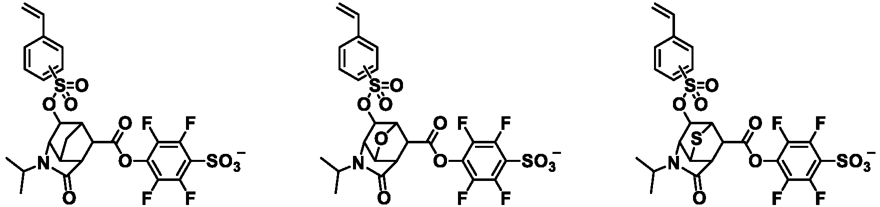

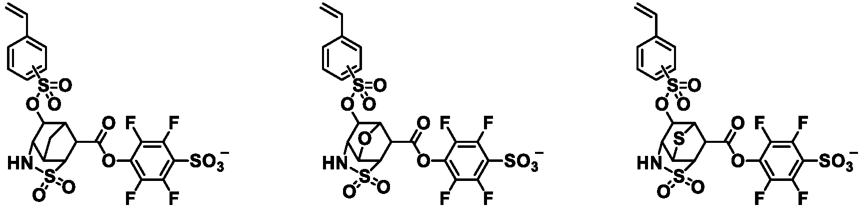

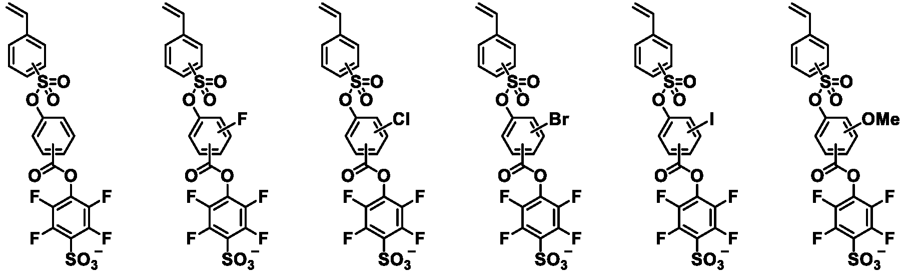

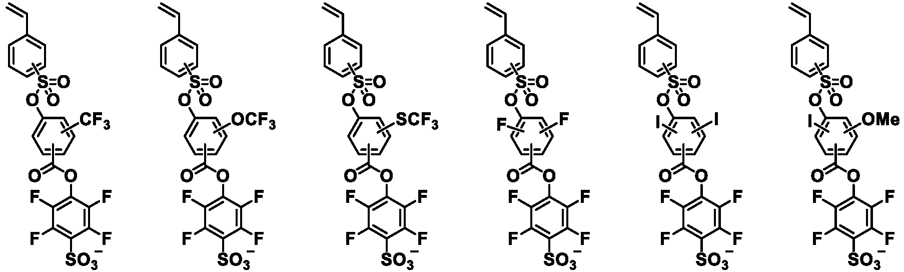

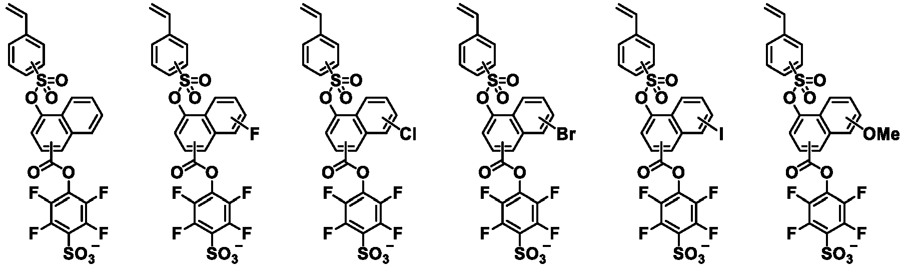

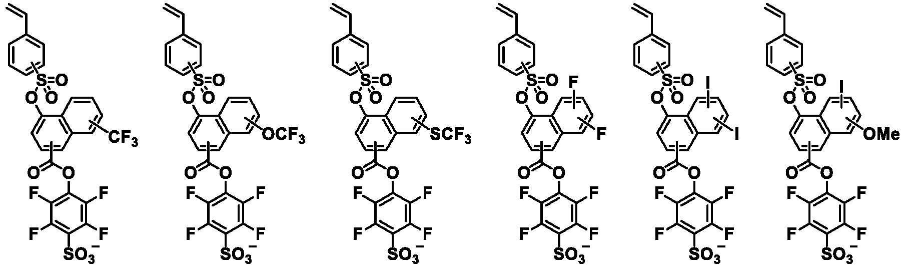

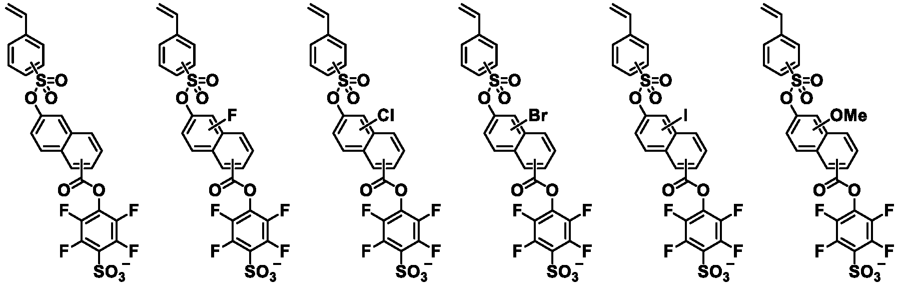

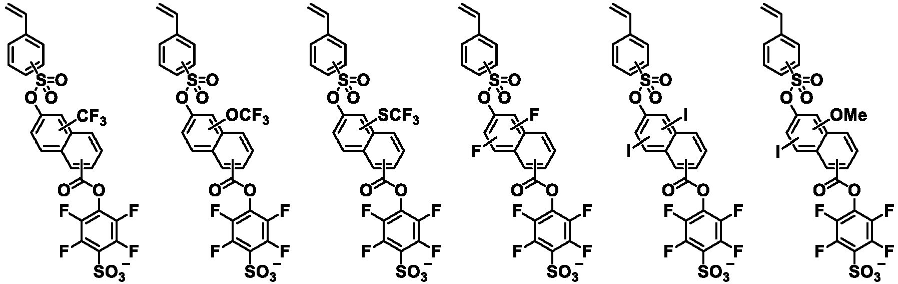

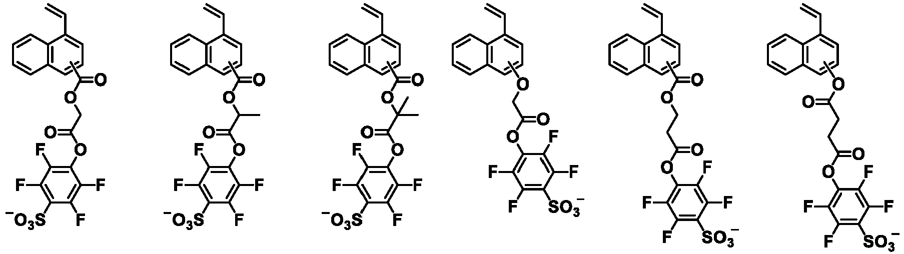

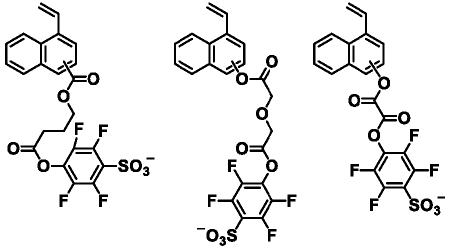

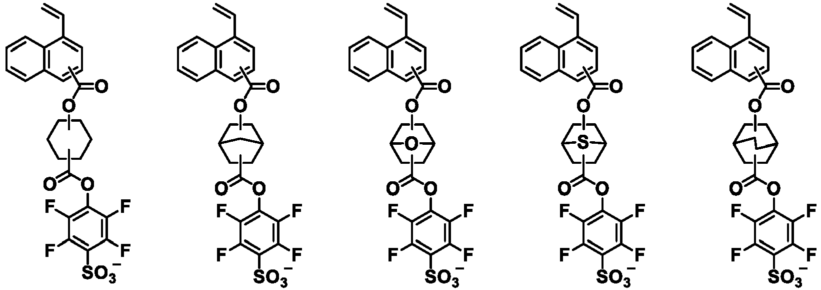

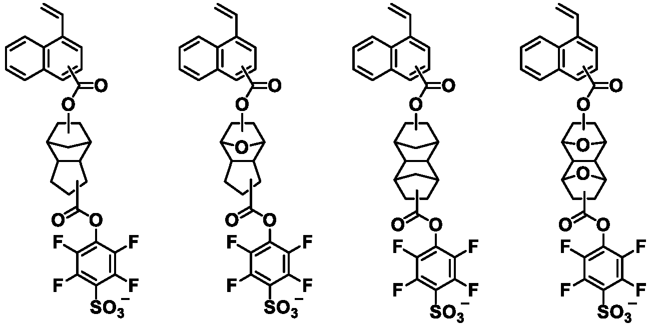

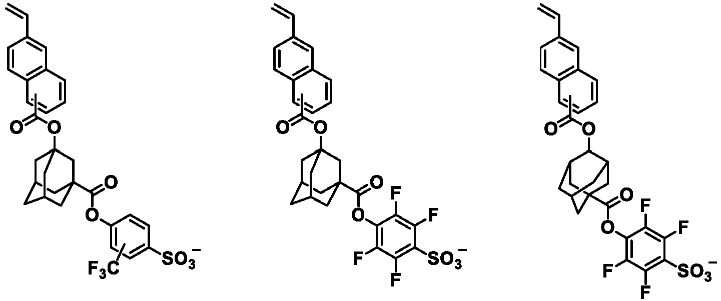

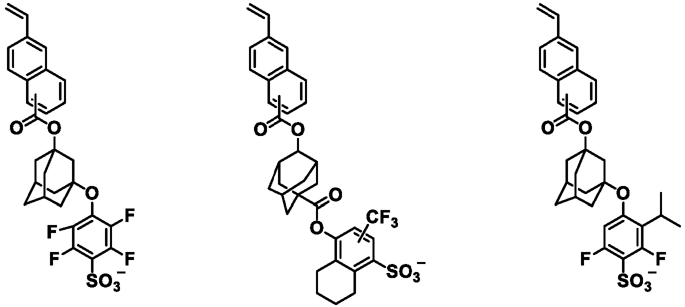

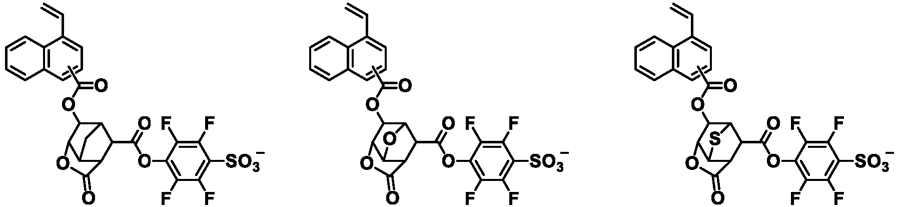

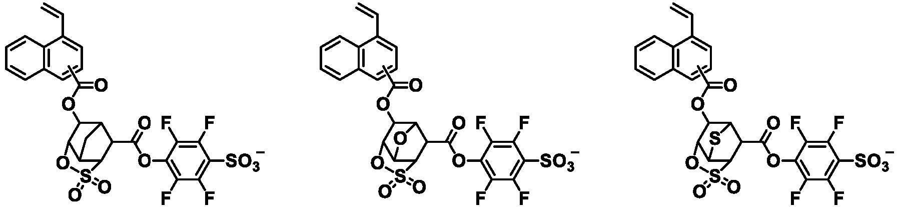

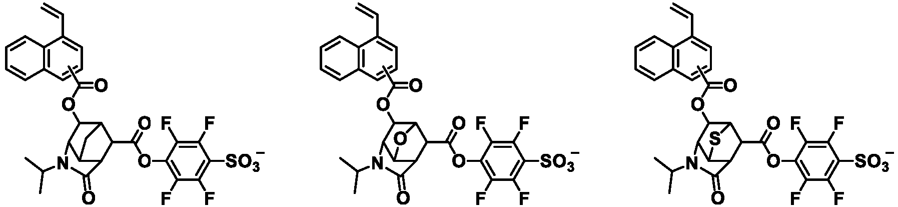

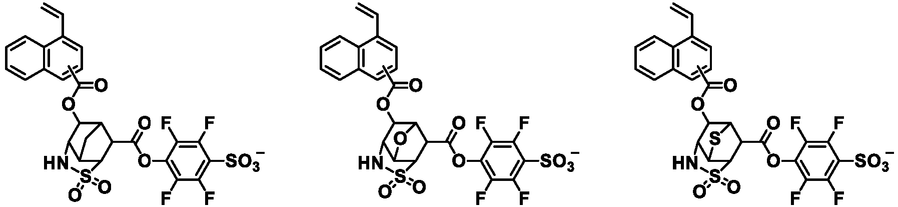

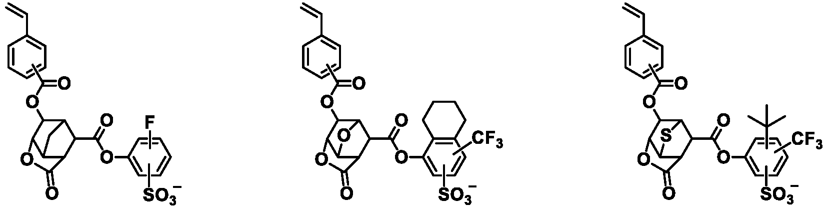

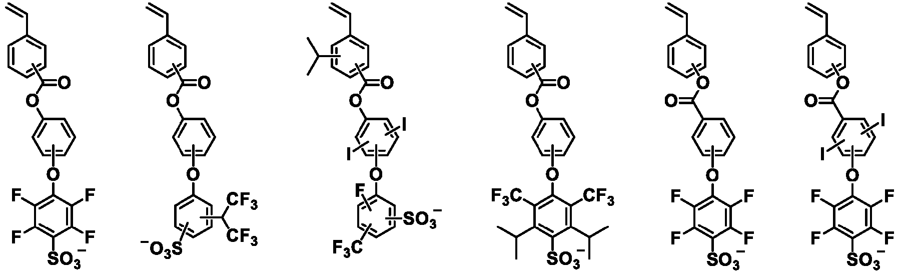

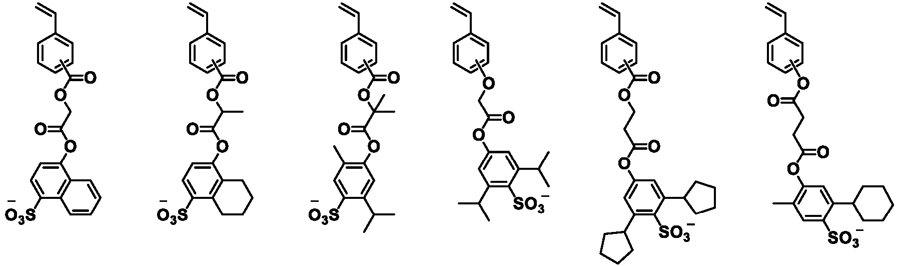

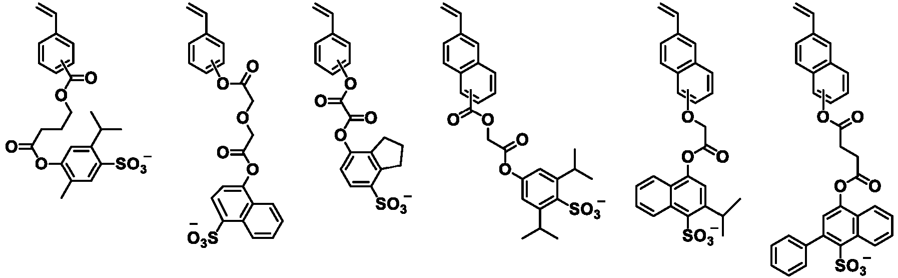

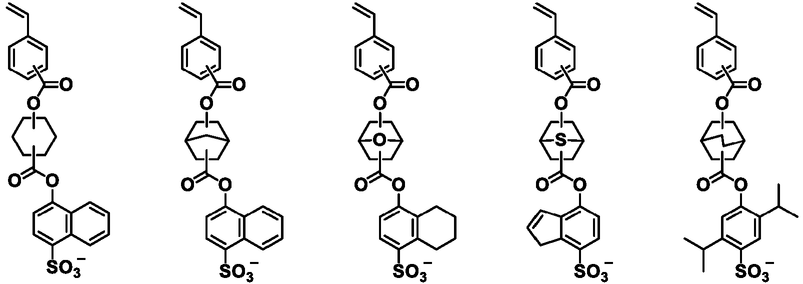

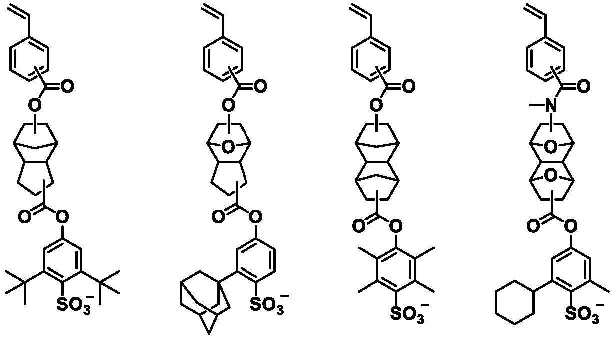

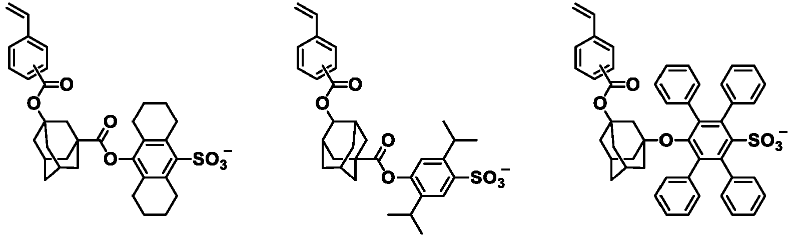

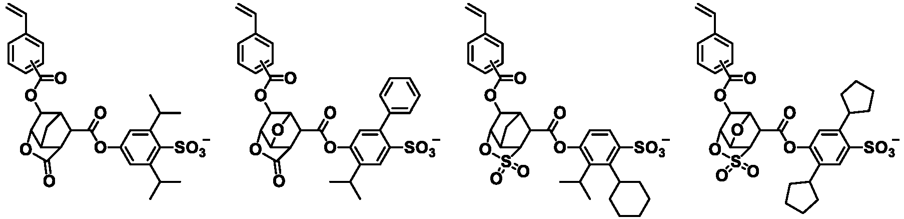

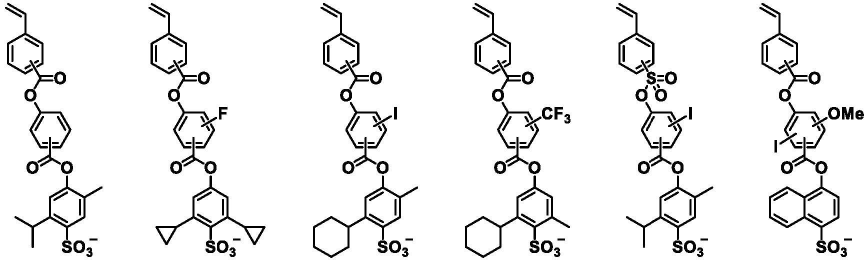

In formula (A1), Z⁺ is an onium cation. The onium cation is preferably a sulfonium cation having the formula (cation-1) or iodonium cation having the formula (cation-2).

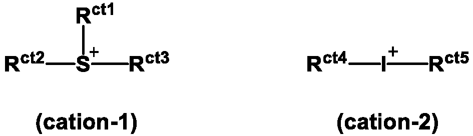

In formulae (cation-1) and (cation-2), R^{ct1} to R^{ct5} are each independently a halogen atom, or C₁-C₃₀ hydrocarbyl group which may contain a heteroatom.

Specific examples of the halogen atom represented by R^{ct1} to R^{ct5} include a fluorine atom, a chlorine atom, a bromine atom, and an iodine atom.

The hydrocarbyl group represented by R^{ct1} to R^{ct5} may be saturated or unsaturated, and may be straight, branched, or cyclic. Examples thereof include C₁-C₃₀ alkyl groups such as methyl, ethyl, n-propyl, isopropyl, n-butyl, sec-butyl and tert-butyl groups; C₃-C₃₀ cyclic saturated hydrocarbyl groups such as cyclopropyl, cyclopentyl, cyclohexyl, cyclopropylmethyl, 4-methylcyclohexyl, cyclohexylmethyl, norbornyl and adamantyl groups; C₂-C₃₀ alkenyl groups such as vinyl, allyl, propenyl, butenyl and hexenyl groups; C₃-C₃₀ cyclic unsaturated hydrocarbyl groups such as a cyclohexenyl group; C₆-C₃₀ aryl groups such as phenyl, naphthyl and thienyl groups; C₇-C₃₀ aralkyl groups such as benzyl, 1-phenylethyl and 2-phenylethyl groups; and combinations thereof. The aryl groups are preferred. Some or all of hydrogen atoms of the hydrocarbyl group may be replaced by a group containing a heteroatom such as an oxygen atom, a sulfur atom, a nitrogen atom or a halogen atom, some constituent -CH₂- of the hydrocarbyl group may be replaced by a group containing a heteroatom such as an oxygen atom, a sulfur atom or a nitrogen atom, and as a result, the hydrocarbyl group may contain a hydroxy group, a fluorine atom, a chlorine atom, a bromine atom, an iodine atom, a cyano group, a nitro group, a carbonyl group, an ether bond, an ester bond, a sulfonic ester bond, a carbonate bond, a lactone ring, a sultone ring, carboxylic acid anhydride (-C(=O)-O-C(=O)-), a haloalkyl group, or the like.

R^{ct1} and R^{ct2} may bond together to form a ring with the sulfur atom to which they are attached. Examples of the structure of the ring include those represented by the formula.

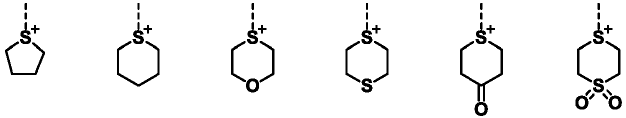

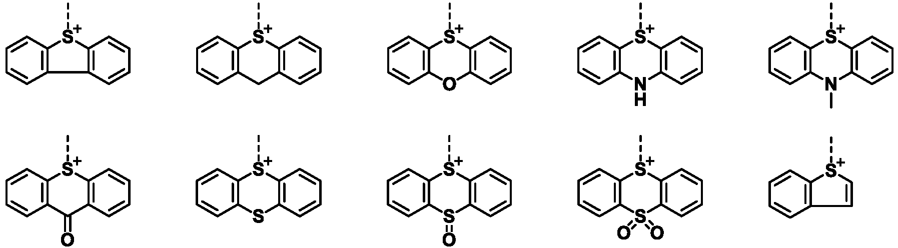

Herein the broken line designates a point of attachment to R^{ct3}.

Examples of the sulfonium cation represented by formula (cation-1) are shown below, but not limited thereto.

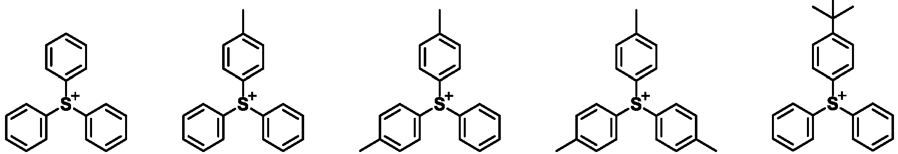

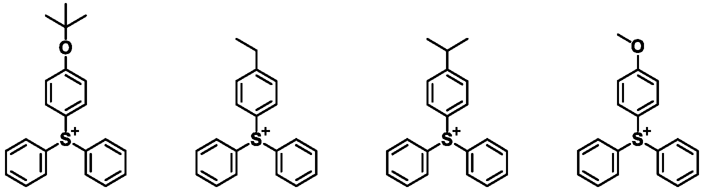

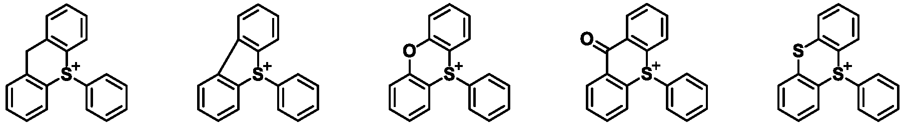

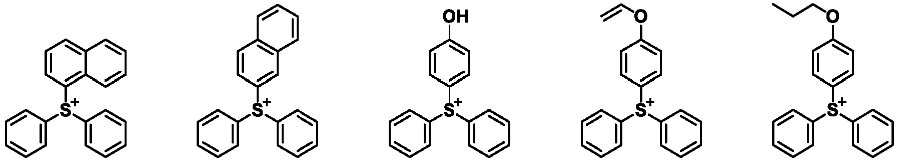

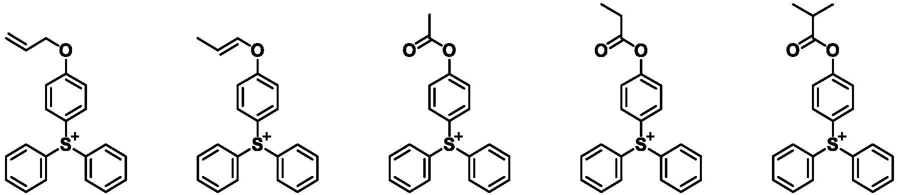

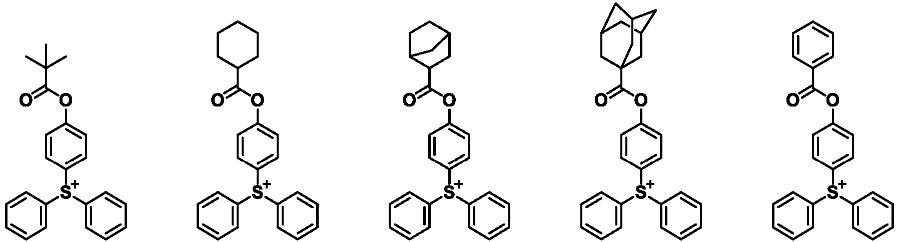

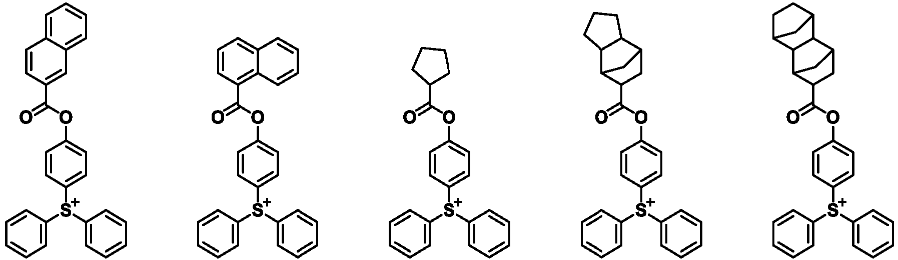

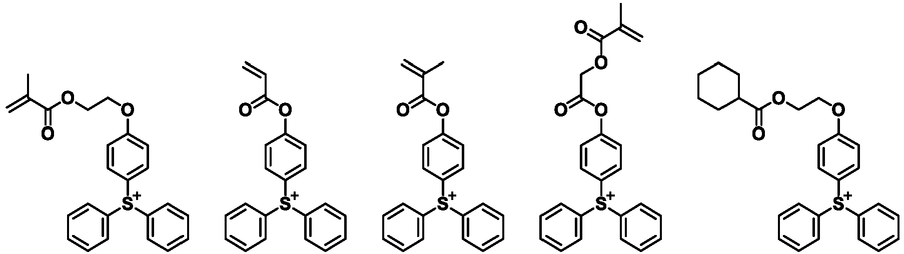

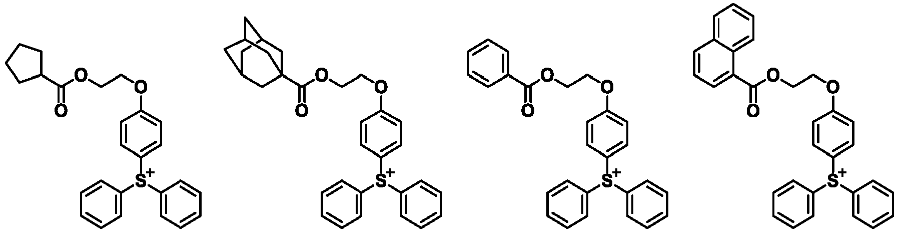

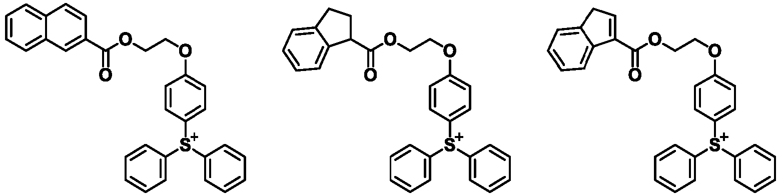

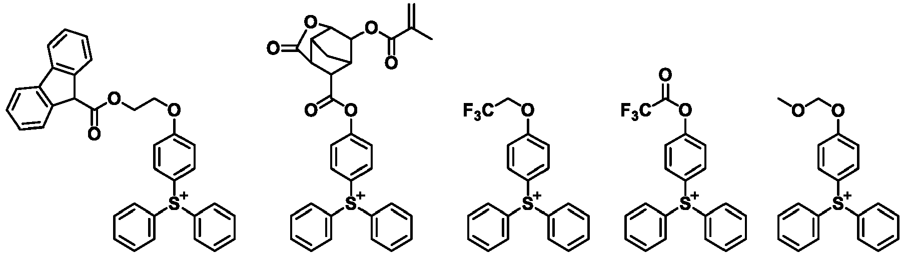

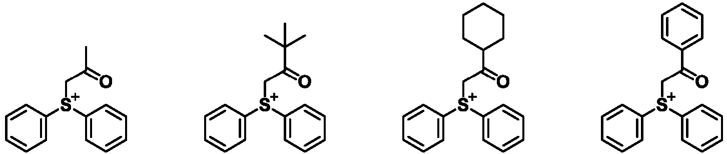

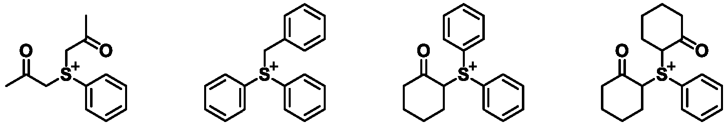

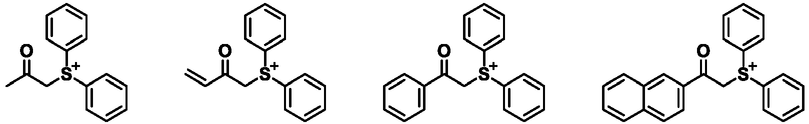

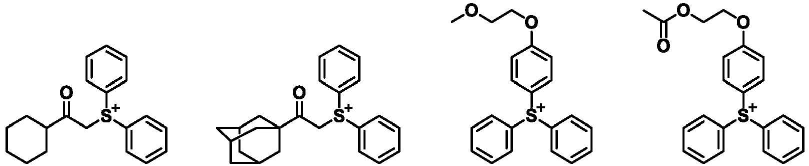

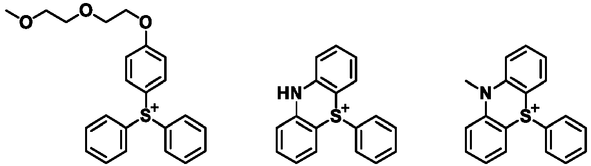

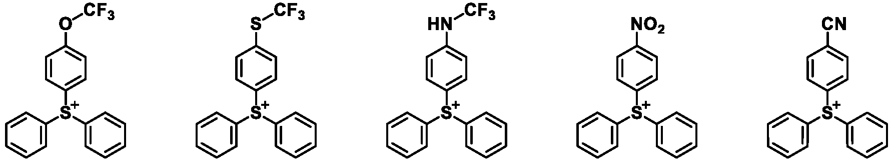

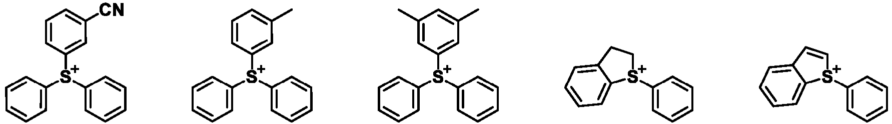

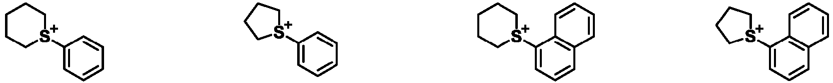

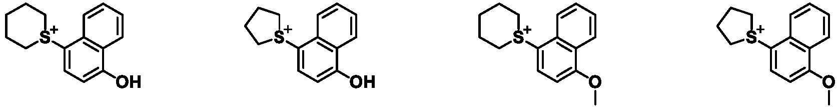

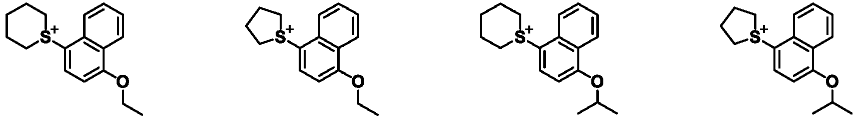

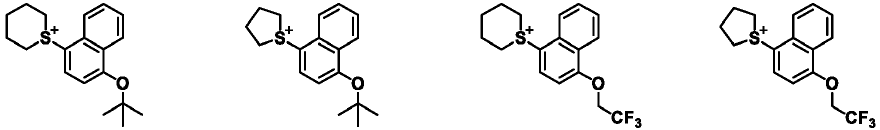

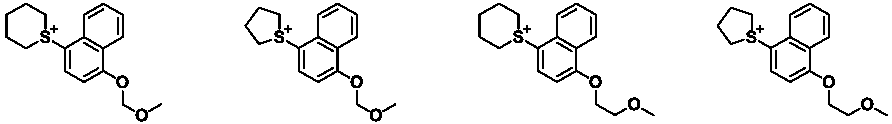

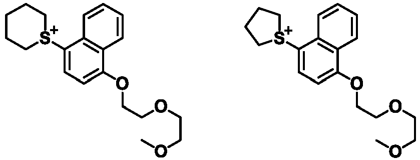

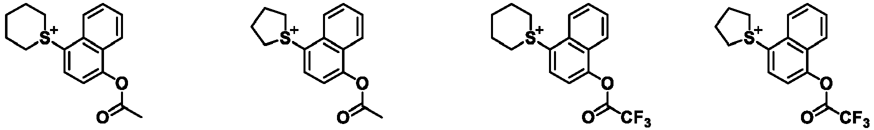

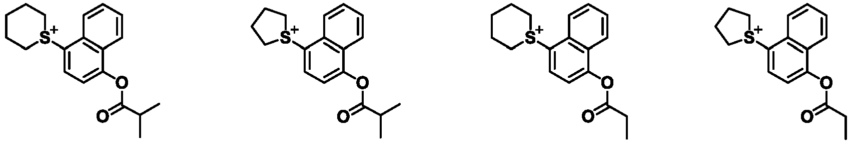

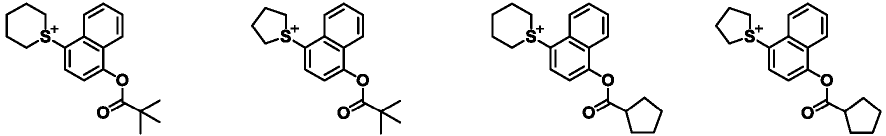

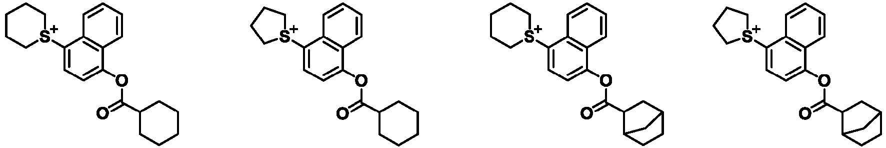

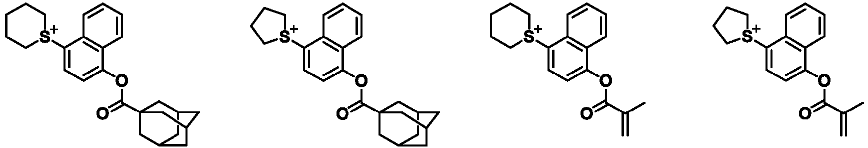

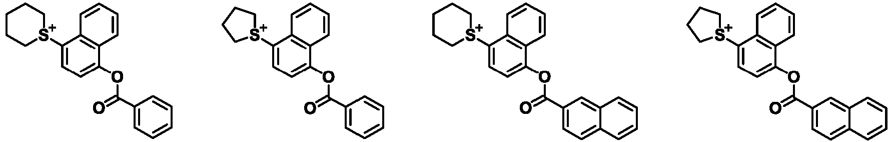

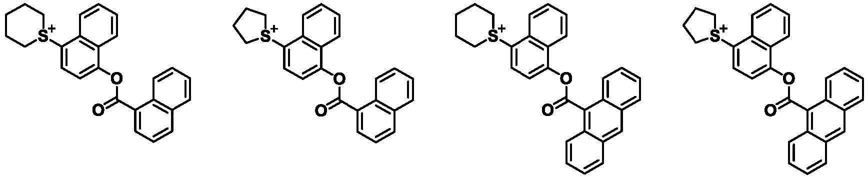

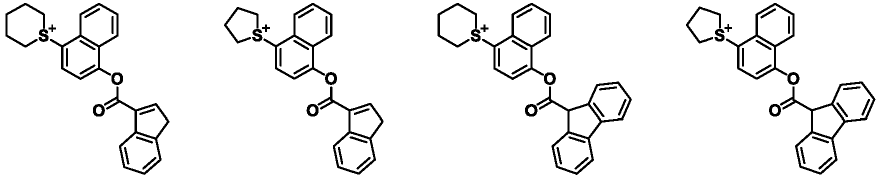

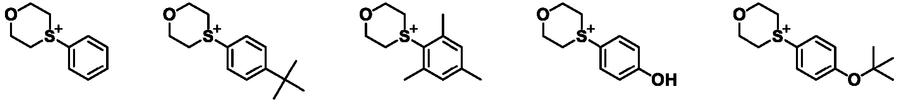

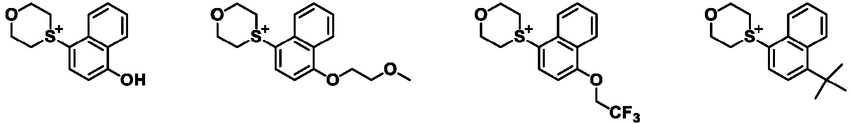

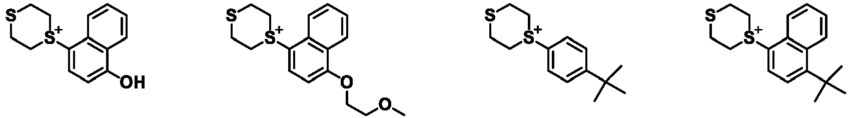

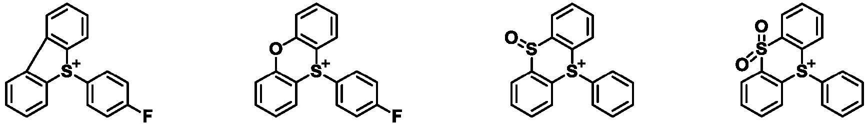

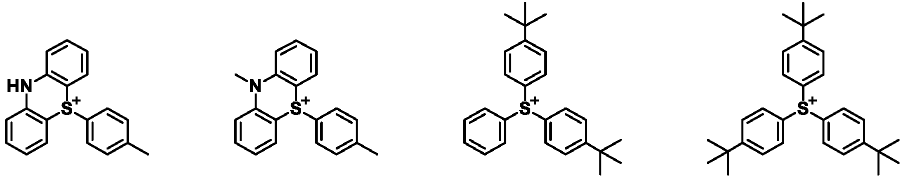

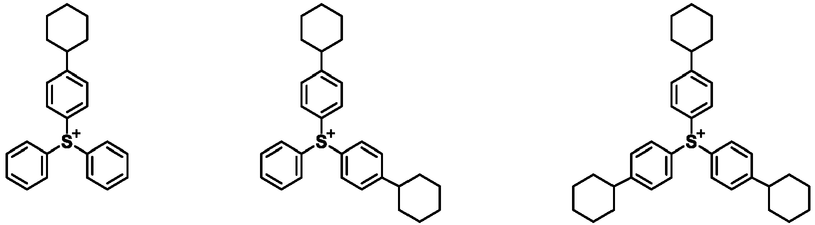

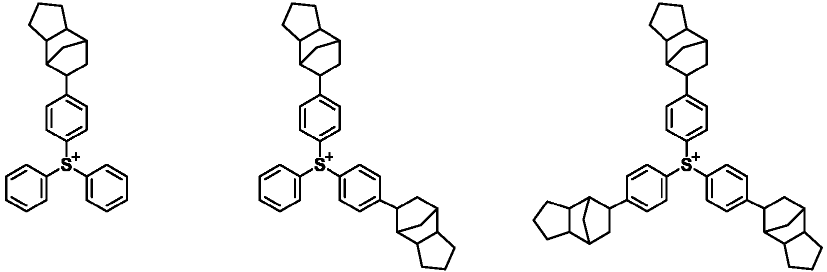

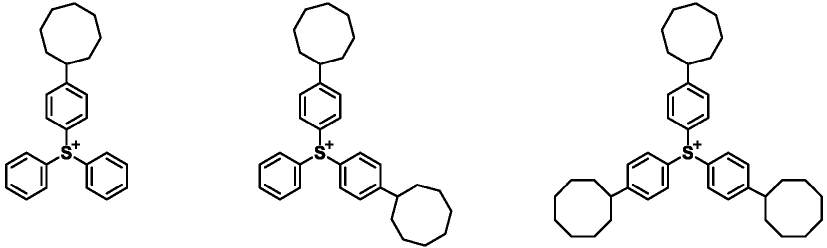

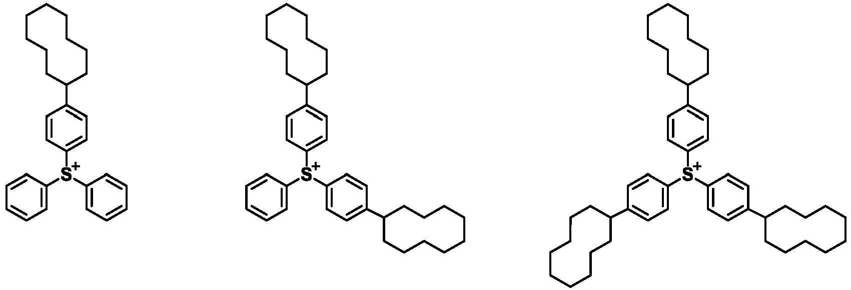

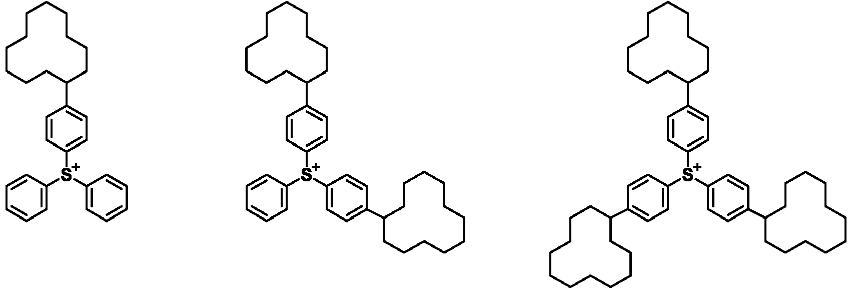

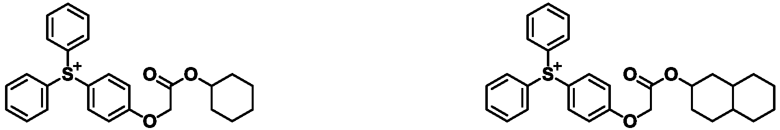

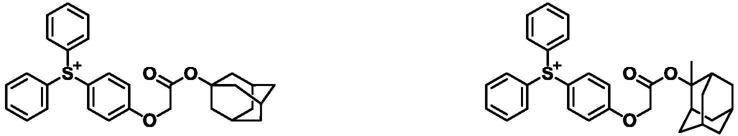

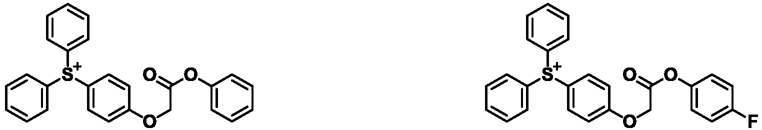

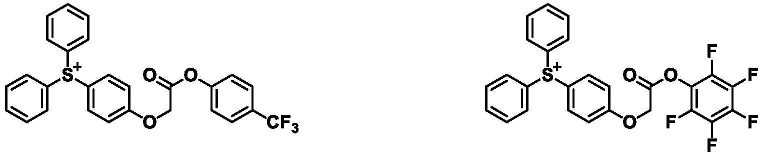

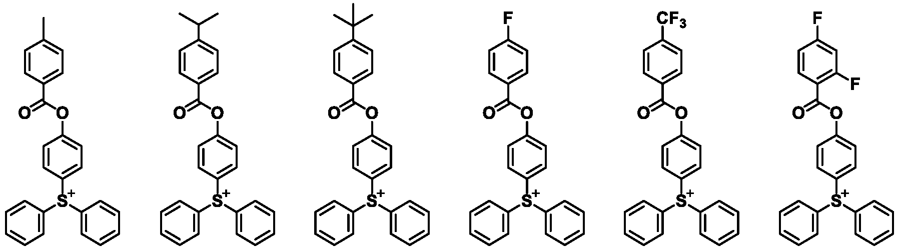

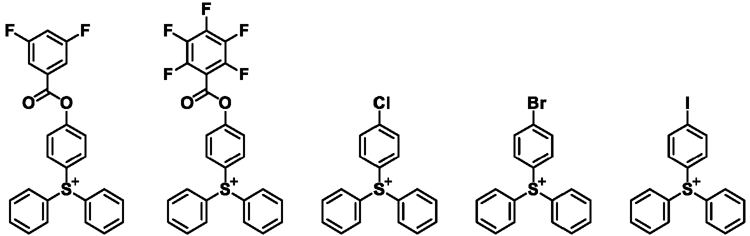

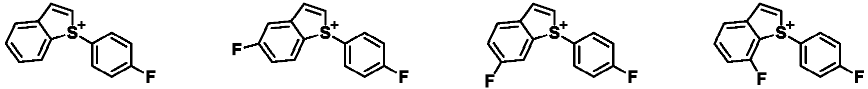

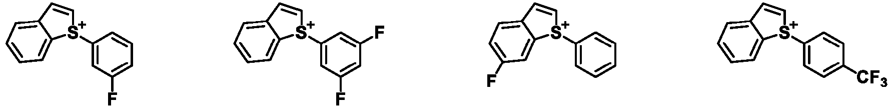

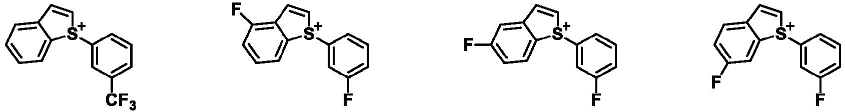

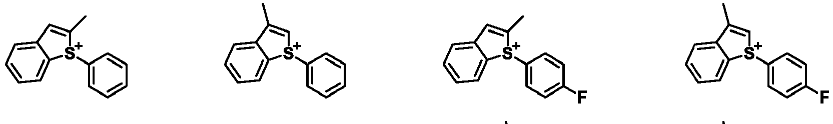

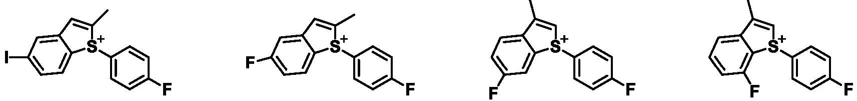

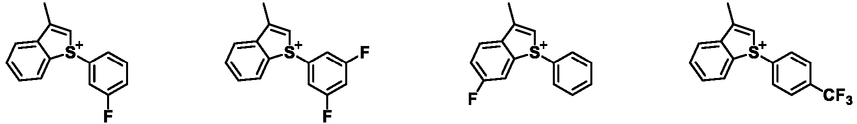

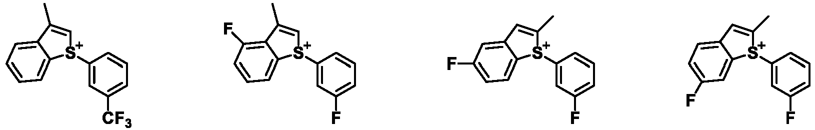

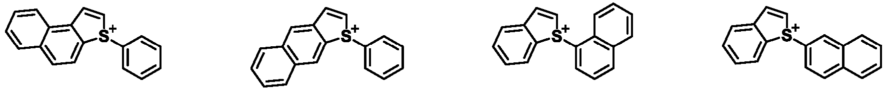

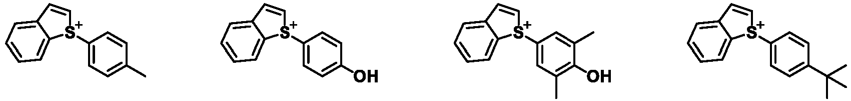

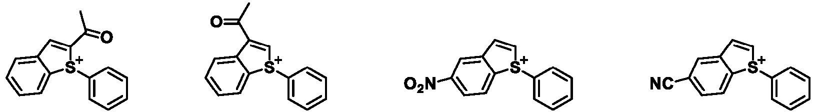

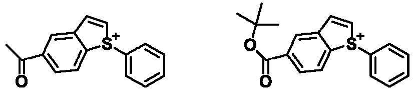

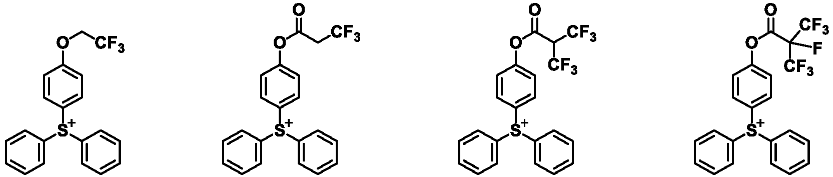

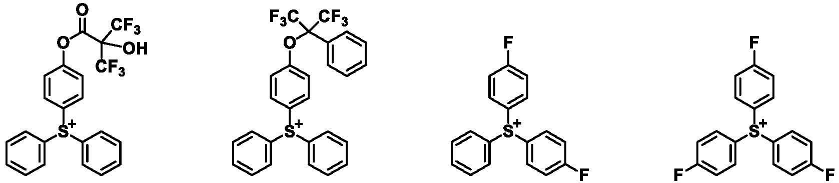

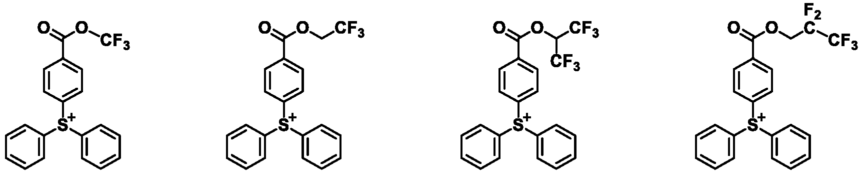

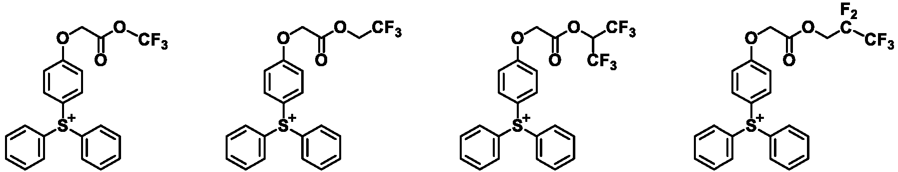

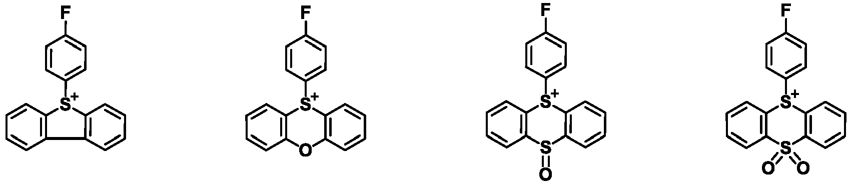

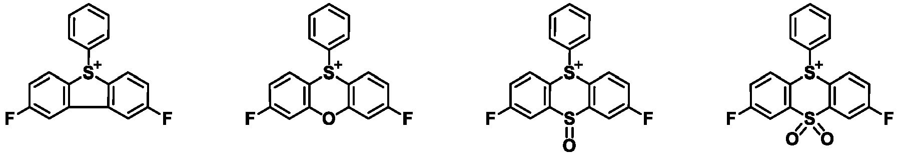

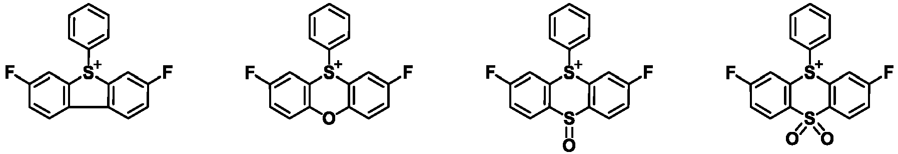

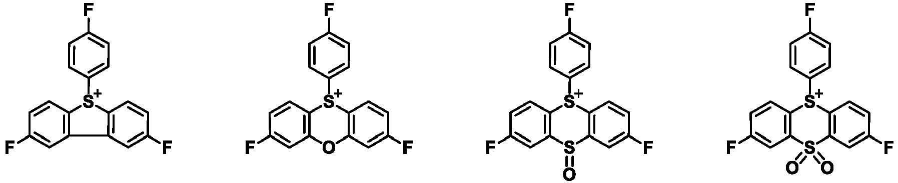

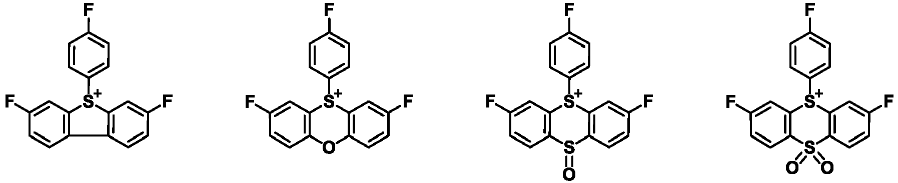

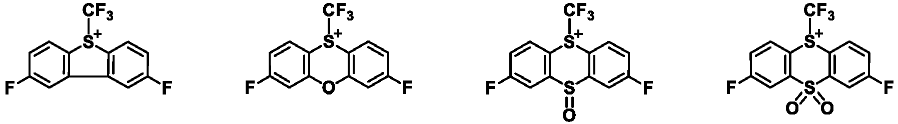

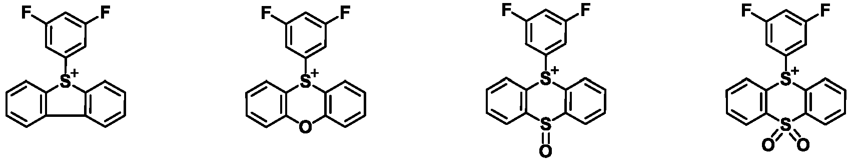

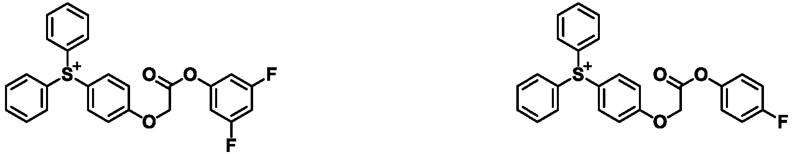

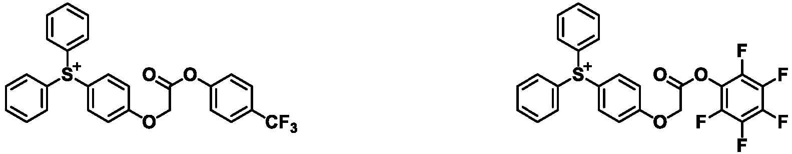

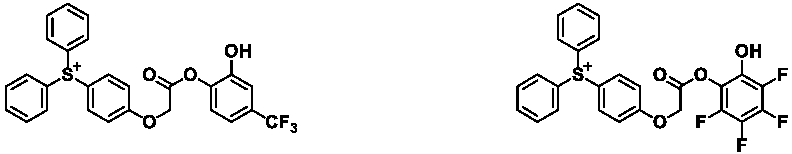

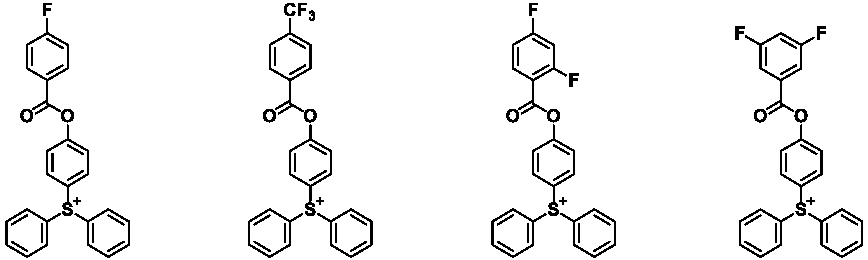

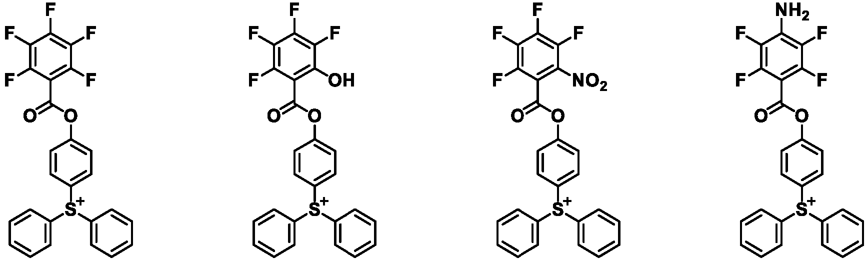

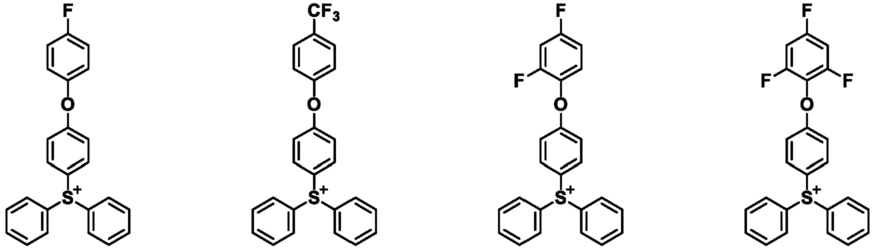

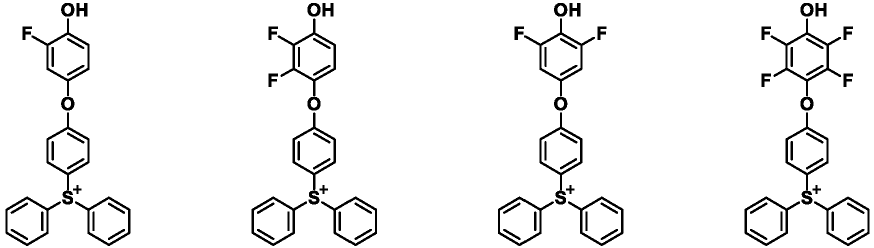

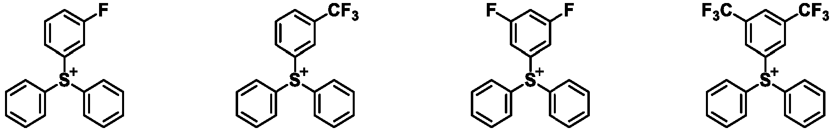

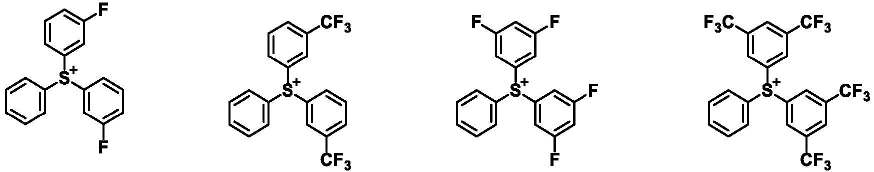

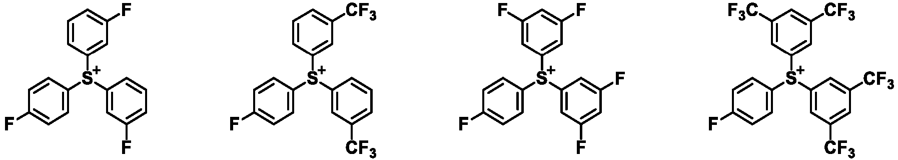

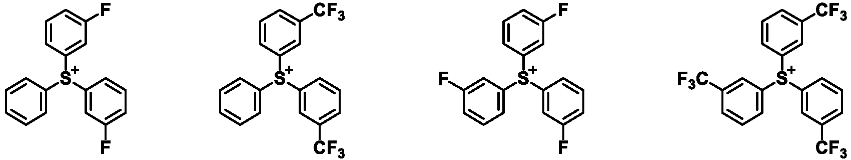

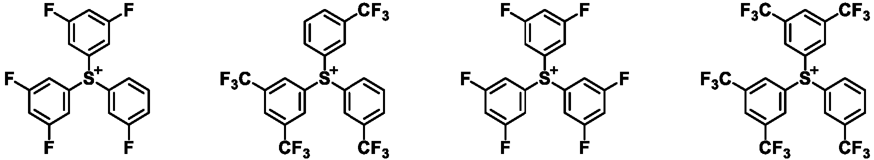

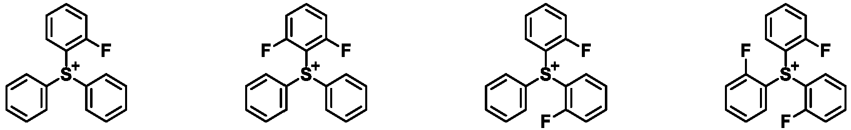

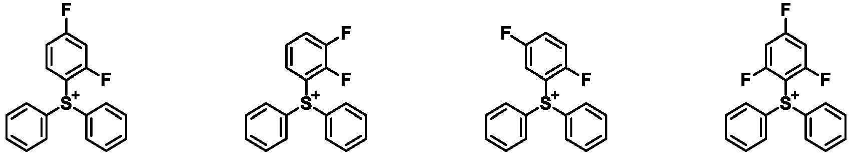

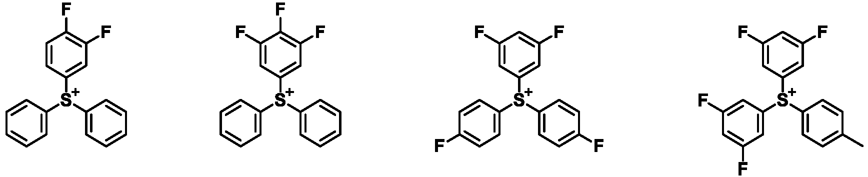

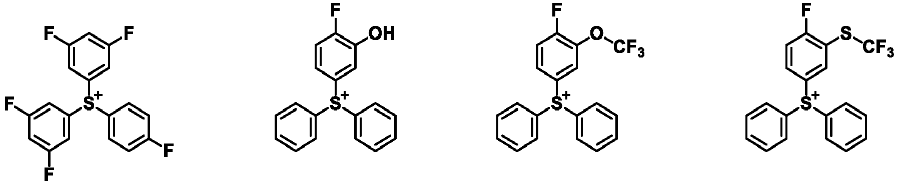

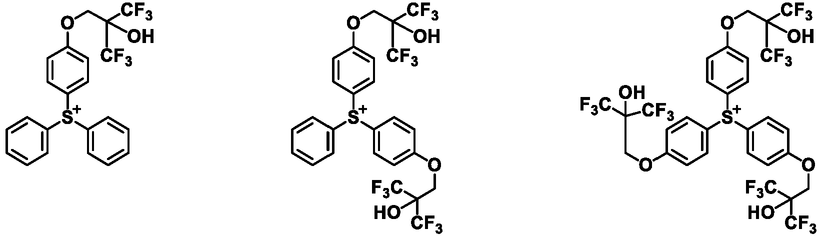

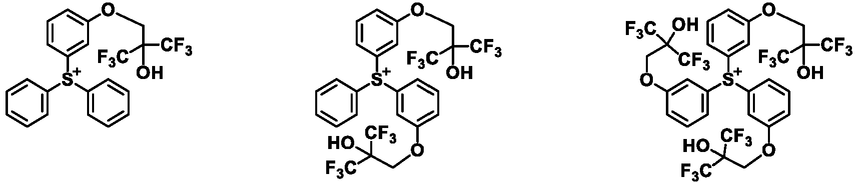

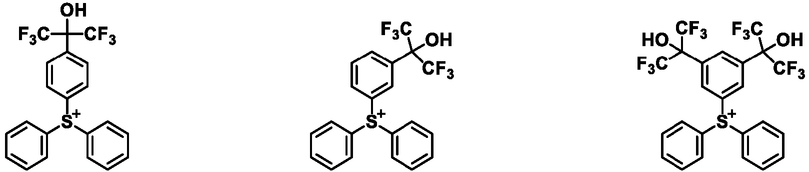

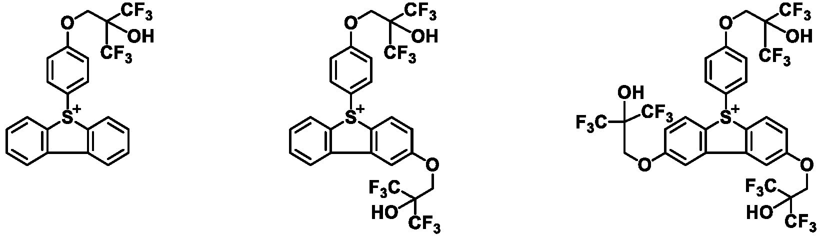

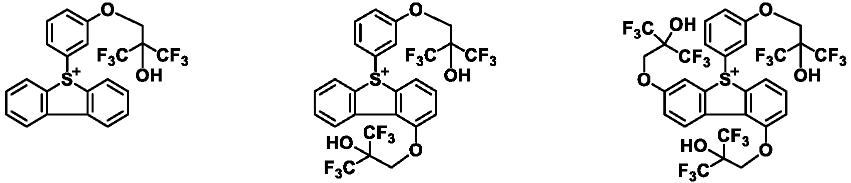

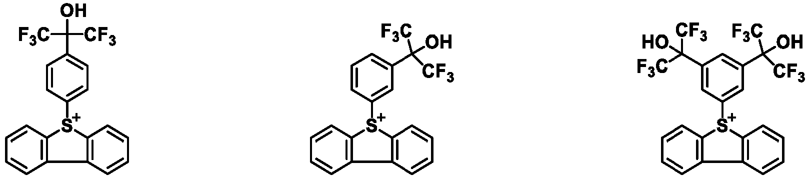

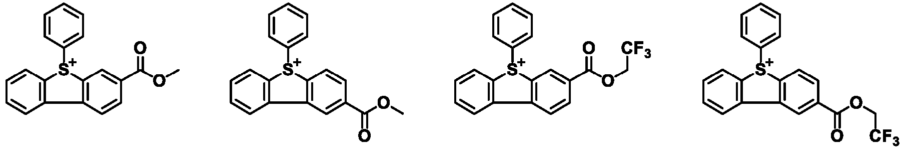

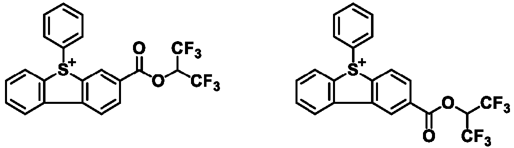

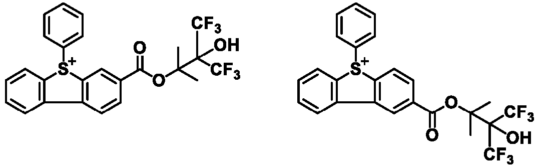

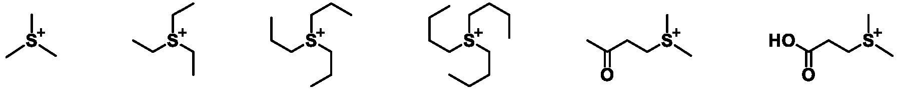

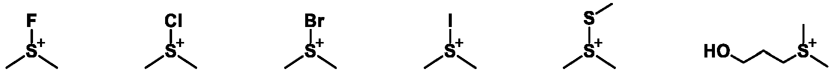

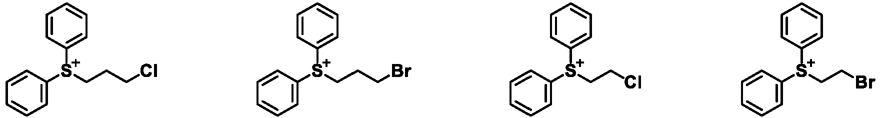

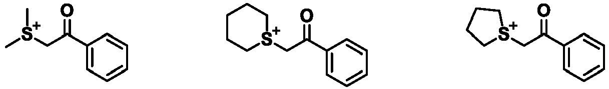

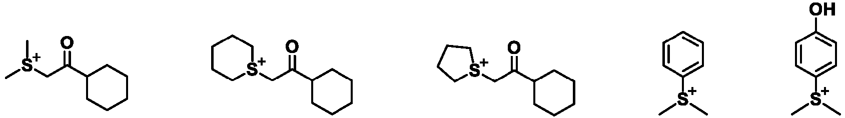

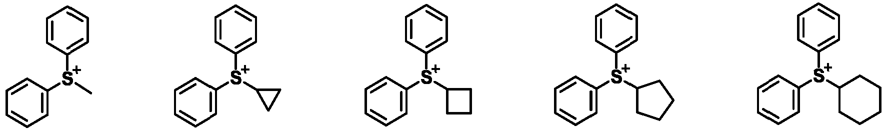

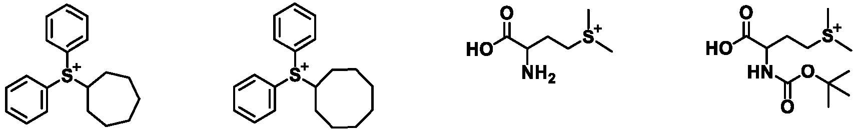

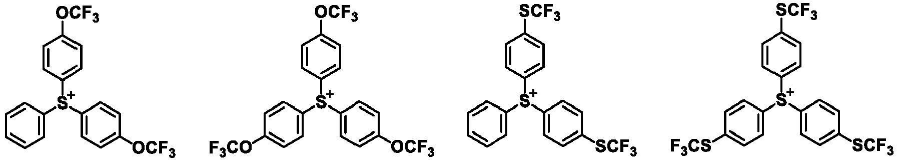

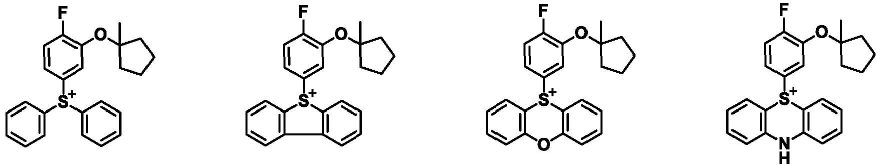

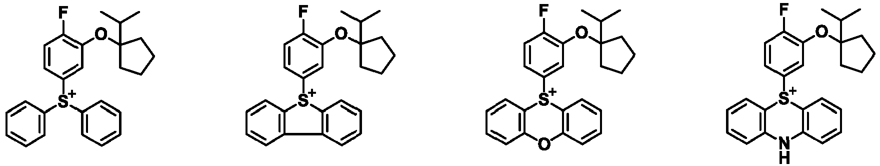

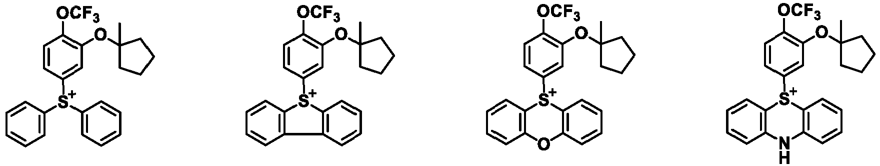

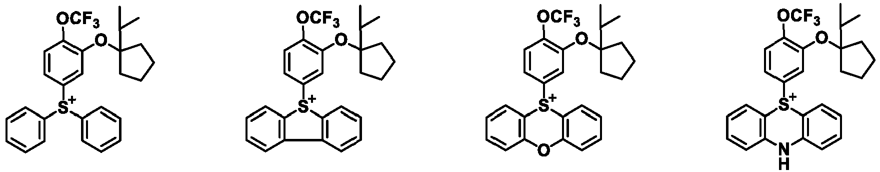

Examples of the iodonium cation represented by formula (cation-2) are shown below, but not limited thereto.

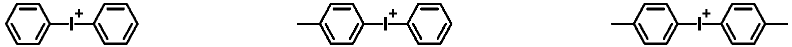

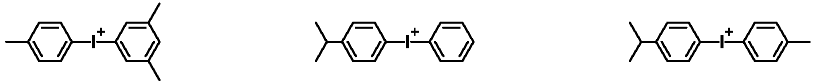

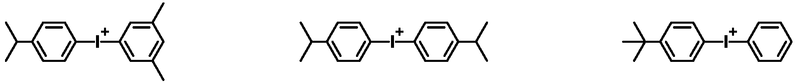

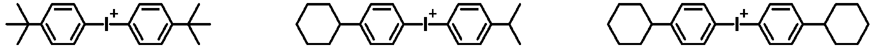

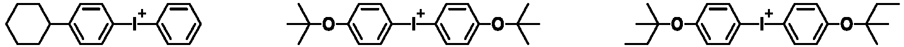

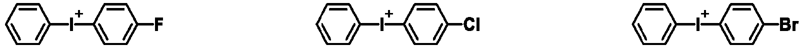

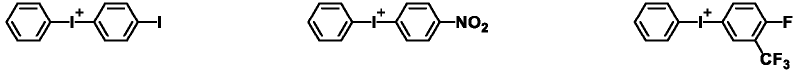

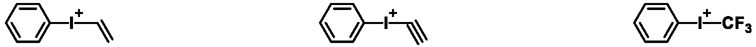

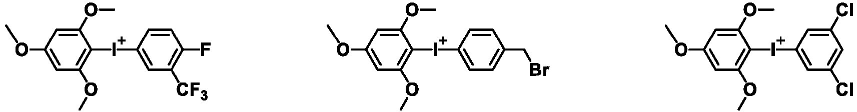

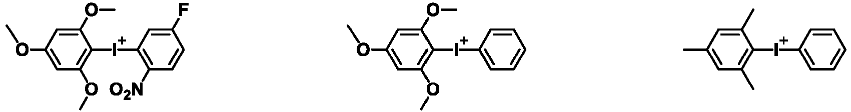

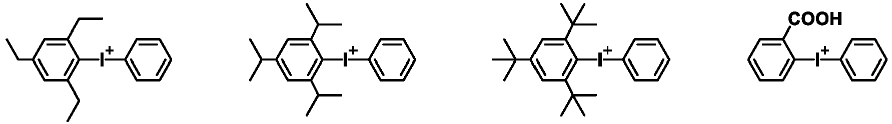

Examples of the monomer having formula (A1) include arbitrary combinations of the anion with the cation.

The monomer having formula (A1) may be synthesized in the same manner as in synthesis of a sulfonium salt having a polymerizable anion in JP 5201363, but the synthesis method is not limited thereto.

The polymer further contains repeat units A2 having a phenolic hydroxy group having the formula (A2).

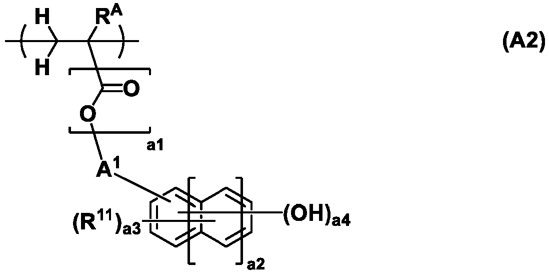

In formula (A2), a1 is 0 or 1. The subscript a2 is an integer of 0 to 2. The polymer has a benzene backbone when a2 is 0, the polymer has a naphthalene backbone when a2 is 1, and the polymer has an anthracene backbone when a2 is 2. The subscript a3 is an integer which satisfies 0 ≤ a3 ≤ 5+2(a2)-a4. The subscript a4 is an integer of 1 to 3. When a2 is 0, a3 is preferably 0, 1, 2 or 3 and a4 is preferably 1, 2 or 3. When a2 is 1 or 2, a3 is preferably 0, 1, 2, 3 or 4 and a4 is preferably 1, 2 or 3.

In formula (A2), R^{A} is a hydrogen atom, fluorine atom, methyl group, or trifluoromethyl group.

In formula (A2), R¹¹ is a halogen atom, nitro group, cyano group, C₁-C₆ saturated hydrocarbyl group which may be substituted with a halogen atom, C₁-C₆ saturated hydrocarbyloxy group which may be substituted with a halogen atom, or C₂-C₈ saturated hydrocarbylcarbonyloxy group which may be substituted with a halogen atom. The saturated hydrocarbyl group and the saturated hydrocarbyl moieties of the saturated hydrocarbyloxy group and saturated hydrocarbylcarbonyloxy group may be straight, branched or cyclic. Examples thereof include alkyl groups such as a methyl group, an ethyl group, a n-propyl group, an isopropyl group, a butyl group, a pentyl group, a hexyl group and structural isomers thereof; cycloalkyl groups such as a cyclopropyl group, a cyclobutyl group, a cyclopentyl group and a cyclohexyl group; and combinations thereof. A carbon count below the upper limit ensures a satisfactory solubility in alkaline developer. Groups R¹¹ may be the same or different when a3 is 2 or more.

In formula (A2), A¹ is a single bond or C₁-C₁₀ saturated hydrocarbylene group in which some constituent -CH₂- may be replaced by -O-. The saturated hydrocarbylene group may be straight, branched or cyclic. Examples thereof include C₁-C₁₀ alkanediyl groups such as a methyl group, an ethane-1,2-diyl group, a propane-1,3-diyl group, a butane-1,4-diyl group, a pentane-1,5-diyl group, a hexane-1,6-diyl group and structural isomers thereof; C₃-C₁₀ cyclic saturated hydrocarbylene groups such as a cyclopropanediyl group, a cyclobutanediyl group, a cyclopentanediyl group and a cyclohexanediyl group; and combinations thereof. For the saturated hydrocarbylene group containing an ether bond, when a1=1 in formula (A2), the ether bond may be incorporated at any position excluding the position between the α-carbon and β-carbon relative to the ester oxygen atom. When a1=0, the atom that bonds with the backbone becomes an ethereal oxygen atom, and a second ether bond may be incorporated at any position excluding the position between the α-carbon and β-carbon relative to the ethereal oxygen atom. Saturated hydrocarbylene groups having no more than 10 carbon atoms are desirable because of a sufficient solubility in alkaline developer.

When a1 is 0 and A¹ is a single bond, in other words, the aromatic ring is directly bonded to the backbone of the polymer (i.e., there is no linker (-C(=O)-O-A¹-)), preferred examples of the repeat unit A2 include units 3-hydroxystyrene, 4-hydroxystyrene, 5-hydroxy-2-vinylnaphthalene, and 6-hydroxy-2-vinylnaphthalene. In particular, repeat units having the formula (A2-1) are preferred. 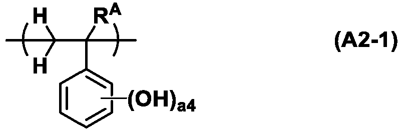 wherein R^{A} and a4 are as defined above.

When a1 is 0 and A¹ is a single bond (i.e., there is no linker (-C(=O)-O-A¹-)), preferred examples of the repeat unit A2 are shown below, but not limited thereto. Herein, R^{A} is as defined above.

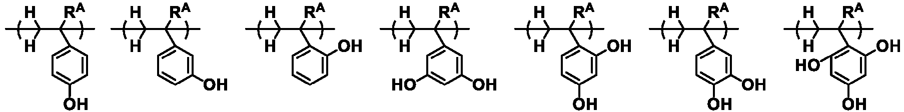

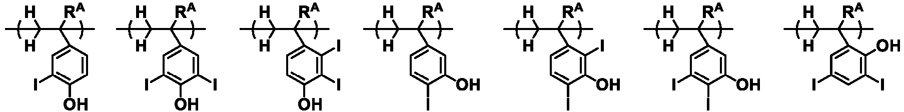

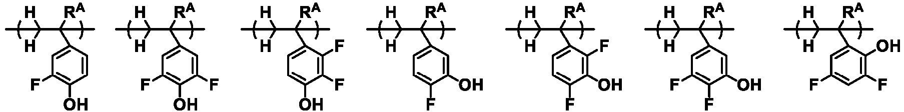

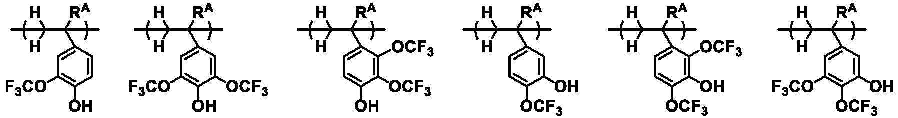

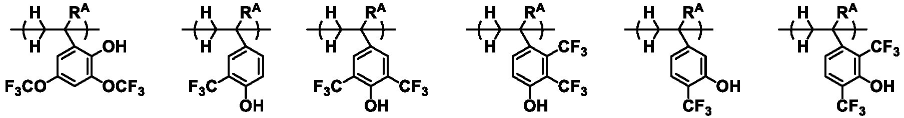

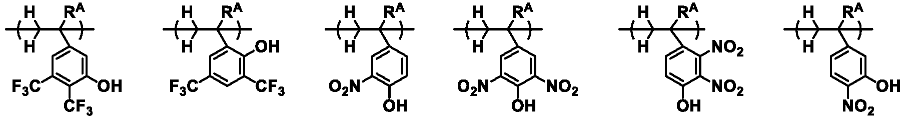

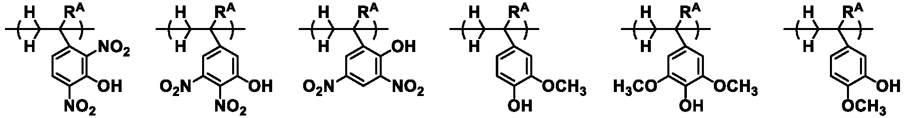

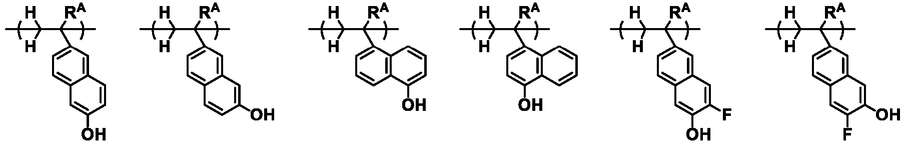

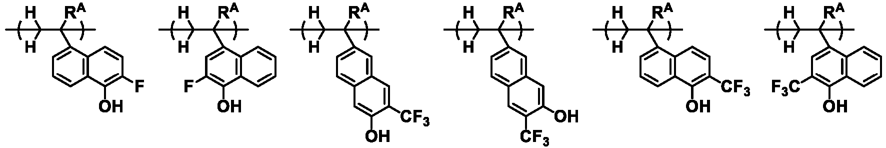

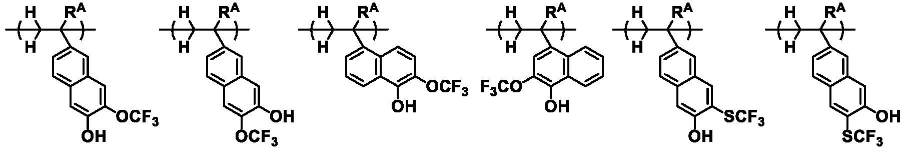

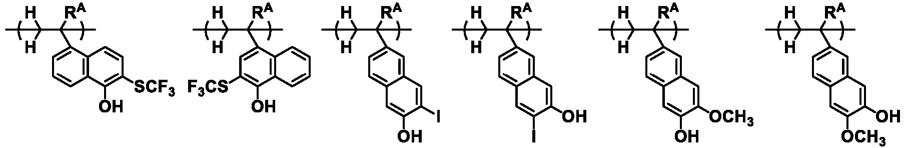

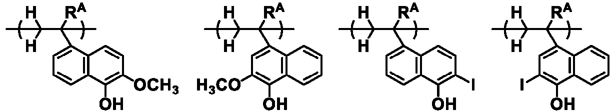

When a1 is 1 (i.e., there is a linker (-C(=O)-O-A¹-)), preferred examples of the repeat unit A2 are shown below, but not limited thereto. Herein, R^{A} is as defined above.

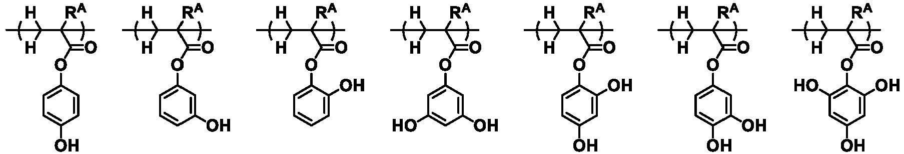

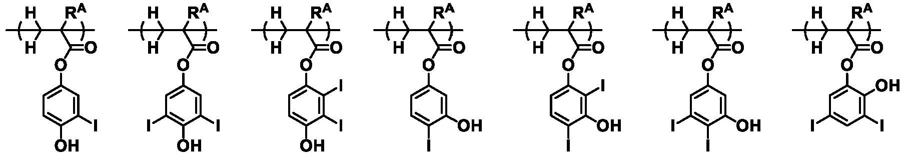

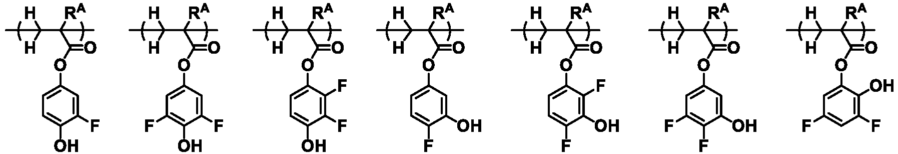

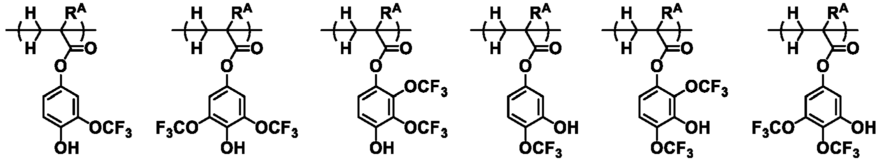

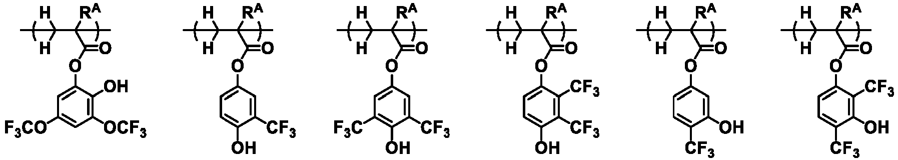

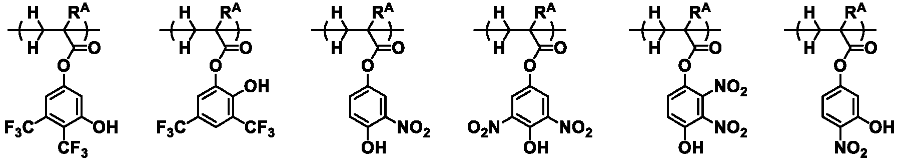

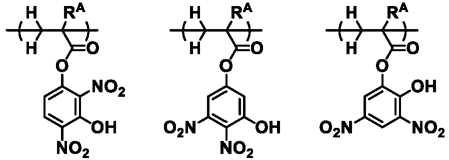

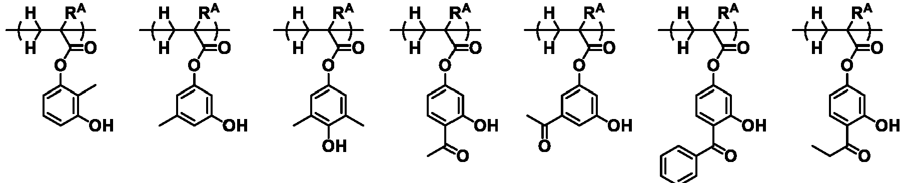

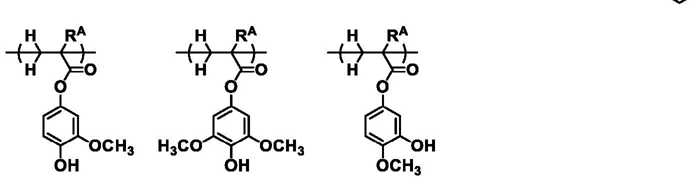

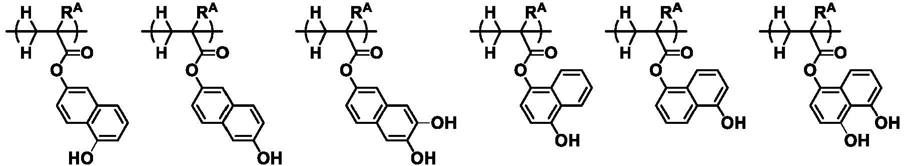

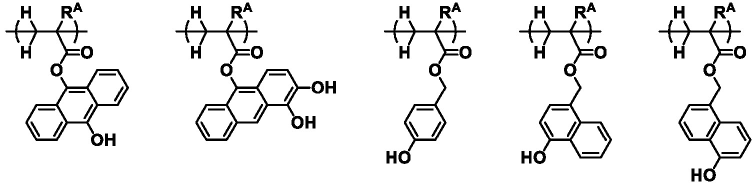

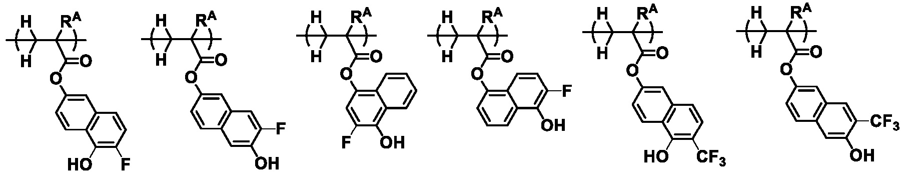

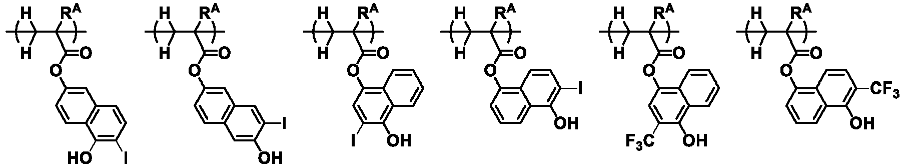

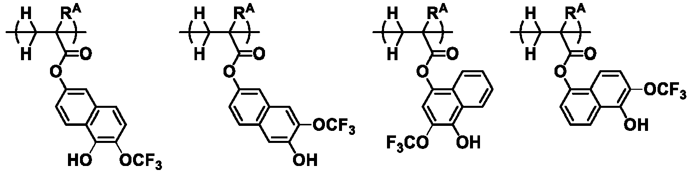

The content of repeat units A2 is preferably 30 to 90 mol%, more preferably 40 to 85 mol% of the overall repeat units of the polymer. It is noted that when the polymer further contains repeat units of at least one type selected from repeat units having formulae (A4) and (A5) and imparting higher etch resistance to the polymer, preferably the repeat units of at least one type containing a phenolic hydroxy group as a substituent, the content of repeat units A2 plus repeat units A4 and/or A5 falls in the above range. The repeat units A2 may each be used singly or in combination of two or more kinds thereof.

For the polymer to have a property as a positive resist composition in which exposed regions are soluble in an alkaline developer, the polymer preferably contains repeat units having a functional group protected by an acid labile group, i.e., repeat units protected by an acid labile group and becoming alkali-soluble under the action of an acid, which are also referred to as repeat units A3, hereinafter.

Examples of the most preferred repeat unit A3 include those having the formula (A3-1), which are also referred to repeat units A3-1, hereinafter.

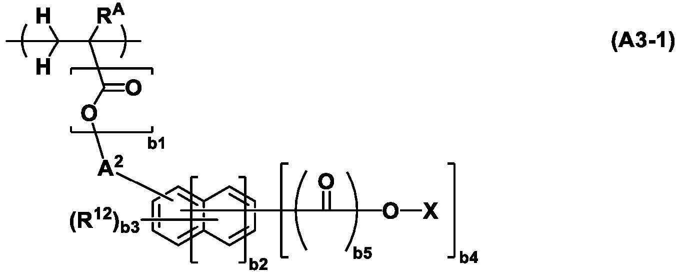

In formula (A3-1), b1 is 0 or 1. The subscript b2 is an integer of 0 to 2. The polymer has a benzene backbone when a2 is 0, the polymer has a naphthalene backbone when a2 is 1, and the polymer has an anthracene backbone when a2 is 2. The subscript b3 is an integer which satisfies 0 ≤ b3 ≤ 5+2(b2)-b4. The subscript b4 is an integer of 1 to 3. The subscript b5 is 0 or 1. In case of b2=0, preferably b3 is an integer of 0 to 3 and b4 is an integer of 1 to 3. In case of b2=1 or 2, preferably b3 is an integer of 0 to 4 and b4 is an integer of 1 to 3.

In formula (A3-1), R^{A} is a hydrogen atom, fluorine atom, methyl group, or trifluoromethyl group.

In formula (A3-1), R¹² is a halogen atom, C₁-C₆ saturated hydrocarbyl group which may be substituted with a halogen atom, C₁-C₆ saturated hydrocarbyloxy group which may be substituted with a halogen atom, or C₂-C₈ saturated hydrocarbylcarbonyloxy group which may be substituted with a halogen atom. The saturated hydrocarbyl group and the saturated hydrocarbyl moieties of the saturated hydrocarbyloxy group and saturated hydrocarbylcarbonyloxy group may be straight, branched or cyclic. Examples thereof include alkyl groups such as a methyl group, an ethyl group, a n-propyl group, an isopropyl group, a butyl group, a pentyl group, a hexyl group and structural isomers thereof; cycloalkyl groups such as a cyclopropyl group, a cyclobutyl group, a cyclopentyl group and a cyclohexyl group; and combinations thereof. A carbon count below the upper limit ensures a satisfactory solubility in alkaline developer. Groups R ¹² may be the same or different when b3 is 2 or more.

In formula (A3-1), A² is a single bond or C₁-C₁₀ saturated hydrocarbylene group in which some constituent -CH₂- may be replaced by -O-. The saturated hydrocarbylene group may be straight, branched or cyclic. Examples thereof include C₁-C₁₀ alkanediyl groups such as a methyl group, an ethane-1,2-diyl group, a propane-1,3-diyl group, a butane-1,4-diyl group, a pentane-1,5-diyl group, a hexane-1,6-diyl group and structural isomers thereof; C₃-C₁₀ cyclic saturated hydrocarbylene groups such as a cyclopropanediyl group, a cyclobutanediyl group, a cyclopentanediyl group and a cyclohexanediyl group; and combinations thereof. For the saturated hydrocarbylene group containing an ether bond, when b1=1 in formula (A3-1), the ether bond may be incorporated at any position excluding the position between the α-carbon and β-carbon relative to the ester oxygen atom. When b1=0, the atom that bonds with the backbone becomes an ethereal oxygen atom, and a second ether bond may be incorporated at any position excluding the position between the α-carbon and β-carbon relative to the ethereal oxygen atom. Saturated hydrocarbylene groups having no more than 10 carbon atoms are desirable because of a sufficient solubility in alkaline developer.

In formula (A3-1), X is an acid labile group when b4 is 1. X is each independently a hydrogen atom or acid labile group, at least one being an acid labile group, in case of b4 is 2 or 3. That is, repeat units A3-1 have phenolic hydroxy groups bonded to an aromatic ring, at least one of which is protected with an acid labile group, or repeat units A3-1 have a carboxy group bonded to an aromatic ring, which is protected with an acid labile group. The acid labile group used herein is not particularly limited as long as it is commonly used in a number of well-known chemically amplified positive resist compositions and eliminated under the action of acid to release an acidic group.

Examples of the acid labile group include a tertiary saturated hydrocarbyl group. The tertiary saturated hydrocarbyl groups of 4 to 18 carbon atoms are preferred because the corresponding monomer for use in polymerization is available through distillation.

The saturated hydrocarbyl group attached to the tertiary carbon atom in the tertiary saturated hydrocarbyl group is preferably a C₁-C₁₅ saturated hydrocarbyl group. The C₁-C₁₅ saturated hydrocarbyl group may be straight, branched or cyclic, and an oxygen atom-containing functional group such as an ether group or carbonyl group may be incorporated in a carbon-carbon bond. The saturated hydrocarbyl groups attached to the tertiary carbon atom may bond together to form a ring with the tertiary carbon atom to which they are attached.

Examples of the saturated hydrocarbyl group bonded to the tertiary carbon atom include methyl, ethyl, propyl, adamantyl, norbornyl, tetrahydrofuran-2-yl, 7-oxanorbornan-2-yl, cyclopentyl, 2-tetrahydrofuryl, tricyclo[5.2.1.0^{2,6}]decyl, 8-ethyl-8-tricyclo[5.2.1.0^{2,6}]decyl, 3-methyl-3-tetracyclo[4.4.0.1^{2,5}.1^{7,10}]dodecyl, tetracyclo[4.4.0.1^{2,5}.1^{7,10}]dodecyl and 3-oxo-1-cyclohexyl groups.

Examples of the tertiary saturated hydrocarbyl group include, but are not limited to, tert-butyl, tert-pentyl, 1-ethyl-1-methylpropyl, 1,1-diethylpropyl, 1,1,2-trimethylpropyl, 1-adamantyl-1-methylethyl, 1-methyl-1-(2-norbornyl)ethyl, 1-methyl-1-(tetrahydrofuran-2-yl)ethyl, 1-methyl-1-(7-oxanorbornan-2-yl)ethyl, 1-methylcyclopentyl, 1-ethylcyclopentyl, 1-propylcyclopentyl, 1-cyclopentylcyclopentyl, 1-cyclohexylcyclopentyl, 1-(2-tetrahydrofuryl)cyclopentyl, 1-(7-oxanorbornan-2-yl)cyclopentyl, 1-methylcyclohexyl, 1-ethylcyclohexyl, 1-cyclopentylcyclohexyl, 1-cyclohexylcyclohexyl, 2-methyl-2-norbornyl, 2-ethyl-2-norbornyl, 8-methyl-8-tricyclo[5.2.1.0^{2,6}]decyl, 8-ethyl-8-tricyclo[5.2.1.0^{2,6}]decyl, 3-methyl-3-tetracyclo[4.4.0.1^{2,5}.1^{7,10}]dodecyl, 3-ethyl-3-tetracyclo[4.4.0.1^{2,5}.1^{7,10}]dodecyl, 2-methyl-2-adamantyl, 2-ethyl-2-adamantyl, 1-methyl-3-oxo-1-cyclohexyl, 1-methyl-1-(tetrahydrofuran-2-yl)ethyl, 5-hydroxy-2-methyl-2-adamantyl and 5-hydroxy-2-ethyl-2-adamantyl groups.

A group having the formula (A3-1-1) is also suitable as the acid labile group. The group having formula (A3-1-1) is often used as the acid labile group. It is a good choice of the acid labile group that ensures to form a pattern having a relatively rectangular pattern-substrate interface in a consistent manner. An acetal structure is formed when X is a group having formula (A3-1-1). 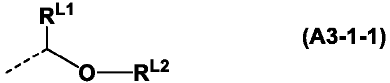 wherein the broken line designates a point of attachment.

In formula (A3-1-1), R^{L1} is a hydrogen atom or C₁-C₁₀ saturated hydrocarbyl group. The saturated hydrocarbyl group may be straight, branched or cyclic.

A choice of R^{L1} may depend on the designed sensitivity of decomposable group to acid. For example, a hydrogen atom or a group having a tertiary carbon atom as a carbon atom bonded to acetal carbon is preferred when the acid decomposable group is designed to ensure relatively high stability and to be decomposed with strong acid. Examples of R^{L1} bonded to acetal carbon via the tertiary carbon atom include, but are not limited to, tert-butyl, tert-pentyl and 1-adamantyl groups. A straight alkyl group is preferred when the acid decomposable group is designed to have relatively high reactivity and high sensitivity to pH changes. Although the choice varies with a particular combination of acid generator and quencher in the resist composition, R^{L1} is preferably a group in which the carbon in bond with acetal carbon is a secondary carbon atom, when R^{L2} is a relatively large alkyl group substituted at the end and the acid decomposable group is designed to undergo a substantial change of solubility by decomposition. Examples of R^{L1} bonded to acetal carbon via the secondary carbon atom include, but are not limited to, sec-butyl, cyclopentyl and cyclohexyl groups.

In formula (A3-1-1), R^{L2} is a C₁-C₃₀ hydrocarbyl group. The hydrocarbyl group may be saturated or unsaturated, and may be straight, branched or cyclic. The hydrocarbyl group may substituted at some constituent -CH₂- with heteroatoms such as an oxygen atom or a sulfur atom, and resultantly contain an ether bond, a sulfide bond or the like. Examples of the hydrocarbyl group include C₁-C₃₀ saturated hydrocarbyl and C₆-C₃₀ aryl groups. Particularly in fine pattern formation, R^{L2} is preferably a C₁-C₆ hydrocarbyl group for acquiring a higher resolution. When R^{L2} is a C₁-C₆ hydrocarbyl group, an alcohol, which is formed after a deprotection reaction by an acid proceeds, is soluble in water. Therefore, in formation of positive tone pattern with an alkaline developer, the alcohol is dissolved in the developer, so that residue defects on exposed regions can be reduced.

Preferred examples of the group having formula (A3-1-1) are shown below, but not limited thereto. In the formulae, R^{L1} is as defined above, and the broken line designates a point of attachment.

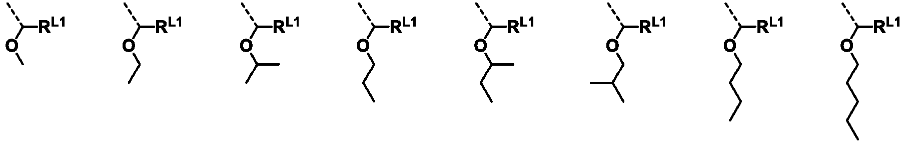

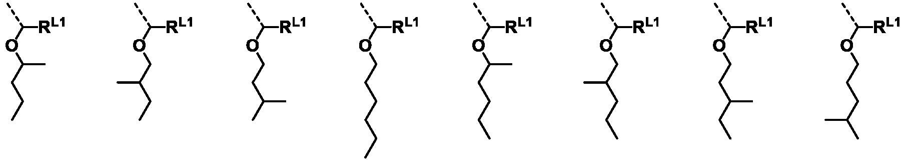

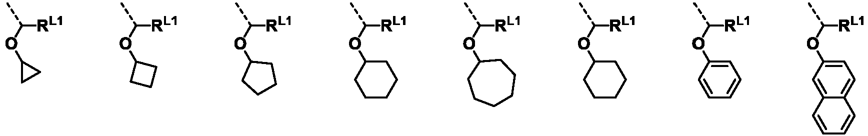

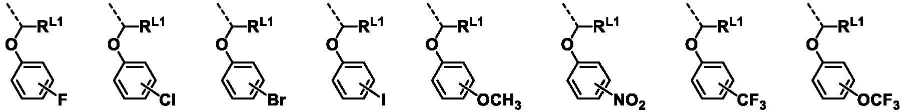

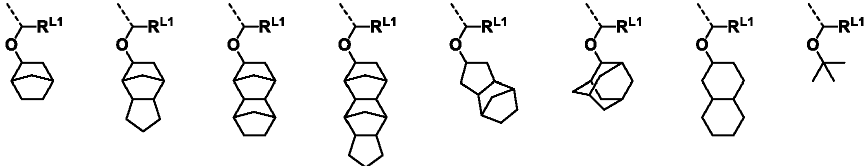

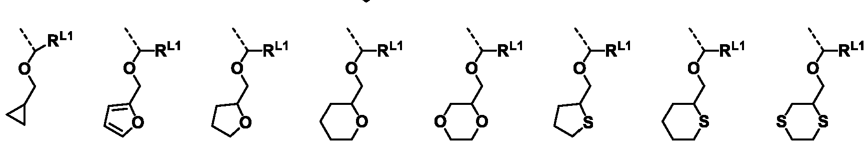

Another choice of acid labile group which can be used herein is a phenolic hydroxy group whose hydrogen is substituted by a tertiary saturated hydrocarbyl moiety: -CH₂COO-. Examples of the tertiary saturated hydrocarbyl moiety are as exemplified above for the tertiary saturated hydrocarbyl group used for the protection of phenolic hydroxy group.

Examples of the repeat unit A3 include repeat units having the formula (A3-2), which are also referred to repeat units A3-2, hereinafter. The repeat unit A3-2 is a good choice as an acid labile group-containing unit which enhances the dissolution rate of exposed regions to improve performance against the variation of line width in develop loading.

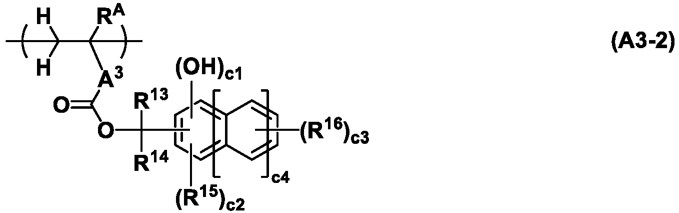

In formula (A3-2), c1 is an integer of 0 to 2. The subscript c2 is an integer of 0 to 2. The subscript c3 is an integer of 0 to 5. The subscript c4 is an integer of 0 to 2.

In formula (A3-2), R^{A} is a hydrogen atom, fluorine atom, methyl group, or trifluoromethyl group.

In formula (A3-2), R¹³ and R¹⁴ are each independently a C₁-C₁₀ hydrocarbyl group which may contain a heteroatom, and R¹³ and R¹⁴ may bond together to form a ring with the carbon atom to which they are attached.

In formula (A3-2), R¹⁵ is each independently a fluorine atom, C₁-C₅ fluorinated alkyl group or C₁-C₅ fluorinated alkoxy group.

In formula (A3-2), R¹⁶ are each independently a C₁-C₁₀ hydrocarbyl group which may contain a heteroatom.

In formula (A3-2), A³ is a single bond, phenylene group, naphthylene group or *-C(=O)-O-A³¹-. A³¹ is a C₁-C₂₀ aliphatic hydrocarbylene group, a phenylene group, or a naphthylene group, and the aliphatic hydrocarbylene group may contain at least one selected from a hydroxy group, an ether bond, an ester bond or a lactone ring. The asterisk (*) designates a point of attachment to the carbon atom in the backbone.

Examples of repeat unit A3-2 are shown below, but not limited thereto. Herein, R^{A} is as defined above.

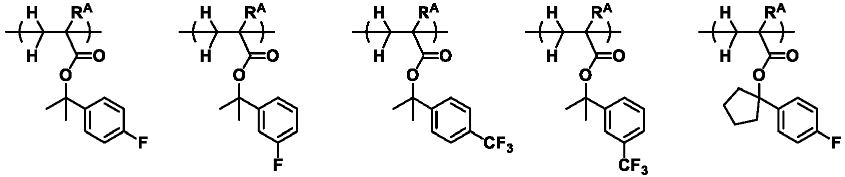

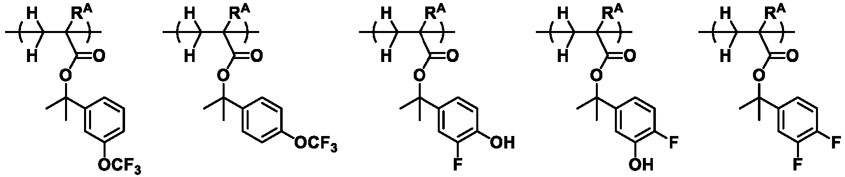

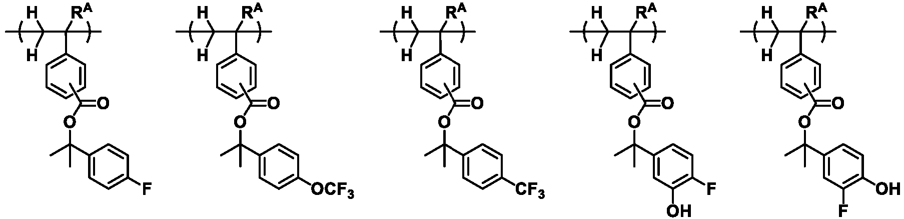

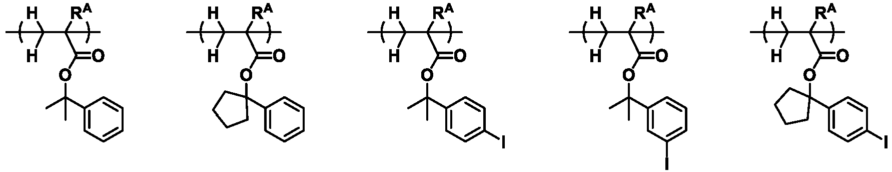

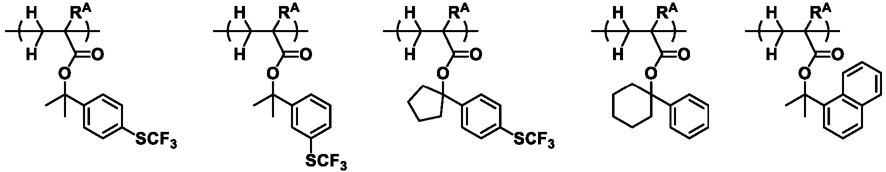

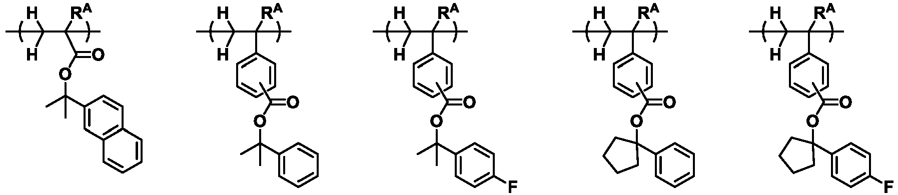

The content of repeat units A3 is preferably 5 to 95 mol%, more preferably 20 to 80 mol% of the overall repeat units of the polymer. The repeat units A3 may each be used singly or in combination of two or more kinds thereof.

The polymer may contain repeat units of at least one type selected from repeat units having the formula (A4), repeat units having the formula (A5) and repeat units having the formula (A6). It is noted that the repeat units having the formulae (A4), (A5) and (A6) are also referred to as units A4, A5 and A6, respectively, hereinafter.

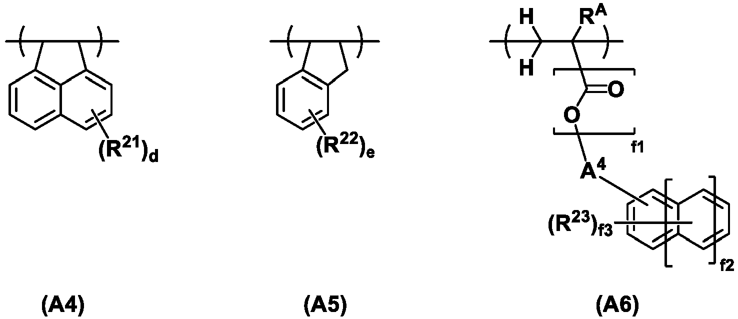

In formulae (A4) and (A5), d is an integer of 0 to 6. The subscript e is an integer of 0 to 4.

In formulae (A4) and (A5), R²¹ and R²² are each independently a hydroxy group, halogen atom, C₁-C₆ saturated hydrocarbyl group which may be substituted with a halogen atom, C₁-C₆ saturated hydrocarbyloxy group which may be substituted with a halogen atom, or C₂-C₈ saturated hydrocarbylcarbonyloxy group which may be substituted with a halogen atom. The saturated hydrocarbyl, saturated hydrocarbyloxy and saturated hydrocarbylcarbonyloxy groups may be straight, branched or cyclic. Groups R²¹ may be the same or different when d is 2 or more. Groups R²² may be the same or different when e is 2 or more.

In formula (A6), f1 is 0 or 1. The subscript f2 is an integer of 0 to 2. The polymer has a benzene backbone when a2 is 0, the polymer has a naphthalene backbone when a2 is 1, and the polymer has an anthracene backbone when a2 is 2. The subscript f3 is an integer of 0 to 5. The subscript f3 is preferably 0, 1, 2 or 3 when f2 is 0. The subscript f3 is preferably 0, 1, 2, 3 or 4 when f2 is 1 or 2.

In formula (A6), R^{A} is a hydrogen atom, fluorine atom, methyl group, or trifluoromethyl group.

In formula (A6), R²³ is a halogen atom, nitro group, cyano group, C₁-C₂₀ saturated hydrocarbyl group, C₁-C₂₀ saturated hydrocarbyloxy group, C₂-C₂₀ saturated hydrocarbylcarbonyloxy group, C₂-C₂₀ saturated hydrocarbyloxyhydrocarbyl group or C₂-C₂₀ saturated hydrocarbylthiohydrocarbyl group, and may be a hydroxy group when f2 is 1 or 2. The saturated hydrocarbyl, saturated hydrocarbyloxy, saturated hydrocarbylcarbonyloxy, saturated hydrocarbyloxyhydrocarbyl and saturated hydrocarbylthiohydrocarbyl groups may be straight, branched or cyclic. Groups R²³ may be the same or different when f3 is 2 or more.

In formula (A6), A⁴ is a single bond or C₁-C₁₀ saturated hydrocarbylene group in which some constituent -CH₂- may be replaced by -O-. The saturated hydrocarbylene group may be straight, branched or cyclic, and examples thereof are as exemplified for A¹ in formula (A2).

When repeat units of at least one type selected from repeat units A4 to A6 are incorporated, better performance is obtained because not only the aromatic ring possesses etch resistance, but the cyclic structure incorporated into the main chain also exerts the effect of improving resistance to etching and EB irradiation during pattern inspection step.

The repeat units A4 to A6 are preferably incorporated in a range of at least 5 mol% based on the overall repeat units of the polymer for obtaining the effect of improving etch resistance. Also, the repeat units A4 to A6 are preferably incorporated in a range of up to 25 mol%, more preferably up to 20 mol% based on the overall repeat units of the polymer. When the relevant units are free of functional groups or have a functional group other than hydroxy, their content of up to 25 mol% is preferred because the risk of forming development defects is eliminated. Each of the repeat units A4 to A6 may be of one type or a combination of plural types.

The content of repeat units having an aromatic ring structure is preferably at least 65 mol%, more preferably at least 75 mol%, still more preferably at least 85 mol% based on the overall repeat units of the polymer.

The polymer may further comprise (meth)acrylate units protected with an acid labile group and/or (meth)acrylate units having an adhesive group such as a lactone structure or a hydroxy group other than phenolic hydroxy, as commonly used in the art. These repeat units are effective for fine adjustment of properties of a resist film, but not essential.

Examples of the (meth)acrylate unit having an adhesive group include repeat units having the formula (A7), repeat units having the formula (A8), and repeat units having the formula (A9), which are also referred to as repeat units A7, A8, and A9, respectively. While these units do not exhibit acidity, they may be used as auxiliary units for providing adhesion to substrates or adjusting solubility.

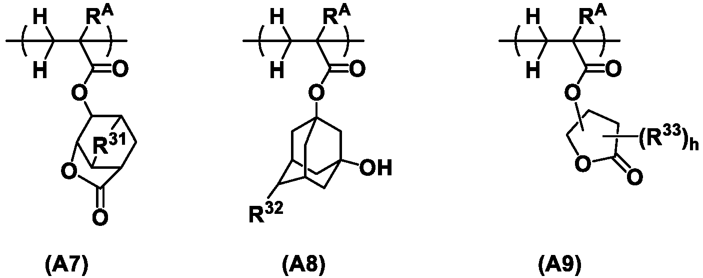

In formulae (A7) to (A9), R^{A} is each independently a hydrogen atom, fluorine atom, methyl group, or trifluoromethyl group. R³¹ is -O- or methylene. R³² is a hydrogen atom or hydroxy group. R³³ is a C₁-C₄ saturated hydrocarbyl group. The subscript h is an integer of 0 to 3.

When the repeat units A7 to A9 are included, their content is preferably 0 to 20 mol%, more preferably 0 to 10 mol% based on the overall repeat units of the polymer. Each of the repeat units B14 to B16 may be of one type or a combination of plural types.

The polymer can be synthesized by copolymerizing monomers protected with a protective group if necessary, by a known method, and then carrying out a deprotection reaction if necessary. The copolymerization reaction is not limited, and is preferably radical polymerization, or anionic polymerization. For these methods, reference may be made to JP-A 2004-115630.

The polymer should preferably have a weight average molecular weight (Mw) of 1,000 to 50,000, and more preferably 2,000 to 20,000. A Mw of at least 1,000 eliminates the risk that pattern features are rounded at their top to invite degradations of resolution and LER. A Mw of up to 50,000 eliminates the risk that LER is degraded when a pattern with a line width of up to 100 nm is formed. As used herein, Mw is measured by gel permeation chromatography (GPC) versus polystyrene standards using THF or DMF solvent.

The polymer preferably has a narrow molecular weight distribution or dispersity (Mw/Mn) of 1.0 to 2.0, more preferably 1.0 to 1.9, even more preferably 1.0 to 1.8. A polymer with such a narrow dispersity eliminates the risk that foreign matter are left on the pattern after development and the pattern profile is aggravated.

The base polymer is designed such that the dissolution rate in alkaline developer is preferably up to 10 nm/min, more preferably up to 7 nm/min, even more preferably up to 5 nm/min. In the lithography of advanced generation wherein the coating film on the substrate is in a thin film range of up to 100 nm, the influence of pattern film thickness loss during alkaline development becomes strong. When the polymer has an alkaline dissolution rate in excess of 10 nm/min, pattern collapse occurs, meaning a failure to form small-size patterns. The problem becomes outstanding in the fabrication of photomasks requiring to be defectless and having a tendency of strong development process. It is noted that the dissolution rate of a base polymer in alkaline developer is computed by spin coating a 16.7 wt% solution of a polymer in propylene glycol monomethyl ether acetate (PGMEA) solvent onto an 8-inch silicon wafer, baking at 100°C for 90 seconds to form a film of 1,000 nm thick, developing the film in a 2.38 wt% aqueous solution of tetramethylammonium hydroxide (TMAH) at 23°C for 100 seconds, and measuring a loss of film thickness.

The base polymer as component (A) may comprise additional polymers as well as the polymers described above. As the additional polymers, polymers that have been heretofore known as base polymers for resist compositions can be used. The content of the other polymer is not limited as long as the effect of the present invention is not impaired.

### (B) Quencher

The inventive chemically amplified positive resist composition may comprise (B) a quencher if necessary. As used herein, the "quencher" refers to a compound capable of trapping an acid generated from an acid generator. This enables reduction of the diffusion rate at which the acid generated from the acid generator diffuses into the resist film, so that even when a substrate whose outermost surface is made from a material containing chromium is used, the material containing chromium is hardly influenced by the acid generated in the resist film.

The quencher is typically selected from conventional basic compounds. Examples of the conventional basic compounds include primary, secondary, and tertiary aliphatic amines, mixed amines, aromatic amines, heterocyclic amines, nitrogen-containing compounds having a carboxy group, nitrogen-containing compounds having a sulfonyl group, nitrogen-containing compounds having a hydroxy group, nitrogen-containing compounds having a hydroxyphenyl group, alcoholic nitrogen-containing compounds, amide derivatives, imide derivatives, and carbamate derivatives. In particular, primary, secondary, and tertiary amine compounds described in paragraphs [0146] to [0164] of JP-A 2008-111103, particularly amine compounds having a hydroxy group, an ether bond, an ester bond, a lactone ring, a cyano group, or a sulfonic acid ester bond, and compounds having a carbamate group described in JP 3790649 are preferred. Inter alia, tris[2-(methoxymethoxy)ethyl]amine, tris[2-(methoxymethoxy)ethyl]amine-N-oxide, dibutylaminobenzoic acid, morpholine derivatives, and imidazole derivatives are preferred. Addition of a basic compound may be effective for further suppressing the diffusion rate of acid in the resist film or correcting the pattern profile.

Onium salts such as sulfonium, iodonium and ammonium salts of carboxylic acids which are not fluorinated at α-position as described in USP 8,795,942 (JP-A 2008-158339) may also be used as the quencher. While an α-fluorinated sulfonic acid, imide acid, and methide acid are necessary to deprotect the acid labile group, an α-non-fluorinated carboxylic acid is released by salt exchange with an α-non-fluorinated onium salt. An α-non-fluorinated carboxylic acid functions as a quencher because it does not induce substantial deprotection reaction.

Examples of the onium salt of α-non-fluorinated carboxylic acid include compounds having the formula (B1).

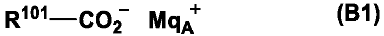

In formula (B1), R¹⁰¹ is hydrogen or a C₁-C₄₀ hydrocarbyl group which may contain a heteroatom, exclusive of the hydrocarbyl group in which the hydrogen bonded to the carbon atom at α-position of the carboxy group is substituted by fluorine or fluoroalkyl moiety.

The hydrocarbyl group represented by R¹⁰¹ may be saturated or unsaturated, and may be straight, branched, or cyclic. Examples thereof include C₁-C₄₀ alkyl groups such as methyl, ethyl, n-propyl, isopropyl, n-butyl, sec-butyl, tert-butyl, n-pentyl, tert-pentyl, n-hexyl, n-octyl, 2-ethylhexyl, n-nonyl, n-decyl; C₃-C₄₀ cyclic saturated hydrocarbyl groups such as cyclopentyl, cyclohexyl, cyclopentylmethyl, cyclopentylethyl, cyclopentylbutyl, cyclohexylmethyl, cyclohexylethyl, cyclohexylbutyl, norbornyl, tricyclo[5.2.1.0^{2,6}]decyl, adamantyl, and adamantylmethyl; C₂-C₄₀ alkenyl groups such as vinyl, allyl, propenyl, butenyl and hexenyl; C₃-C₄₀ cyclic unsaturated aliphatic hydrocarbyl groups such as cyclohexenyl; C₆-C₄₀ aryl groups such as phenyl, naphthyl, alkylphenyl groups (e.g., 2-methylphenyl, 3-methylphenyl, 4-methylphenyl, 4-ethylphenyl, 4-tert-butylphenyl, 4-n-butylphenyl), di- or tri-alkylphenyl groups (e.g., 2,4-dimethylphenyl and 2,4,6-triisopropylphenyl), alkylnaphthyl groups (e.g., methylnaphthyl and ethylnaphthyl), dialkylnaphthyl groups (e.g., dimethylnaphthyl and diethylnaphthyl); and C₇-C₄₀ aralkyl groups such as benzyl, 1-phenylethyl and 2-phenylethyl.

In the hydrocarbyl group, some or all of the hydrogen atoms may be substituted by a moiety containing a heteroatom such as oxygen, sulfur, nitrogen or halogen, and some constituent -CH₂- may be replaced by a moiety containing a heteroatom such as oxygen, sulfur or nitrogen, so that the group may contain a hydroxy moiety, cyano moiety, carbonyl moiety, ether bond, thioether bond, ester bond, sulfonic ester bond, carbonate bond, lactone ring, sultone ring, carboxylic anhydride (-C(=O)-O-C(=O)-), or haloalkyl moiety. Examples of heteroatom-containing hydrocarbyl groups include heteroaryl groups such as thienyl, 4-hydroxyphenyl, alkoxyphenyl groups such as 4-methoxyphenyl, 3-methoxyphenyl, 2-methoxyphenyl, 4-ethoxyphenyl, 4-tert-butoxyphenyl, 3-tert-butoxyphenyl; alkoxynaphthyl groups such as methoxynaphthyl, ethoxynaphthyl, n-propoxynaphthyl and n-butoxynaphthyl; dialkoxynaphthyl groups such as dimethoxynaphthyl and diethoxynaphthyl; and aryloxoalkyl groups, typically 2-aryl-2-oxoethyl groups such as 2-phenyl-2-oxoethyl, 2-(1-naphthyl)-2-oxoethyl and 2-(2-naphthyl)-2-oxoethyl.

In formula (B1), Mq_{A}⁺ is an onium cation. The onium cation is preferably a sulfonium, iodonium or ammonium cation, with the sulfonium cation or iodonium cation being more preferred. Examples of the sulfonium cation are as exemplified for the sulfonium cation represented by formula (cation-1). Examples of the iodonium cation are as exemplified for the iodonium cation represented by formula (cation-2).

Examples of the anion in the onium salt having formula (B1) are shown below, but not limited thereto.

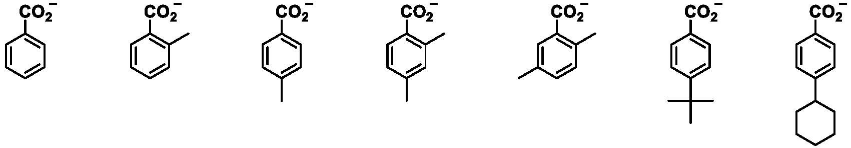

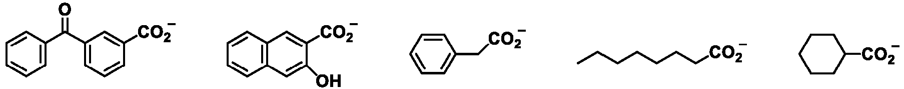

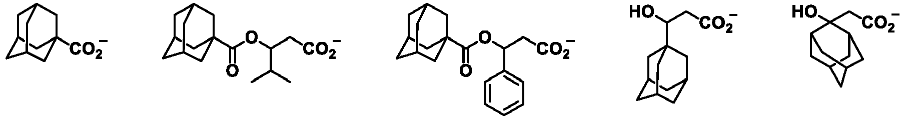

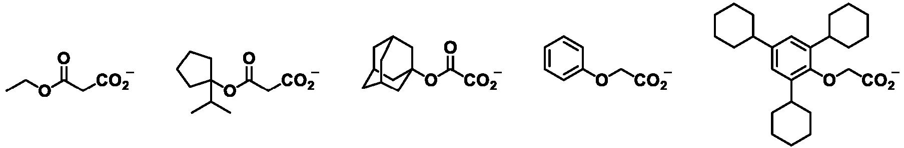

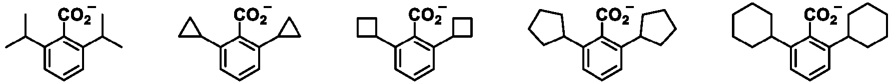

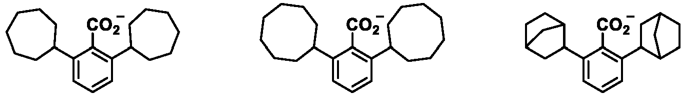

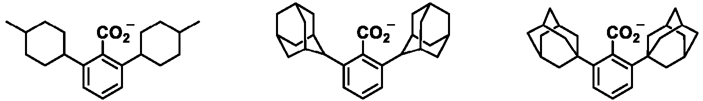

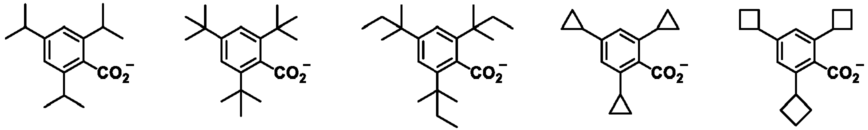

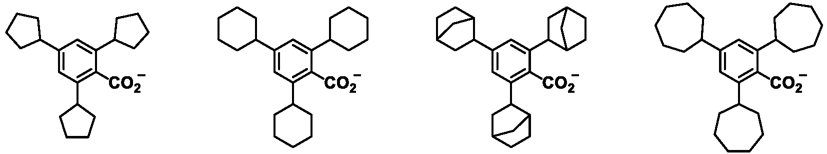

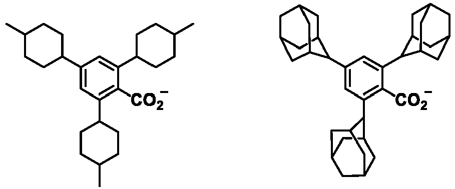

A sulfonium salt of iodized benzene ring-containing carboxylic acid having the formula (B2) is also useful as the quencher.

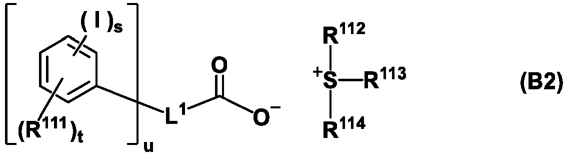

In formula (B2), s is an integer of 1 to 5. The subscript t is an integer of 0 to 3. The sum of s + t is 1 or more and 5 or less. The subscript u is an integer of 1 to 3.

In formula (B2), R¹¹¹ is hydroxy, fluorine, chlorine, bromine, amino, nitro, cyano, or a C₁-C₆ saturated hydrocarbyl, C₁-C₆ saturated hydrocarbyloxy, C₂-C₆ saturated hydrocarbylcarbonyloxy, or C₁-C₄ saturated hydrocarbylsulfonyloxy group, in which some or all hydrogen atoms may be substituted by halogen atom, or -N(R^{111A})-C(=O)-R^{111B}, or -N(R^{111A})-C(=O)-O-R^{111B}. R^{111A} is a hydrogen atom or a C₁-C₆ saturated hydrocarbyl group. R^{111B} is a C₁-C₆ saturated hydrocarbyl group, or a C₂-C₈ unsaturated hydrocarbyl group. Groups R¹¹¹ may be the same or different when t and/or u is 2 or more.

In formula (B2), L¹ is a single bond, or a C₁-C₂₀ (u+1)-valent linking group which may contain at least one moiety selected from an ether bond, a carbonyl group, an ester bond, an amide bond, a sultone ring, a lactam ring, a carbonate bond, a halogen atom, a hydroxy group and a carboxy group. The saturated hydrocarbyl, saturated hydrocarbyloxy, saturated hydrocarbylcarbonyloxy and saturated hydrocarbylsulfonyloxy groups may be straight, branched or cyclic.

In formula (B2), R¹¹², R¹¹³ and R¹¹⁴ are each independently halogen atom or a C₁-C₂₀ hydrocarbyl group which may contain a heteroatom. The hydrocarbyl group may be saturated or unsaturated, and may be straight, branched, or cyclic. Examples thereof include C₁-C₂₀ alkyl, C₂-C₂₀ alkenyl, C₆-C₂₀ aryl and C₇-C₂₀ aralkyl groups. Some or all of hydrogen atoms of the hydrocarbyl group may be replaced by a hydroxy group, a carboxy group, a halogen atom, an oxo group, a cyano group, a nitro group, a sultone ring, a sulfo group or a sulfonium salt-containing group, and some constituent -CH₂- of the hydrocarbyl group may be replaced by an ether bond, an ester bond, a carbonyl group, an amide bond, a carbonate bond, or a sulfonic ester bond. R¹¹² and R¹¹³ may bond together to form a ring with a sulfur atom to which they are attached.

Examples of the compound having formula (B2) include those described in USP 10,295,904 (JP-A 2017-219836). The compounds (B2) exert a sensitizing effect due to remarkable absorption and an acid diffusion-controlling effect.

A nitrogen-containing carboxylic acid salt compound having the formula (B3) is also useful as the quencher.

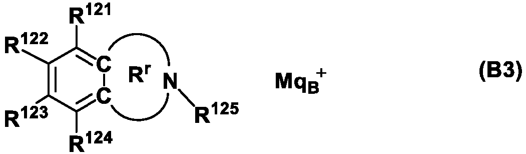

In formula (B3), R¹²¹ to R¹²⁴ are each independently a hydrogen atom, -L²-CO₂⁻, or a C₁-C₂₀ hydrocarbyl group which may contain a heteroatom. R¹²¹ and R¹²², R¹²² and R¹²³, or R¹²³ and R¹²⁴ may bond together to form a ring with the carbon atom to which they are attached. L² is a single bond or C₁-C₂₀ hydrocarbylene group which may contain a heteroatom. R¹²⁵ is a hydrogen atom or C₁-C₂₀ hydrocarbyl group which may contain a heteroatom.

In formula (B3), the ring R^{r} is a C₂-C₆ ring containing the carbon and nitrogen atoms in the formula, in which some or all of the carbon-bonded hydrogen atoms may be substituted by a C₁-C₂₀ hydrocarbyl group or -L²-CO₂- and in which some carbon may be replaced by sulfur, oxygen or nitrogen. The ring may be alicyclic or aromatic and is preferably a 5- or 6-membered ring. Suitable rings include pyridine, pyrrole, pyrrolidine, piperidine, pyrazole, imidazoline, pyridazine, pyrimidine, pyrazine, imidazoline, oxazole, thiazole, morpholine, thiazine, and triazole rings.

The carboxylic onium salt having formula (B3) has at least one -L²-CO₂⁻ group. That is, at least one of R¹²¹ to R¹²⁴ is -L²-CO₂⁻, and/or at least one of hydrogen atoms bonded to carbon atoms in the ring R is substituted by -L²-CO₂⁻.

In formula (B3), Mq_{B}⁺ is a sulfonium, iodonium or ammonium cation, with the sulfonium cation being preferred. Examples of the sulfonium cation are as exemplified for the sulfonium cation represented by formula (cation-1).

Examples of the anion in the compound having formula (B3) are shown below, but not limited thereto.

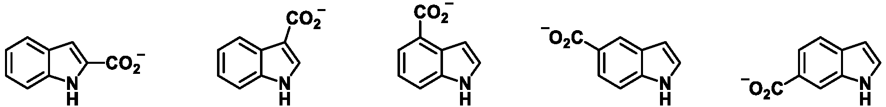

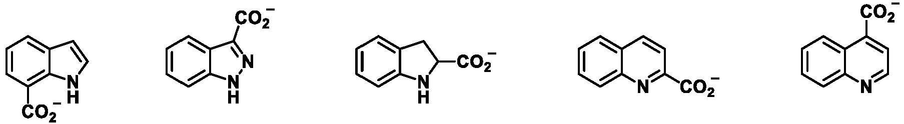

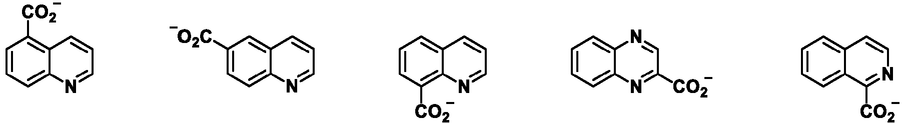

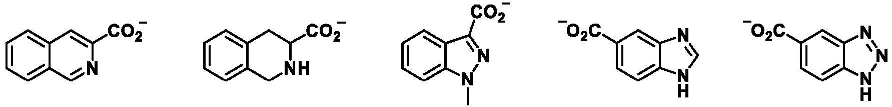

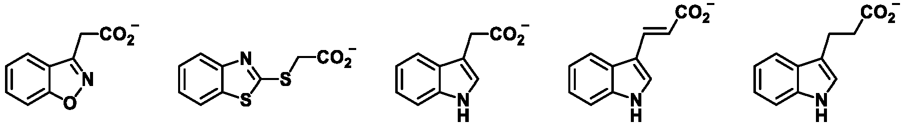

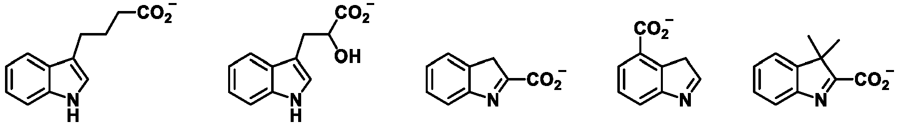

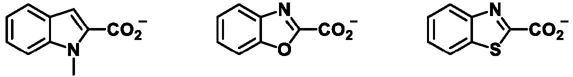

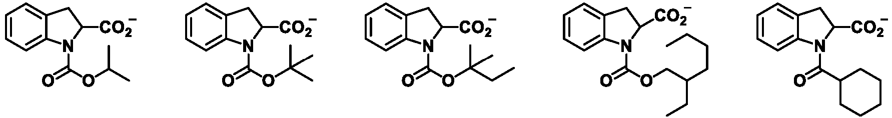

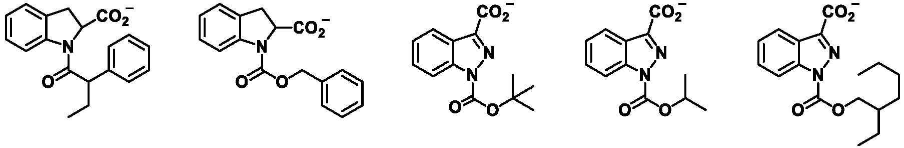

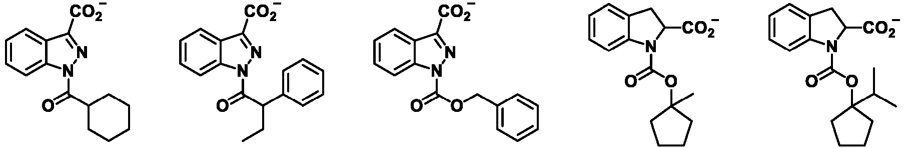

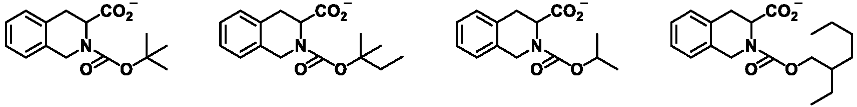

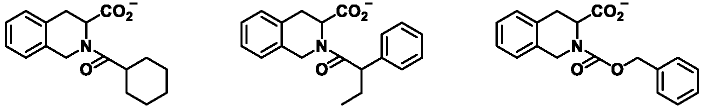

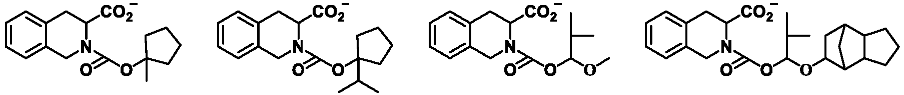

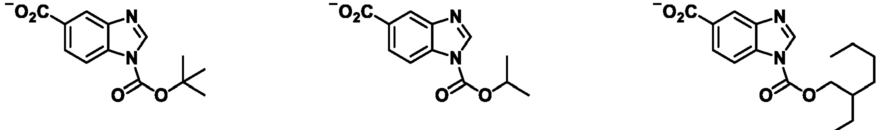

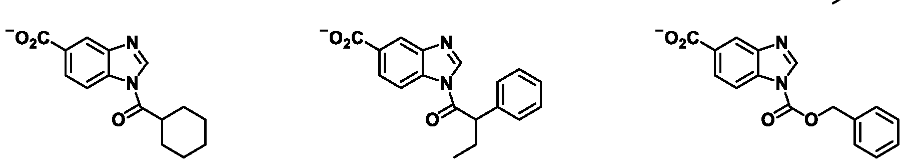

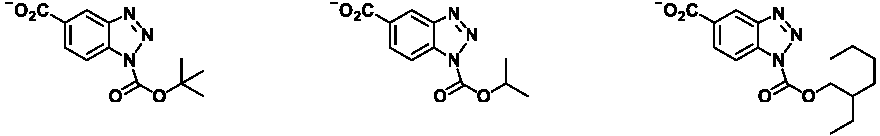

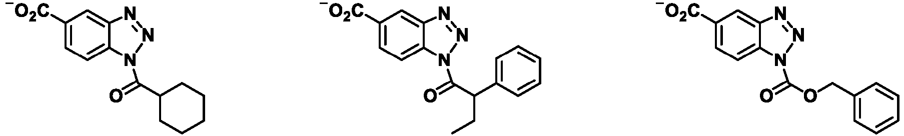

Weak acid betaine compounds are also useful as the quencher. Examples of the hydrocarbylene group are shown below, but not limited thereto.

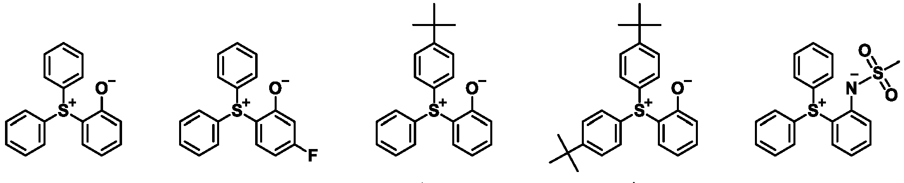

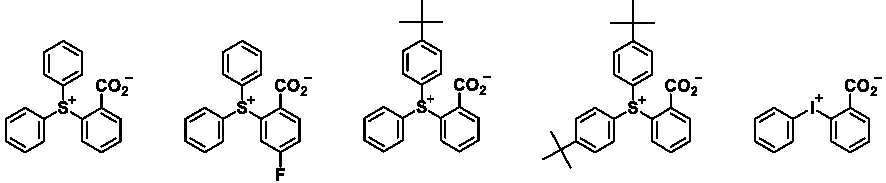

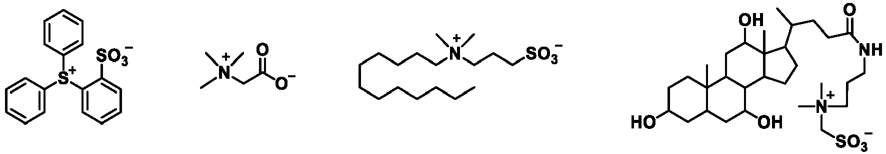

Also useful are quenchers of polymer type as described in USP 7,598,016 (JP-A 2008-239918). The polymeric quencher segregates at the resist surface after coating and thus enhances the rectangularity of resist pattern. When a protective film is applied as is often the case in the immersion lithography, the polymeric quencher is also effective for preventing a film thickness loss of resist pattern or rounding of pattern top.

When the inventive chemically amplified positive resist composition comprises the quencher, the content of the quencher is preferably 0 to 50 parts by weight, more preferably 0.1 to 40 parts by weight per 80 parts by weight of the base polymer. The quencher may be used alone or in admixture.

### (C) Organic solvent

The inventive resist composition may comprise (C) an organic solvent. The organic solvent is not particularly limited as long as the components are soluble therein. Examples of the organic solvent are described in JP-A 2008-111103, paragraphs [0144]-[0145] (USP 7,537,880). Exemplary solvents include ketones such as cyclohexanone, cyclopentanone, methyl-2-n-pentyl ketone and 2-heptanone; alcohols such as 3-methoxybutanol, 3-methyl-3-methoxybutanol, 1-methoxy-2-propanol, 1-ethoxy-2-propanol and diacetone alcohol (DAA); ethers such as propylene glycol monomethyl ether (PGME), ethylene glycol monomethyl ether, propylene glycol monoethyl ether, ethylene glycol monoethyl ether, propylene glycol dimethyl ether, and diethylene glycol dimethyl ether; esters such as PGMEA, propylene glycol monoethyl ether acetate, ethyl lactate (EL), ethyl pyruvate, butyl acetate, methyl 3-methoxypropionate, ethyl 3-ethoxypropionate, tert-butyl acetate, tert-butyl propionate and propylene glycol mono-tert-butyl ether acetate; and lactones such as γ-butyrolactone; and mixtures thereof. When a polymer containing an acid labile group of acetal form is used, a high-boiling alcohol solvent may be added for accelerating the deprotection reaction of acetal, for example, diethylene glycol, propylene glycol, glycerol, 1,4-butanediol or 1,3-butanediol.

Of the foregoing organic solvents, 1-ethoxy-2-propanol, PGMEA, PGME, cyclohexanone, EL, γ-butyrolactone and mixtures thereof are preferred.

When the inventive chemically amplified positive resist composition comprises the organic solvent (C), the content of the organic solvent (C) is preferably 200 to 10,000 parts by weight, more preferably 400 to 5,000 parts by weight per 80 parts by weight of the base polymer (B). The organic solvent (C) may be used alone or in admixture.

### (D) Fluorinated polymer

The chemically amplified positive resist composition may further comprise a fluorinated polymer for the purposes of enhancing contrast, preventing chemical flare of acid upon exposure to high-energy radiation, preventing mixing of acid from an anti-charging film in the step of coating an anti-charging film-forming material on a resist film, and suppressing unexpected unnecessary pattern degradation. The fluorinated polymer contains repeat units of at least one type selected from repeat units having the formula (D1), repeat units having the formula (D2), repeat units having the formula (D3), and repeat units having the formula (D4), as components (D). It is noted that repeat units having formulae (D1), (D2), (D3), and (D4) are also referred to as repeat units D1, D2, D3, and D4, respectively, hereinafter. Since the fluorinated polymer also has a surface active function, it can prevent insoluble residues from re-depositing onto the substrate during the development step and is thus effective for preventing development defects.

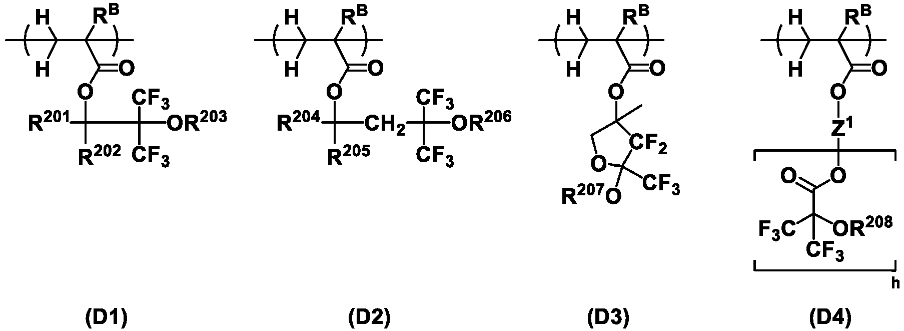

In formulae (D1) to (D4), h is an integer of 1 to 3. R^{B} is each independently a hydrogen atom, fluorine atom, methyl group, or trifluoromethyl group. R²⁰¹, R²⁰², R²⁰⁴ and R²⁰⁵ are each independently a hydrogen atom or C₁-C₁₀ saturated hydrocarbyl group. R²⁰³, R²⁰⁶, R²⁰⁷ and R²⁰⁸ are each independently a hydrogen atom, C₁-C₁₅ hydrocarbyl group, C₁-C₁₅ fluorinated hydrocarbyl group or acid labile group, and an ether bond or carbonyl group may intervene in a carbon-carbon bond when each of R²⁰³, R²⁰⁶, R²⁰⁷ and R²⁰⁸ is a hydrocarbyl group or fluorinated hydrocarbyl group. Z¹ is a C₁-C₂₀ (h+1)-valent hydrocarbon group or C₁-C₂₀ (h+1)-valent fluorinated hydrocarbon group. The asterisk (*) designates a point of attachment to the carbon atom in the backbone.

The C₁-C₁₀ saturated hydrocarbyl groups represented by R²⁰¹, R²⁰², R²⁰⁴ and R²⁰⁵ may be straight, branched or cyclic. Examples thereof include C₁-C₁₀ alkyl groups such as methyl, ethyl, n-propyl, isopropyl, n-butyl, isobutyl, sec-butyl, tert-butyl, n-pentyl, n-hexyl, n-heptyl, n-octyl, n-nonyl and n-decyl, and C₃-C₁₀ cyclic saturated hydrocarbyl groups such as cyclopropyl, cyclobutyl, cyclopentyl, cyclohexyl, adamantyl and norbornyl. Of these, C₁-C₆ saturated hydrocarbyl groups are preferred.

The C₁-C₁₅ saturated hydrocarbyl groups represented by R²⁰³, R²⁰⁶, R²⁰⁷ and R²⁰⁸ may be straight, branched or cyclic. Examples thereof include C₁-C₁₅ alkyl, C₂-C₁₅ alkenyl and C₂-C₁₅ alkynyl groups, with the C₁-C₁₅ alkyl groups being preferred. Suitable alkyl groups include methyl, ethyl, n-propyl, isopropyl, n-butyl, isobutyl, sec-butyl, n-pentyl, n-hexyl, n-heptyl, n-octyl, n-nonyl, n-decyl, n-undecyl, n-dodecyl, n-tridecyl, n-tetradecyl and n-pentadecyl groups. Examples of the fluorinated hydrocarbyl group include the foregoing hydrocarbyl groups in which some or all carbon-bonded hydrogen atoms are substituted by fluorine atoms.

Examples of the C₁-C₂₀ (h+1)-valent hydrocarbon group Z¹ include the foregoing C₁-C₂₀ alkyl groups and C₃-C₂₀ cyclic saturated hydrocarbyl groups, with k number of hydrogen atoms being eliminated. Examples of the C₁-C₂₀ (h+1)-valent fluorinated hydrocarbon group Z¹ include the foregoing (h+1)-valent hydrocarbon groups in which one or more hydrogen atoms are substituted by fluorine.

Examples of repeat units D1 to D4 are shown below, but not limited thereto. Herein R^{B} is as defined above.

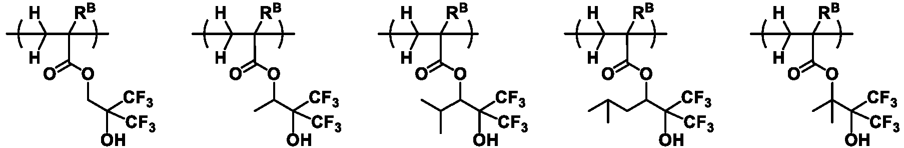

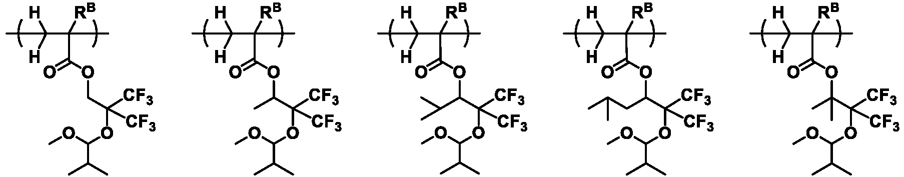

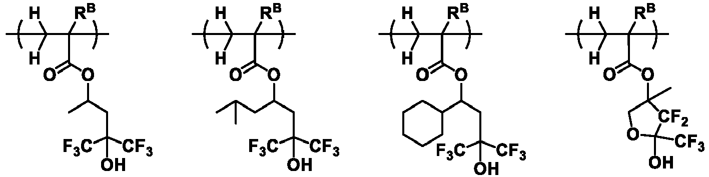

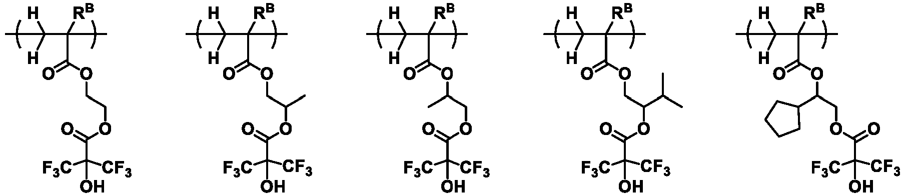

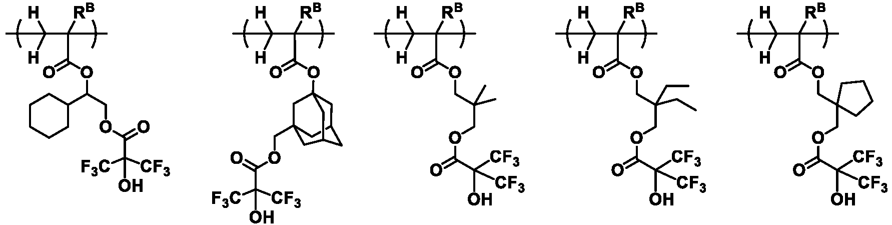

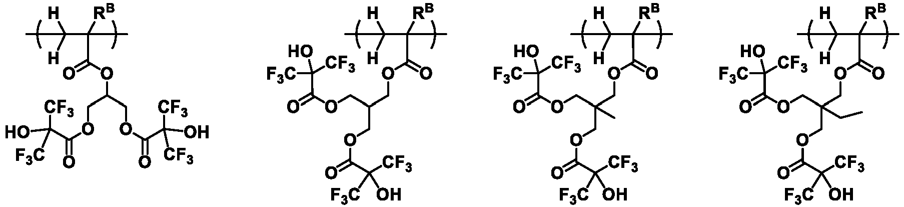

Preferably the fluorinated polymer further contains repeat units of at least one type selected from repeat units having the formula (D5) and repeat units having the formula (D6). It is noted that repeat units having formulae (D5) and (D6) are also referred to as repeat units D5 and D6, respectively, hereinafter.

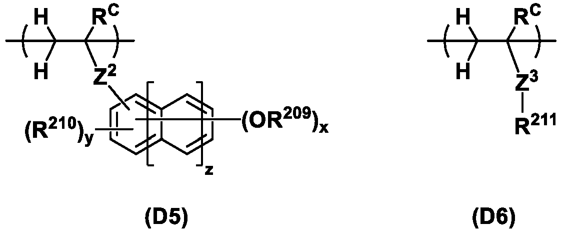

In formulae (D5) to (D6), x is an integer of 1 to 3. The subscript y is an integer which satisfies 0 ≤ y ≤ 5+2z-x. The subscript z is 0 or 1. R^{C} is each independently a hydrogen atom or methyl group. R²⁰⁹ is a hydrogen atom or straight or branched C₁-C₅ hydrocarbyl group in which a group containing a heteroatom may intervene in a carbon-carbon bond. R²¹⁰ is a straight or branched C₁-C₅ hydrocarbyl group in which a group containing a heteroatom may intervene in a carbon-carbon bond. R²¹¹ is a C₁-C₂₀ saturated hydrocarbyl group in which at least one hydrogen atom is substituted by a fluorine atom, and some constituent -CH₂- of the saturated hydrocarbyl group may be replaced by an ester bond or ether bond. Z² is a single bond, *-C(=O)-O- or *-C(=O)-NH-. Z³ is a single bond, -O-, *-C(=O)-O-Z³¹-Z³²- or *-C(=O)-NH-Z³¹-Z³²-. Z³¹ is a single bond or C₁-C₁₀ saturated hydrocarbylene group. Z³² is a single bond, ester bond, ether bond or sulfonamide bond. The asterisk (*) designates a point of attachment to the carbon atom in the backbone.

Examples of the C₁-C₅ hydrocarbyl groups R²⁰⁹ and R²¹⁰ include alkyl, alkenyl and alkynyl groups, with the alkyl groups being preferred. Examples of the alkyl group include methyl, ethyl, n-propyl, isopropyl, n-butyl, isobutyl, sec-butyl and n-pentyl groups. In the hydrocarbyl groups, a moiety containing a heteroatom such as oxygen, sulfur or nitrogen may intervene in a carbon-carbon bond.

Preferably, -OR²⁰⁹ in formula (D5) is a hydrophilic group. In this case, R²⁰⁹ is preferably hydrogen or a C₁-C₅ alkyl group in which oxygen intervenes in a carbon-carbon bond.

The C₁-C₂₀ saturated hydrocarbyl group R²¹¹ in which at least one hydrogen atom is substituted by a fluorine atom may be straight, branched or cyclic, and examples thereof include C₁-C₂₀ alkyl groups or C₃-C₂₀ cyclic saturated hydrocarbyl groups in which at least one hydrogen atom is substituted by a fluorine atom.

Z² is preferably *-C(=O)-O- or *-C(=O)-NH-. Also preferably R^{C} is methyl. The inclusion of carbonyl in Z² enhances the ability to trap the acid originating from the anti-charging film. A polymer wherein R^{C} is methyl is a robust polymer having a high glass transition temperature (Tg) which is effective for suppressing acid diffusion. As a result, the resist film is improved in stability with time, and neither resolution nor pattern profile is degraded.

The C₁-C₁₀ saturated hydrocarbylene group Z³ may be straight, branched or cyclic, and examples thereof include methanediyl, ethane-1,1-diyl, ethane-1,2-diyl, propane-1,1-diyl, propane-1,2-diyl, propane-1,3-diyl, propane-2,2-diyl, butane-1,1-diyl, butane-1,2-diyl, butane-1,3-diyl, butane-2,3-diyl, butane-1,4-diyl, and 1,1-dimethylethane-1,2-diyl groups.

Examples of the repeat unit D5 are shown below, but not limited thereto. Herein, R^{C} is as defined above.

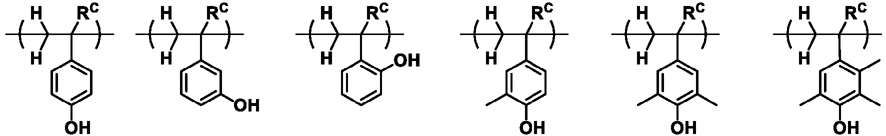

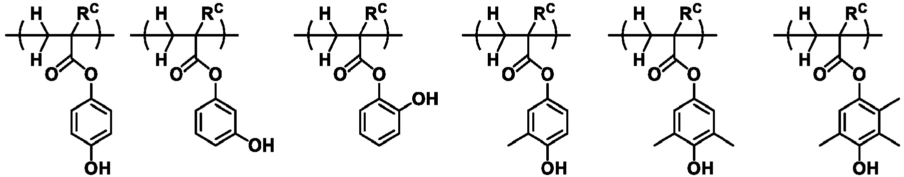

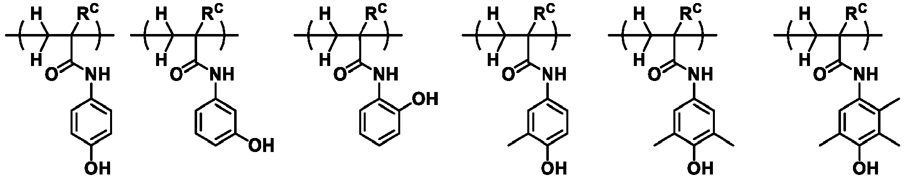

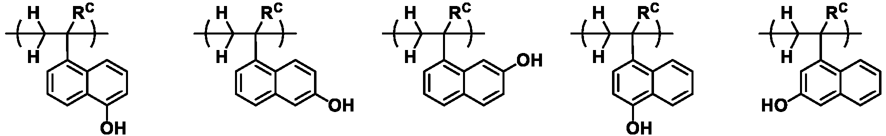

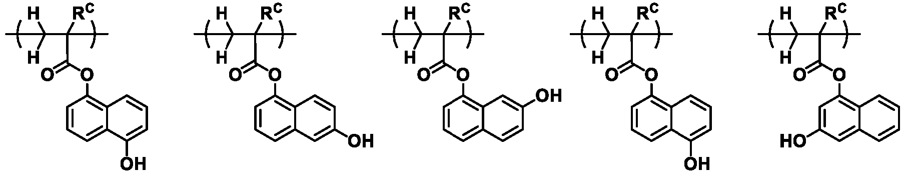

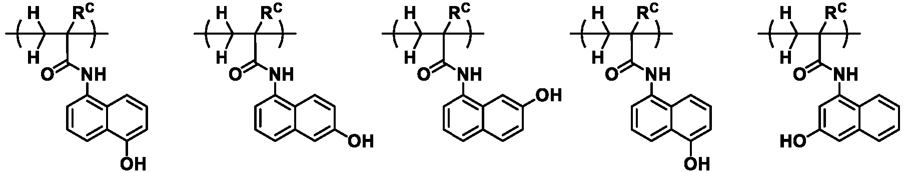

Examples of the repeat unit D6 are shown below, but not limited thereto. Herein, R^{C} is as defined above.

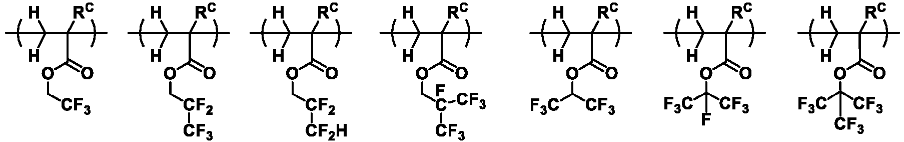

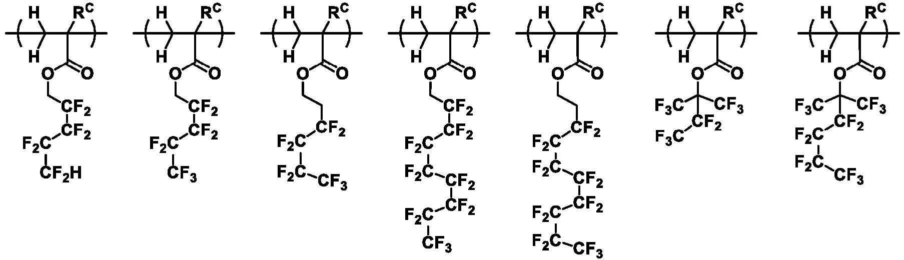

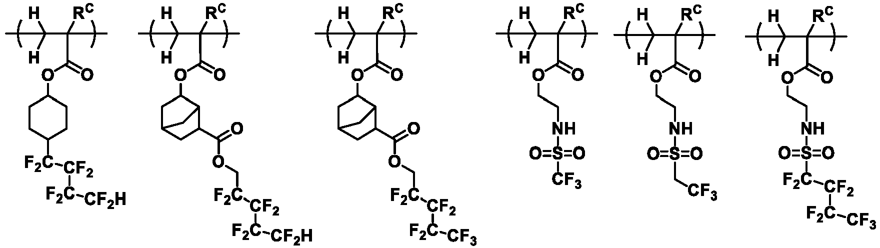

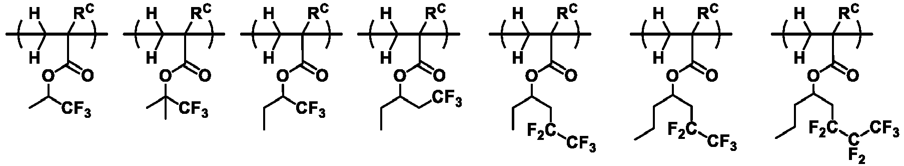

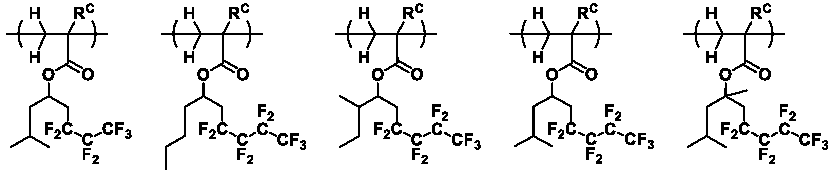

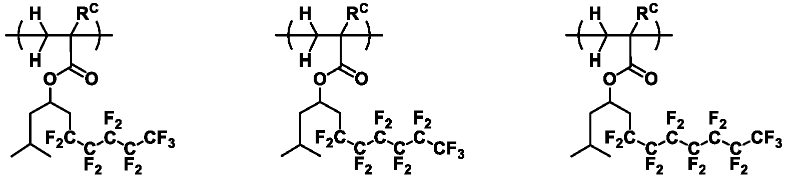

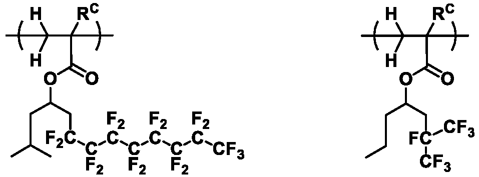

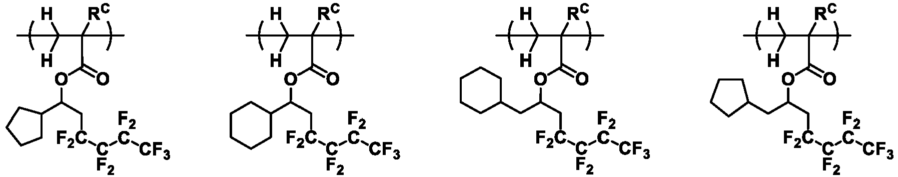

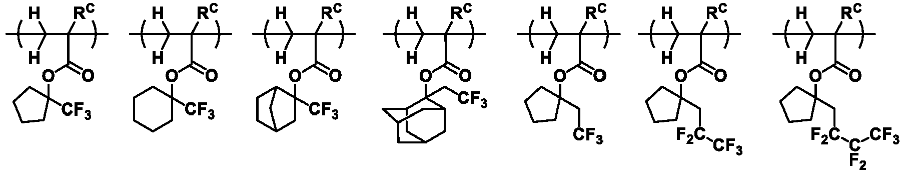

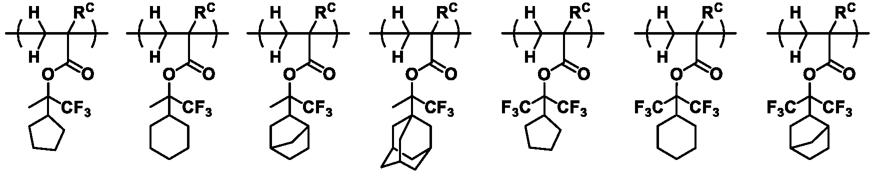

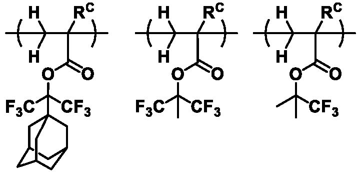

The repeat units D1 to D4 are preferably incorporated in an amount of 15 to 95 mol%, more preferably 20 to 85 mol% based on the overall repeat units of the fluorinated polymer. The repeat unit D5 and/or D6 is preferably incorporated in an amount of 5 to 85 mol%, more preferably 15 to 80 mol% based on the overall repeat units of the fluorinated polymer. Each of repeat units D1 to D6 may be used alone or in admixture.

The fluorinated polymer (D) may comprise additional repeat units as well as the repeat units D1 to D6. Suitable additional repeat units include those described in USP 9,091,918 (JP-A 2014-177407, paragraphs[0046]-[0078]). When the fluorinated polymer (D) comprises additional repeat units, their content is preferably up to 50 mol% based on the overall repeat units of the fluorinated polymer.

The fluorinated polymer (D) may be synthesized by combining suitable monomers optionally protected with a protective group, copolymerizing them in the standard way, and effecting deprotection reaction if necessary. The copolymerization reaction is not limited, and is preferably radical polymerization, or anionic polymerization. For these methods, reference may be made to JP-A 2004-115630.

The fluorinated polymer (D) should preferably have a Mw of 2,000 to 50,000, and more preferably 3,000 to 20,000. A fluorinated polymer with a Mw of at least 2,000 prevents extra acid diffusion and degradations of resolution and age stability. A polymer with a Mw of up to 50,000 has a sufficient solubility in solvent and leaves no coating defects. The fluorinated polymer (D) preferably has a dispersity (Mw/Mn) of 1.0 to 2.2, more preferably 1.0 to 1.7.

When the inventive chemically amplified positive resist composition comprises fluorinated polymer (D), the content of the fluorinated polymer (D) is preferably 0.01 to 30 parts by weight, more preferably 0.1 to 20 parts by weight per 80 parts by weight of the base polymer (A). The fluorinated polymer (D) may be used alone or in admixture.

### (E) Photoacid generator

The inventive chemically amplified positive resist composition may further comprise (E) a photoacid generator (PAG). The PAG used herein may be any compound capable of generating an acid upon exposure to high-energy radiation Suitable PAGs include sulfonium salts, iodonium salts, sulfonyldiazomethane, N-sulfonyloxyimide, and oxime-O-sulfonate acid generators.

Suitable PAGs include nonafluorobutane sulfonate, partially fluorinated sulfonates described in JP-A 2012-189977, paragraphs [0247]-[0251], partially fluorinated sulfonates described in JP-A 2013-101271, paragraphs [0261]-[0265], and those described in JP-A 2008-111103, paragraphs[0122]-[0142] and JP-A 2010-215608, paragraphs [0080]-[0081]. Among others, arenesulfonate and alkanesulfonate type PAGs are preferred because they generate acids having an appropriate strength to deprotect the acid labile group in repeat unit A3.

The preferred PAGs are salt compounds having a sulfonium anion of the structure shown below.

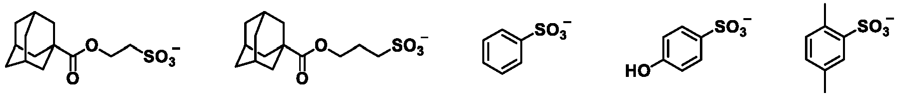

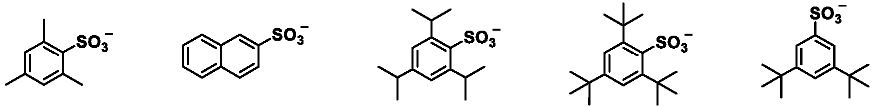

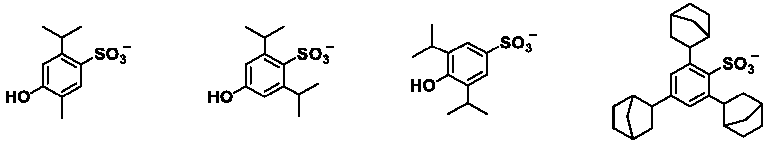

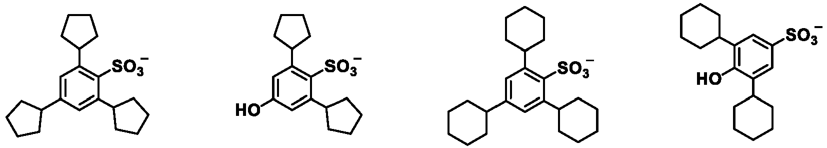

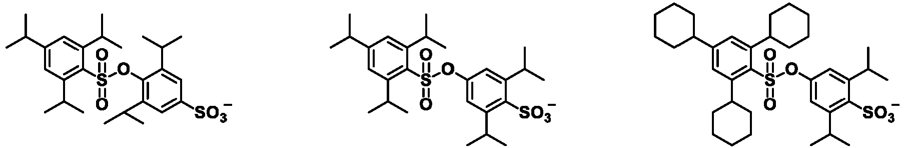

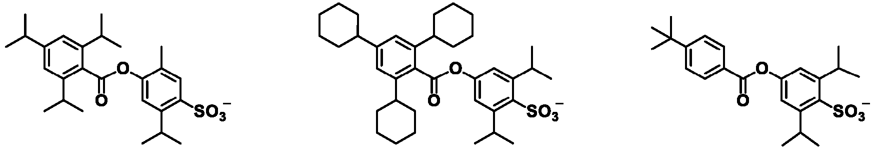

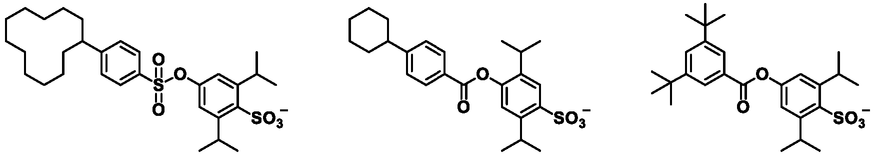

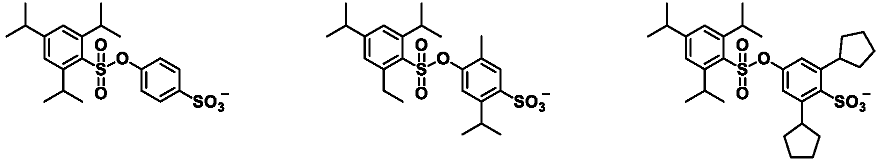

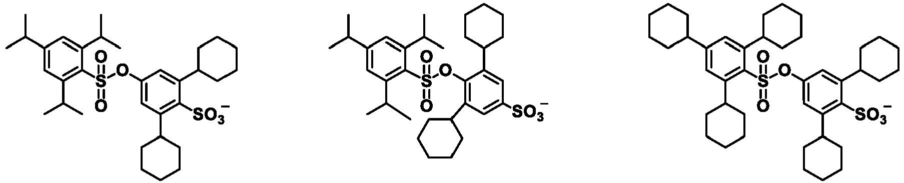

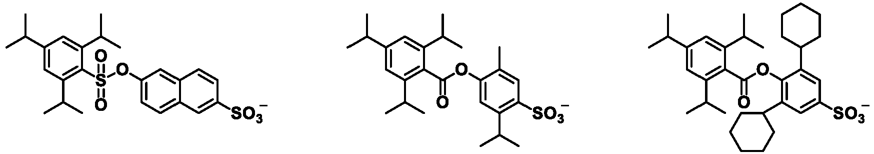

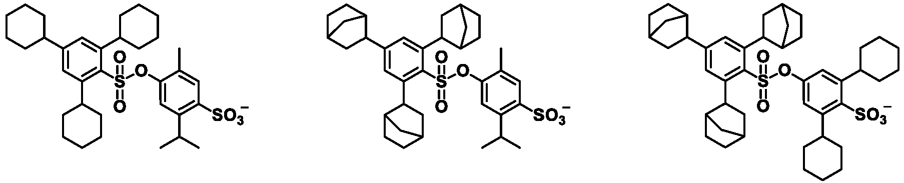

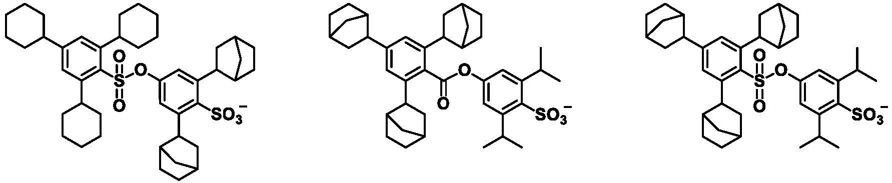

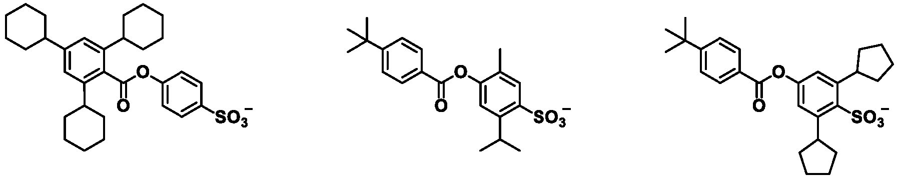

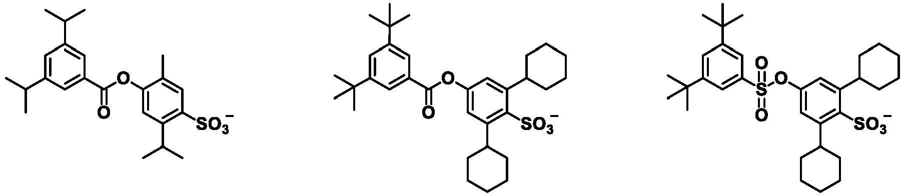

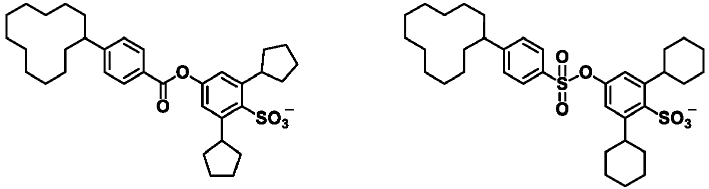

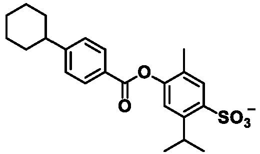

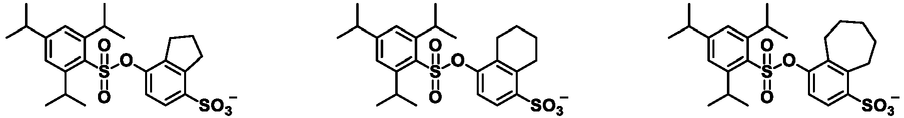

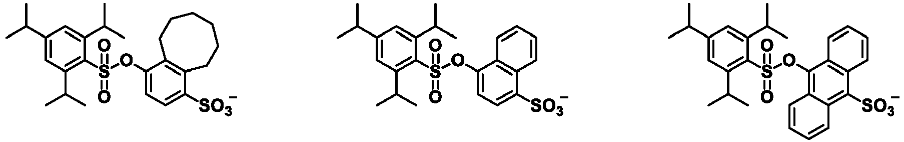

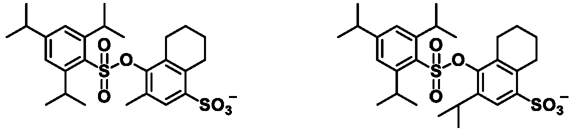

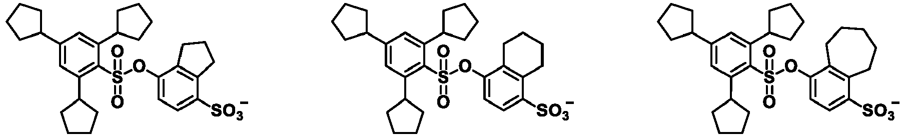

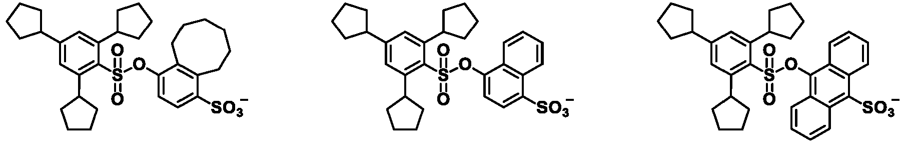

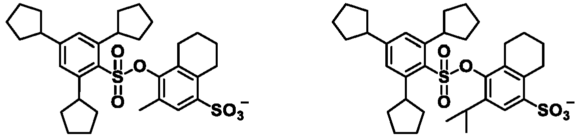

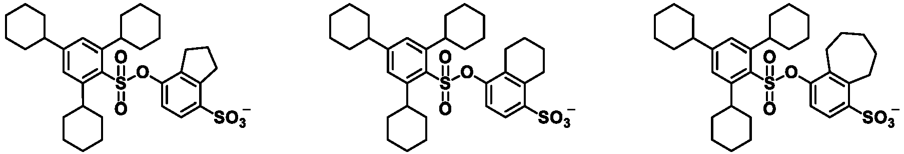

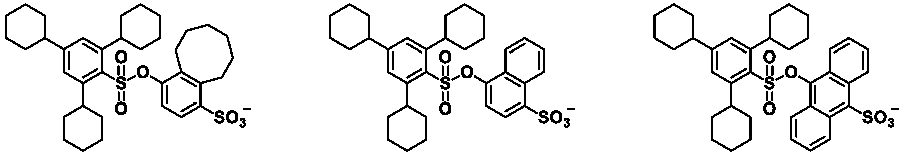

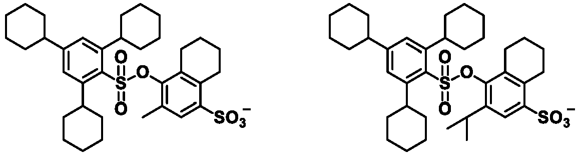

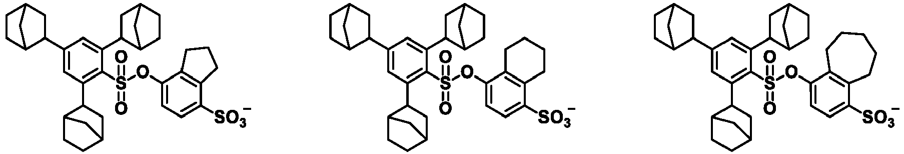

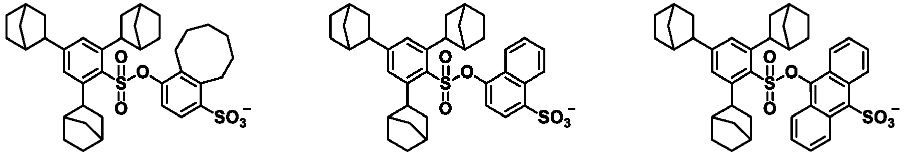

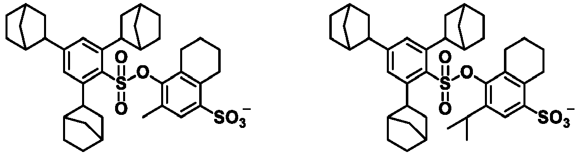

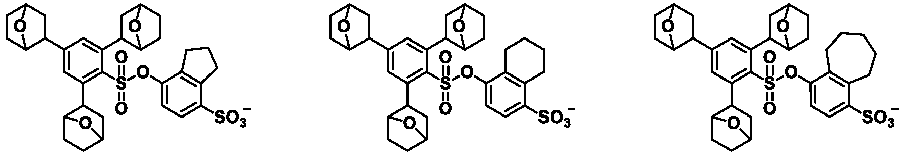

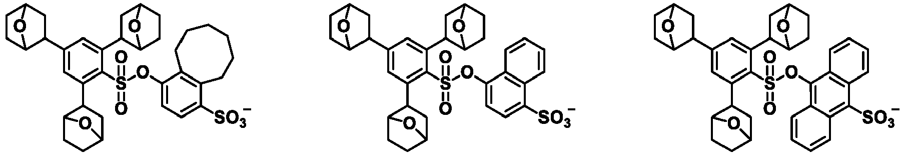

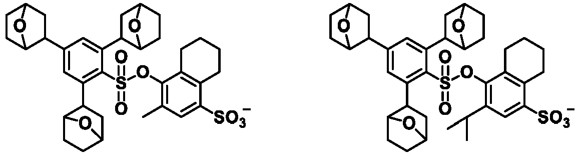

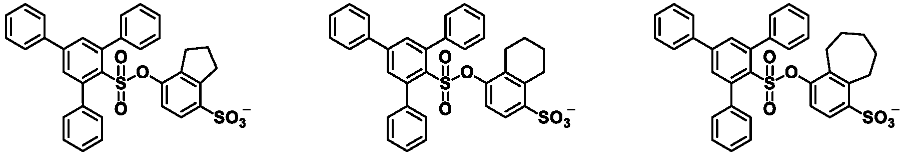

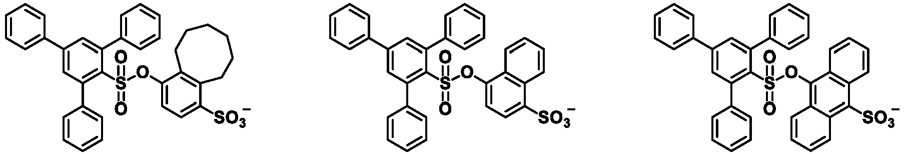

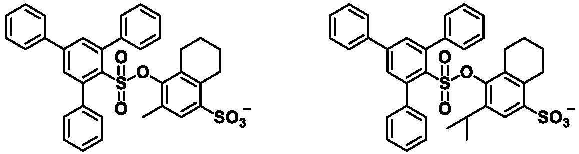

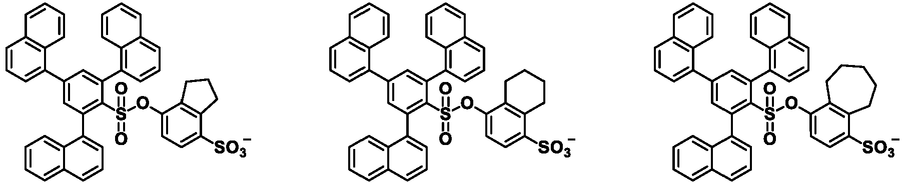

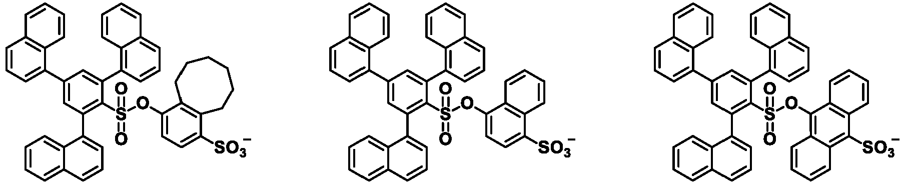

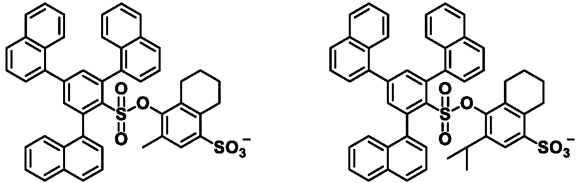

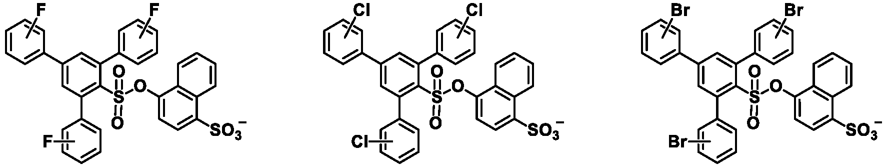

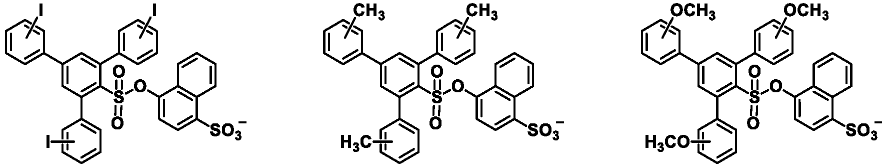

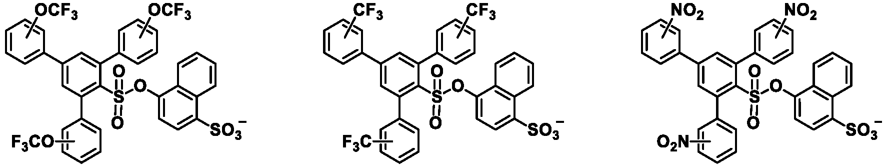

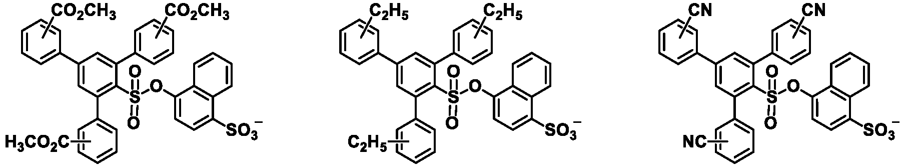

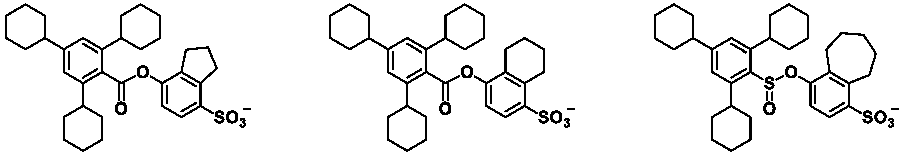

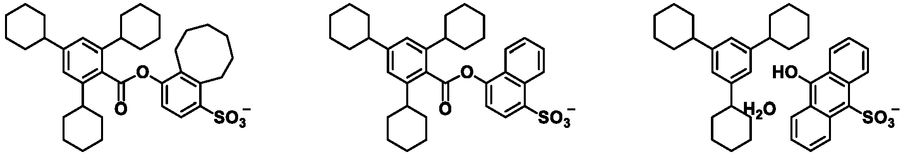

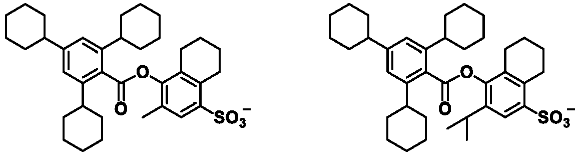

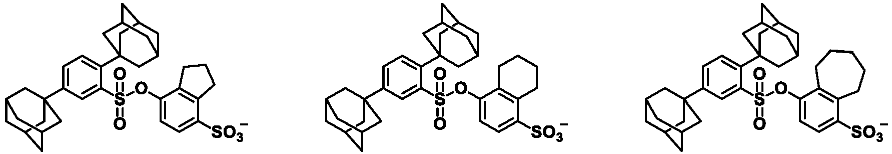

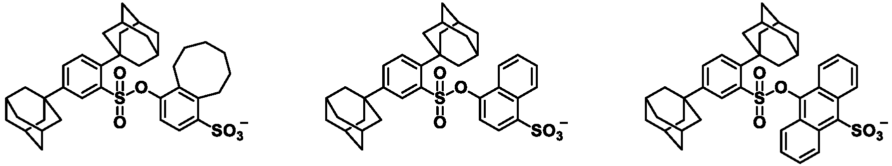

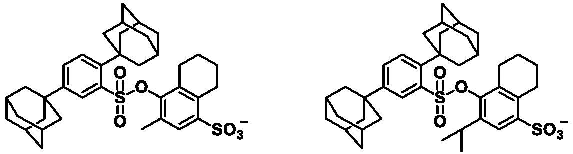

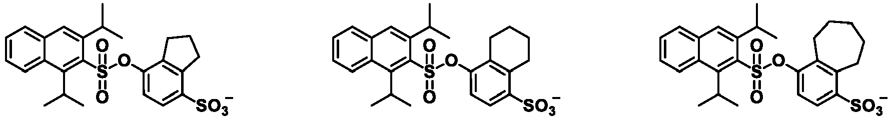

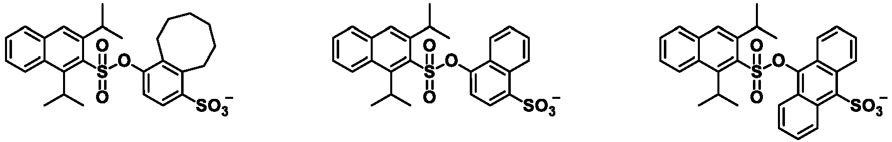

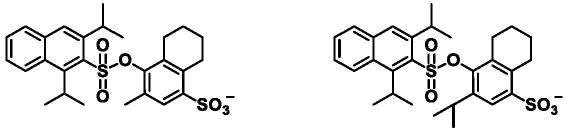

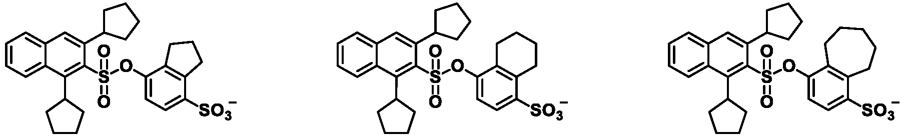

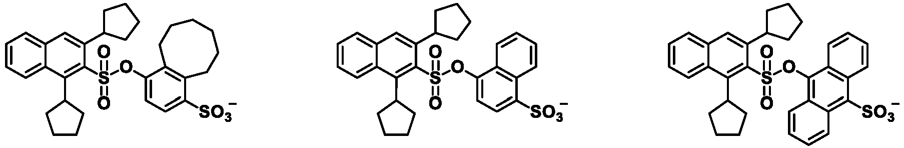

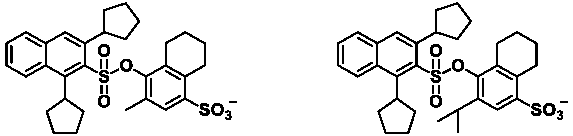

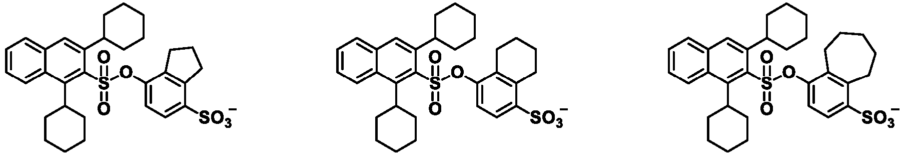

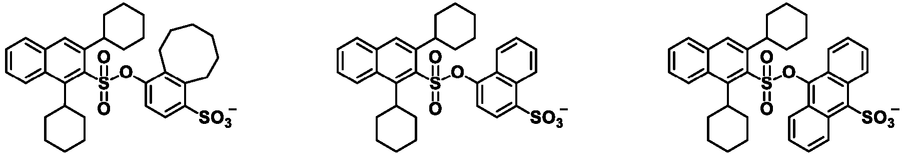

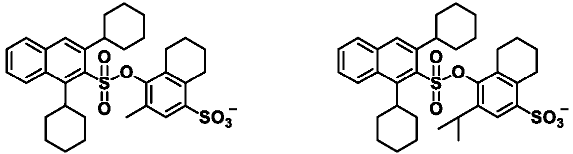

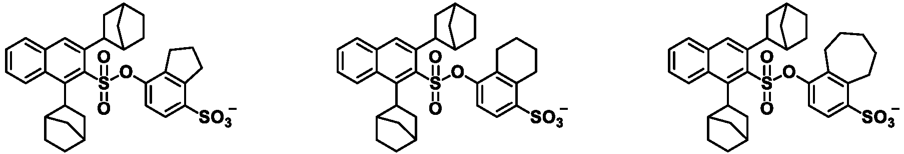

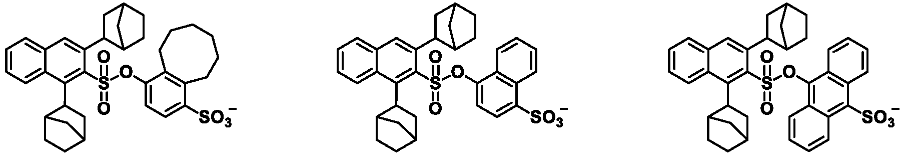

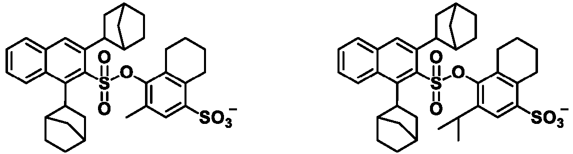

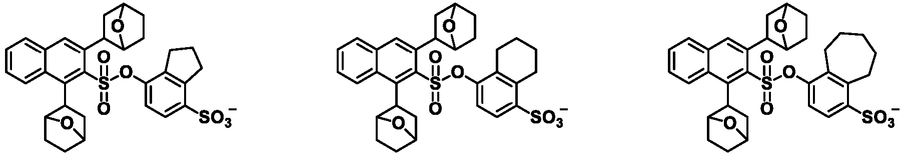

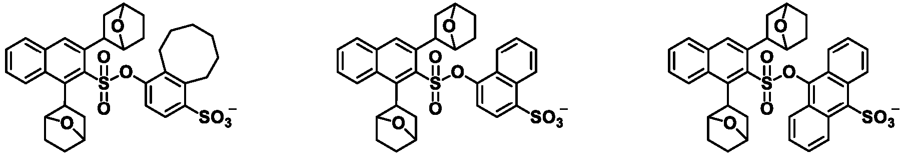

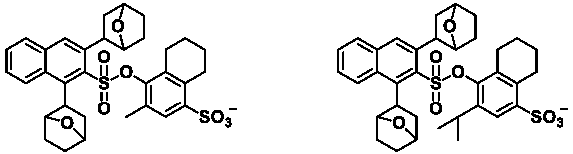

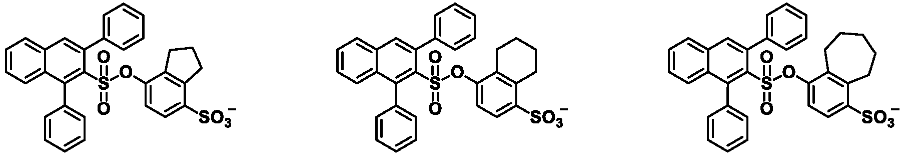

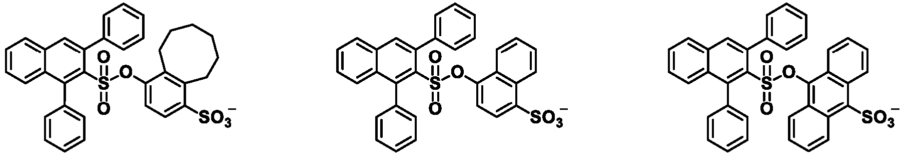

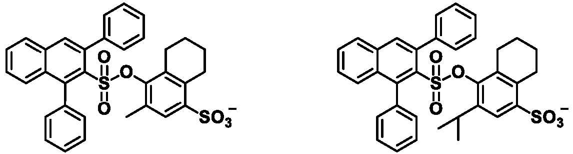

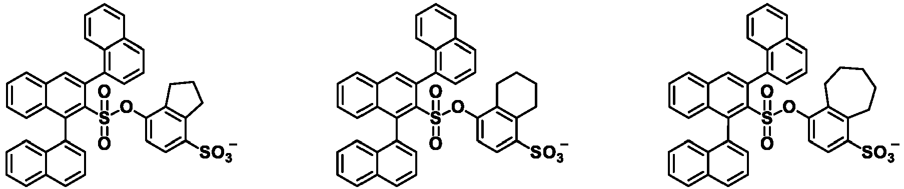

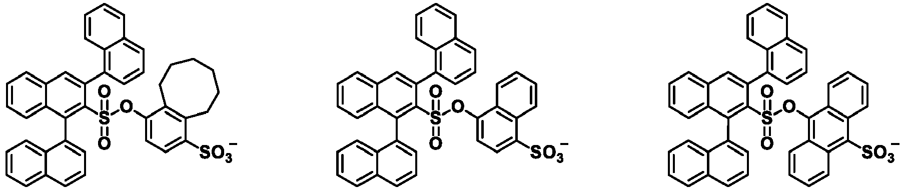

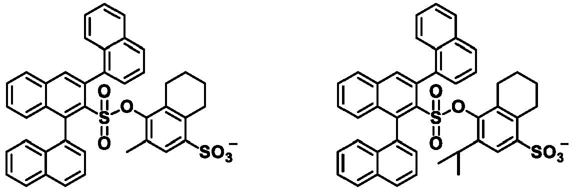

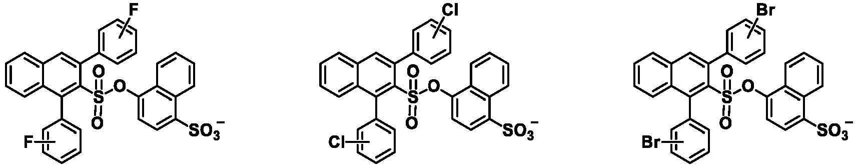

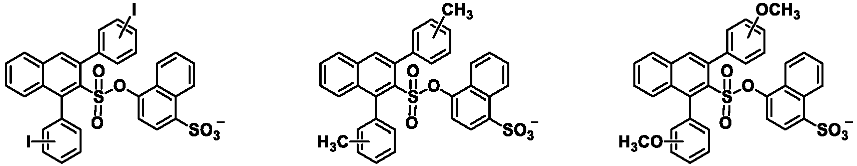

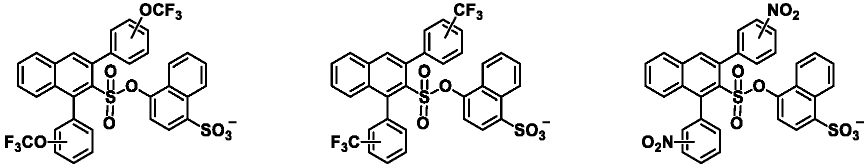

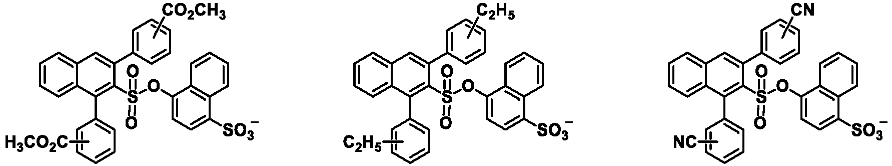

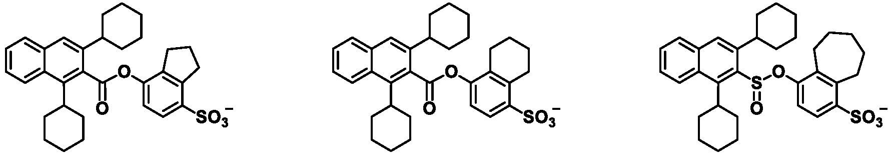

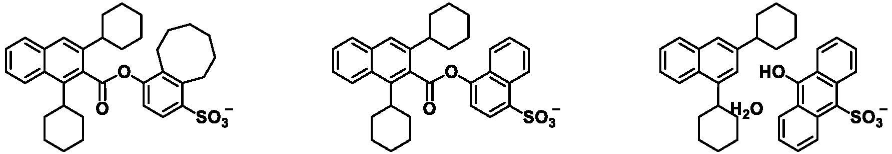

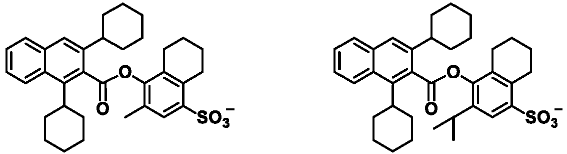

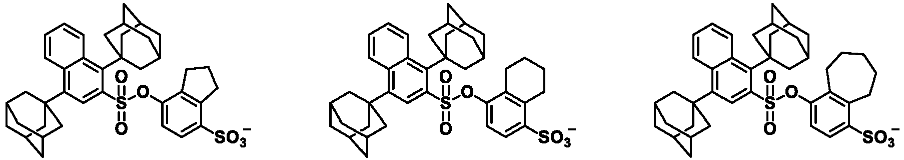

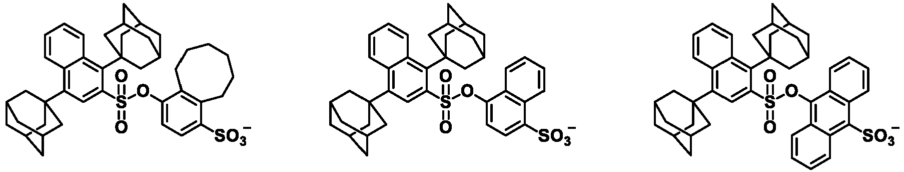

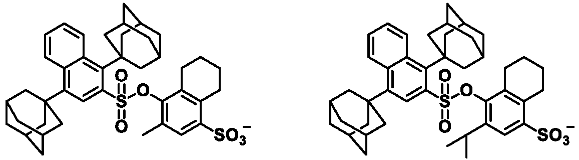

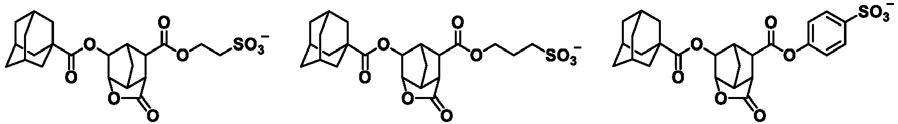

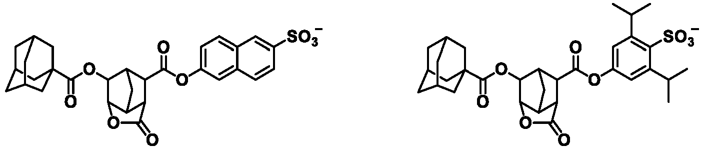

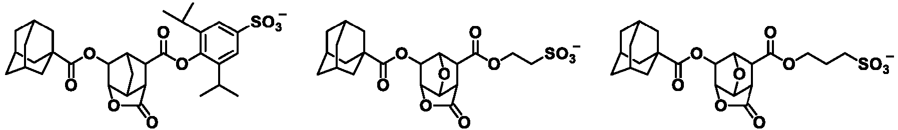

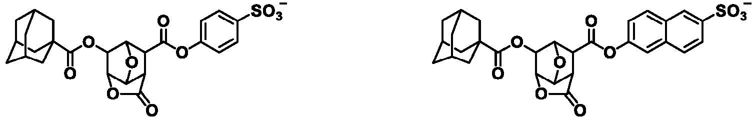

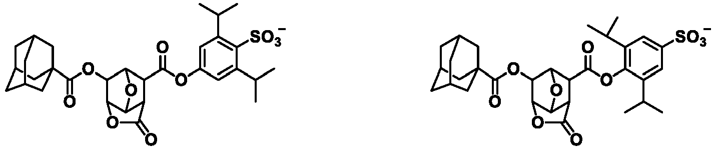

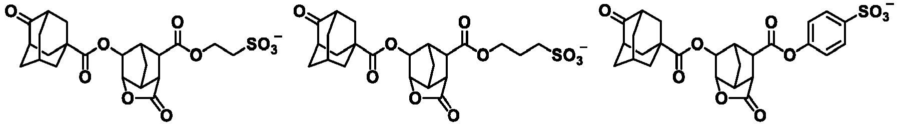

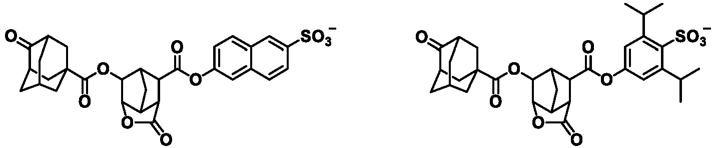

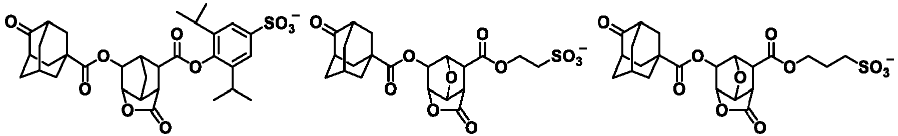

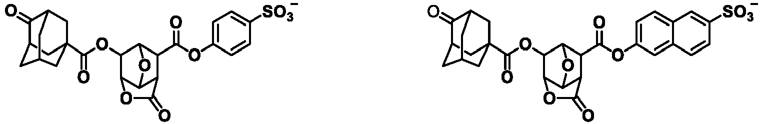

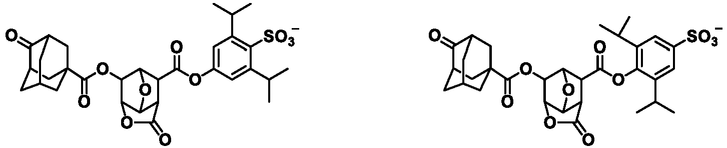

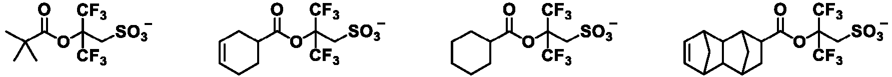

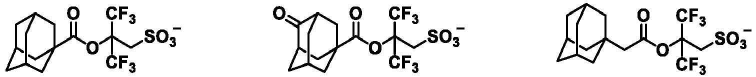

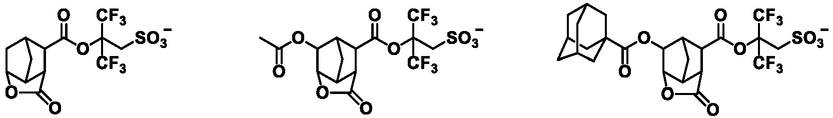

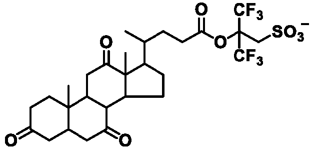

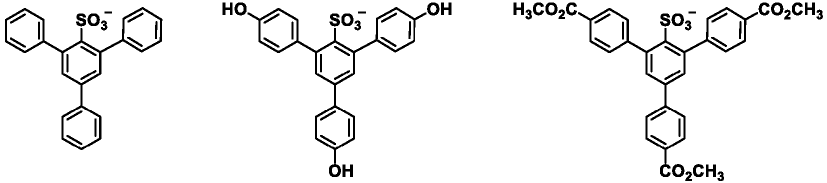

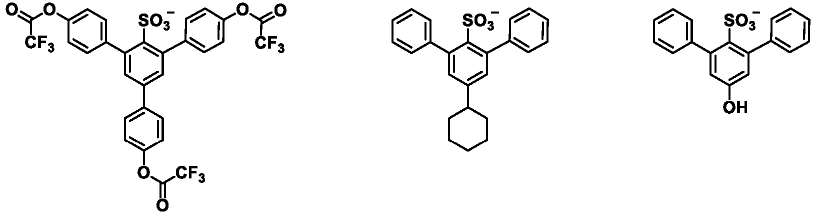

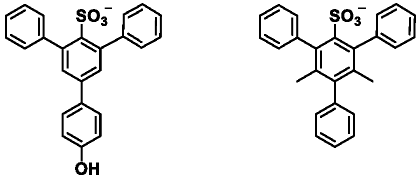

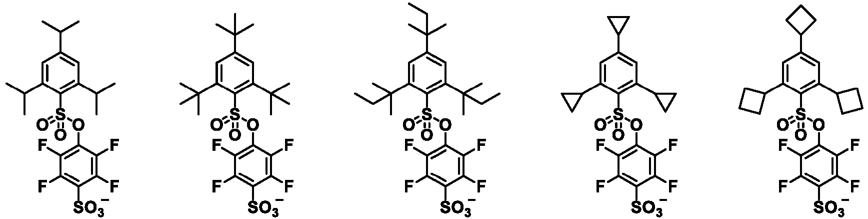

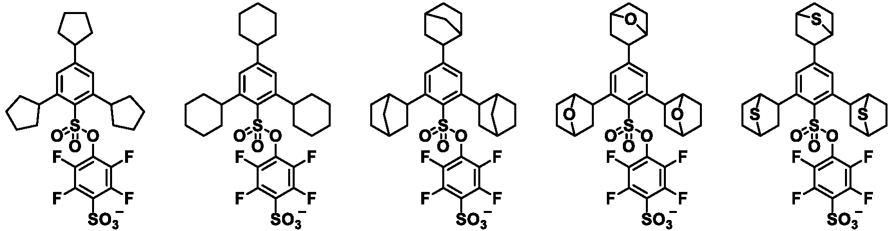

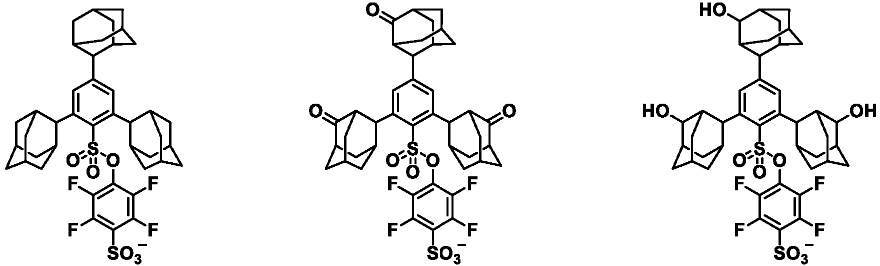

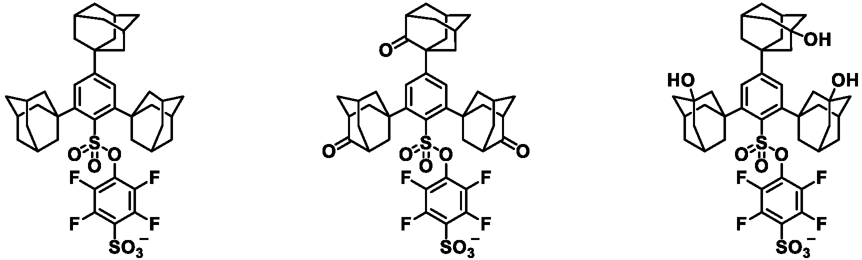

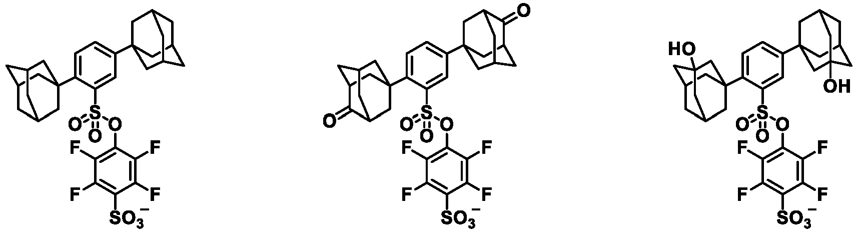

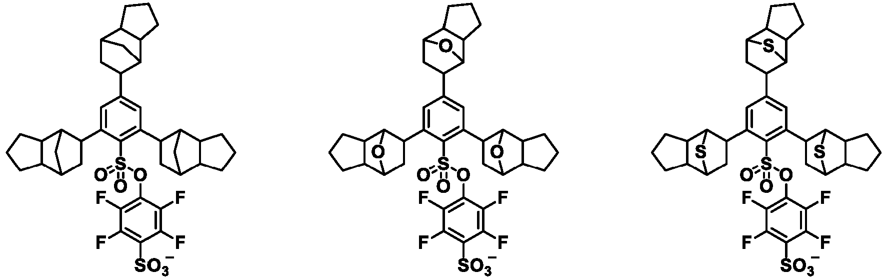

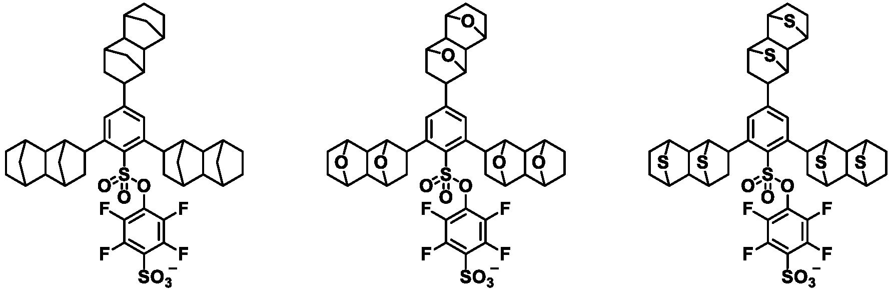

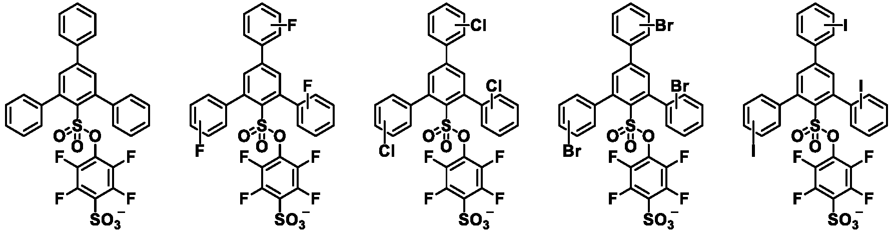

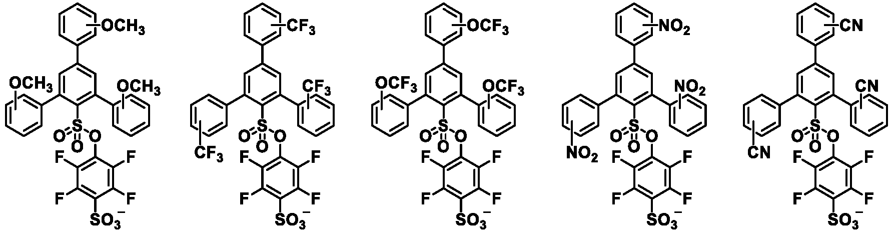

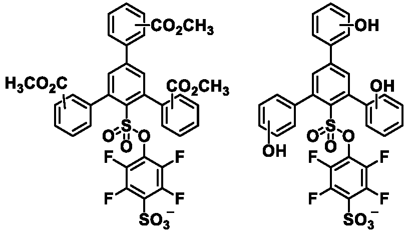

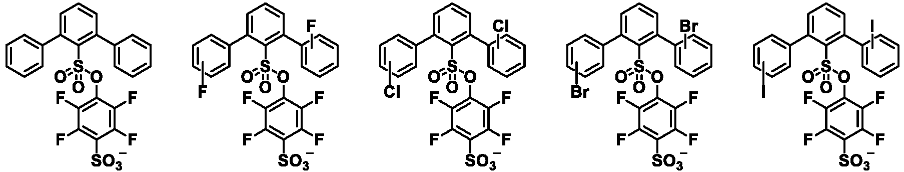

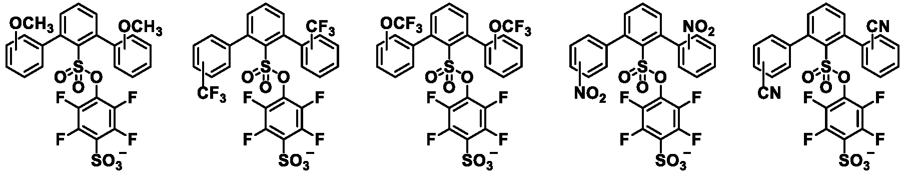

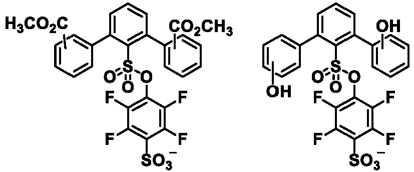

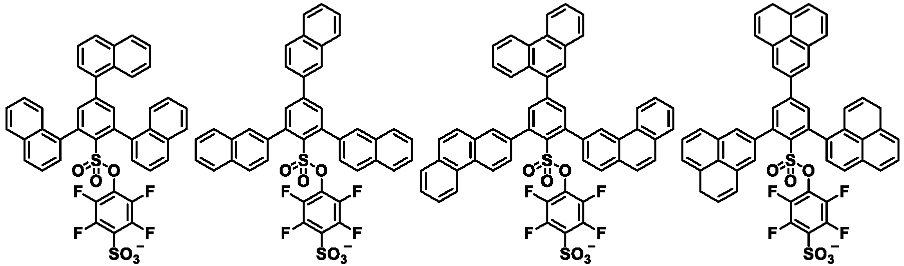

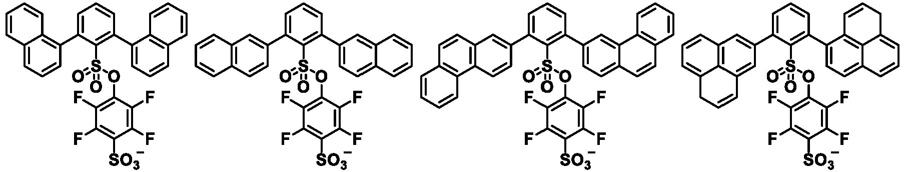

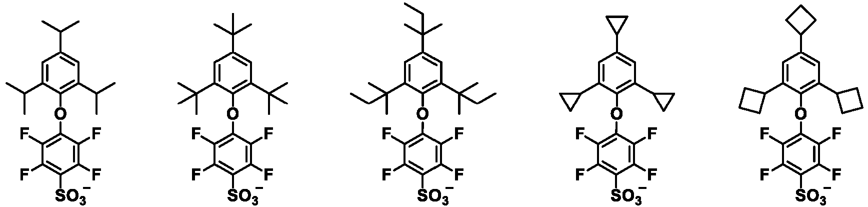

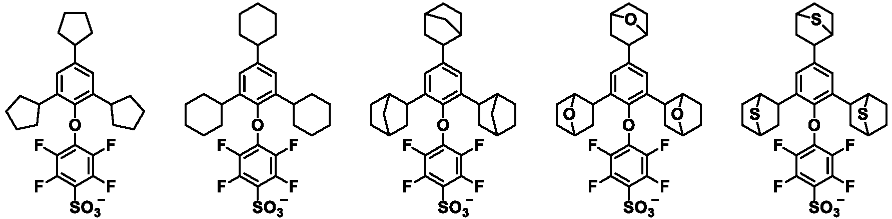

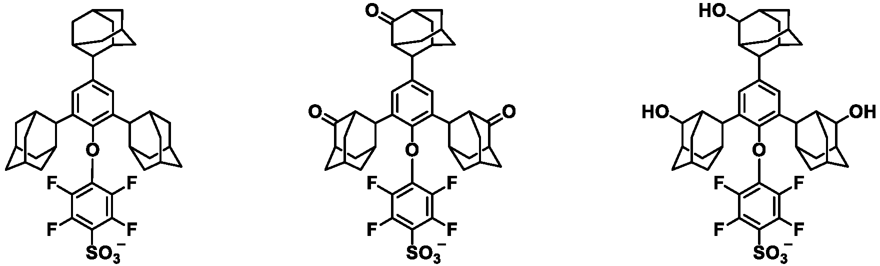

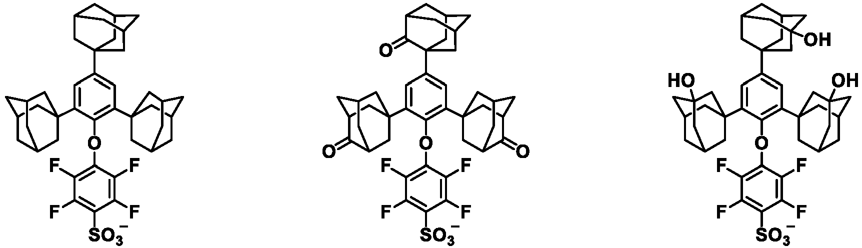

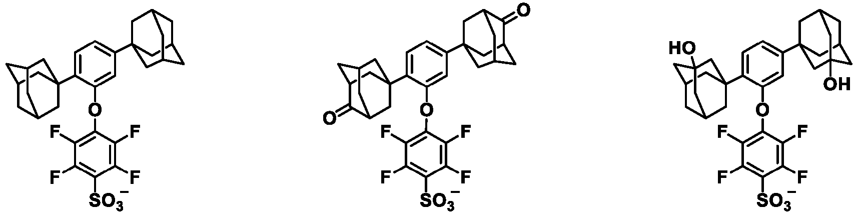

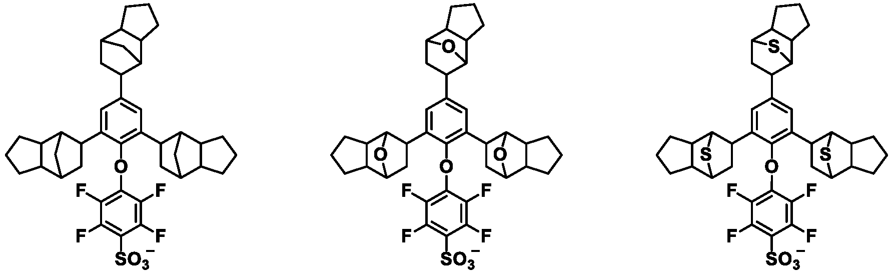

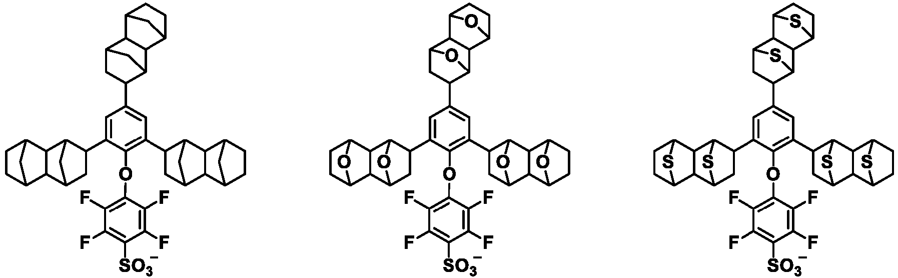

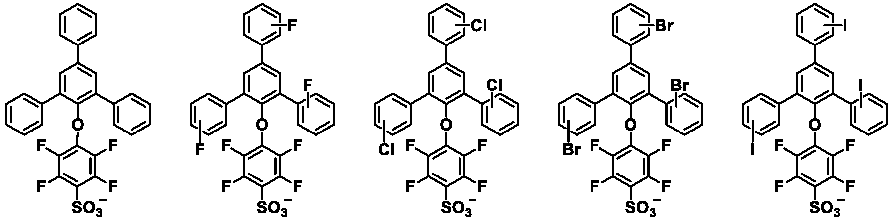

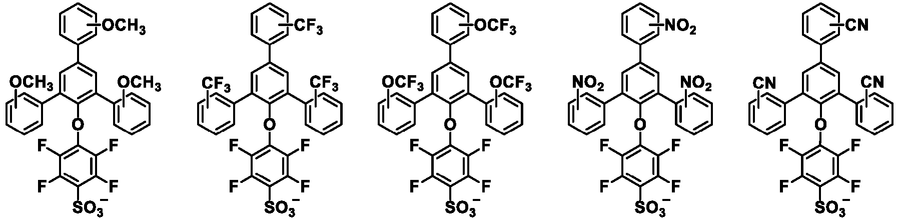

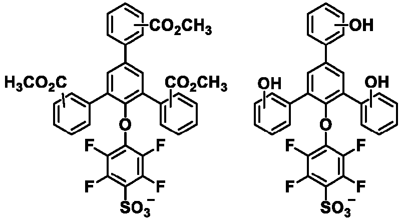

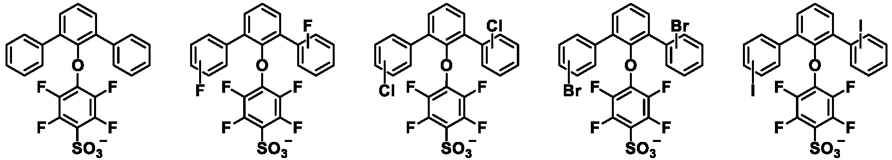

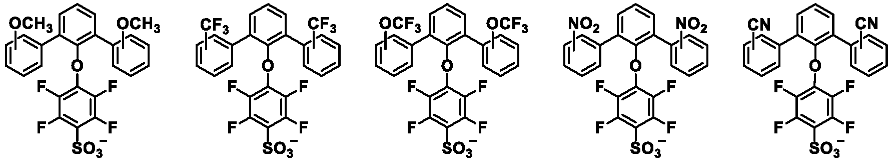

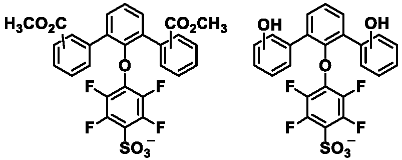

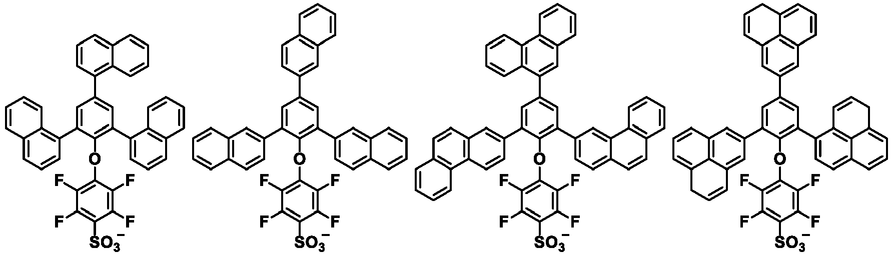

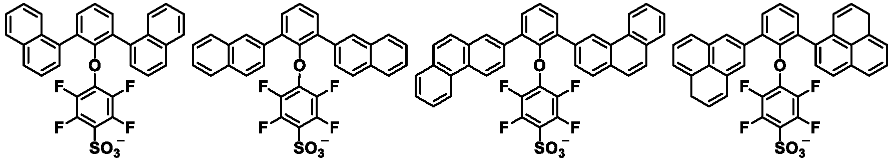

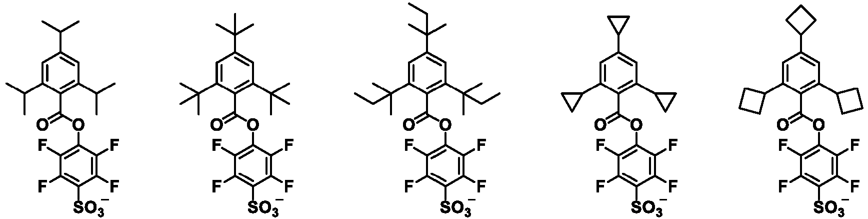

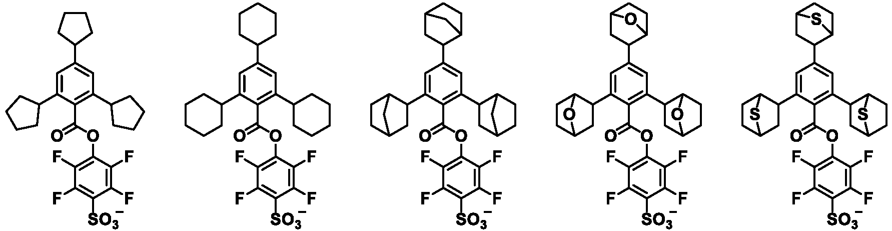

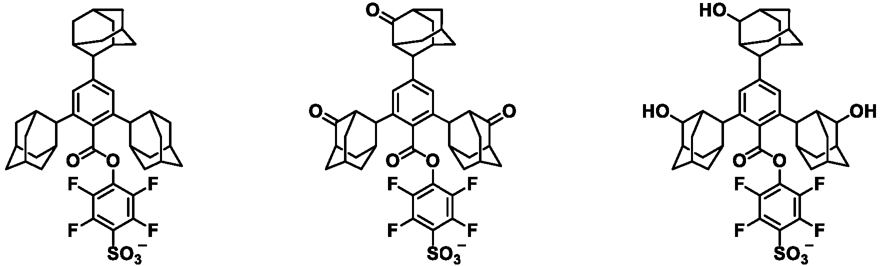

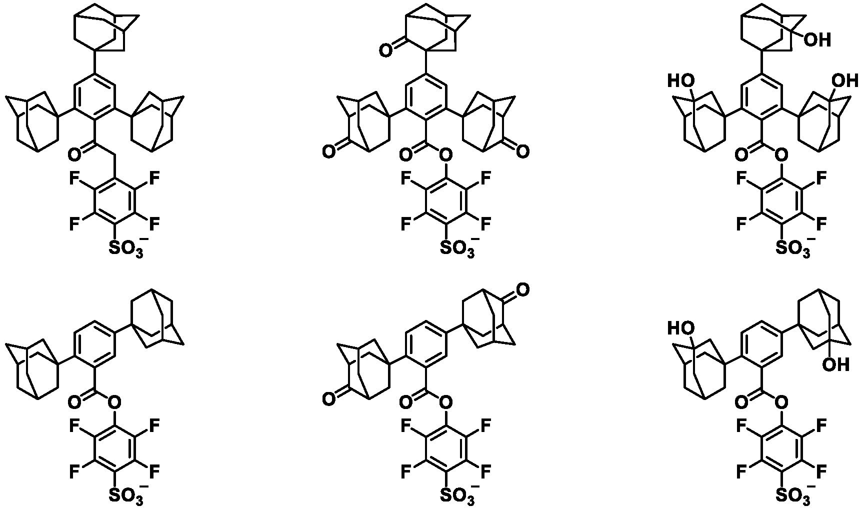

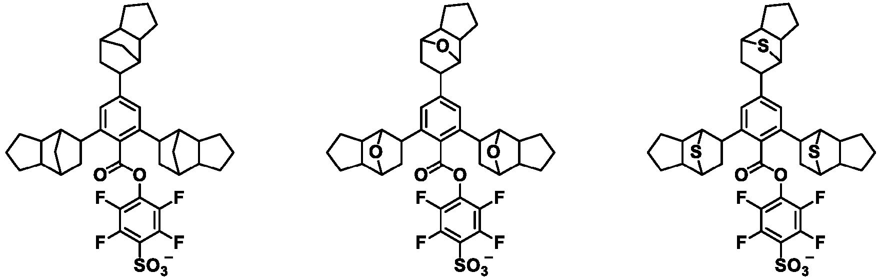

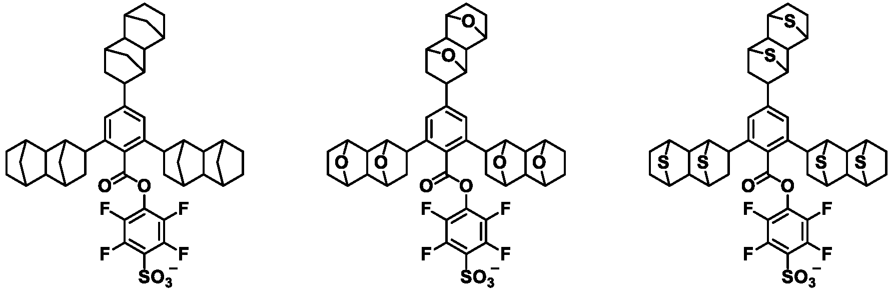

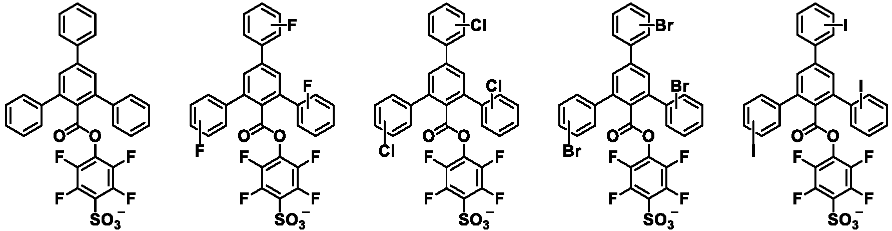

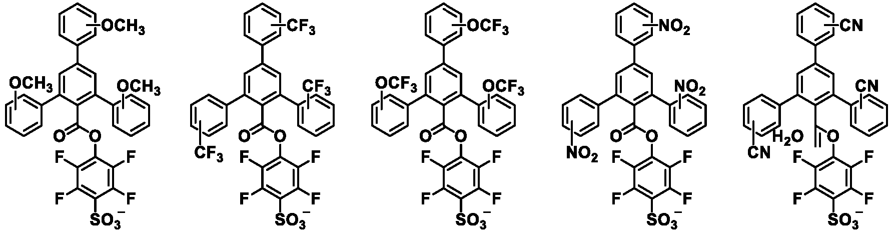

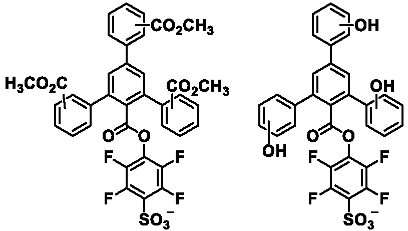

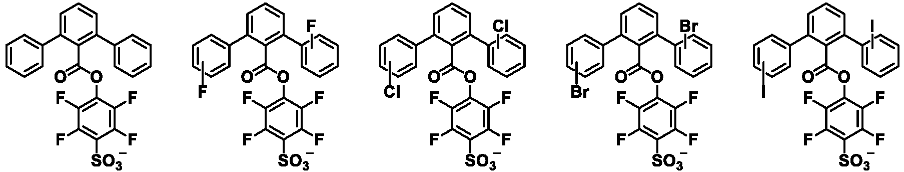

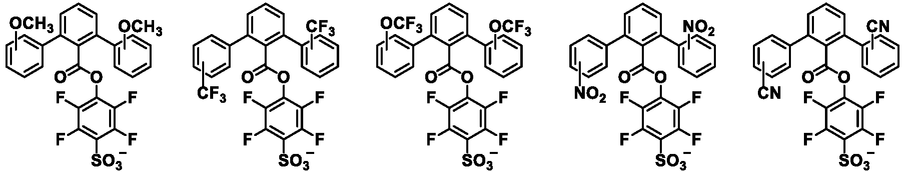

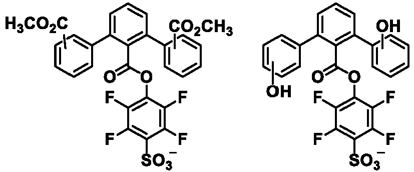

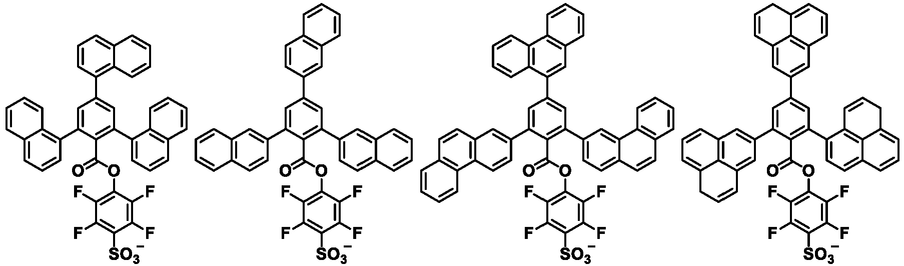

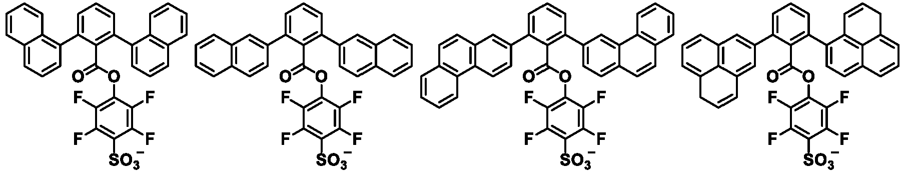

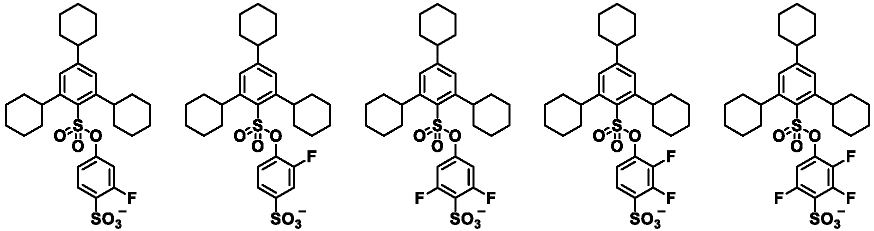

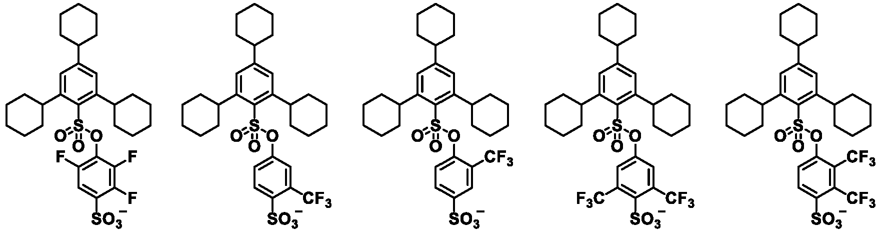

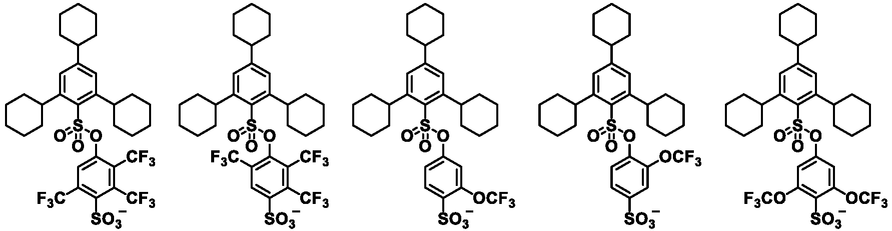

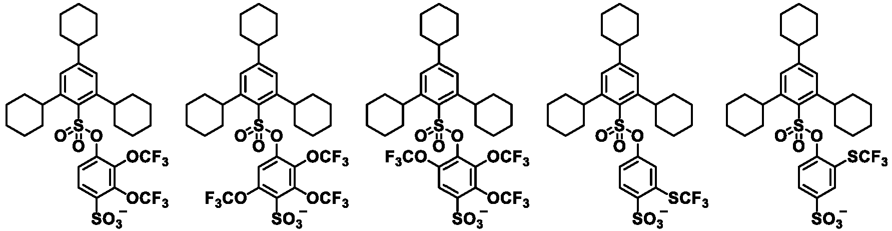

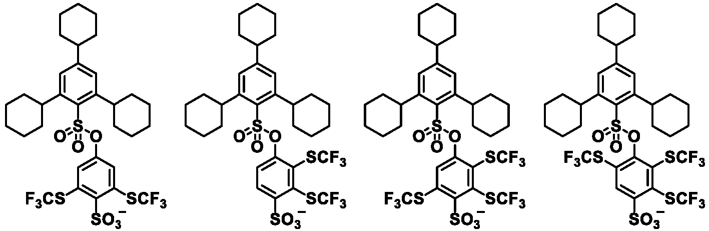

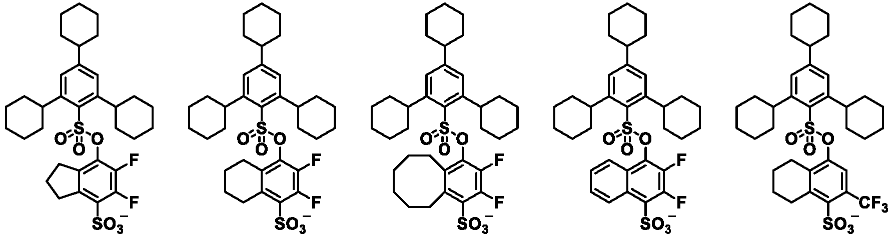

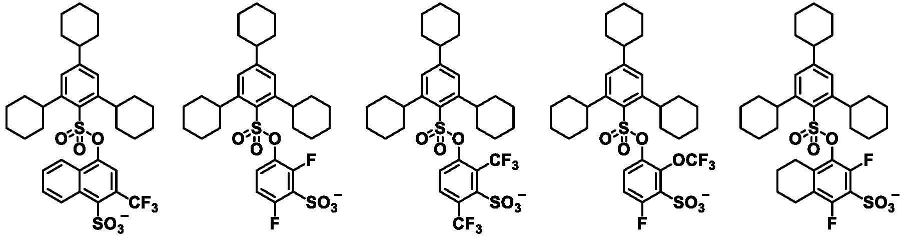

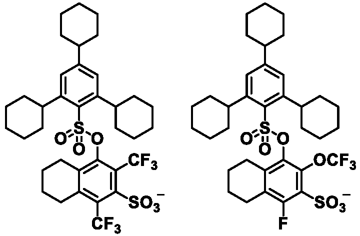

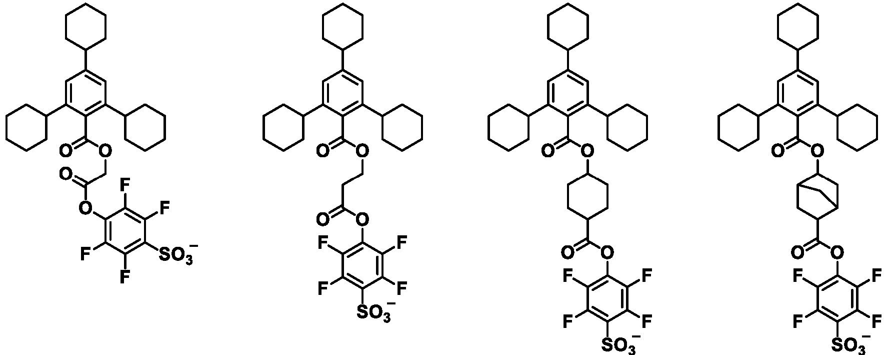

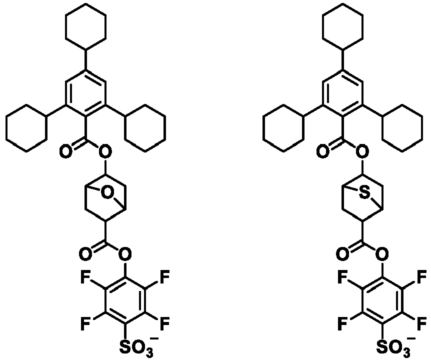

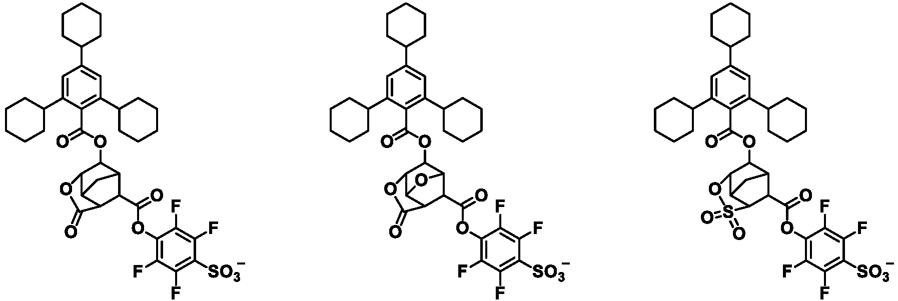

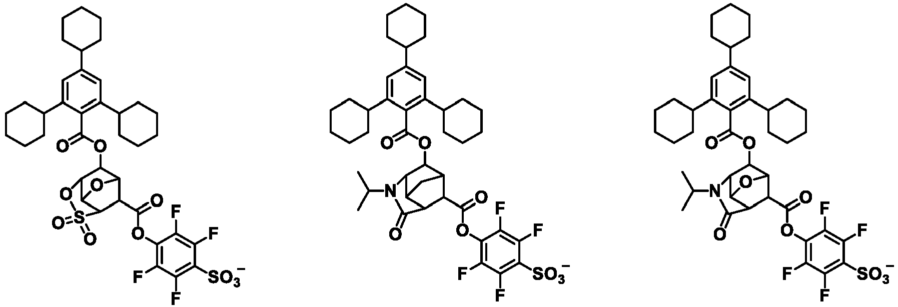

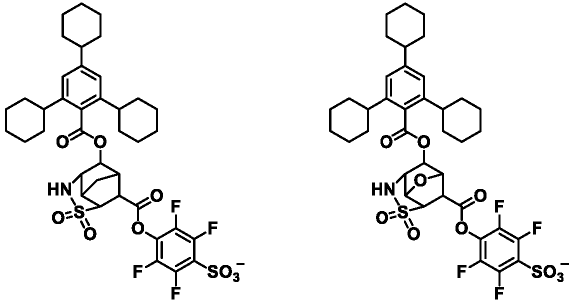

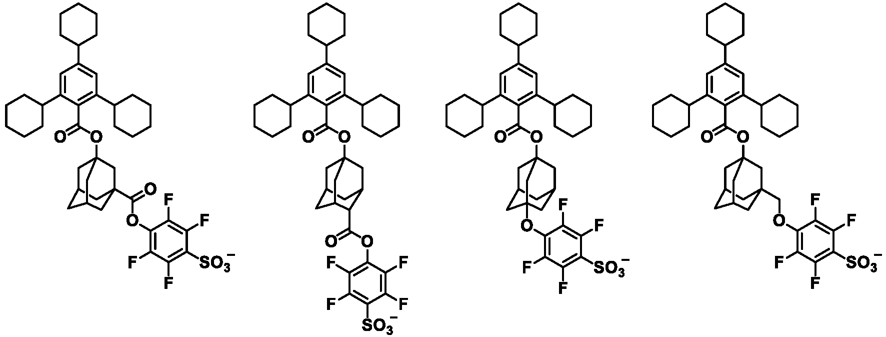

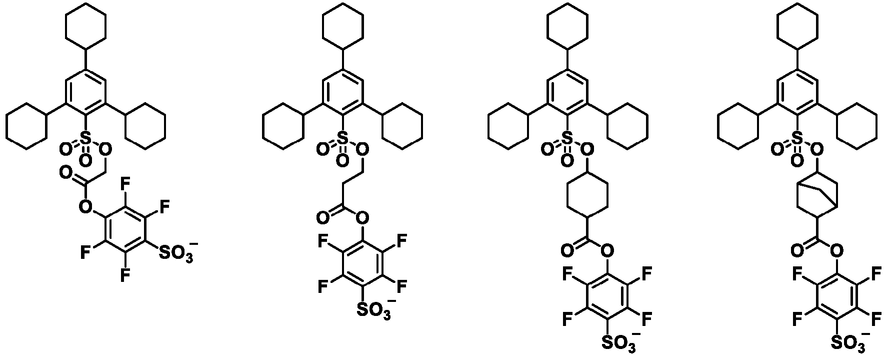

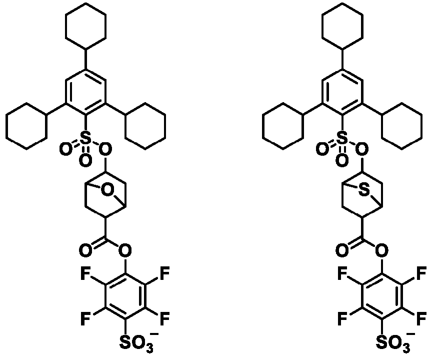

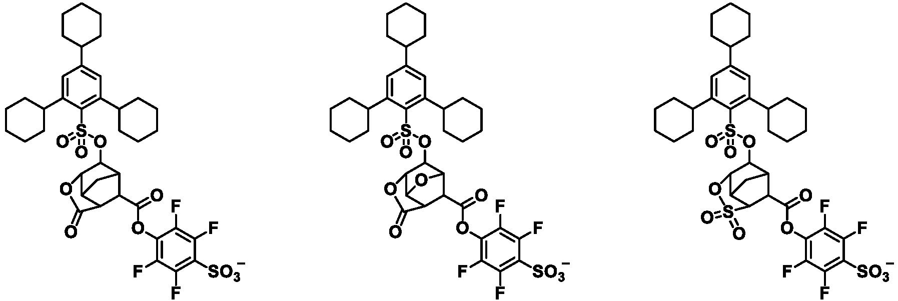

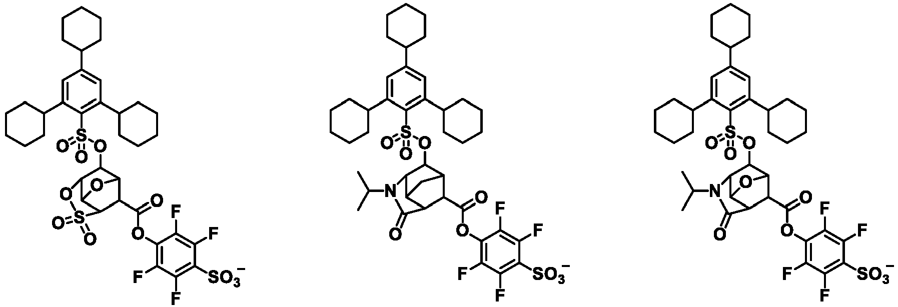

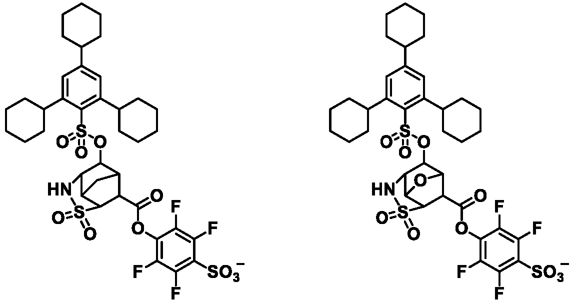

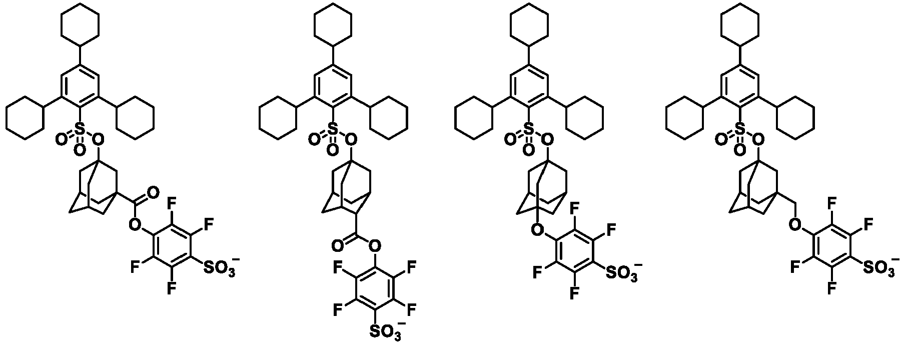

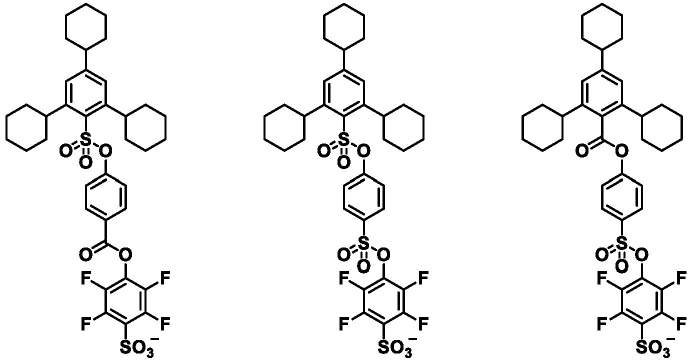

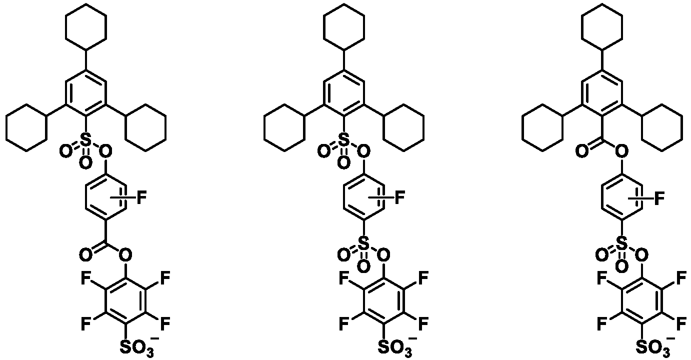

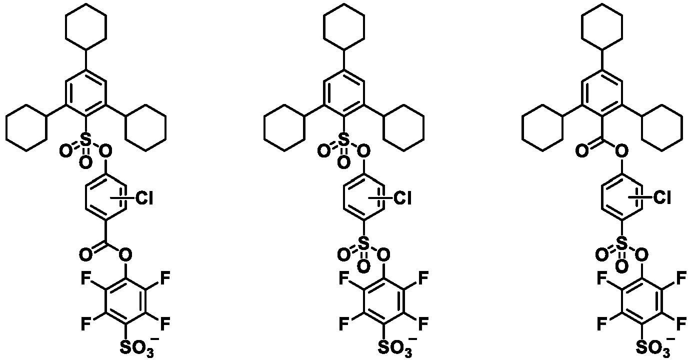

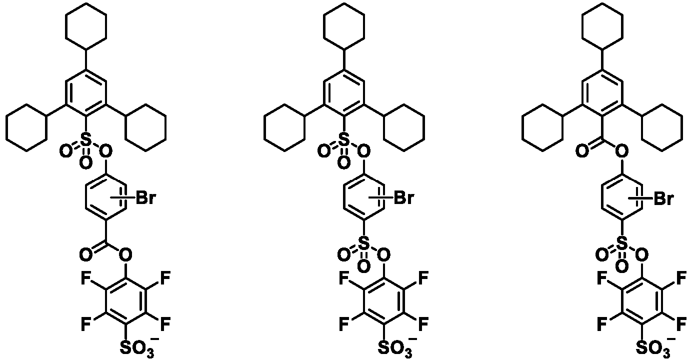

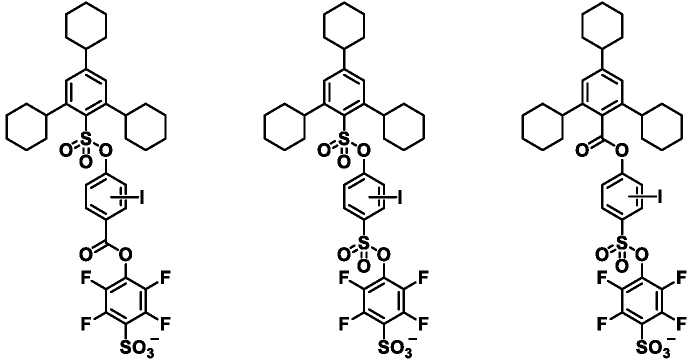

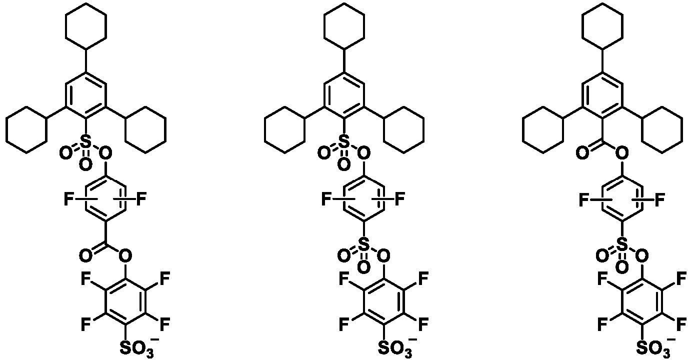

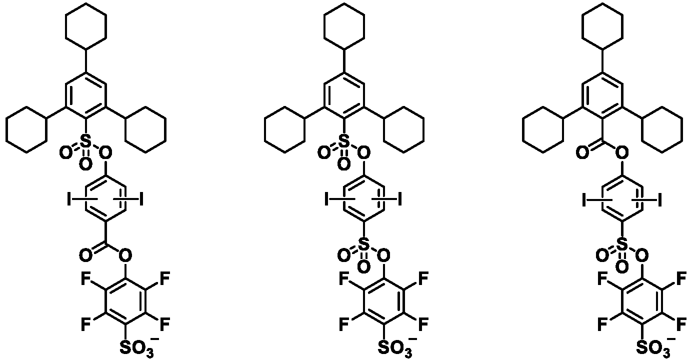

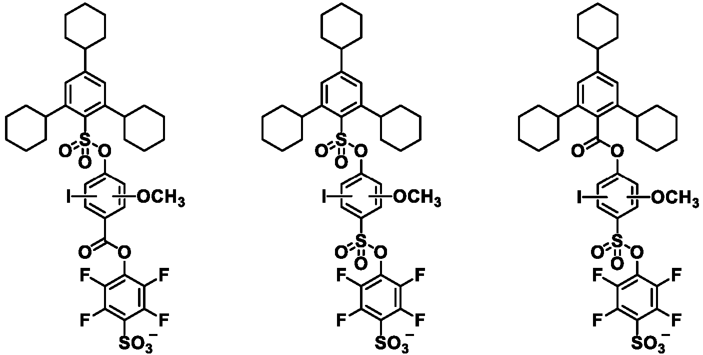

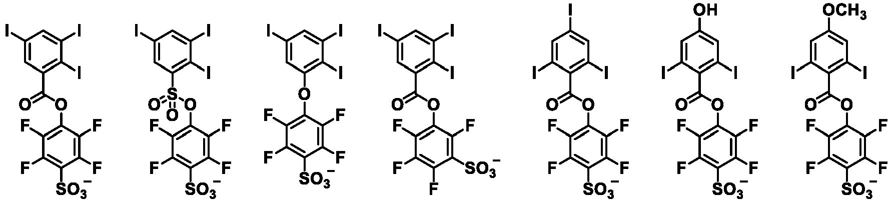

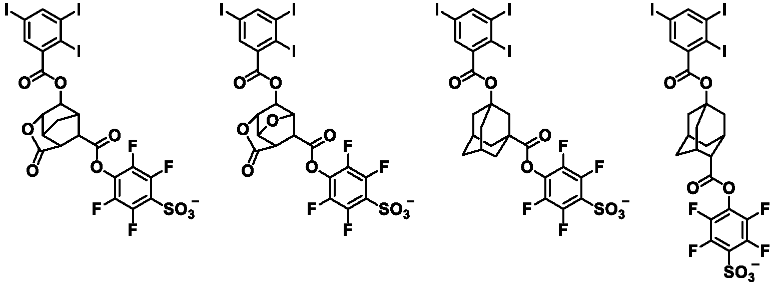

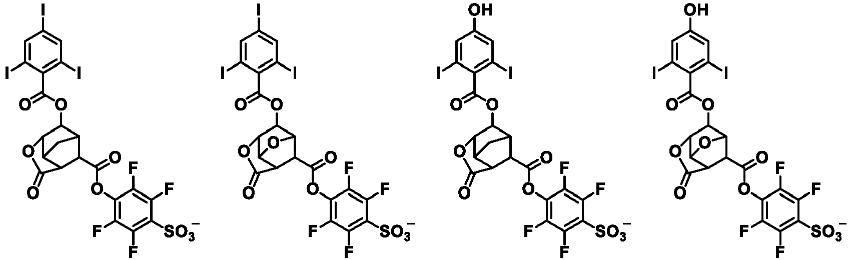

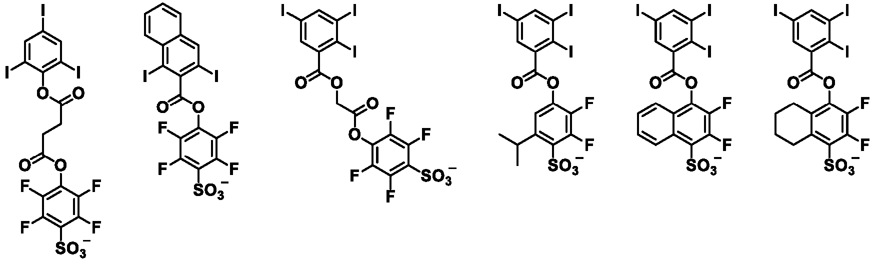

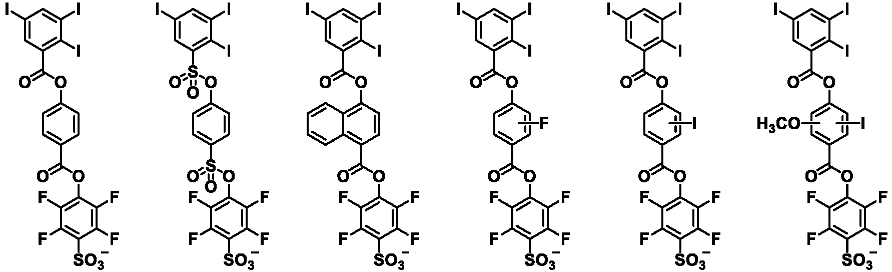

Also preferred as the PAG is a salt compound containing an anion having the formula (E1).

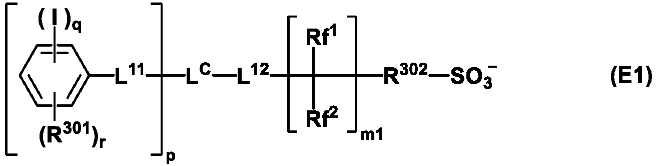

In formula (E1), m1 is 0 or 1. The subscript p is an integer of 1 to 3. The subscript q is an integer of 1 to 5. The subscript r is an integer of 0 to 3. The sum of q + r is 1 or more and 5 or less.

In formula (E1), L¹¹ is a single bond, ether bond, ester bond, carbonyl group, sulfonic ester bond, carbonate bond, or carbamate bond.

In formula (E1), L¹² is an ether bond, ester bond, carbonyl group, sulfonic ester bond, carbonate bond, or carbamate bond.

In formula (E1), L^{C} is a single bond or a C₁-C₂₀ hydrocarbylene group when p is 1. L^{C} is a C₁-C₂₀ (p+1)-valent hydrocarbon group when p is 2 or 3. The hydrocarbylene group and (p+1)-valent hydrocarbon group may contain at least one moiety selected from an ether bond, a carbonyl group, an ester bond, an amide bond, a sultone ring, a lactam ring, a carbonate bond, a halogen atom, a hydroxy group and a carboxy group.

The C₁-C₂₀ hydrocarbylene group L^{C} may be saturated or unsaturated and straight, branched or cyclic. Specific examples thereof include C₁-C₂₀ alkanediyl groups such as methanediyl, ethane-1,1-diyl, ethane-1,2-diyl, propane-1,3-diyl, butane-1,4-diyl, pentane-1,5-diyl, hexane-1,6-diyl, heptane-1,7-diyl, octane-1,8-diyl, nonane-1,9-diyl, decane-1,10-diyl, undecane-1,11-diyl and dodecane-1,12-diyl; C₃-C₂₀ cyclic saturated hydrocarbylene groups such as cyclopentanediyl, cyclohexanediyl, norbornanediyl and adamantanediyl; C₂-C₂₀ unsaturated aliphatic hydrocarbylene groups such as vinylene and propene-1,3-diyl; C₆-C₂₀ arylene groups such as phenylene and naphthylene; and groups obtained by combining the foregoing. The C₁-C₂₀ (p+1)-valent hydrocarbon group represented by L^{C} may be saturated or unsaturated, and may be straight, branched, or cyclic. Examples thereof include those exemplified above for the C₁-C₂₀ hydrocarbylene group, with one or two hydrogen atoms being eliminated.

In formula (E1), Rf¹ and Rf² are each independently a hydrogen atom, fluorine atom or trifluoromethyl group, at least one of Rf¹ and Rf² is fluorine or trifluoromethyl.

In formula (E1), R³⁰¹ is hydroxy, carboxy, a C₁-C₆ saturated hydrocarbyl group, C₁-C₆ saturated hydrocarbyloxy group, C₂-C₆ saturated hydrocarbylcarbonyloxy group, fluorine, chlorine, bromine, -N(R^{301A})(R^{301B}), -N(R^{301C})-C(=O)-R^{301D} or -N(R^{301C})-C(=O)-O-R^{301D}. R^{301A} and R^{301B} are each independently a hydrogen atom, or C₁-C₆ saturated hydrocarbyl group. R^{301C} is a hydrogen atom or C₁-C₆ saturated hydrocarbyl group. R^{301D} is a C₁-C₆ saturated hydrocarbyl group or C₂-C₈ unsaturated hydrocarbyl group.

The C₁-C₆ saturated hydrocarbyl group represented by R³⁰¹, R^{301A}, R^{301B} and R^{301C} may be straight, branched or cyclic. Examples thereof include C₁-C₆ alkyl groups such as methyl, ethyl, n-propyl, isopropyl, n-butyl, isobutyl, sec-butyl, tert-butyl, n-pentyl, and n-hexyl; and C₃-C₆ cyclic saturated hydrocarbyl groups such as cyclopropyl, cyclobutyl, cyclopentyl, and cyclohexyl. Examples of the saturated hydrocarbyl moiety in the C₁-C₆ saturated hydrocarbyloxy group represented by R³⁰¹ are as exemplified above for the saturated hydrocarbyl group. Examples of the saturated hydrocarbyl moiety in the C₂-C₆ saturated hydrocarbylcarbonyloxy group represented by R³⁰¹ are as exemplified above for the C₁-C₆ saturated hydrocarbyl group, but of 1 to 5 carbon atoms.

The C₂-C₈ unsaturated hydrocarbyl group represented by R^{301D} may be straight, branched or cyclic. Examples thereof include C₂-C₈ alkenyl groups such as vinyl, propenyl, butenyl, and hexenyl; C₂-C₈ alkynyl groups such as ethynyl, propynyl, and butynyl; and C₃-C₈ cyclic unsaturated aliphatic hydrocarbyl groups such as cyclohexenyl and norbornenyl.

In formula (E1), R³⁰² is a C₁-C₂₀ saturated hydrocarbylene group or C₆-C₂₀ arylene group. Some or all of the hydrogen atoms in the saturated hydrocarbylene group may be substituted by halogen exclusive of fluorine. Some or all of the hydrogen atoms in the arylene group may be substituted by a substituent selected from C₁-C₂₀ saturated hydrocarbyl groups, C₁-C₂₀ saturated hydrocarbyloxy groups, C₆-C₂₀ aryl groups, halogen, and hydroxy.

The C₁-C₂₀ hydrocarbylene group R³⁰² may be saturated or unsaturated and straight, branched or cyclic. Examples thereof are as exemplified above as a C₁-C₂₀ hydrocarbylene group L^{C}.

Examples of the C₆-C₂₀ arylene group represented by R³⁰² include phenylene, naphthylene, phenanthrenediyl, and anthracenediyl. The C₁-C₂₀ saturated hydrocarbyl moiety and hydrocarbyl moiety in the C₁-C₂₀ hydrocarbyloxy moiety, which are substituents on the arylene group, may be straight, branched or cyclic and examples thereof include C₁-C₂₀ alkyl groups such as methyl, ethyl, n-propyl, isopropyl, n-butyl, isobutyl, sec-butyl, tert-butyl, n-pentyl, n-hexyl, n-octyl, n-nonyl, n-decyl, undecyl, dodecyl, tridecyl, tetradecyl, pentadecyl, heptadecyl, octadecyl, nonadecyl, and icosyl; and C₃-C₂₀ cyclic saturated hydrocarbyl groups such as cyclopropyl, cyclopentyl, cyclohexyl, cyclopropylmethyl, 4-methylcyclohexyl, cyclohexylmethyl, norbornyl, and adamantyl. Examples of the C₆-C₁₄ arylene moiety which is a substituent on the arylene group include phenylene, naphthylene, phenanthrenediyl and anthracenediyl.

The anion of formula (E1) is preferably an anion having the formula (E2).

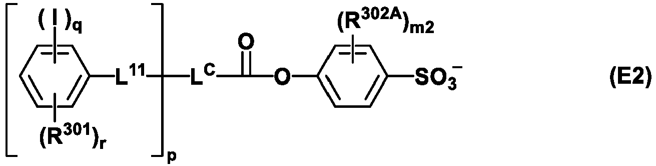

In formula (E2), p, q, r, L¹¹, L^{C}, and R³⁰¹ are as defined above. The subscript m2 is an integer of 1 to 4. R^{302A} is a C₁-C₂₀ saturated hydrocarbyl group, C₁-C₂₀ saturated hydrocarbyloxy group, C₆-C₁₄ aryl group, halogen or hydroxy group. When m2 is 2, 3 or 4, a plurality of R^{302A} may be identical or different.

Examples of the anion having formula (E1) are shown below, but not limited thereto.

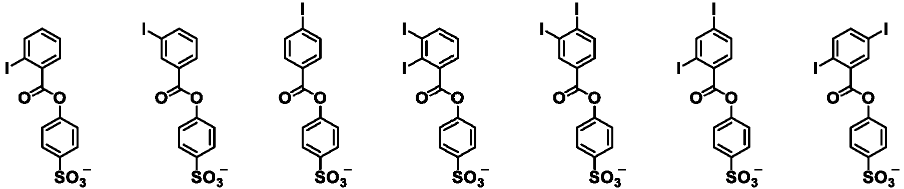

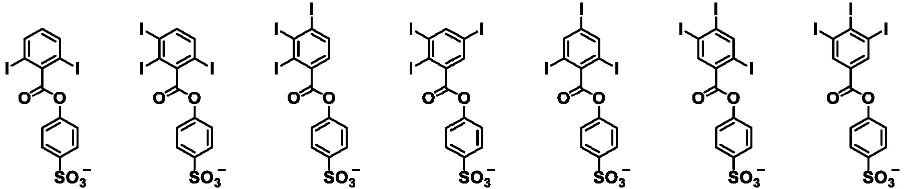

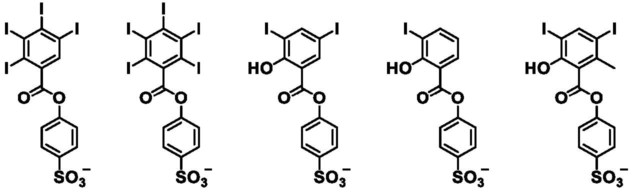

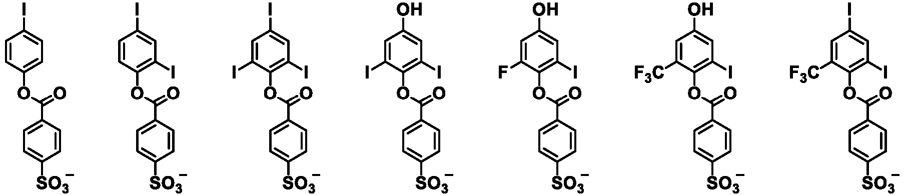

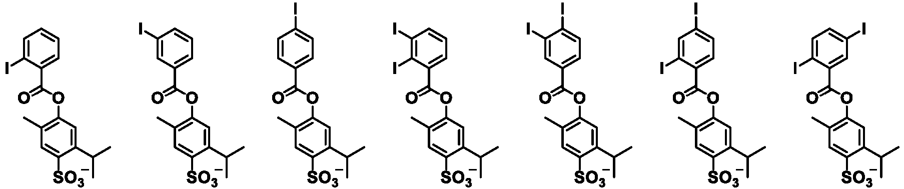

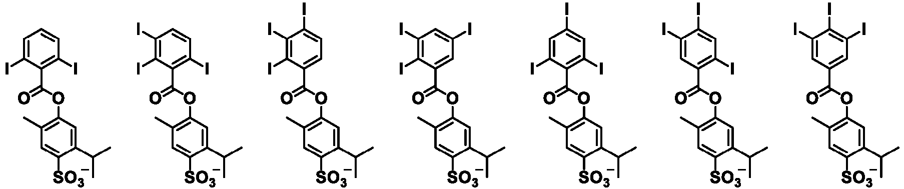

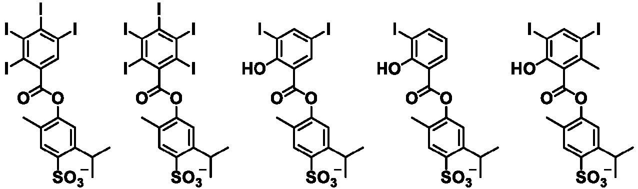

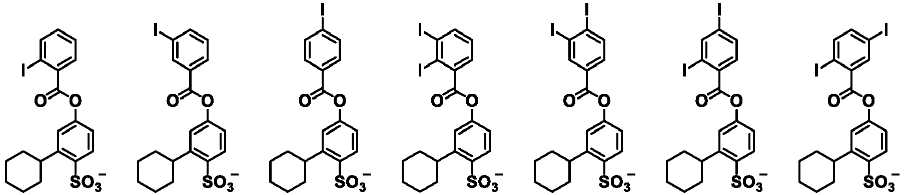

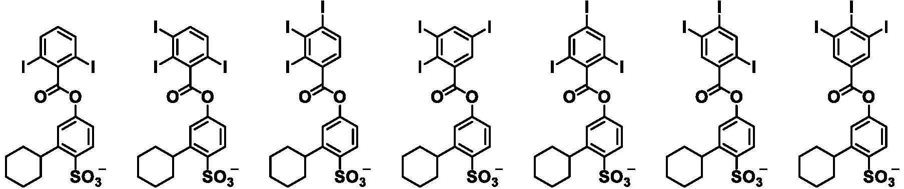

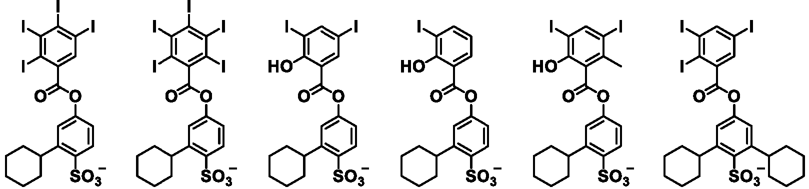

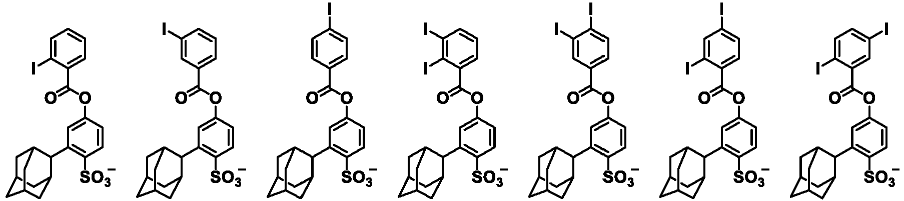

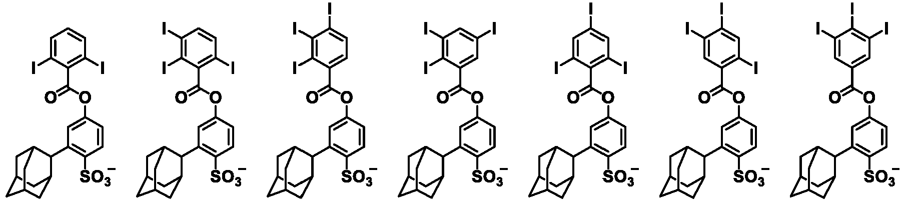

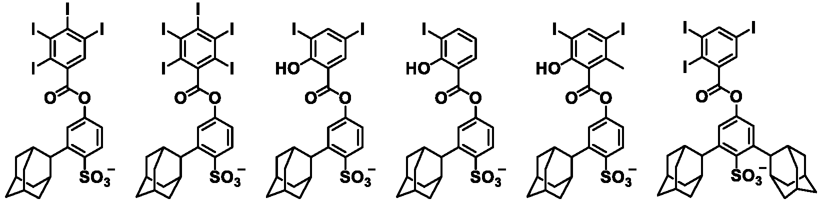

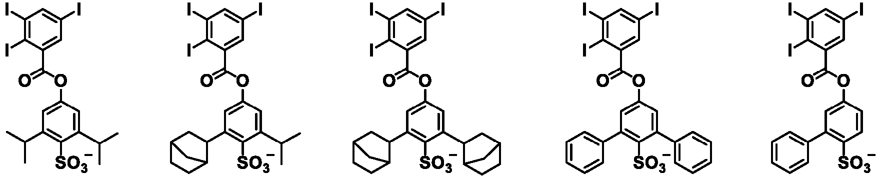

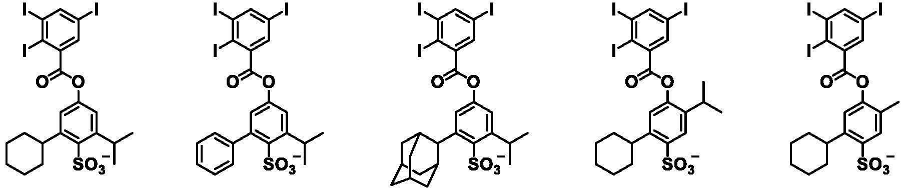

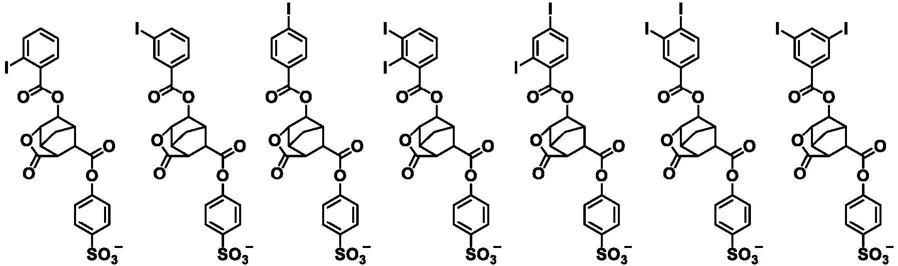

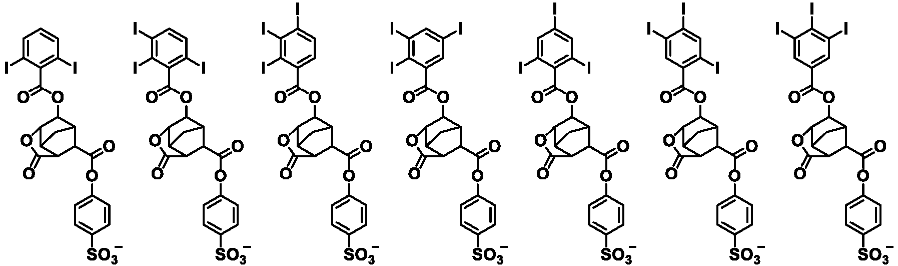

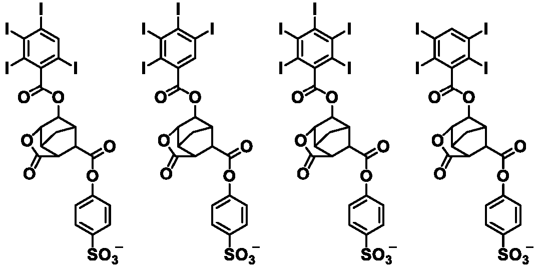

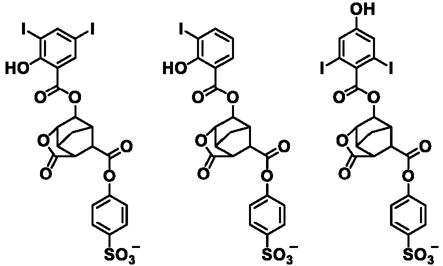

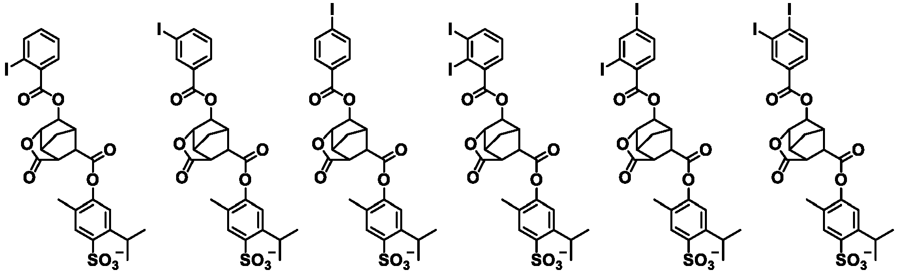

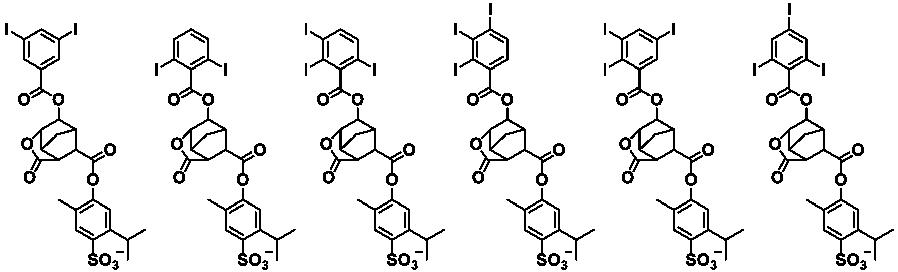

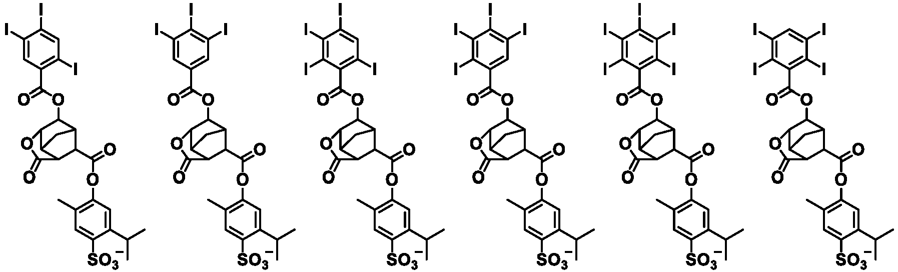

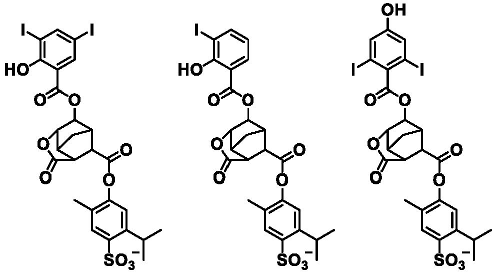

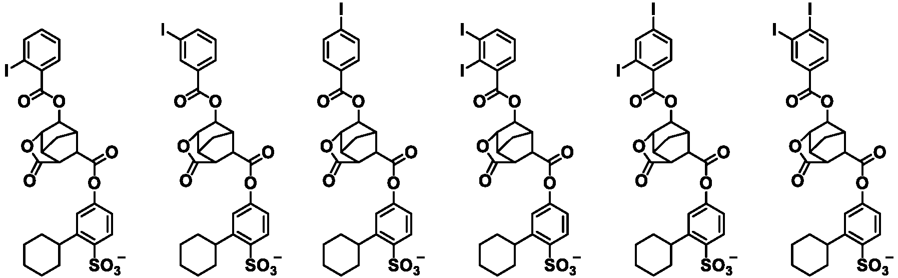

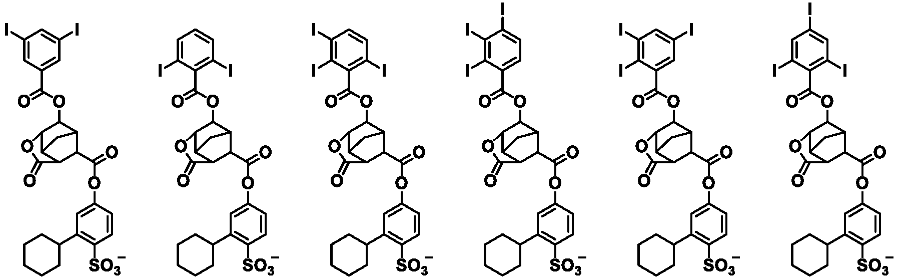

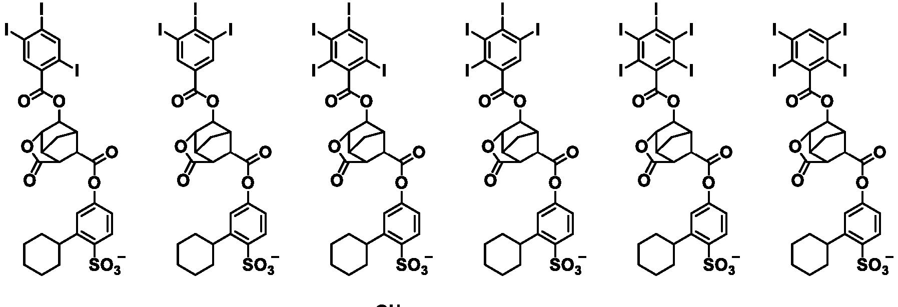

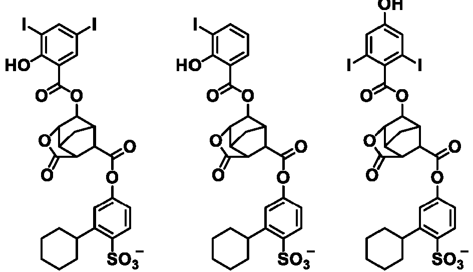

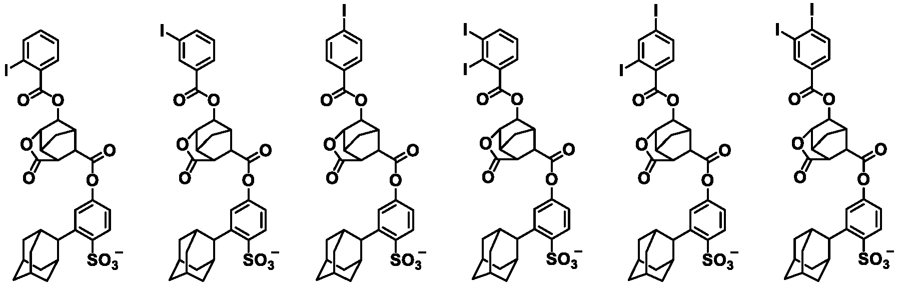

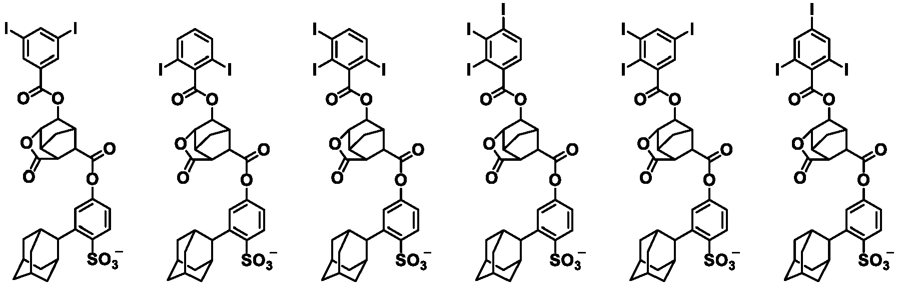

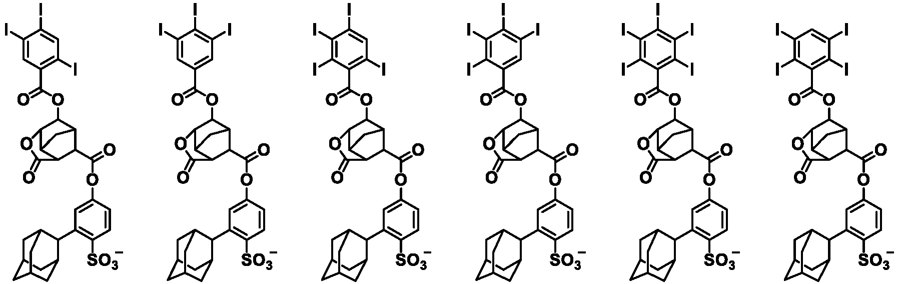

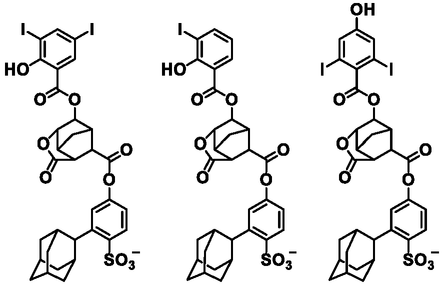

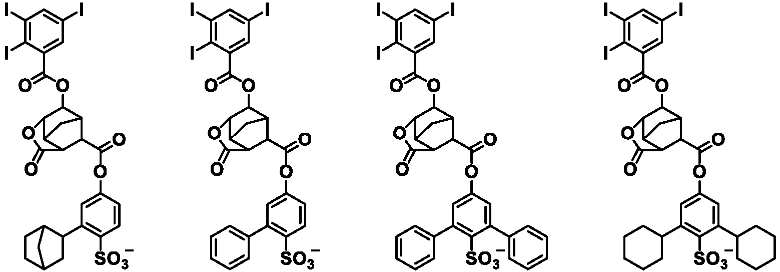

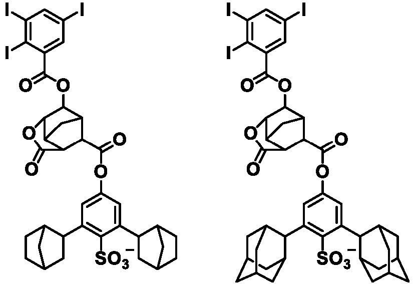

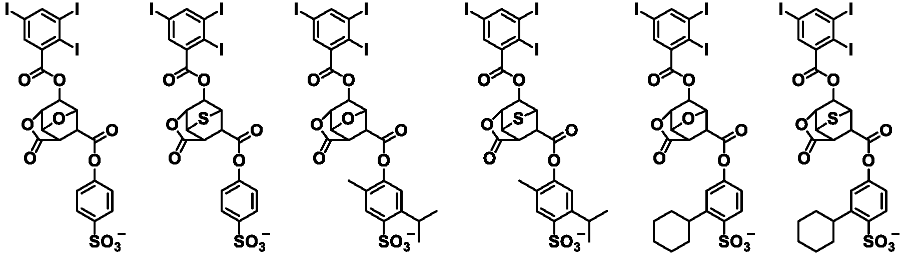

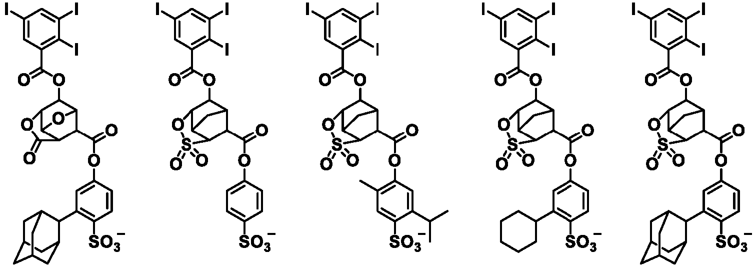

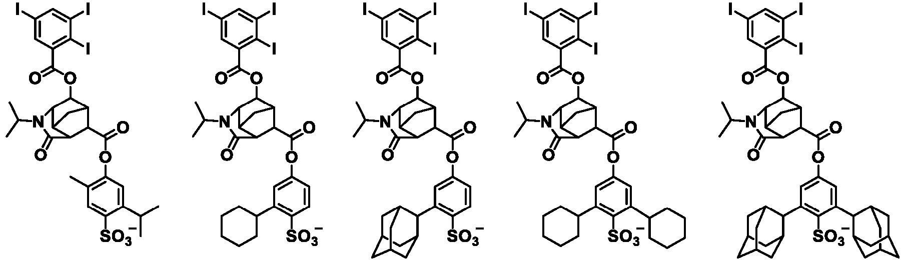

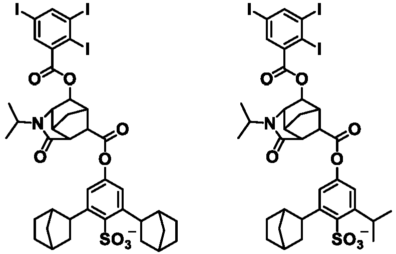

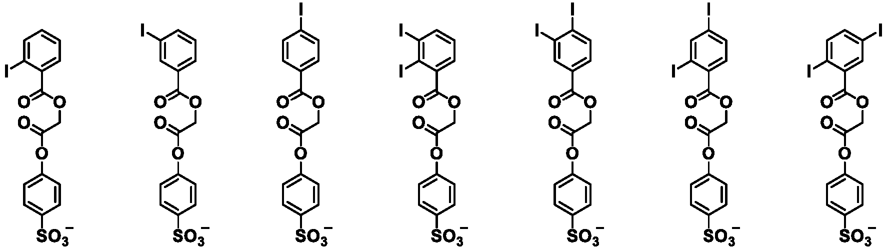

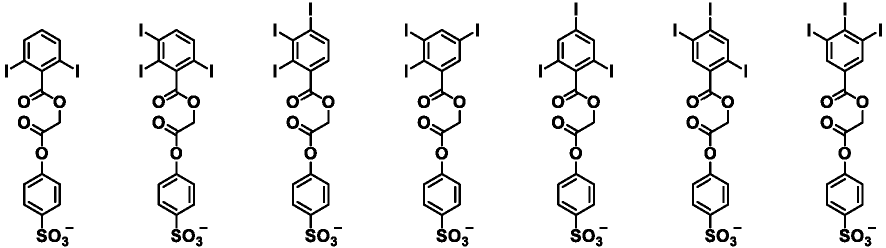

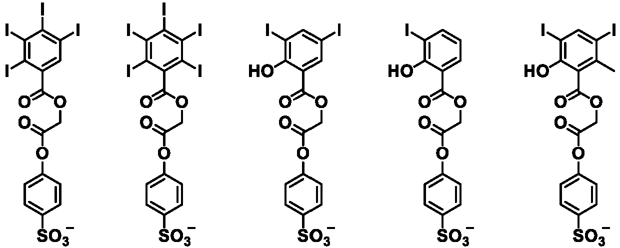

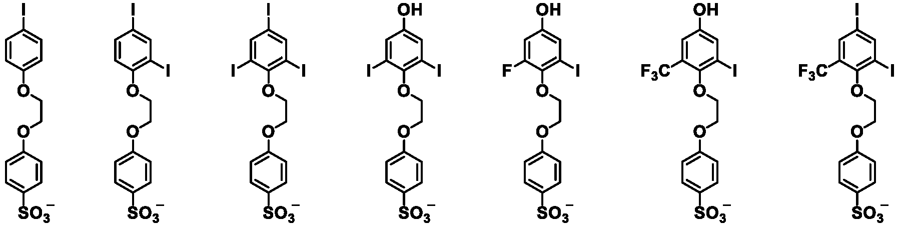

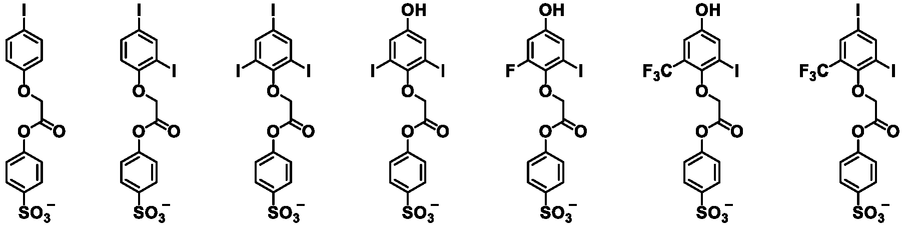

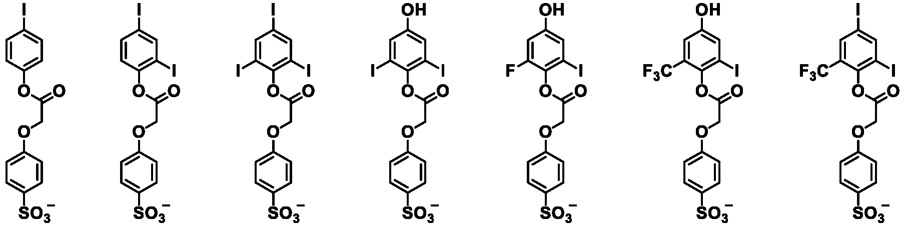

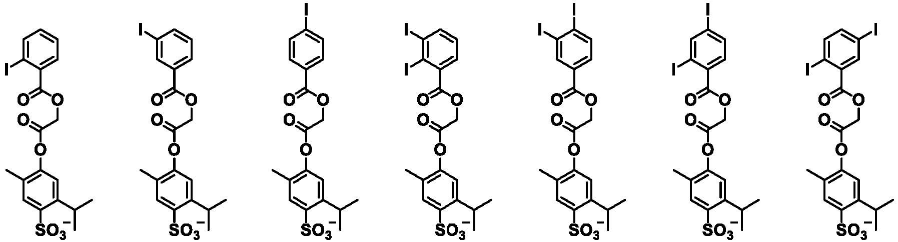

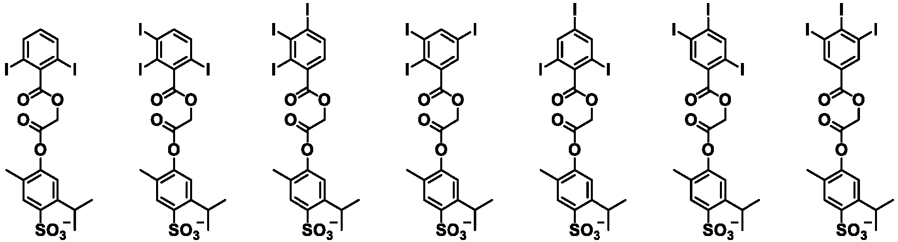

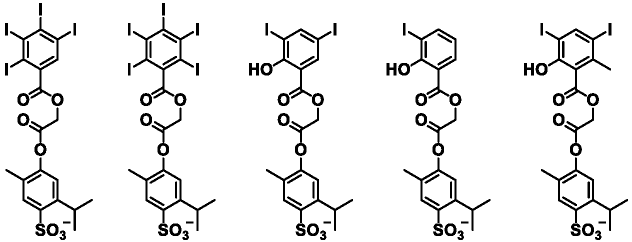

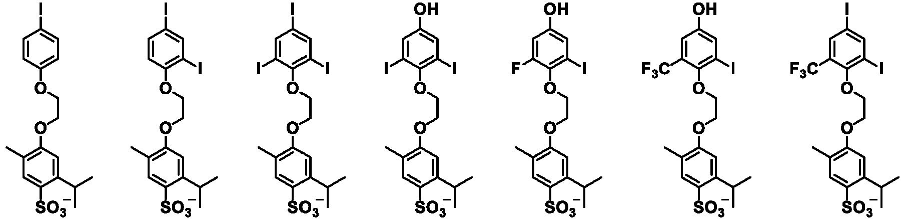

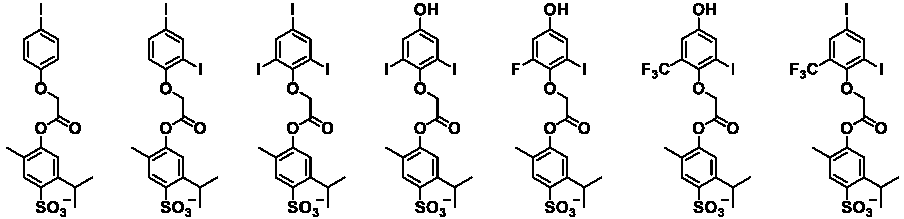

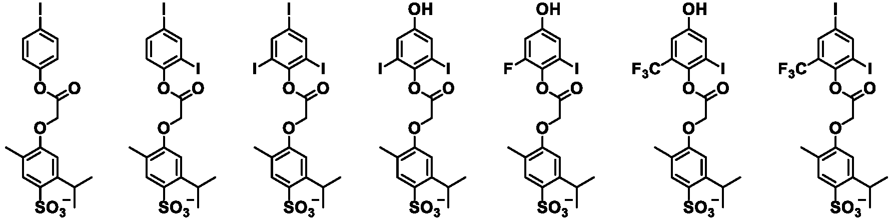

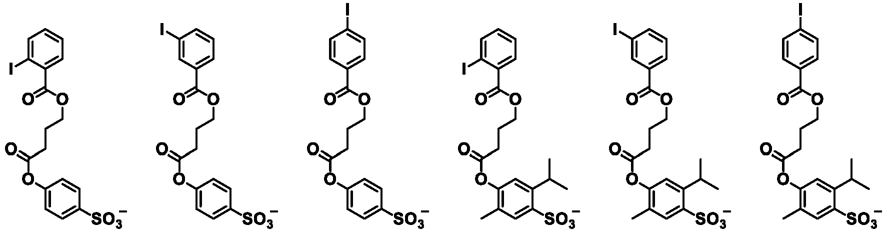

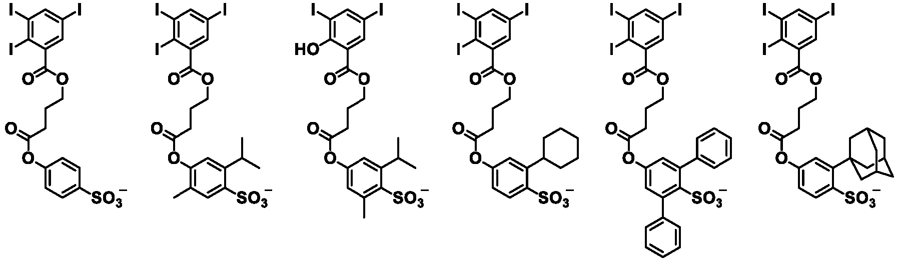

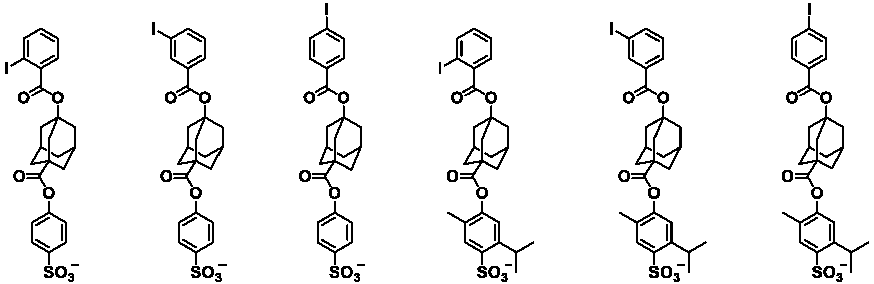

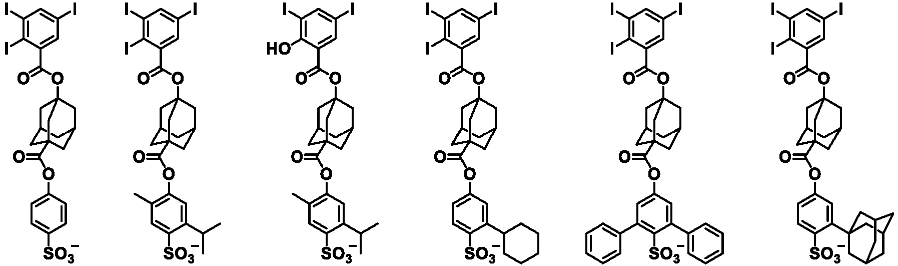

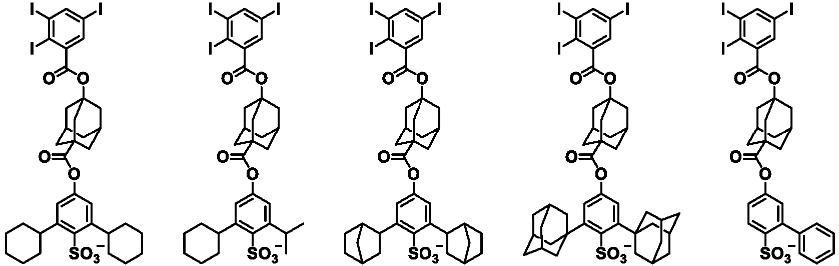

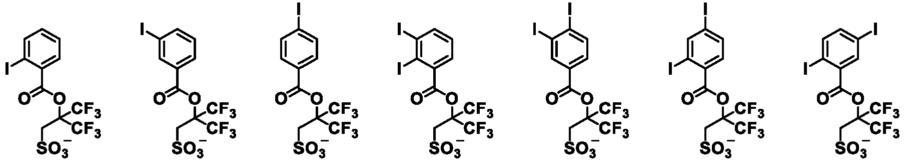

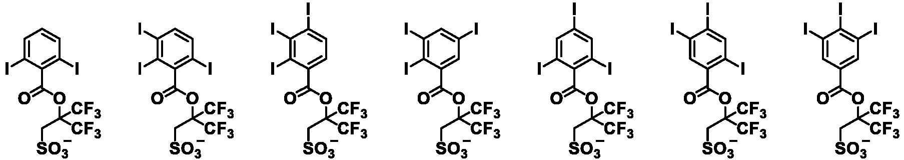

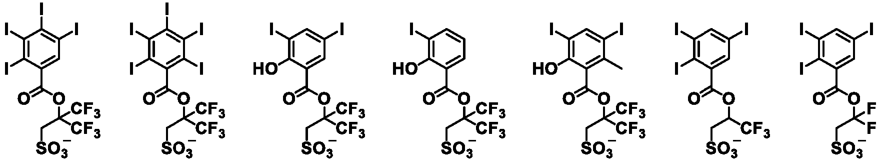

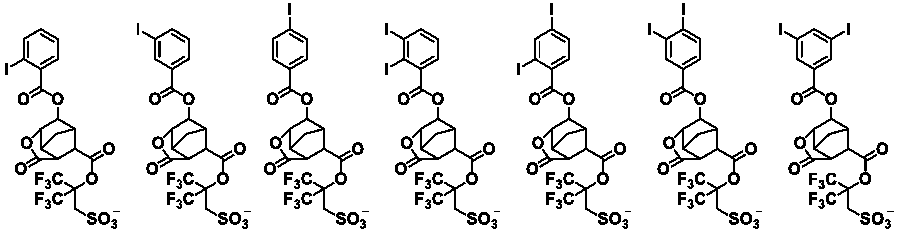

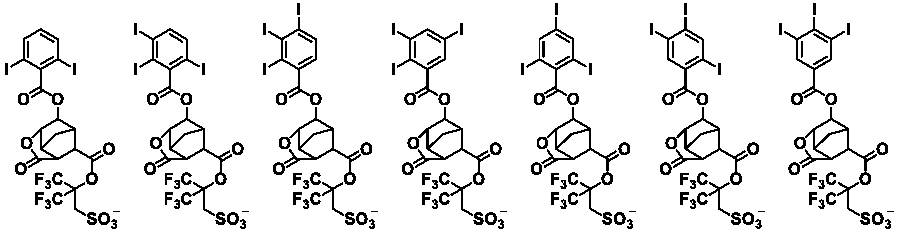

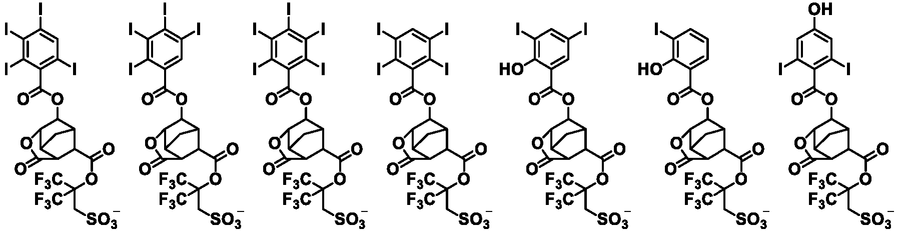

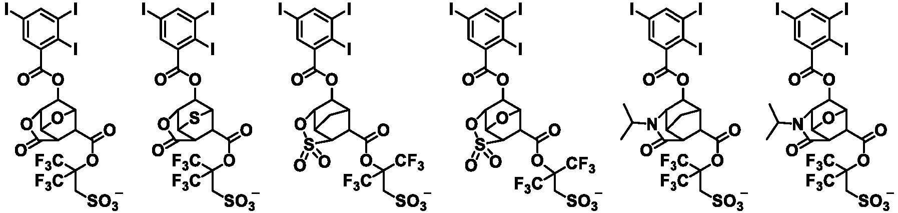

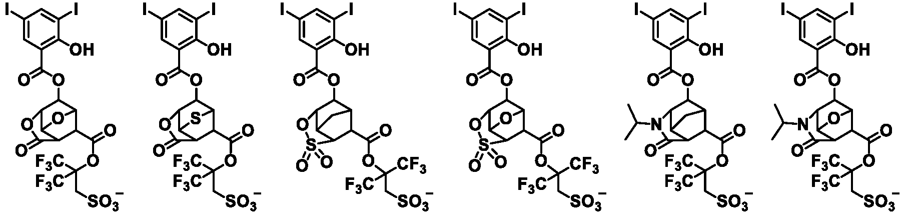

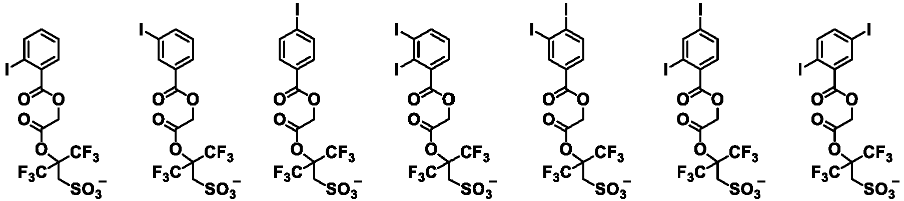

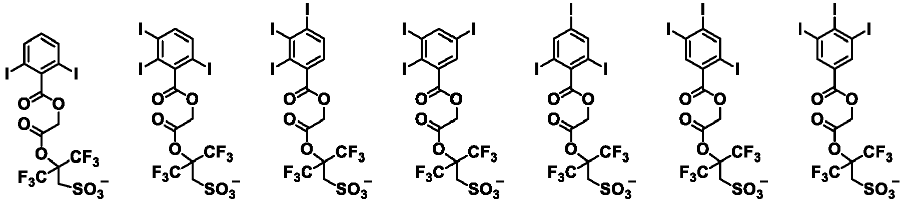

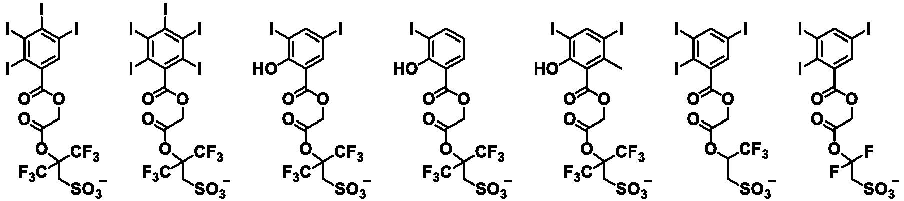

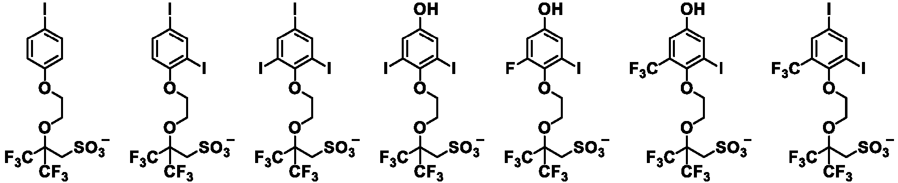

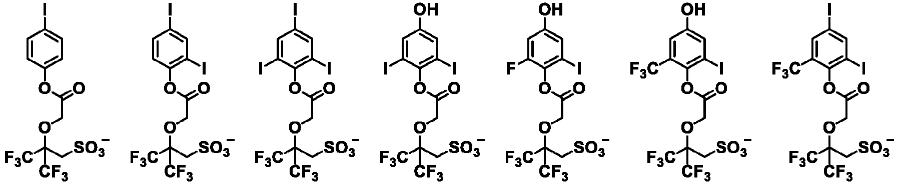

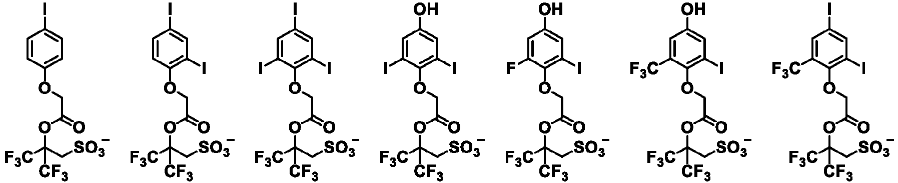

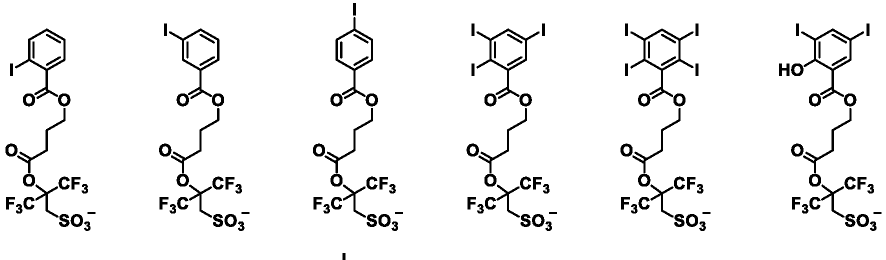

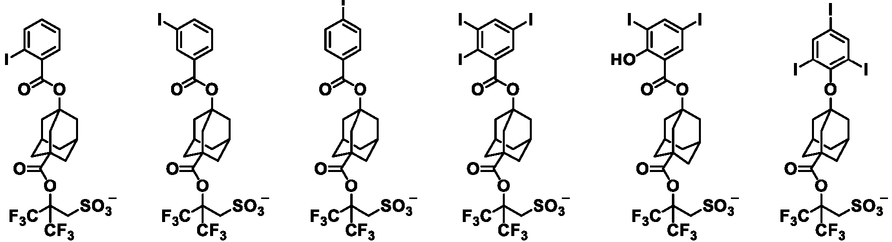

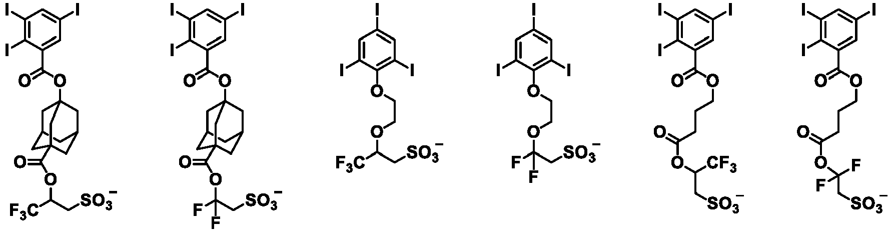

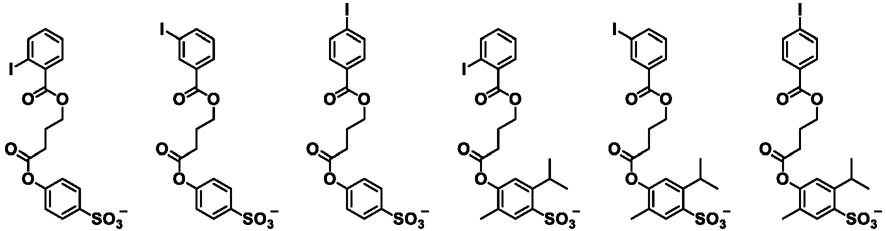

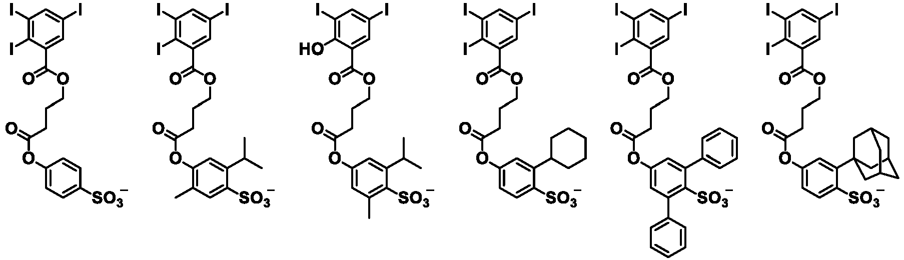

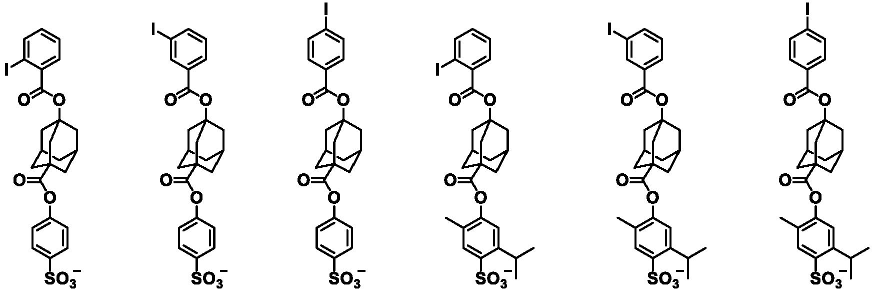

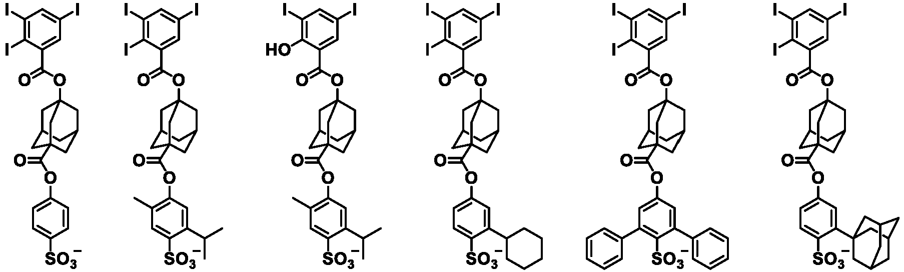

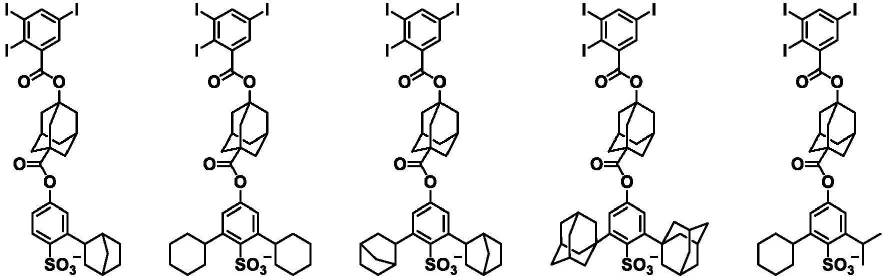

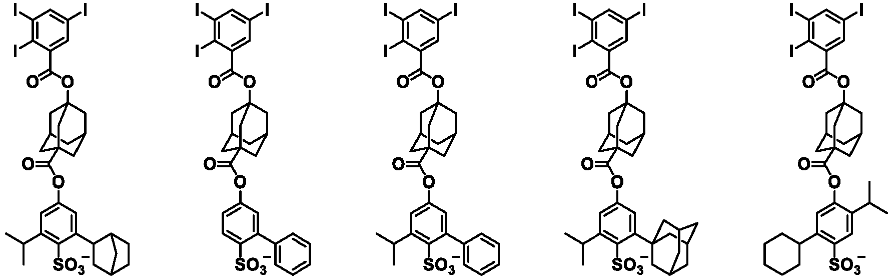

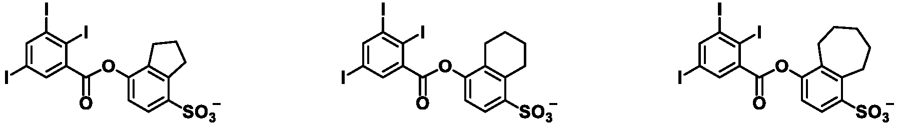

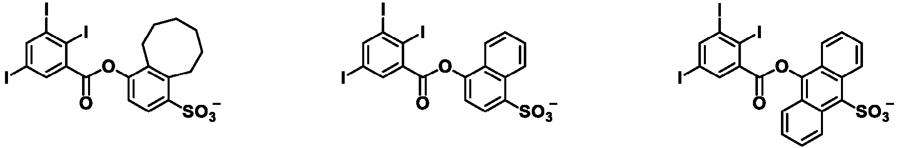

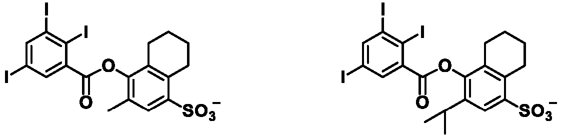

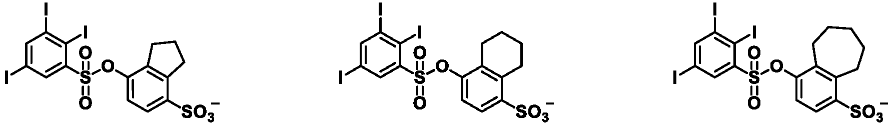

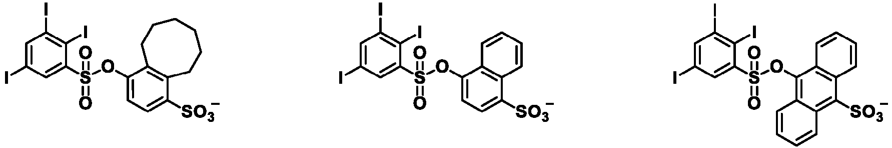

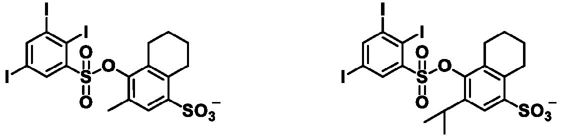

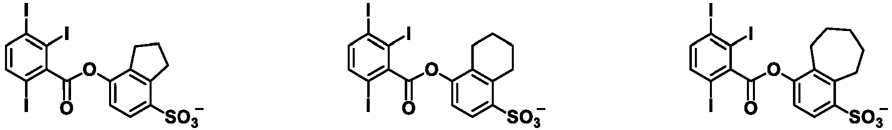

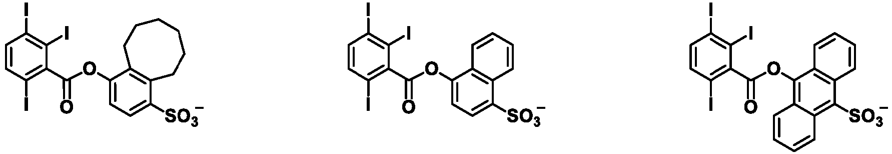

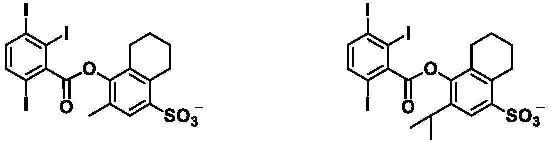

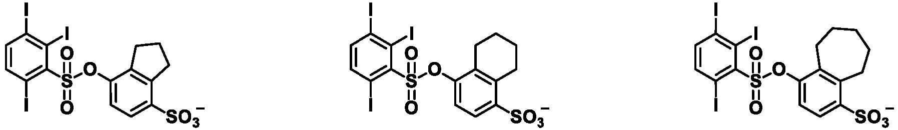

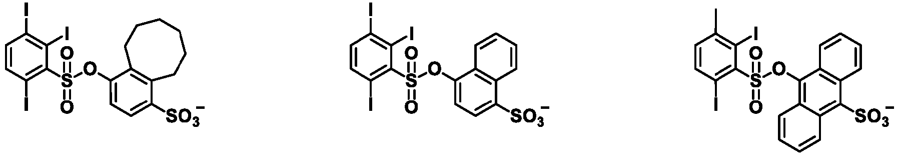

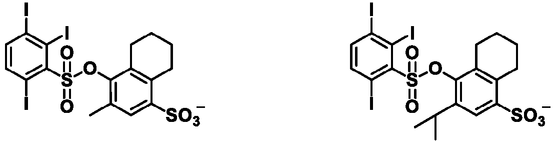

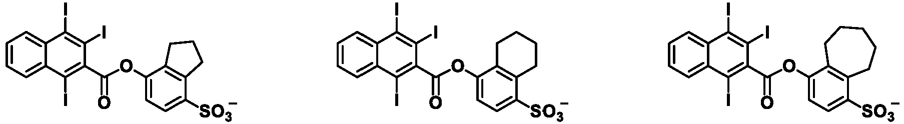

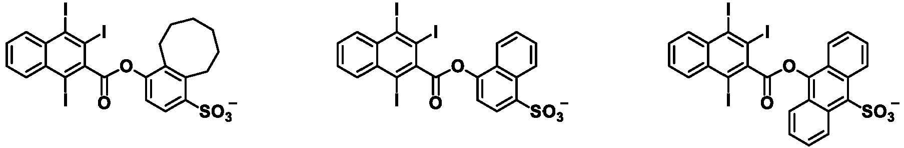

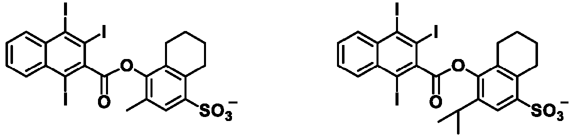

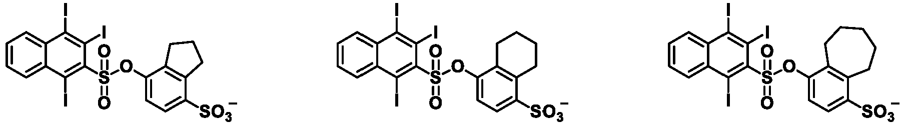

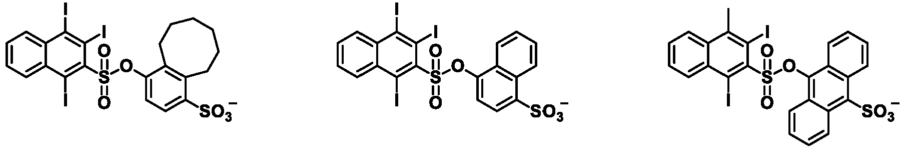

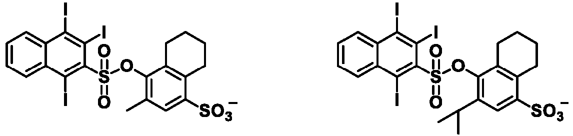

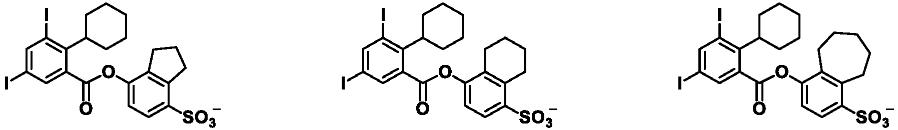

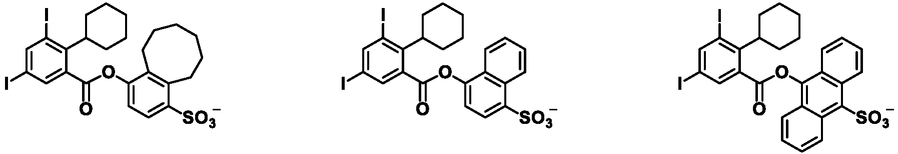

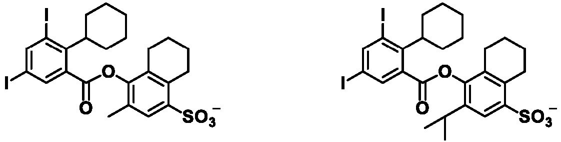

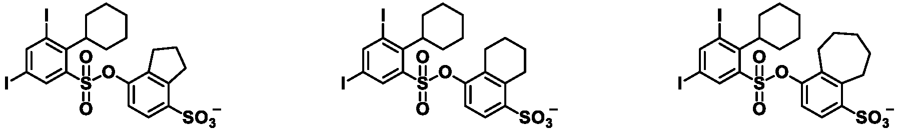

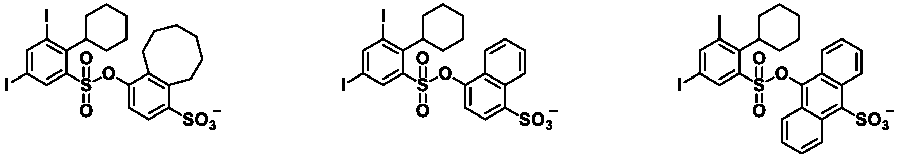

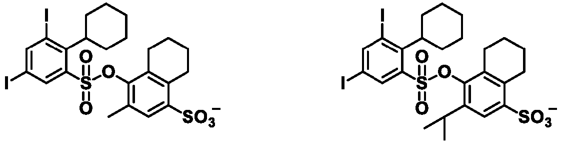

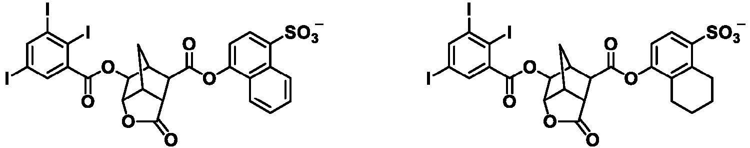

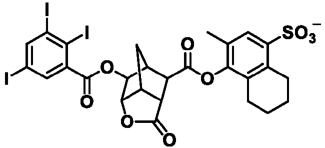

Preferred examples of the cation that pairs with the anion in the photoacid generator (E) include sulfonium cations and iodonium cations. Examples of the sulfonium cation are as exemplified for the sulfonium cation represented by formula (cation-1), but not limited thereto. Examples of the iodonium cation are as exemplified for the sulfonium cation represented by formula (cation-2), but not limited thereto.

The PAG generates an acid having a pKa value of preferably -2.0 or larger, more preferably -1.0 or larger. The upper limit of pKa is preferably 2.0. Notably, the pKa value is computed using pKa DB in software ACD/Chemsketch ver: 9.04 of Advanced Chemistry Development Inc.

When the inventive chemically amplified positive resist composition comprises photoacid generator (E), the content of the photoacid generator (E) is preferably 1 to 10 parts by weight, more preferably 1 to 5 parts by weight per 80 parts by weight of the base polymer. The incorporation of the photoacid generator (E) can appropriately adjust the amount of an acid generated in the exposed regions and the ability to inhibit dissolution of the unexposed regions. The photoacid generator (E) may be used alone or in admixture.

When the inventive chemically amplified positive resist composition contains both the photoacid generator (E) and the quencher (B), the weight ratio of the photoacid generator to the quencher (photoacid generator/quencher) is preferably less than 3/1, more preferably less than 2.5/1, even more preferably less than 2/1. As long as the weight ratio of the PAG to the quencher in the chemically amplified positive resist composition is in the range, the resist composition is able to fully suppress acid diffusion, leading to improved resolution and dimensional uniformity.

### (F) Surfactant

The inventive chemically amplified positive resist composition may contain any conventional surfactants as component (F) for facilitating to coat the composition to the substrate. A number of surfactants are known in the art as described in WO 2006/121096, JP-A 2008-102383, JP-A 2008-304590, JP-A 2004-115630 and JP-A 2005-8766, and any suitable one may be chosen therefrom.

When the inventive chemically amplified positive resist composition comprises surfactant (F), the content of the surfactant (F) is preferably 2 parts by weight or less, more preferably 1 part by weight or less per 80 parts by weight of the base polymer (A). The lower limit thereof is preferably 0.01 parts by weight or more. The surfactant (F) may be used alone or in admixture.

### Resist pattern forming process

The inventive resist pattern forming process comprises the steps of: applying the chemically amplified positive resist composition defined herein onto a substrate to form a resist film thereon, exposing the resist film to a pattern of high-energy radiation, and developing the exposed resist film in an alkaline developer.

The substrate used herein may be a substrate for integrated circuitry fabrication, e.g., Si, SiO, SiO₂, SiN, SiON, TiN, WSi, BPSG, SOG, organic antireflective film, etc. or a substrate for mask circuitry fabrication, e.g., Cr, CrO, CrON, MoSi₂, Si, SiO, SiO₂, etc. The coating is prebaked on a hot plate at a temperature of preferably 60 to 150°C for 1 to 20 minutes, more preferably at 80 to 140°C for 1 to 10 minutes. The resulting resist film is generally 0.03 to 2 µm thick.

The resist film is then exposed to a desired pattern of high-energy radiation. Examples of the high-energy radiation include UV, deep-UV, excimer laser radiation (e.g., KrF or ArF), EB, EUV, X-rays, γ-rays and synchrotron radiation.

When UV, deep-UV, excimer laser, EUV, X-rays, γ-rays, or synchrotron radiation is used as the high-energy radiation, the resist film is exposed thereto through a mask having a desired pattern preferably at a dose of about 1 to 300 mJ/cm², more preferably 10 to 200 mJ/cm². On use of EB as the high-energy radiation, a pattern is written directly preferably in a dose of 1 to 300 µC/cm², more preferably 10 to 200 µC/cm². The inventive chemically amplified positive resist composition is particularly for EUV or EB lithography.

The exposure may be performed by conventional lithography whereas the immersion lithography of holding a liquid, typically water between the resist film and the mask may be employed if desired. In the case of immersion lithography, a protective film which is insoluble in water may be formed on the resist film.

After the exposure, the resist film may be baked (PEB) on a hotplate preferably at 60 to 150°C for 1 to 20 minutes, more preferably at 80 to 140°C for 1 to 10 minutes.

After the exposure or PEB, the resist film is developed in a developer in the form of an aqueous alkaline solution for preferably 0.1 to 3 minutes, more preferably 0.5 to 2 minutes by conventional techniques such as dip, puddle and spray techniques. A preferable developer is a 0.1 to 5 wt%, more preferably 2 to 3 wt% aqueous solution of tetramethylammonium hydroxide (TMAH) or another alkali. In this way, the desired pattern is formed on the substrate.

The inventive chemically amplified positive resist composition has particularly high etch resistance, and is effectively used under conditions required to ensure that even when the time until PEB after exposure is extended, the change of the pattern line width as well as LER is small. The resist composition is effectively applicable to a substrate, specifically a substrate having a surface layer of material to which a resist film is less adherent and which is likely to invite pattern stripping or pattern collapse. A typical substrate has sputter deposited on their outermost surface metallic chromium or a chromium compound containing at least one light element selected from oxygen, nitrogen and carbon. The inventive chemically amplified positive resist composition is effective for pattern formation using a photomask blank as a substrate.

### EXAMPLES

Hereinafter, the present invention is specifically described with reference to a Synthesis Example, Examples, and Comparative Examples, but the present invention is not limited to the following Examples.

### [1] Synthesis of base polymer

The monomers used for base polymers are as follows.

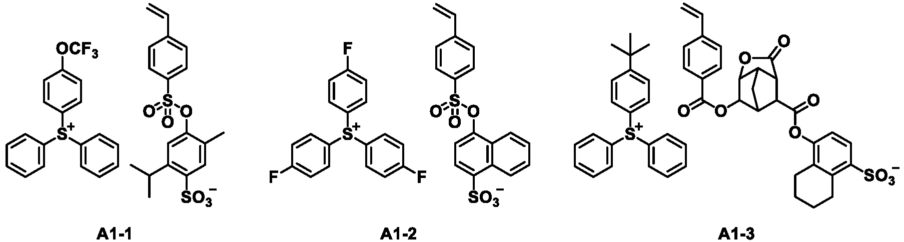

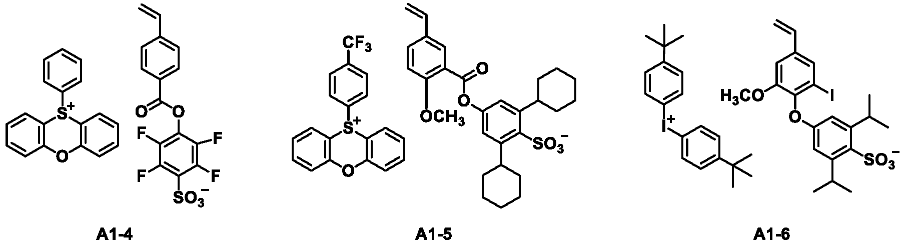

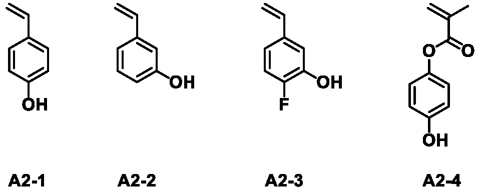

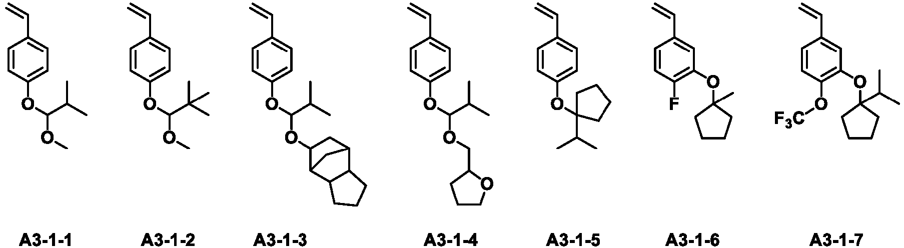

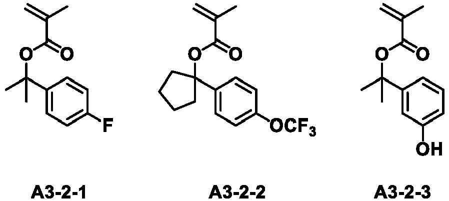

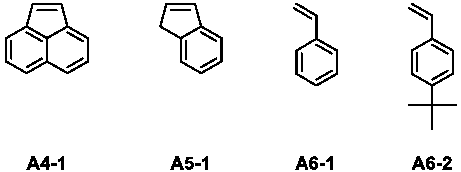

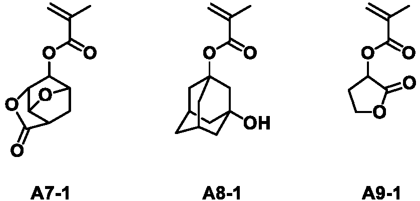

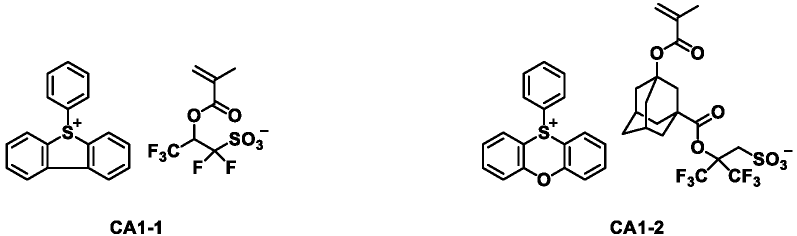

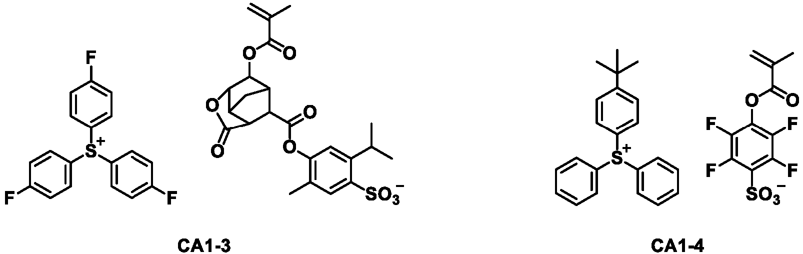

### Synthesis Example 1

### Synthesis of Polymer P-1

A flask under nitrogen atmosphere was charged with 21.1 g of Monomer A1-1, 41.0 g of Monomer A2-1-1, 29.3 g of Monomer A3-1-1, 8.6 g of Monomer A4-1, 3.74 g of V-601 (manufactured by Fujifilm Wako Pure Chemical Corp.), and 139 g of MEK to prepare a monomer/initiator solution. Another flask under nitrogen atmosphere was charged with 46 g of MEK, which was heated to 80°C with stirring. The monomer/initiator solution was added dropwise to the MEK over 4 hours. After the completion of dropwise addition, the polymerization solution was continuously stirred for 2 hours while maintaining the temperature of 80°C, and then cooled to room temperature. The obtained polymerization solution was added dropwise to 3,000 g of hexane with vigorous stirring, and the precipitated polymer was separated by filtration. The precipitate was washed twice with 600 g of hexane and vacuum dried at 50°C for 20 hours to obtain Polymer P-1 as white powder (amount 97.1 g, yield 97%). Polymer P-1 had a Mw of 9,800 and a Mw/Mn of 1.67. It is noted that Mw is as measured by GPC versus polystyrene standards using DMF solvent.

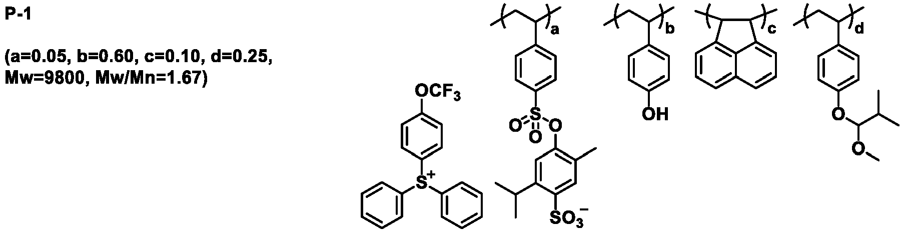

### Synthesis Examples 2 to 25 and Comparative Synthesis Examples 1 to 21

### Synthesis of Polymers P-2 to P-25 and Comparative Polymers CP-1 to CP-21

Polymers as shown in Tables 1 and 2 were synthesized by the same procedure as in Synthesis Example 1 except that the type and amount of monomers were changed.

**Table 1**

| Polymer | Unit 1 | Incorporation ratio (mol%) | Unit 2 | Incorporation ratio (mol%) | Unit 3 | Incorporation ratio (mol%) | Unit 4 | Incorporation ratio (mol%) | Unit 5 | Incorporation ratio (mol%) | Mw | Mw/Mn |
|---|---|---|---|---|---|---|---|---|---|---|---|---|
| P-1 | A1-1 | 5 | A2-1 | 60 | A3-1-1 | 25 | A4-1 | 10 | - | - | 9,800 | 1.67 |
| P-2 | A1-2 | 5 | A2-1 | 60 | A3-1-1 | 25 | A4-1 | 10 | - | - | 9,600 | 1.65 |
| P-3 | A1-3 | 5 | A2-1 | 60 | A3-1-1 | 25 | A4-1 | 10 | - | - | 9,700 | 1.64 |
| P-4 | A1-4 | 5 | A2-1 | 60 | A3-1-1 | 25 | A4-1 | 10 | - | - | 9,900 | 1.66 |
| P-5 | A1-5 | 5 | A2-1 | 60 | A3-1-1 | 25 | A4-1 | 10 | - | - | 9,600 | 1.66 |
| P-6 | A1-6 | 5 | A2-1 | 60 | A3-1-1 | 25 | A4-1 | 10 | - | - | 9,800 | 1.65 |
| P-7 | A1-1 | 5 | A2-2 | 60 | A3-1-1 | 25 | A4-1 | 10 | - | - | 9,800 | 1.63 |
| P-8 | A1-1 | 5 | A2-3 | 60 | A3-1-1 | 25 | A5-1 | 10 | - | - | 9,600 | 1.67 |
| P-9 | A1-1 | 5 | A2-4 | 60 | A3-1-1 | 25 | A6-1 | 10 | - | - | 9,500 | 1.67 |
| P-10 | A1-1 | 5 | A2-1 | 60 | A3-1-2 | 25 | A4-1 | 10 | - | - | 9,800 | 1.65 |
| P-11 | A1-1 | 5 | A2-1 | 60 | A3-1-3 | 25 | A4-1 | 10 | - | - | 9,900 | 1.66 |
| P-12 | A1-2 | 5 | A2-1 | 60 | A3-1-4 | 25 | A6-1 | 10 | - | - | 9,300 | 1.63 |
| P-13 | A1-1 | 5 | A2-1 | 60 | A3-1-5 | 25 | A4-1 | 10 | - | - | 9,200 | 1.69 |
| P-14 | A1-3 | 5 | A2-1 | 60 | A3-1-6 | 25 | A6-2 | 10 | - | - | 9,400 | 1.68 |
| P-15 | A1-1 | 5 | A2-1 | 60 | A3-1-7 | 25 | A4-1 | 10 | - | - | 9,800 | 1.63 |
| P-16 | A1-4 | 8 | A2-2 | 65 | A3-2-1 | 22 | A6-1 | 5 | - | - | 9,900 | 1.66 |
| P-17 | A1-2 | 10 | A2-3 | 62 | A3-2-2 | 23 | A7-1 | 5 | - | - | 9,500 | 1.63 |
| P-18 | A1-5 | 10 | A2-3 | 55 | A3-2-3 | 23 | A4-1 | 12 | - | - | 9,700 | 1.65 |
| P-19 | A1-1 | 7 | A2-4 | 58 | A3-1-7 | 20 | A4-1 | 10 | A7-1 | 5 | 9,200 | 1.64 |
| P-20 | A1-1 | 5 | A2-1 | 60 | A3-1-4 | 25 | - | - | A8-1 | 10 | 9,300 | 1.66 |
| P-21 | A1-2 | 10 | A2-2 | 55 | A3-1-6 | 25 | A7-1 | 5 | A9-1 | 10 | 9,300 | 1.68 |
| P-22 | A1-4 | 8 | A2-1 | 62 | A3-1-7 | 20 | - | - | A9-1 | 10 | 9,600 | 1.65 |
| P-23 | A1-4 | 8 | A2-2 | 55 | A3-1-2 | 24 | A6-1 | 5 | A7-1 | 8 | 9,800 | 1.67 |
| P-24 | A1-1 | 10 | A2-1 | 65 | A3-1-3 | 25 | - | - | - | - | 9,400 | 1.64 |
| P-25 | A1-6 | 5 | A2-3 | 60 | A3-1-2 | 25 | A4-1 | 5 | A9-1 | 5 | 9,800 | 1.68 |

**Table 2**

| Polymer | Unit 1 | Incorporation ratio (mol%) | Unit 2 | Incorporation ratio (mol%) | Unit 3 | Incorporation ratio (mol%) | Unit 4 | Incorporation ratio (mol%) | Unit 5 | Incorporation ratio (mol%) | Mw | Mw/Mn |
|---|---|---|---|---|---|---|---|---|---|---|---|---|
| CP-1 | CA1-1 | 5 | A2-1 | 60 | A3-1-1 | 25 | A4-1 | 10 | - | - | 9,700 | 1.66 |
| CP-2 | CA1-2 | 5 | A2-1 | 60 | A3-1-1 | 25 | A4-1 | 10 | - | - | 9,400 | 1.65 |
| CP-3 | CA1-3 | 5 | A2-1 | 60 | A3-1-1 | 25 | A4-1 | 10 | - | - | 9,600 | 1.68 |
| CP-4 | CA1-4 | 5 | A2-1 | 60 | A3-1-1 | 25 | A4-1 | 10 | - | - | 9,300 | 1.67 |
| CP-5 | CA1-1 | 5 | A2-2 | 60 | A3-1-1 | 25 | A4-1 | 10 | - | - | 9,700 | 1.63 |
| CP-6 | CA1-2 | 5 | A2-3 | 60 | A3-1-1 | 25 | A5-1 | 10 | - | - | 9,600 | 1.65 |
| CP-7 | CA1-1 | 5 | A2-1 | 60 | A3-1-2 | 25 | A4-1 | 10 | - | - | 9,500 | 1.66 |
| CP-8 | CA1-2 | 5 | A2-1 | 60 | A3-1-3 | 25 | A4-1 | 10 | - | - | 9,400 | 1.68 |
| CP-9 | CA1-3 | 5 | A2-1 | 60 | A3-1-4 | 25 | A6-1 | 10 | - | - | 9,500 | 1.65 |
| CP-10 | CA1-4 | 5 | A2-1 | 60 | A3-1-5 | 25 | A4-1 | 10 | - | - | 9,800 | 1.67 |
| CP-11 | CA1-3 | 5 | A2-1 | 60 | A3-1-6 | 25 | A6-2 | 10 | - | - | 9,300 | 1.65 |
| CP-12 | CA1-4 | 5 | A2-1 | 60 | A3-1-7 | 25 | A4-1 | 10 | - | - | 9,400 | 1.65 |
| CP-13 | CA1-1 | 10 | A2-3 | 62 | A3-2-1 | 23 | A7-1 | 5 | - | - | 9,500 | 1.63 |
| CP-14 | CA1-3 | 7 | A2-4 | 58 | A3-1-7 | 20 | A4-1 | 10 | A7-1 | 5 | 9,200 | 1.64 |
| CP-15 | CA1-2 | 5 | A2-1 | 60 | A3-1-4 | 25 | - | - | A8-1 | 10 | 9,300 | 1.66 |
| CP-16 | CA1-4 | 8 | A2-1 | 62 | A3-1-7 | 20 | - | - | A9-1 | 10 | 9,600 | 1.65 |
| CP-17 | A2-1 | 70 | A3-1-3 | 18 | B3-3 | 12 | - | - | - | - | 4,500 | 1.47 |
| CP-18 | A2-1 | 60 | A3-1-4 | 25 | A4-1 | 10 | - | - | - | - | 5,600 | 1.57 |
| CP-19 | A2-2 | 56 | A3-1-2 | 26 | A4-1 | 8 | A7-1 | 10 | - | - | 6,000 | 1.41 |
| CP-20 | A2-1 | 60 | A3-1-6 | 25 | B3-4 | 10 | - | - | - | - | 5,800 | 1.57 |
| CP-21 | A2-3 | 70 | A3-1-5 | 15 | A3-2-1 | 15 | - | - | - | - | 4,900 | 1.52 |

### [2] Preparation of chemically amplified positive resist composition

### Examples 1-1 to 1-31 and Comparative Examples 1-1 to 1-25

A chemically amplified positive resist composition was prepared by dissolving selected components in an organic solvent in accordance with the formulation shown in Tables 3 to 4 and filtering the solution through a nylon filter with a pore size of 5 nm and a UPE filter with a pore size of 1 nm. The organic solvent was a mixture of 940 pbw of PGMEA, 1,870 pbw of EL, and 1,870 pbw of PGME.

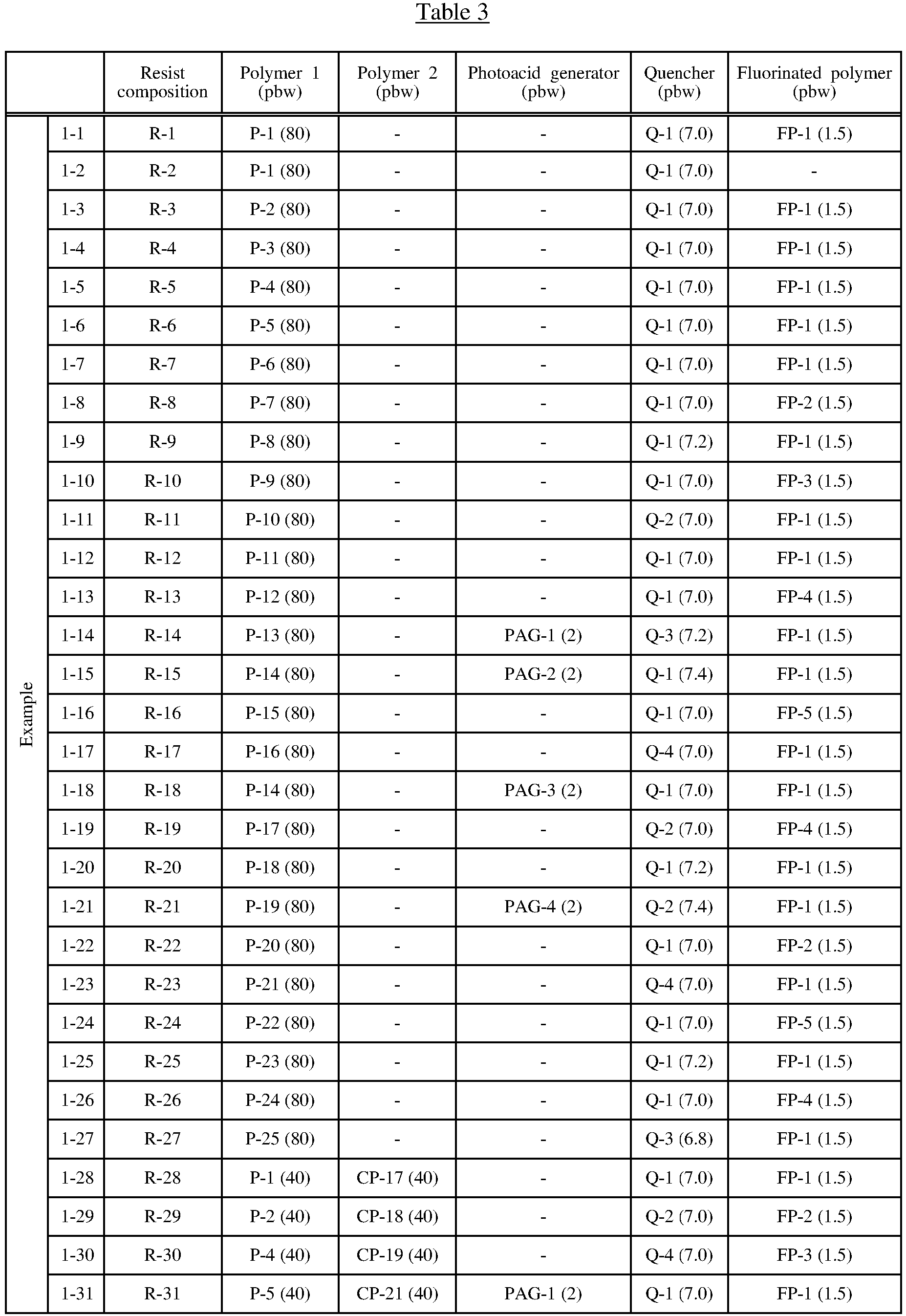

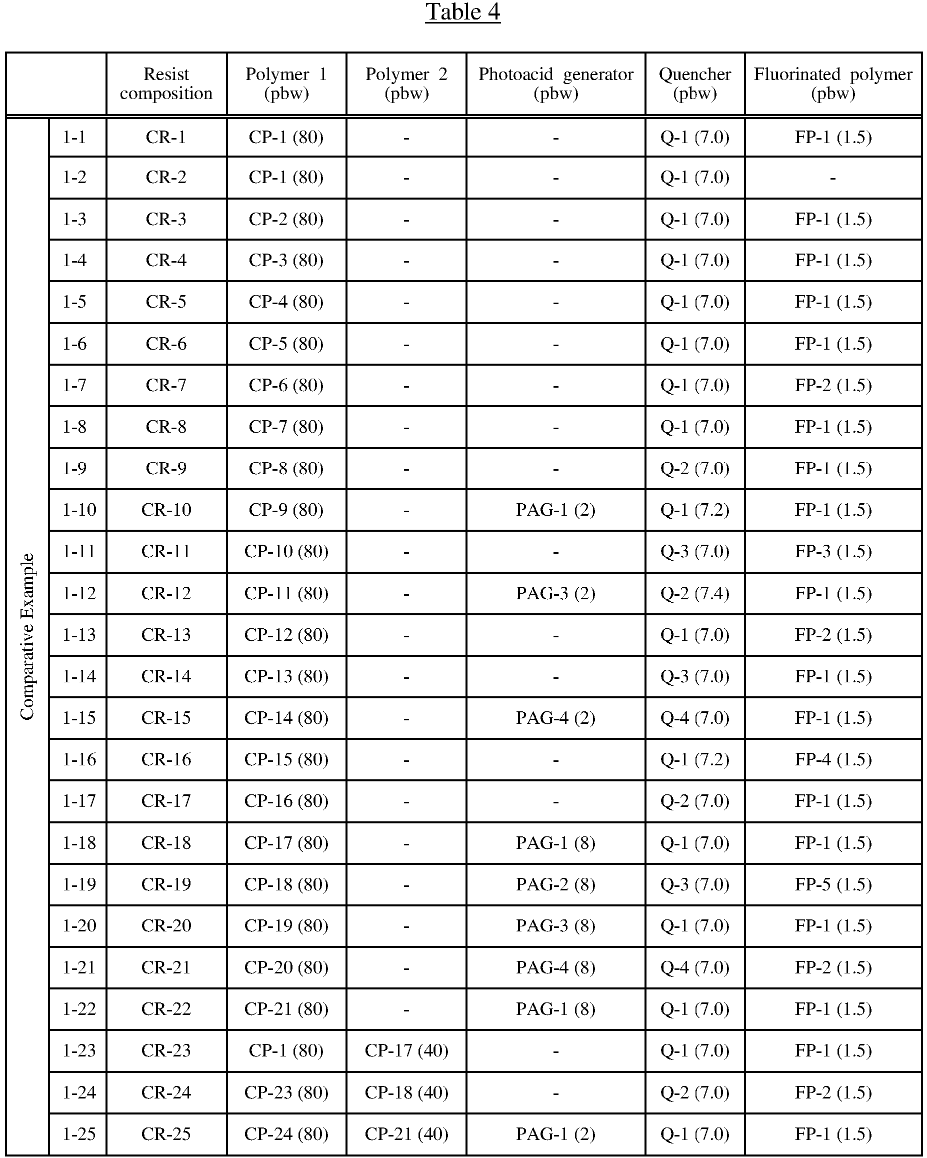

Photoacid generators PAG-1 to PAG-4, quenchers Q-1 to Q-4 and fluorinated polymers FP-1 to FP-5 in Tables 3 and 4 are identified below.

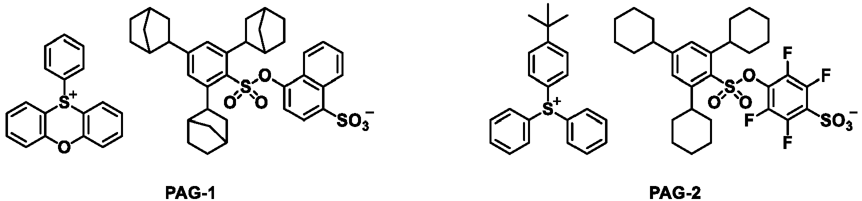

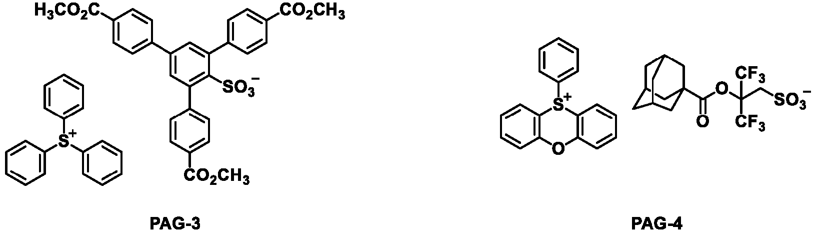

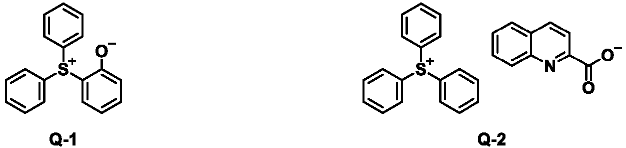

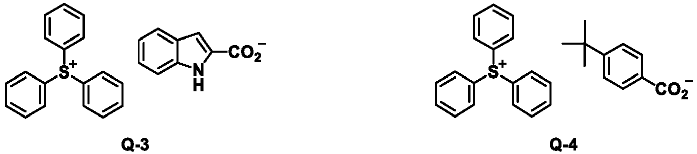

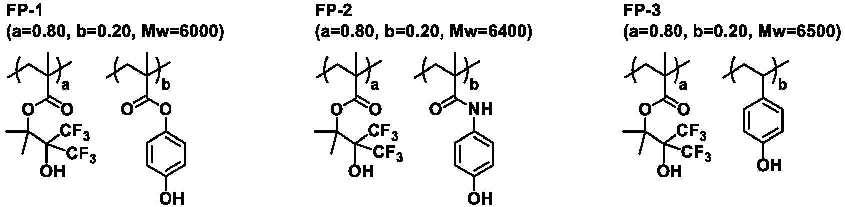

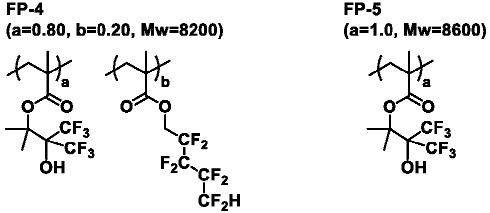

### [3] EB lithography test

### Examples 2-1 to 2-31 and Comparative Examples 2-1 to 2-25

There was furnished a reflection type mask blank for EUV lithography masks. Namely, a mask blank was furnished by forming a multilayer reflective film of 40 Mo/Si layers having a thickness of 284 nm on a low thermal expansion glass substrate of 6 inch squares, then successively depositing thereon a Ru film of 3.5 nm thick as a protective film, a TaN film of 70 nm thick as an absorber layer, and a CrN film of 6 nm thick as a hard mask.

Using a coater/developer system ACT-M (Tokyo Electron Ltd.), each of the positive resist compositions (R-1 to R-31, CR-1 to CR-25) was spin coated onto the reflection type photomask blank and prebaked on a hotplate at 110°C for 600 seconds to form a resist film of 80 nm thick. The thickness of the resist film was measured by an optical film thickness measurement system Nanospec (Nanometrics Inc.). Measurement was made at 81 points in the plane of the blank substrate excluding an outer rim portion extending 10 mm inward from the periphery, and an average film thickness and a film thickness range were computed therefrom.

The resist film was exposed to EB using an EB writer system EBM-5000Plus (NuFlare Technology Inc., accelerating voltage 50 kV), then baked (PEB) at 110°C for 600 seconds, and developed in a 2.38 wt% TMAH aqueous solution, thereby yielding a positive pattern.

The resist pattern was evaluated as follows. The patterned mask blank was observed under a top-down scanning electron microscope (TD-SEM). The optimum dose (Eop) was defined as the exposure dose (µC/cm²) which provided a 1:1 resolution at the top and bottom of a 200-nm 1:1 line-and-space (LS) pattern. The resolution (or maximum IS resolution) was defined as the minimum size at the dose which provided a 9:1 resolution for an isolated space (IS) of 200 nm. The edge roughness (LER) of a 200-nm LS pattern was measured under SEM. The pattern was visually observed to judge whether or not the profile was rectangular. The results are shown in Tables 5 and 6.

**Table 5**

| | | Resist composition | Optimal exposure dose (µC/cm²) | Maximum IS resolution (nm) | LER (nm) | Pattern profile |
|---|---|---|---|---|---|---|
| Example | 2-1 | R-1 | 200 | 15 | 3.6 | rectangular |
| | 2-2 | R-2 | 205 | 17 | 3.7 | rectangular |
| | 2-3 | R-3 | 200 | 17 | 3.6 | rectangular |
| | 2-4 | R-4 | 210 | 16 | 3.8 | rectangular |
| | 2-5 | R-5 | 200 | 17 | 3.6 | rectangular |
| | 2-6 | R-6 | 205 | 17 | 3.7 | rectangular |
| | 2-7 | R-7 | 210 | 16 | 3.7 | rectangular |
| | 2-8 | R-8 | 200 | 17 | 3.8 | rectangular |
| | 2-9 | R-9 | 205 | 15 | 3.5 | rectangular |
| | 2-10 | R-10 | 200 | 16 | 3.7 | rectangular |
| | 2-11 | R-11 | 210 | 17 | 3.8 | rectangular |
| | 2-12 | R-12 | 200 | 16 | 3.6 | rectangular |
| | 2-13 | R-13 | 205 | 16 | 3.6 | rectangular |
| | 2-14 | R-14 | 200 | 17 | 3.7 | rectangular |
| | 2-15 | R-15 | 210 | 16 | 3.6 | rectangular |
| | 2-16 | R-16 | 200 | 17 | 3.8 | rectangular |
| | 2-17 | R-17 | 205 | 17 | 3.6 | rectangular |
| | 2-18 | R-18 | 210 | 16 | 3.7 | rectangular |
| | 2-19 | R-19 | 200 | 17 | 3.6 | rectangular |
| | 2-20 | R-20 | 205 | 16 | 3.8 | rectangular |
| | 2-21 | R-21 | 200 | 15 | 3.6 | rectangular |
| | 2-22 | R-22 | 210 | 17 | 3.7 | rectangular |
| | 2-23 | R-23 | 205 | 16 | 3.6 | rectangular |
| | 2-24 | R-24 | 200 | 17 | 3.8 | rectangular |
| | 2-25 | R-25 | 210 | 17 | 3.9 | rectangular |
| | 2-26 | R-26 | 205 | 16 | 3.6 | rectangular |
| | 2-27 | R-27 | 200 | 18 | 3.7 | rectangular |
| | 2-28 | R-28 | 205 | 15 | 3.8 | rectangular |
| | 2-29 | R-29 | 210 | 17 | 3.6 | rectangular |
| | 2-30 | R-30 | 205 | 16 | 3.7 | rectangular |
| | 2-31 | R-31 | 200 | 17 | 3.8 | rectangular |

**Table 6**

| | | Resist composition | Optimal exposure dose (µC/cm²) | Maximum IS resolution (nm) | LER (nm) | Pattern profile |
|---|---|---|---|---|---|---|
| Comparative Example | 2-1 | CR-1 | 200 | 22 | 4.3 | rectangular |
| | 2-2 | CR-2 | 210 | 21 | 4.1 | rectangular |
| | 2-3 | CR-3 | 200 | 22 | 4.3 | rectangular |
| | 2-4 | CR-4 | 205 | 22 | 4.2 | rectangular |
| | 2-5 | CR-5 | 200 | 21 | 4.1 | rectangular |
| | 2-6 | CR-6 | 210 | 22 | 4.2 | rectangular |
| | 2-7 | CR-7 | 205 | 20 | 4.3 | rectangular |
| | 2-8 | CR-8 | 200 | 22 | 4.3 | rectangular |
| | 2-9 | CR-9 | 210 | 22 | 4.1 | rectangular |
| | 2-10 | CR-10 | 205 | 21 | 4.3 | rectangular |
| | 2-11 | CR-11 | 200 | 22 | 4.2 | rectangular |
| | 2-12 | CR-12 | 205 | 20 | 4.3 | footing |
| | 2-13 | CR-13 | 210 | 22 | 4.1 | rectangular |
| | 2-14 | CR-14 | 200 | 22 | 4.1 | rectangular |
| | 2-15 | CR-15 | 210 | 21 | 4.2 | rectangular |
| | 2-16 | CR-16 | 200 | 22 | 4.3 | footing |
| | 2-17 | CR-17 | 205 | 20 | 4.3 | rectangular |
| | 2-18 | CR-18 | 200 | 22 | 4.1 | rectangular |
| | 2-19 | CR-19 | 210 | 20 | 4.2 | footing |
| | 2-20 | CR-20 | 205 | 22 | 4.3 | rectangular |
| | 2-21 | CR-21 | 200 | 21 | 4.1 | footing |
| | 2-22 | CR-22 | 210 | 22 | 4.2 | rectangular |
| | 2-23 | CR-23 | 200 | 20 | 4.2 | footing |
| | 2-24 | CR-24 | 200 | 22 | 4.3 | rectangular |
| | 2-25 | CR-25 | 210 | 21 | 4.1 | rectangular |

As is apparent from the results shown in Tables 5 and 6, all the chemically amplified positive resist compositions (R-1 to R-31) within the scope of the invention show satisfactory IS resolution, LER and pattern rectangularity as compared with comparative resist compositions (CR-1 to CR-25).

### [4] Evaluation of dry etch resistance

### Examples 3-1 to 3-25 and Comparative Examples 3-1 to 3-21

Each of the polymers (P-1 to P-25 and CP-1 to CP-21 shown in Tables 1 and 2), 2 g, was dissolved in 10 g of cyclohexanone, and passed through a filter having a pore size of 0.2 µm, obtaining a polymer solution. The polymer solution was spin coated onto a mask blank of 152 mm squares having a chromium film as the outermost surface and baked to form a polymer film of 300 nm thick.

Using a mask dry etching instrument Gen-4 (Plasma Thermo Ltd.), the polymer film was etched with chlorine gas under the following conditions.

The difference in film thickness before and after etching was determined.

The etching conditions are shown below.

| | |
|---|---|
| Chamber pressure: | 6.0 mTorr |
| RF power: | 700 V |
| Cl₂ gas flow rate: | 185 sccm |
| O₂ gas flow rate: | 55 sccm |
| He gas flow rate: | 9 sccm |
| Time: | 75 sec |

In this evaluation, a smaller film thickness difference, i.e., a smaller amount of decrease, indicates higher etching resistance.

The results of dry etch resistance evaluation are shown in Tables 7 and 8.

**Table 7**

| | | Polymer | Cl₂/O₂-based gas etching rate (nm/min) |
|---|---|---|---|
| Example | 3-1 | P-1 | 95 |
| | 3-2 | P-2 | 94 |
| | 3-3 | P-3 | 97 |
| | 3-4 | P-4 | 96 |
| | 3-5 | P-5 | 96 |
| | 3-6 | P-6 | 96 |
| | 3-7 | P-7 | 98 |
| | 3-8 | P-8 | 97 |
| | 3-9 | P-9 | 96 |
| | 3-10 | P-10 | 97 |
| | 3-11 | P-11 | 96 |
| | 3-12 | P-12 | 95 |
| | 3-13 | P-13 | 96 |
| | 3-14 | P-14 | 96 |
| | 3-15 | P-15 | 98 |
| | 3-16 | P-16 | 96 |
| | 3-17 | P-17 | 98 |
| | 3-18 | P-18 | 97 |
| | 3-19 | P-19 | 96 |
| | 3-20 | P-20 | 96 |
| | 3-21 | P-21 | 99 |
| | 3-22 | P-22 | 98 |
| | 3-23 | P-23 | 99 |
| | 3-24 | P-24 | 97 |
| | 3-25 | P-25 | 96 |

**Table 8**

| | | Polymer | Cl₂/O₂-based gas etching rate (nm/min) |
|---|---|---|---|
| Comparative Example | 3-1 | CP-1 | 121 |
| | 3-2 | CP-2 | 110 |
| | 3-3 | CP-3 | 109 |
| | 3-4 | CP-4 | 112 |
| | 3-5 | CP-5 | 123 |
| | 3-6 | CP-6 | 106 |
| | 3-7 | CP-7 | 118 |
| | 3-8 | CP-8 | 106 |
| | 3-9 | CP-9 | 108 |
| | 3-10 | CP-10 | 104 |
| | 3-11 | CP-11 | 107 |
| | 3-12 | CP-12 | 115 |
| | 3-13 | CP-13 | 109 |
| | 3-14 | CP-14 | 108 |
| | 3-15 | CP-15 | 107 |
| | 3-16 | CP-16 | 107 |
| | 3-17 | CP-17 | 97 |
| | 3-18 | CP-18 | 98 |
| | 3-19 | CP-19 | 98 |
| | 3-20 | CP-20 | 98 |
| | 3-21 | CP-21 | 99 |

From the results shown in Tables 7 and 8, it is confirmed that the inventive polymer has excellent dry etch resistance to a Cl₂/O₂-based gas.

From the above results, it has been demonstrated that the chemically amplified positive resist compositions and resist pattern forming process according to the invention are useful in the photolithography for the fabrication of semiconductor devices, especially the processing of photomask blanks of transmission and reflection types.

## Claims

1. A chemically amplified positive resist composition comprising (A) a base polymer comprising a polymer containing repeat units having the formula (A1) and repeat units having the formula (A2), the polymer being adapted to increase its solubility in an aqueous alkaline under the action of an acid: 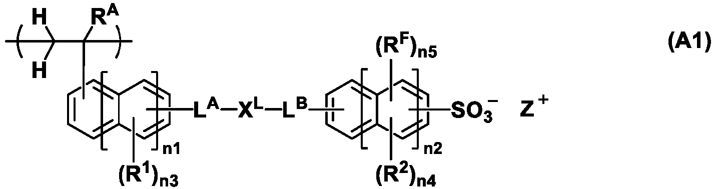
wherein n1 is 0 or 1, n2 is 0 or 1, n3 is an integer of 0 to 4, n4 is an integer of 0 to 4, n5 is an integer of 0 to 4, n4 + n5 is from 0 to 4 when n2 is 0, n4 + n5 is from 0 to 6 when n2 is 1, excluding that all n1 to n5 are 0,
R^{A} is a hydrogen atom, fluorine atom, methyl group or trifluoromethyl group,
R¹ is a halogen atom, nitro group, cyano group or C₁-C₂₀ hydrocarbyl group which may contain a heteroatom, and a plurality of R¹ may bond together to form a ring with the carbon atoms to which they are attached when n3 is 2 or more,
R² is a C₁-C₂₀ hydrocarbyl group which may contain a heteroatom, and a plurality of R² may bond together to form a ring with the carbon atom to which they are attached when n4 is 2 or more,
R^{F} is a fluorine atom, C₁-C₆ fluorinated alkyl group, C₁-C₆ fluorinated alkoxy group or C₁-C₆ fluorinated alkylthio group,
L^{A} and L^{B} are each independently a single bond, ether bond, ester bond, sulfonic ester bond, sulfonic amide bond, carbonate bond or carbamate bond,
X^{L} is a C₁-C₄₀ hydrocarbylene group which may contain a heteroatom, and
Z⁺ is an onium cation, 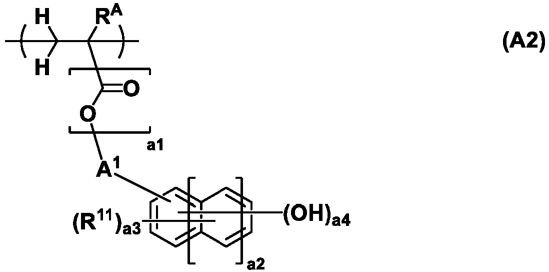
wherein a1 is 0 or 1, a2 is an integer of 0 to 2, a3 is an integer which satisfies 0 ≤ a3 ≤ 5+2(a2)-a4, and a4 is an integer of 1 to 3,
R^{A} is a hydrogen atom, fluorine atom, methyl group or trifluoromethyl group,
R¹¹ is a halogen atom, C₁-C₆ saturated hydrocarbyl group which may be substituted with a halogen atom, C₁-C₆ saturated hydrocarbyloxy group which may be substituted with a halogen atom, or C₂-C₈ saturated hydrocarbylcarbonyloxy group which may be substituted with a halogen atom, and
A¹ is a single bond or C₁-C₁₀ saturated hydrocarbylene group in which some constituent -CH₂- may be replaced by -O-.

2. The chemically amplified positive resist composition according to claim 1, wherein Z⁺ is a sulfonium cation having the formula (cation-1) or iodonium cation having the formula (cation-2): 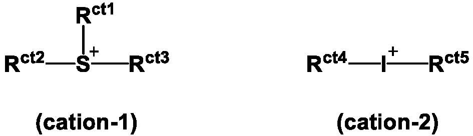 wherein R^{ct1} to R^{ct5} are each independently a halogen atom, or C₁-C₃₀ hydrocarbyl group which may contain a heteroatom, and R^{ct1} and R^{ct2} may bond together to form a ring with the sulfur atom to which they are attached.

3. The chemically amplified positive resist composition according to claim 1 or 2, wherein the polymer further comprises repeat units of at least one type selected from repeat units having the formula (A3-1) and repeat units having the formula (A3-2): 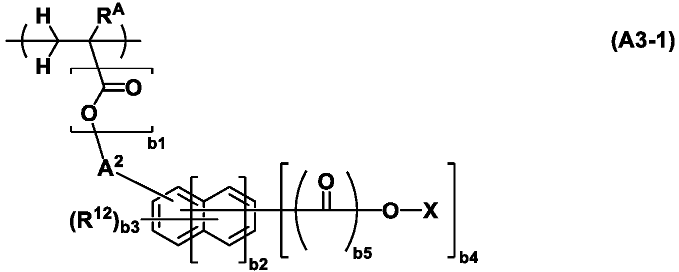 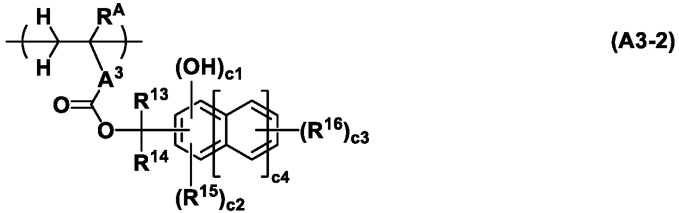 wherein b1 is 0 or 1, b2 is an integer of 0 to 2, b3 is an integer which satisfies 0 ≤ b3 ≤ 5+2(b2)-b4, b4 is an integer of 1 to 3, and b5 is 0 or 1,
c1 is an integer of 0 to 2, c2 is an integer of 0 to 2, c3 is an integer of 0 to 5, and c4 is an integer of 0 to 2,
R^{A} is a hydrogen atom, fluorine atom, methyl group or trifluoromethyl group,
R¹² is a halogen atom, C₁-C₆ saturated hydrocarbyl group which may be substituted with a halogen atom, C₁-C₆ saturated hydrocarbyloxy group which may be substituted with a halogen atom, or C₂-C₈ saturated hydrocarbylcarbonyloxy group which may be substituted with a halogen atom,
R¹³ and R¹⁴ are each independently a C₁-C₁₀ hydrocarbyl group which may contain a heteroatom, and R¹³ and R¹⁴ may bond together to form a ring with the carbon atom to which they are attached,
R¹⁵ is each independently a fluorine atom, C₁-C₅ fluorinated alkyl group or C₁-C₅ fluorinated alkoxy group,
R¹⁶ is each independently a C₁-C₁₀ hydrocarbyl group which may contain a heteroatom,
A² is a single bond or C₁-C₁₀ saturated hydrocarbylene group in which some constituent -CH₂- may be replaced by -O-,
X is an acid labile group when b4 is 1, and is each independently a hydrogen atom or acid labile group, at least one being an acid labile group, in case of b4 is 2 or 3, and
A³ is a single bond, phenylene group, naphthylene group or *-C(=O)-O-A³¹-, A³¹ is a C₁-C₂₀ aliphatic hydrocarbylene group, phenylene group, or naphthylene group, and the aliphatic hydrocarbylene group may contain at least one selected from a hydroxy group, an ether bond, an ester bond or a lactone ring, and the asterisk (*) designates a point of attachment to the carbon atom in the backbone.

4. The chemically amplified positive resist composition according to any one of claims 1 to 3, wherein the polymer further comprises repeat units of at least one type selected from repeat units having the formula (A4), repeat units having the formula (A5) and repeat units having the formula (A6): 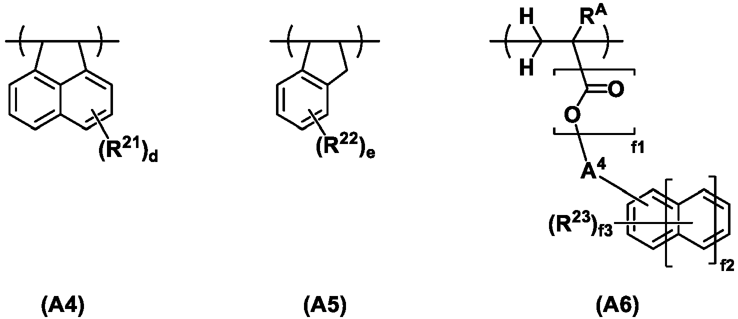 wherein d is an integer of 0 to 6, e is an integer of 0 to 4,
f1 is 0 or 1, f2 is an integer of 0 to 2, and f3 is an integer of 0 to 5,
R^{A} is a hydrogen atom, fluorine atom, methyl group or trifluoromethyl group,
R²¹ and R²² are each independently a hydroxy group, halogen atom, C₁-C₆ saturated hydrocarbyl group which may be substituted with a halogen atom, C₁-C₆ saturated hydrocarbyloxy group which may be substituted with a halogen atom, or C₂-C₈ saturated hydrocarbylcarbonyloxy group which may be substituted with a halogen atom,
R²³ is a halogen atom, nitro group, cyano group, C₁-C₂₀ saturated hydrocarbyl group, C₁-C₂₀ saturated hydrocarbyloxy group, C₂-C₂₀ saturated hydrocarbylcarbonyloxy group, C₂-C₂₀ saturated hydrocarbyloxyhydrocarbyl group or C₂-C₂₀ saturated hydrocarbylthiohydrocarbyl group, and may be a hydroxy group when f2 is 1 or 2, and
A⁴ is a single bond or C₁-C₁₀ saturated hydrocarbylene group in which some constituent -CH₂- may be replaced by -O-.

5. The chemically amplified positive resist composition according to any one of claims 1 to 4, wherein the repeat units having an aromatic ring structure are incorporated in a range of 60 mol% or more based on the overall repeat units of the polymer contained in (A) the base polymer.

6. The chemically amplified positive resist composition according to any one of claims 1 to 5, further comprising (B) a quencher.

7. The chemically amplified positive resist composition according to any one of claims 1 to 6, further comprising (C) an organic solvent.

8. The chemically amplified positive resist composition according to claim 1, further comprising (D) a fluorinated polymer containing repeat units of at least one type selected from repeat units having the formula (D1), repeat units having the formula (D2), repeat units having the formula (D3) and repeat units having the formula (D4): 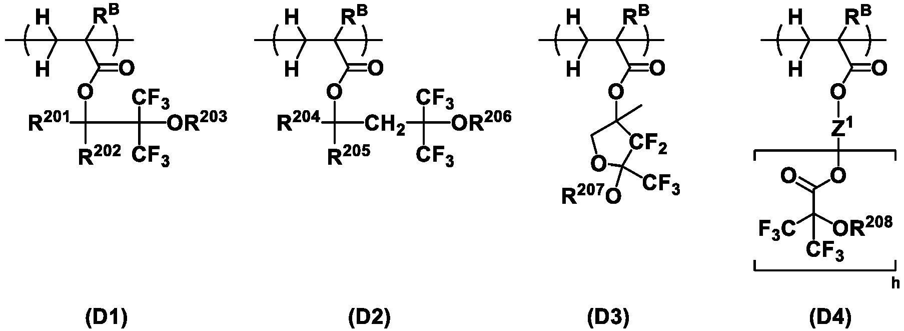 wherein h is an integer of 1 to 3,
R^{B} is each independently a hydrogen atom, fluorine atom, methyl group, or trifluoromethyl group,
R²⁰¹, R²⁰², R²⁰⁴ and R²⁰⁵ are each independently a hydrogen atom or C₁-C₁₀ saturated hydrocarbyl group,
R²⁰³, R²⁰⁶, R²⁰⁷ and R²⁰⁸ are each independently a hydrogen atom, C₁-C₁₅ hydrocarbyl group, C₁-C₁₅ fluorinated hydrocarbyl group or acid labile group, and an ether bond or carbonyl group may intervene in a carbon-carbon bond when each of R²⁰³, R²⁰⁶, R²⁰⁷ and R²⁰⁸ is a hydrocarbyl group or fluorinated hydrocarbyl group, and
Z¹ is a C₁-C₂₀ (h+1)-valent hydrocarbon group or C₁-C₂₀ (h+1)-valent fluorinated hydrocarbon group.

9. The chemically amplified positive resist composition according to claim 8, wherein the fluorinated polymer further comprises repeat units of at least one type selected from repeat units having the formula (D5) and repeat units having the formula (D6): 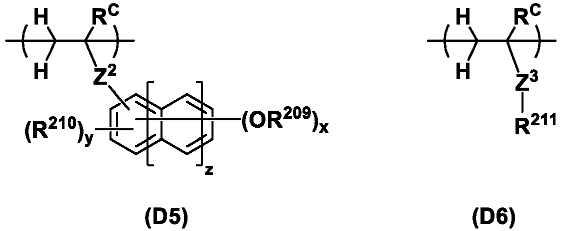 wherein x is an integer of 1 to 3, y is an integer which satisfies 0 ≤ y ≤ 5+2z-x, and z is 0 or 1,
R^{C} is each independently a hydrogen atom or methyl group,
R²⁰⁹ is a hydrogen atom or straight or branched C₁-C₅ hydrocarbyl group in which a group containing a heteroatom may intervene in a carbon-carbon bond,
R²¹⁰ is a straight or branched C₁-C₅ hydrocarbyl group in which a group containing a heteroatom may intervene in a carbon-carbon bond,
R²¹¹ is a C₁-C₂₀ saturated hydrocarbyl group in which at least one hydrogen atom is substituted by a fluorine atom, and some constituent -CH₂- of the saturated hydrocarbyl group may be replaced by an ester bond or ether bond,
Z² is a single bond, *-C(=O)-O- or *-C(=O)-NH-,
Z³ is a single bond, -O-, *-C(=O)-O-Z³¹-Z³²- or *-C(=O)-NH-Z³¹-Z³²-, Z³¹ is a single bond or C₁-C₁₀ saturated hydrocarbylene group, and Z³² is a single bond, ester bond, ether bond or sulfonamide bond, and
the asterisk (*) designates a point of attachment to the carbon atom in the backbone.

10. The chemically amplified positive resist composition according to any one of claims 1 to 9, further comprising (E) a photoacid generator.

11. A resist pattern forming process comprising the steps of: applying the chemically amplified positive resist composition according to any one of claims 1 to 10 onto a substrate to form a resist film thereon, exposing the resist film to a pattern of high-energy radiation, and developing the exposed resist film in an alkaline developer.

12. The resist pattern forming process according to claim 11, wherein the high-energy radiation is KrF excimer laser, ArF excimer laser, an extreme ultraviolet ray or an electron beam.

13. The resist pattern forming process according to claim 11 or 12, wherein the substrate has the outermost surface of a material containing at least one selected from chromium, silicon, tantalum, molybdenum, cobalt, nickel, tungsten, and tin.

14. The resist pattern forming process according to any one of claims 11 to 13, wherein the substrate is a mask blank of transmission or reflection type.

15. A mask blank of transmission or reflection type which is coated with the chemically amplified positive resist composition according to any one of claims 1 to 10.
